(19) Europäisches Patentamt
European Patent Office
Office européen des brevets

(11) EP 3 851 443 B1

(12) **EUROPEAN PATENT SPECIFICATION**

(45) Date of publication and mention of the grant of the patent:
**13.09.2023 Bulletin 2023/37**

(21) Application number: **21151992.1**

(22) Date of filing: **18.01.2021**

(51) International Patent Classification (IPC):
***C07F 15/00*** *(2006.01)* ***C09K 11/06*** *(2006.01)*
***H10K 85/00*** *(2023.01)* ***H10K 85/30*** *(2023.01)*
***H10K 101/10*** *(2023.01)*

(52) Cooperative Patent Classification (CPC):
**C07F 15/0033; C09K 11/06; H10K 85/342;**
C09K 2211/185; H10K 50/11; H10K 2101/10

(54) **ORGANOMETALLIC COMPOUND, ORGANIC LIGHT-EMITTING DEVICE INCLUDING ORGANOMETALLIC COMPOUND, AND ELECTRONIC APPARATUS INCLUDING ORGANIC LIGHT-EMITTING DEVICE**

ORGANOMETALLISCHE VERBINDUNG, ORGANISCHE LICHTEMITTIERENDE VORRICHTUNG MIT ORGANOMETALLISCHER VERBINDUNG UND ELEKTRONISCHE VORRICHTUNG MIT ORGANISCHER LICHTEMITTIERENDER VORRICHTUNG

COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.01.2020 KR 20200007377**

(43) Date of publication of application:
**21.07.2021 Bulletin 2021/29**

(73) Proprietor: **Samsung Electronics Co., Ltd.**
**Suwon-si, Gyeonggi-do 16677 (KR)**

(72) Inventors:
- **KANG, Byungjoon**
  **16678 Gyeonggi-do (KR)**
- **KWAK, Seungyeon**
  **16678 Gyeonggi-do (KR)**
- **LEE, Kum Hee**
  **16678 Gyeonggi-do (KR)**
- **JEON, Aram**
  **16678 Gyeonggi-do (KR)**
- **HWANG, Kyuyoung**
  **16678 Gyeonggi-do (KR)**
- **LEE, Banglin**
  **16678 Gyeonggi-do (KR)**
- **ISHIHARA, Shingo**
  **16678 Gyeonggi-do (KR)**
- **CHO, Yuri**
  **16678 Gyeonggi-do (KR)**
- **CHOI, Byoungki**
  **16678 Gyeonggi-do (KR)**
- **HONG, Seokhwan**
  **16678 Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**JP-A- 2003 252 888**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 851 443 B1

## Description

FIELD OF THE INVENTION

One or more embodiments of the present disclosure relate to an organometallic compound, an organic light-emitting device including the organometallic compound, and an electronic apparatus including the organic light-emitting device.

BACKGROUND OF THE INVENTION

Organic light-emitting devices (OLEDs) are self-emission devices which produce full-color images. In addition, OLEDs have wide viewing angles and exhibit excellent driving voltage and response speed characteristics.

OLEDs include an anode, a cathode, and an organic layer disposed between the anode and the cathode and including an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

JP 2003 252888 A discloses an organic iridium complex which may be used as a phosphorescent dye, or as an organic electroluminescent element in a thin-film organic electroluminescent device or near-infrared light-emitting material.

SUMMARY OF THE INVENTION

Provided are a novel organometallic compound, an organic light-emitting device including the organometallic compound, and an electronic apparatus including the organic light-emitting device.

Additional aspects will be set forth in part in the description which follows and, in part, will be apparent from the description, or may be learned by practice of the presented embodiments of the disclosure.

According to an aspect of the invention, an organometallic compound is provided in accordance with claim 1.

According to another aspect, an organic light-emitting device is provided in accordance with claim 13.

The organometallic compound may be included in the emission layer, and the organometallic compound included in the emission layer may serve as a dopant.

According to another aspect, an electronic apparatus may include the organic light-emitting device.

BRIEF DESCRIPTION OF THE DRAWINGS

The above and other aspects, features, and advantages of certain embodiments of the disclosure will be more apparent from the following description taken in conjunction with the FIGURE, which is a schematic cross-sectional view of an organic light-emitting device according to one or more exemplary embodiments.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing

from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to a cross section illustration that is a schematic illustration of one or more idealized embodiments. As such, variations from the shapes of the illustration as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figure are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, or 5% of the stated value.

An aspect of the present invention provides an organometallic compound represented by Formula 1:

Formula 1 $M(L_1)_{n1}(L_2)_{n2}$

wherein, in Formula 1, M is iridium (Ir), platinum (Pt), osmium (Os), titanium (Ti), zirconium (Zr), hafnium (Hf), europium (Eu), terbium (Tb), thulium (Tm), or rhodium (Rh).

In an embodiment, M may be Ir, Pt, Os, or Rh.

In Formula 1, $L_1$ is a ligand represented by Formula 2:

Formula 2

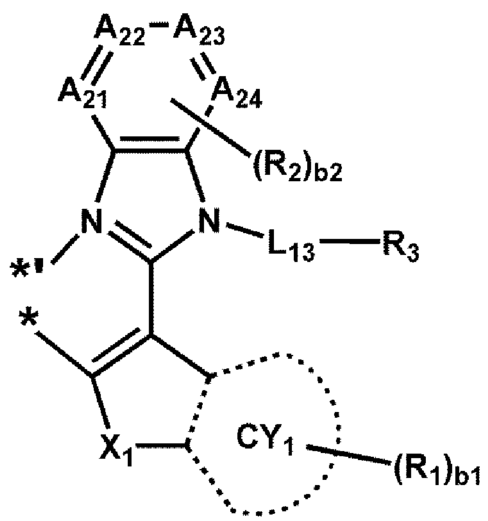

Formula 2 may be understood by referring to the description thereof provided herein.

In Formula 1, n1 indicates the number of $L_1$ groups, and n1 is 1, 2, or 3. When n1 is 2 or greater, at least two $L_1$ groups are identical to or different from each other. In some embodiments, n1 may be 1 or 2.

$L_2$ in Formula 1 is a monodentate ligand, a bidentate ligand, a tridentate ligand, or a tetradentate ligand. $L_2$ may be understood by referring to the description of $L_2$ provided herein.

In Formula 2, n2 indicates the number of $L_2$ groups, and n2 is 0, 1, 2, 3, or 4. When n2 is 2 or greater, at least two $L_2$ groups are identical to different from each other. In some embodiments, n2 may be 1 or 2.

In Formula 1, $L_1$ and $L_2$ are different from each other.

In an embodiment, in Formula 1, M may be Ir or Os, and the sum of n1 and n2 may be 3 or 4, or M may be Pt, and the sum of n1 and n2 may be 2.

In one or more embodiments, in Formula 1, M may be Ir, n1 and n2 may each independently be 1 or 2, and the sum of n1 and n2 may be 3.

In one or more embodiments, in Formula 1, M may be Ir, n1 may be 3, and n2 may be 0. In this embodiment, three $L_1$ groups may be identical to one another.

In Formula 2, $A_{21}$ to $A_{24}$ are each independently N or C. In some embodiments, $A_{21}$ to $A_{24}$ may each be C.

In Formula 2, $X_1$ is O or S.

In Formula 2, $L_{13}$ is a single bond, a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

In some embodiments, $L_{13}$ in Formula 2 may be:

a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each independently unsubstituted or substituted with at least one $R_{10a}$.

In an embodiment, $L_{13}$ in Formula 2 may be:

a single bond; or
a benzene group, a naphthalene group, a pyridine group, a dibenzofuran group, a dibenzothiophene group, or a carbazole group, each unsubstituted or substituted with at least one $R_{10a}$.

In Formula 2, ring $CY_1$ is a $C_5$-$C_{30}$ carbocyclic group or a $C_1$-$C_{30}$ heterocyclic group.

In some embodiments, in Formula 2, ring $CY_1$ may be i) a first ring, ii) a second ring, iii) a condensed ring in which at least two first rings are condensed with each other, iv) a condensed ring in which at least two second rings are condensed with each other, or v) a condensed ring in which at least one first ring and at least one second ring are condensed with each other,

wherein the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an iso-thiadiazole group, a thiatriazole group, an isothiatriazole group, a pyrazole group, an imidazole group, a triazole group, a tetrazole group, an azasilole group, a diazasilole group, or a triazasilole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In an embodiment, in Formula 2, ring $CY_1$ may be i) the first ring or ii) the second ring.

In one or more embodiments, in Formula 2, ring $CY_1$ may be a condensed ring in which at least two rings are condensed with each other.

In some embodiments, in Formula 2, ring $CY_1$ may be iii) a condensed ring in which at least two first rings are condensed with each other, iv) a condensed ring in which at least two second rings are condensed with each other, or

v) a condensed ring in which at least one first ring and at least one second ring are condensed with each other.

In some embodiments, in Formula 2, ring $CY_1$ may be a cyclopentane group, a cyclohexane group, a cycloheptane group, a cyclopentene group, a cyclohexene group, a cycloheptene group, an adamantane group, a norbornane group, a norbornene group, a bicyclo[1.1.1]pentane group, a bicyclo[2.1.1]hexane group, a bicyclo[2.2.2]octane group, a benzene group, a naphthalene group, an anthracene group, a phenanthrene group, a triphenylene group, a pyrene group, a chrysene group, a 1,2,3,4-tetrahydronaphthalene group, a pyrrole group, borole group, a phosphole group, a cyclopentadiene group, a silole group, a germole group, a thiophene group, a selenophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a quinoxaline group, a quinazoline group, a phenanthroline group, a pyrazole group, an imidazole group, a triazole group, an azaborole group, an azaphosphole group, an azacyclopentadiene group, an azasilole group, an azagermole group, an azaselenophene group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, in Formula 2, ring $CY_1$ may be a benzene group, a naphthalene group, an anthracene group, a phenanthrene group, a triphenylene group, a pyrene group, a chrysene group, a pyridine group, a pyrimidine group, a pyrazine group, a pyridazine group, a quinoline group, an isoquinoline group, a benzoquinoline group, a benzoisoquinoline group, a quinoxaline group, a quinazoline group, or a phenanthroline group.

In Formula 2, $R_1$ and $R_2$ are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group (e.g., a substituted or unsubstituted $C_2$-$C_{10}$ heterocycloalkenyl group), a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$. $Q_1$ to $Q_9$ may respectively be understood by referring to the descriptions of $Q_1$ to $Q_9$ provided herein.

In Formula 2, $R_3$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group.

In some embodiments, in Formula 2, $R_1$ and $R_2$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkenyl group, a $C_1$-$C_{20}$ alkoxy group, or a $C_1$-$C_{20}$ alkylthio group;

a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt

thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_2$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$,

wherein $Q_1$ to $Q_9$ may each independently be:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a $C_1$-$C_{10}$ alkyl group, a phenyl group, or a combination thereof.

In some embodiments, in Formula 2, $R_1$ and $R_2$ may each independently be hydrogen, deuterium, -F, $-CH_3$, $-CD_3$, $-CD_2H$, $-CDH_2$, $-CF_3$, $-CF_2H$, $-CFH_2$, a $C_1$-$C_{10}$ alkyl group, a $C_2$-$C_{10}$ alkenyl group, a $C_1$-$C_{10}$ alkoxy group, a

$C_1$-$C_{10}$ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-236, a group represented by one of Formulae 9-201 to 9-236 in which at least one hydrogen is substituted with deuterium, a group represented by one of Formulae 9-201 to 9-236 in which at least one hydrogen is substituted with -F, a group represented by one of Formulae 10-1 to 10-130, a group represented by one of Formulae 10-1 to 10-130 in which at least one hydrogen is substituted with deuterium, a group represented by one of Formulae 10-1 to 10-130 in which at least one hydrogen is substituted with -F, a group represented by one of Formulae 10-201 to 10-358, a group represented by one of Formulae 10-201 to 10-358 in which at least one hydrogen is substituted with deuterium, a group represented by one of Formulae 10-201 to 10-358 in which at least one hydrogen is substituted with -F, $-Si(Q_3)(Q_4)(Q_5)$, or $-Ge(Q_3)(Q_4)(Q_5)$, wherein $Q_3$ to $Q_5$ may respectively be understood by referring to the descriptions of $Q_3$ to $Q_5$ provided herein:

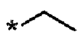
9-1
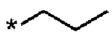
9-2
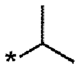
9-3
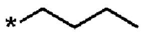
9-4
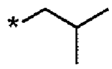
9-5
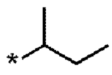
9-6
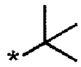
9-7
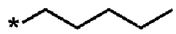
9-8

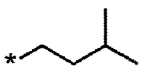
9-9
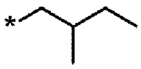
9-10
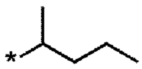
9-11
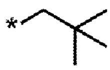
9-12
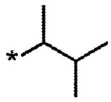
9-13
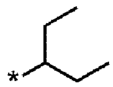
9-14
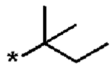
9-15

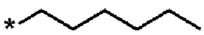
9-16
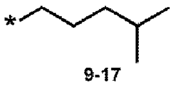
9-17
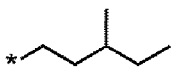
9-18
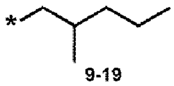
9-19
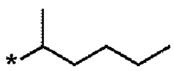
9-20
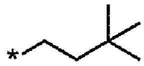
9-21

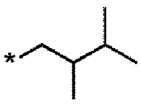
9-22
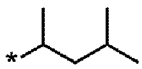
9-23
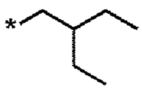
9-24
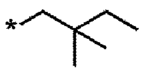
9-25
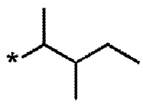
9-26
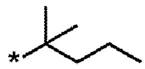
9-27
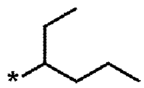
9-28

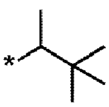
9-29
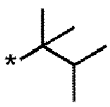
9-30
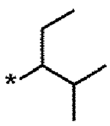
9-31
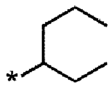
9-32
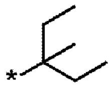
9-33
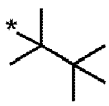
9-34
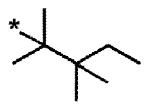
9-35
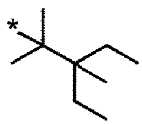
9-36

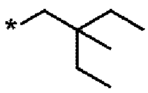
9-37
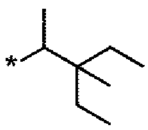
9-38
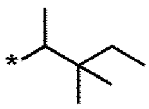
9-39

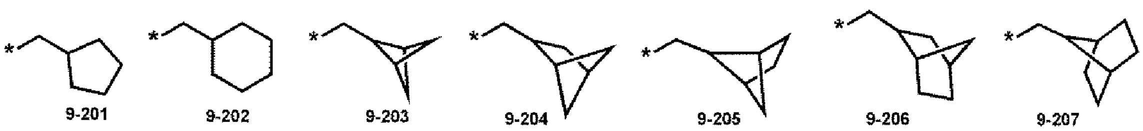
9-201 9-202 9-203 9-204 9-205 9-206 9-207

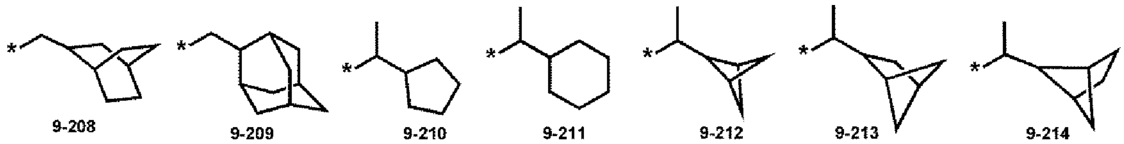

9-208 9-209 9-210 9-211 9-212 9-213 9-214

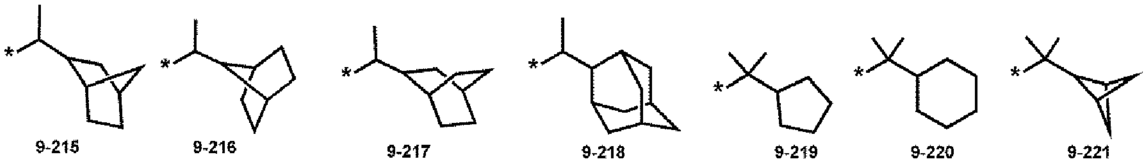

9-215 9-216 9-217 9-218 9-219 9-220 9-221

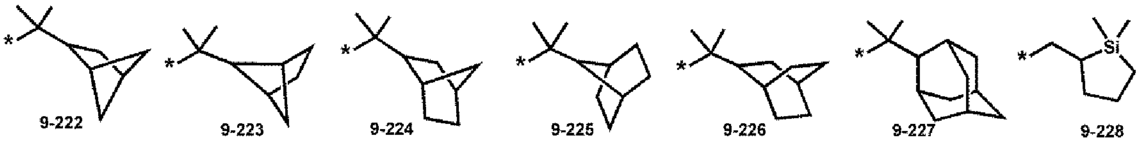

9-222 9-223 9-224 9-225 9-226 9-227 9-228

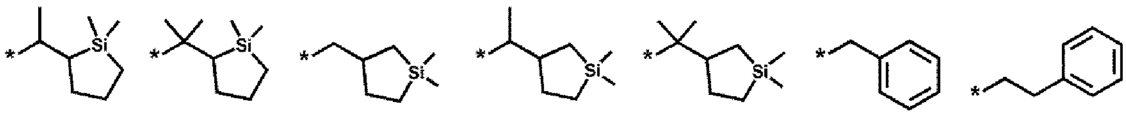

9-229 9-230 9-231 9-232 9-233 9-234 9-235

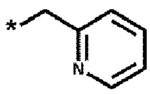

9-236

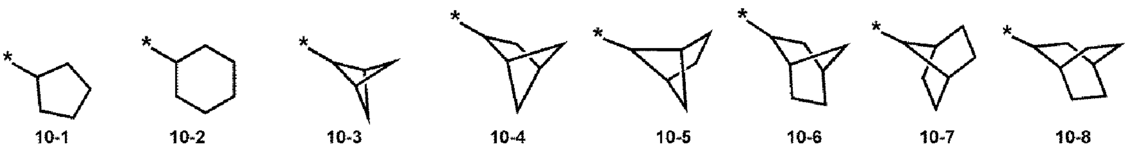

10-1 10-2 10-3 10-4 10-5 10-6 10-7 10-8

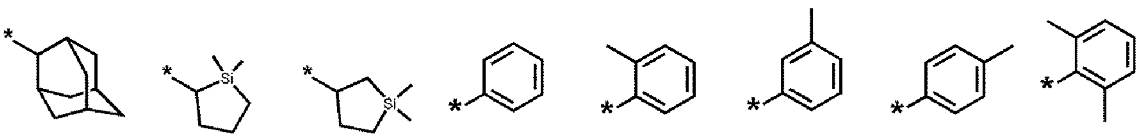

10-9 10-10 10-11 10-12 10-13 10-14 10-15 10-16

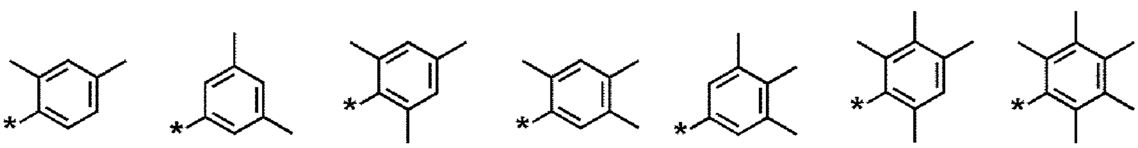

10-17 10-18 10-19 10-20 10-21 10-22 10-23

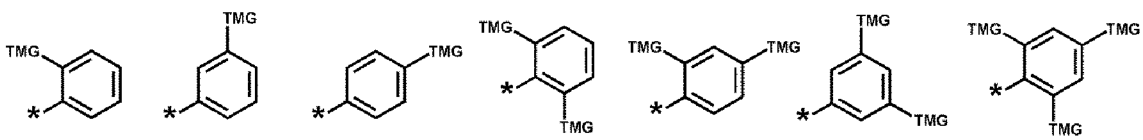

10-24 10-25 10-26 10-27 10-28 10-29 10-30

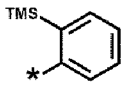
10-31
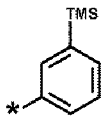
10-32
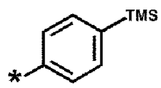
10-33
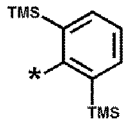
10-34
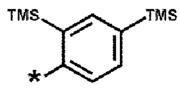
10-35
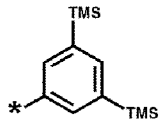
10-36
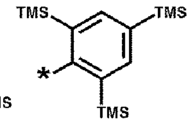
10-37

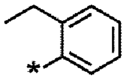
10-38
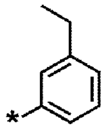
10-39
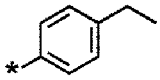
10-40
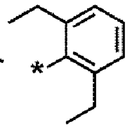
10-41
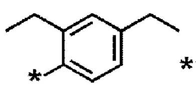
10-42
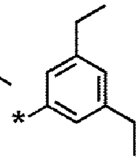
10-43
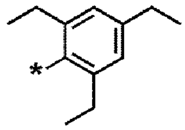
10-44

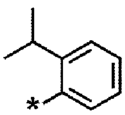
10-45
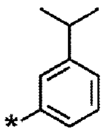
10-46
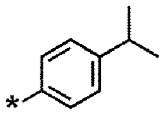
10-47
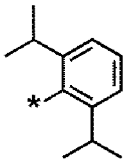
10-48
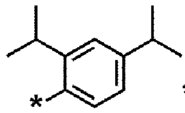
10-49
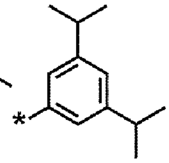
10-50
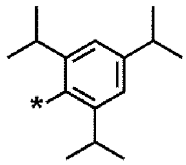
10-51

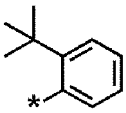
10-52
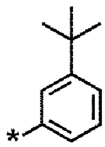
10-53
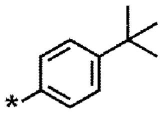
10-54
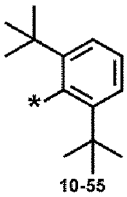
10-55
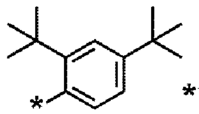
10-56
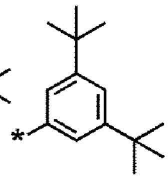
10-57
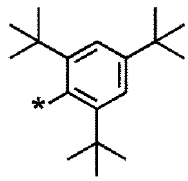
10-58

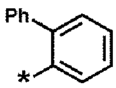
10-59
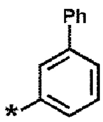
10-60
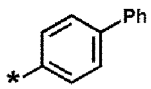
10-61
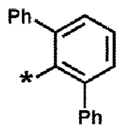
10-62
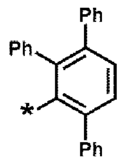
10-63
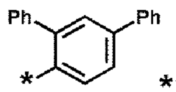
10-64
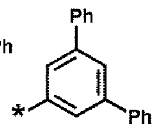
10-65
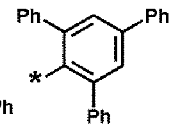
10-66

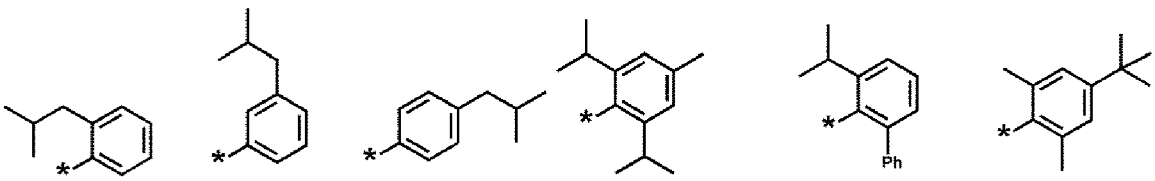
10-67 10-68 10-69 10-70 10-71 10-72

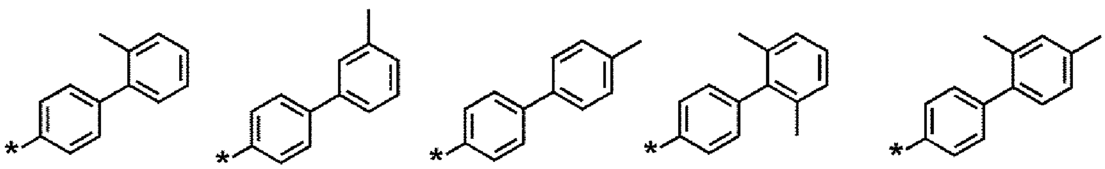
10-73 10-74 10-75 10-76 10-77

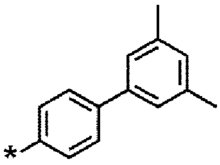
10-78
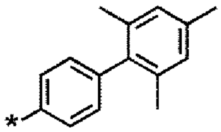
10-79
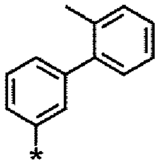
10-80
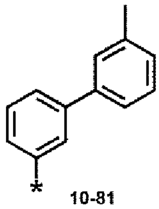
10-81
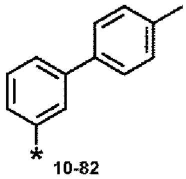
10-82

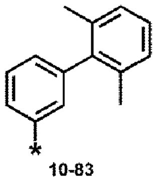
10-83
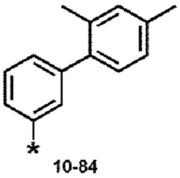
10-84
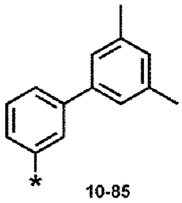
10-85
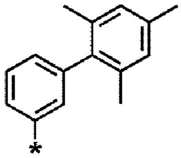
10-86
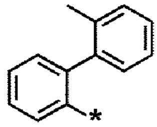
10-87
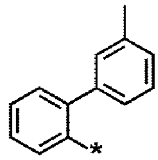
10-88

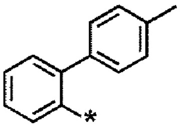
10-89
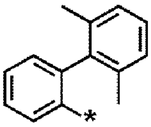
10-90
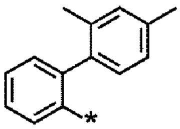
10-91
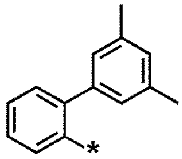
10-92
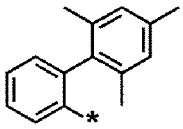
10-93
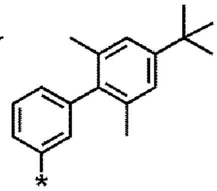
10-94

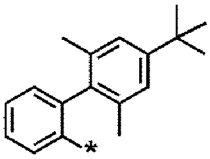
10-95
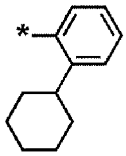
10-96
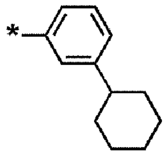
10-97
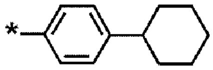
10-98
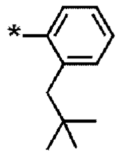
10-99
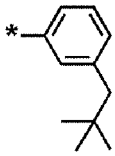
10-100

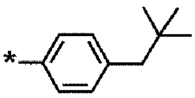
10-101
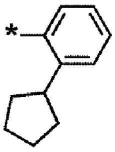
10-102
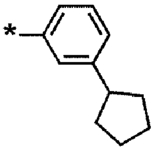
10-103
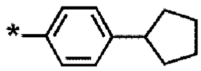
10-104
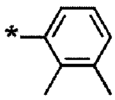
10-105
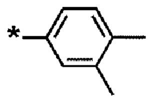
10-106

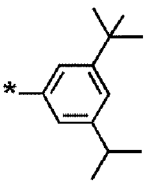
10-107
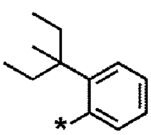
10-108
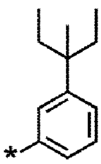
10-109
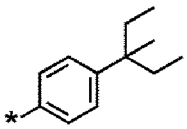
10-110
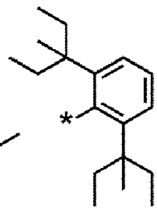
10-111
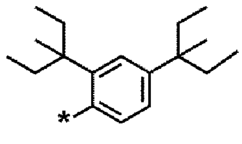
10-112

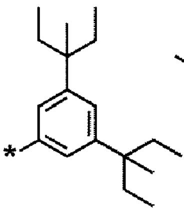
10-113
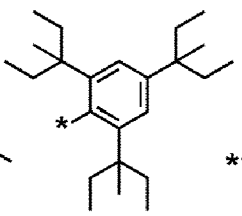
10-114
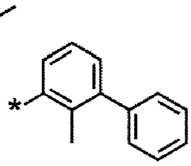
10-115
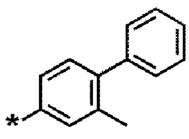
10-116
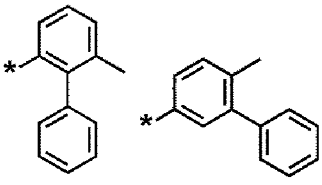
10-117
10-118

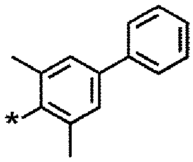
10-119

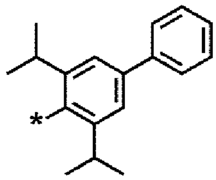
10-120

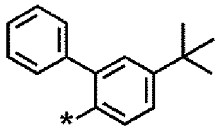
10-121

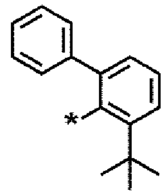
10-122

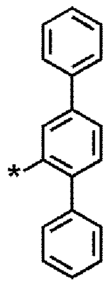
10-123

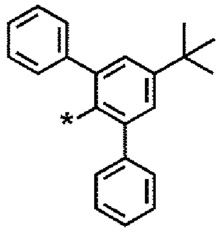
10-124

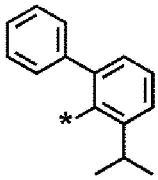
10-125

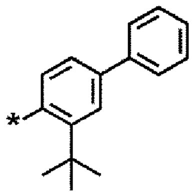
10-126

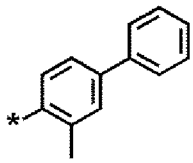
10-127

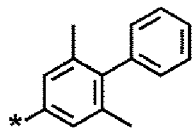
10-128

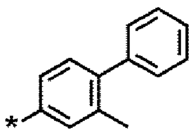
10-129

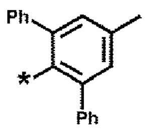
10-130

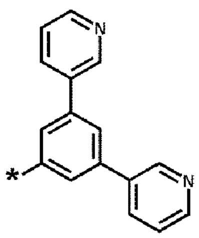
10-201

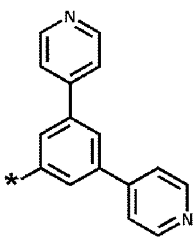
10-202

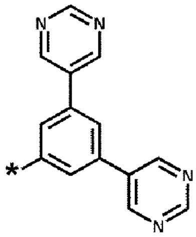
10-203

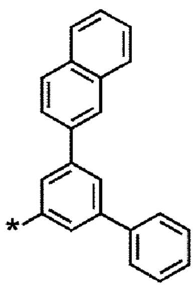
10-204

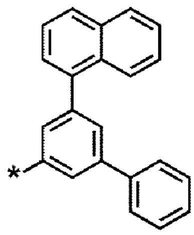
10-205

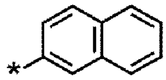
10-206

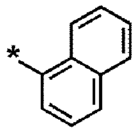
10-207

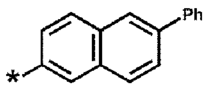
10-208

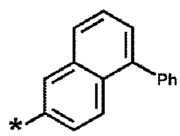
10-209

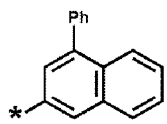
10-210

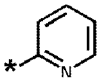
10-211

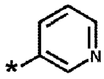
10-212

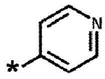
10-213

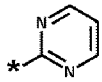
10-214

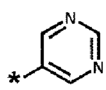
10-215

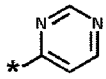
10-216

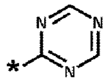
10-217

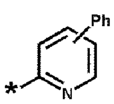
10-218

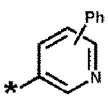
10-219

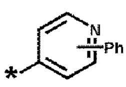
10-220

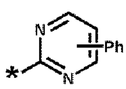
10-221

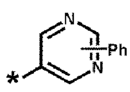
10-222

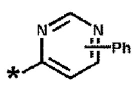
10-223

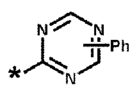
10-224

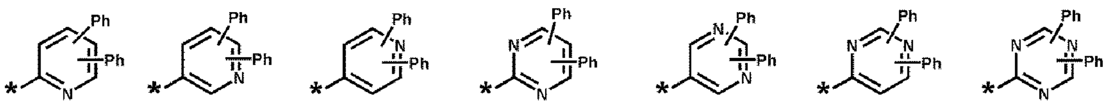

10-225 10-226 10-227 10-228 10-229 10-230 10-231

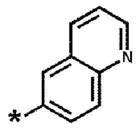 10-232
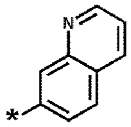 10-233
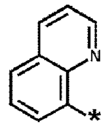 10-234
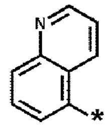 10-235
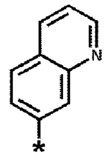 10-236
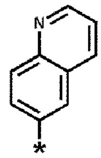 10-237

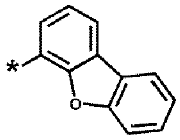 10-238
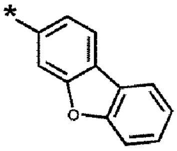 10-239
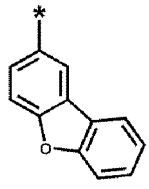 10-240
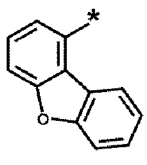 10-241
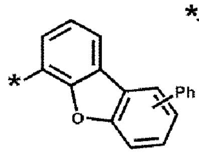 10-242
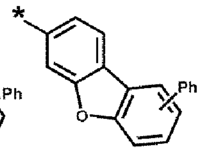 10-243

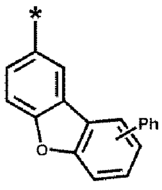 10-244
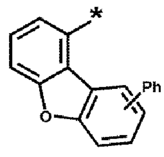 10-245
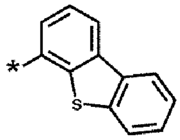 10-246
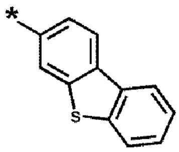 10-247
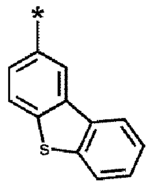 10-248
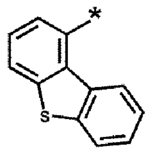 10-249

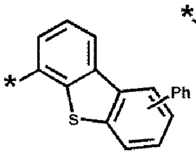 10-250
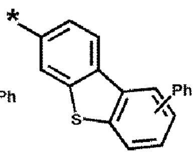 10-251
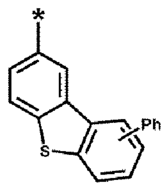 10-252
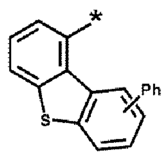 10-253
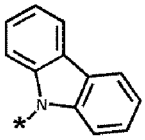 10-254
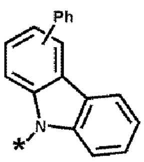 10-255

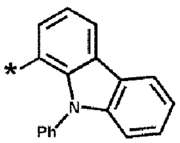 10-256
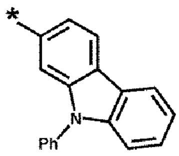 10-257
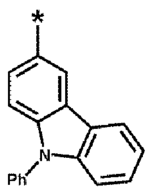 10-258
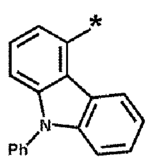 10-259
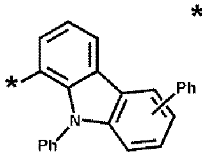 10-260
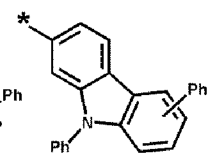 10-261

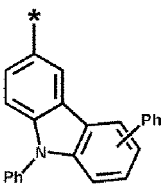 10-262
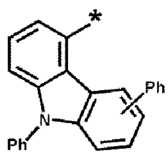 10-263
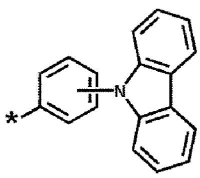 10-264
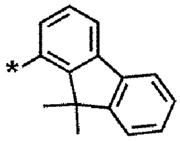 10-265
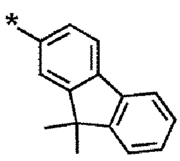 10-266
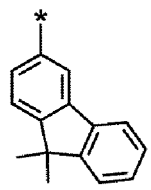 10-267

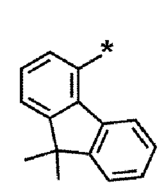 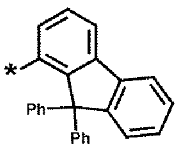 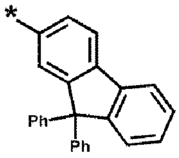 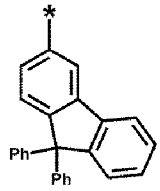 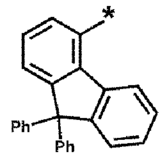

10-268 10-269 10-270 10-271 10-272

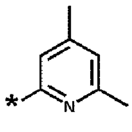 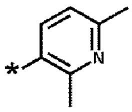 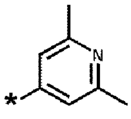 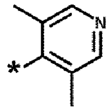 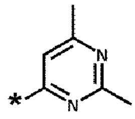 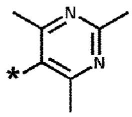 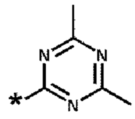

10-273 10-274 10-275 10-276 10-277 10-278 10-279

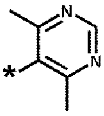 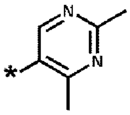 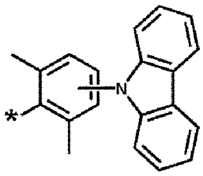 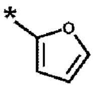 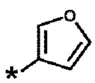 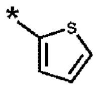 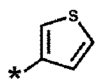

10-280 10-281 10-282 10-283 10-284 10-285 10-286

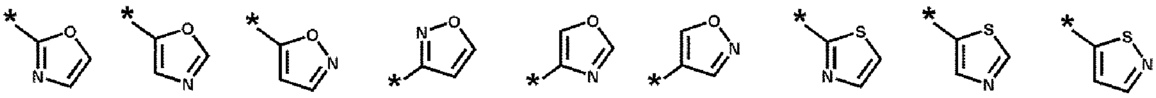

10-287 10-288 10-289 10-290 10-291 10-292 10-293 10-294 10-295

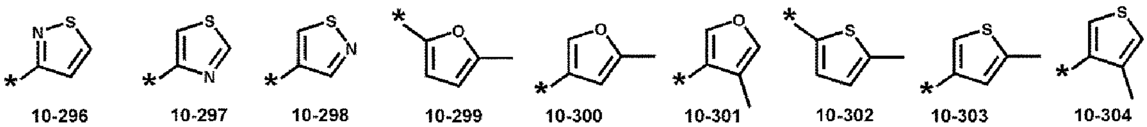

10-296 10-297 10-298 10-299 10-300 10-301 10-302 10-303 10-304

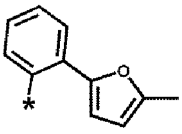 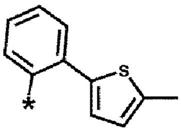 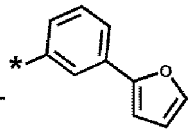 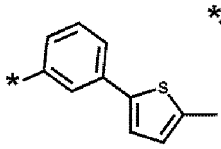 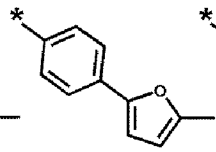 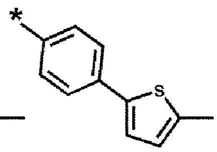

10-305 10-306 10-307 10-308 10-309 10-310

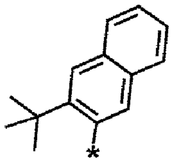 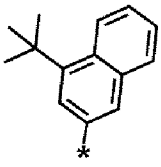 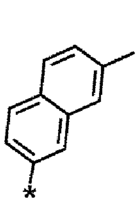 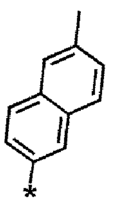 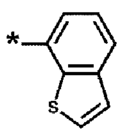 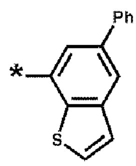 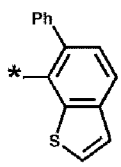

10-311 10-312 10-313 10-314 10-315 10-316 10-317

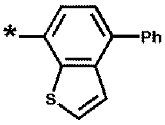
10-318

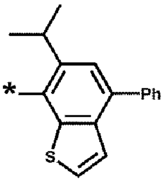
10-319

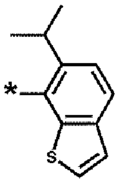
10-320

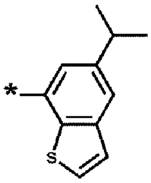
10-321

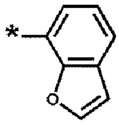
10-322

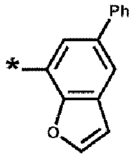
10-323

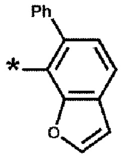
10-324

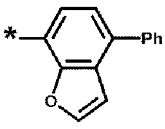
10-325

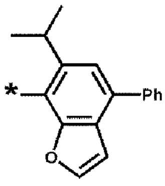
10-326

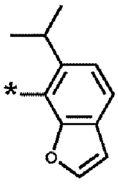
10-327

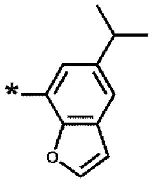
10-328

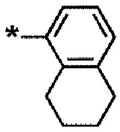
10-329

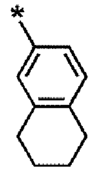
10-330

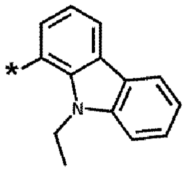
10-331

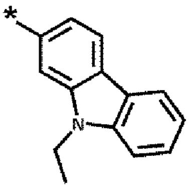
10-332

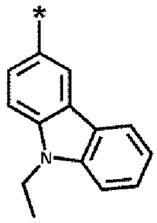
10-333

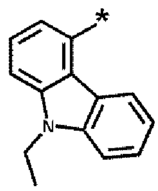
10-334

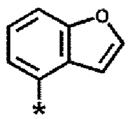
10-335

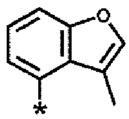
10-336

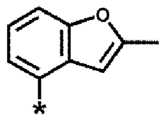
10-337

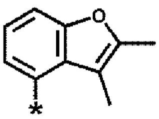
10-338

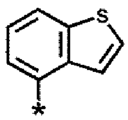
10-339

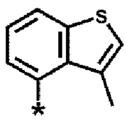
10-340

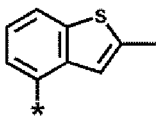
10-341

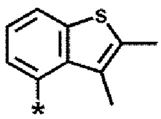
10-342

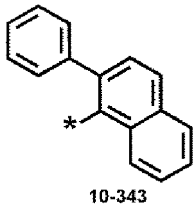
10-343

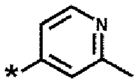
10-344

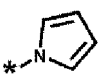
10-345

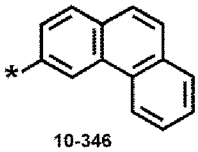
10-346

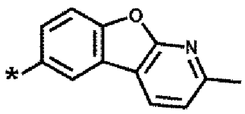
10-347

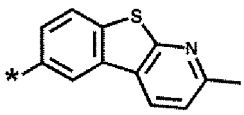
10-348

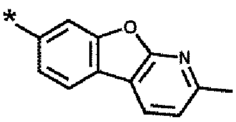
10-349

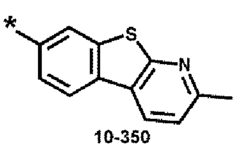
10-350

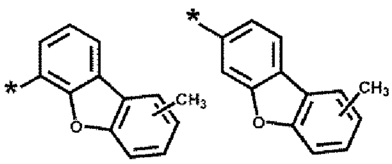
10-351

10-352

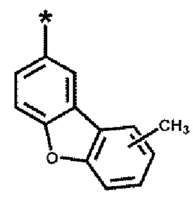
10-353

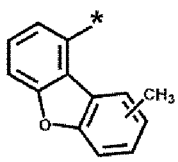
10-354

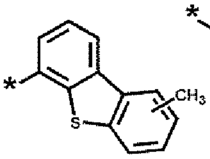
10-355

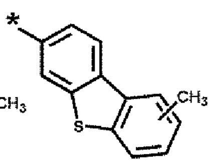
10-356

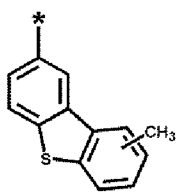
10-357

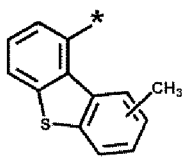
10-358

In Formulae 9-1 to 9-39, 9-201 to 9-236, 10-1 to 10-130, and 10-201 to 10-358, * indicates a bonding site to an adjacent atom, "Ph" represents a phenyl group, "TMS" and "$SiMe_3$" each represent a trimethylsilyl group, and "TMG" and "GeMes" each represent a trimethylgermyl group.

The "group represented by one of Formulae 9-1 to 9-39 in which at least one hydrogen is substituted with deuterium" and the "group represented by one of Formulae 9-201 to 9-236 in which at least one hydrogen is substituted with deuterium" may each be, for example, a group represented by one of Formulae 9-501 to 9-514 and 9-601 to 9-636:

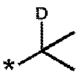
9-501

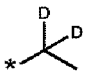
9-502

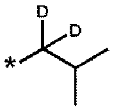
9-503

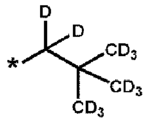
9-504

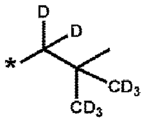
9-505

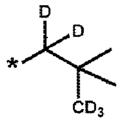
9-506

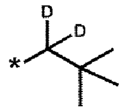
9-507

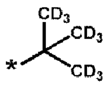
9-508

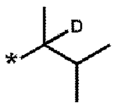
9-509

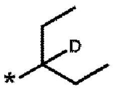
9-510

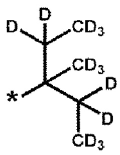
9-511

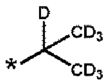
9-512

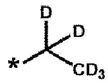
9-513

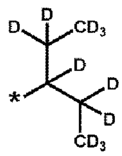
9-514

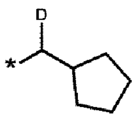
9-601

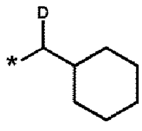
9-602

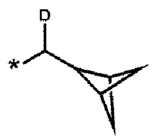
9-603

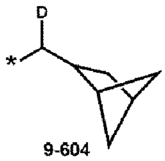
9-604

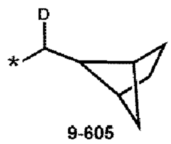
9-605

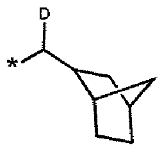
9-606

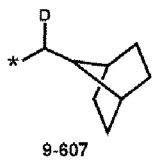
9-607

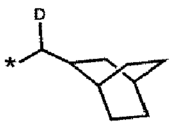
9-608

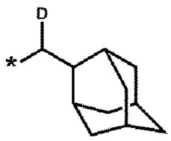
9-609

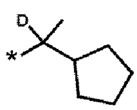
9-610

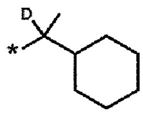
9-611

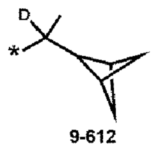
9-612

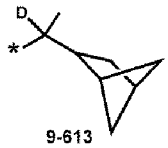
9-613

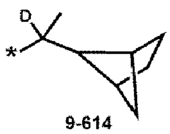
9-614

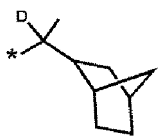
9-615

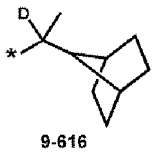
9-616

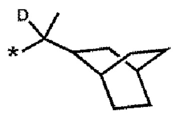
9-617

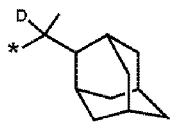
9-618

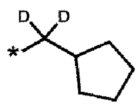
9-619

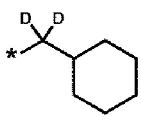
9-620

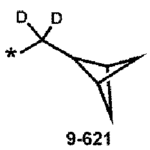
9-621

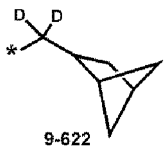
9-622

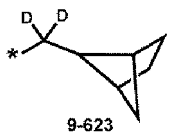
9-623

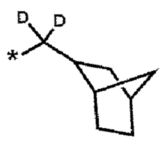
9-624

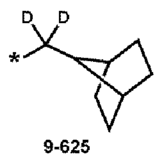
9-625

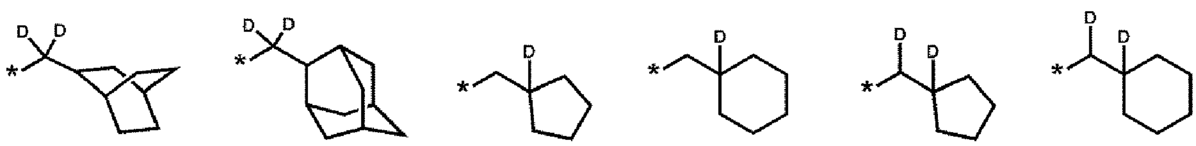
9-626 9-627 9-628 9-629 9-630 9-631

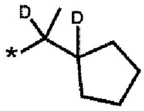
9-632
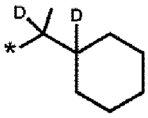
9-633
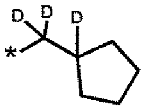
9-634
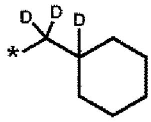
9-635
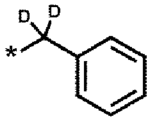
9-636

The "group represented by one of Formulae 9-1 to 9-39 in which at least one hydrogen is substituted with -F" and the "group represented by one of Formulae 9-201 to 9-236 in which at least one hydrogen is substituted with -F" may each be, for example, a group represented by one of Formulae 9-701 to 710:

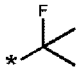
9-701
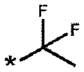
9-702
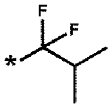
9-703
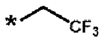
9-704
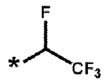
9-705
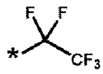
9-706
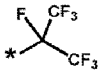
9-707
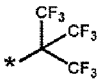
9-708
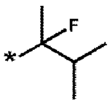
9-709
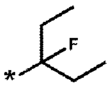
9-710

The "group represented by one of Formulae 10-1 to 10-130 in which at least one hydrogen is substituted with a deuterium" and the "group represented by one of Formulae 10-201 to 10-358 in which at least one hydrogen is substituted with deuterium" may each be, for example, a group represented by one of Formulae 10-501 to 553:

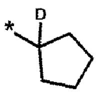
10-501
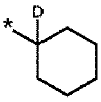
10-502
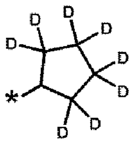
10-503
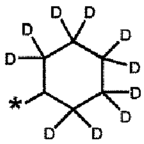
10-504
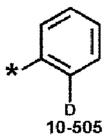
10-505
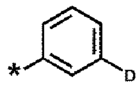
10-506
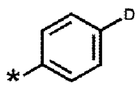
10-507
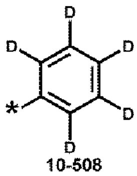
10-508
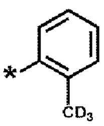
10-509
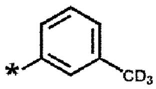
10-510
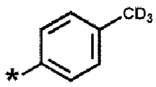
10-511
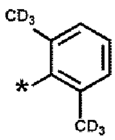
10-512
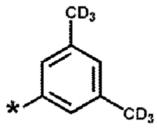
10-513
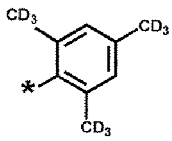
10-514
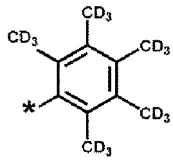
10-515
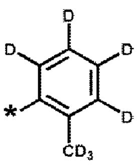
10-516
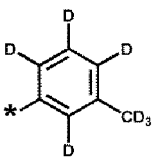
10-517
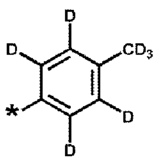
10-518
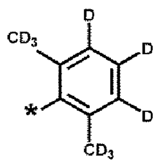
10-519
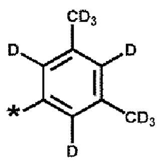
10-520
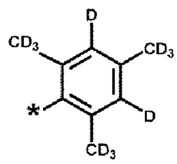
10-521
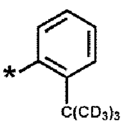
10-522
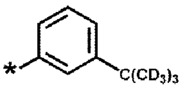
10-523
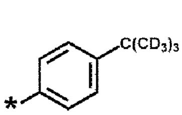
10-524
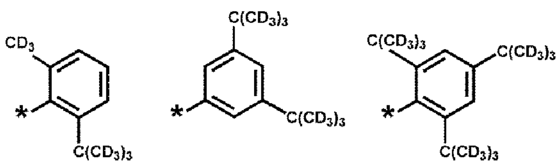
10-525
10-526
10-527

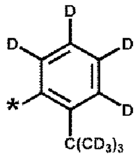
10-528

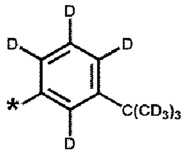
10-529

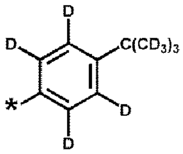
10-530

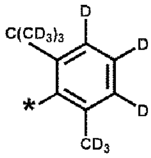
10-531

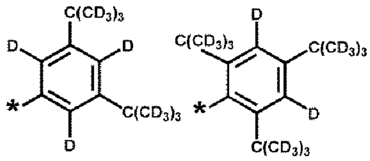
10-532 10-533

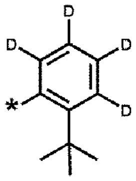
10-534

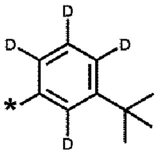
10-535

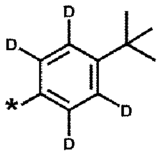
10-536

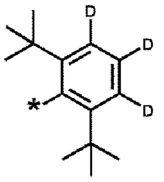
10-537

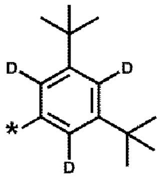
10-538

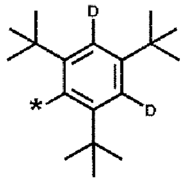
10-540

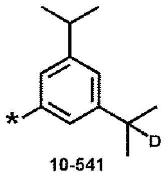
10-541

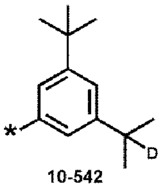
10-542

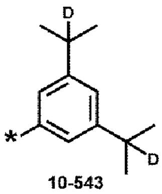
10-543

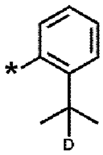
10-544

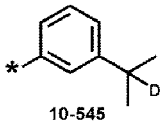
10-545

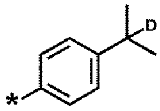
10-546

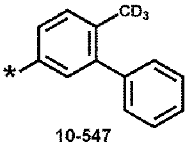
10-547

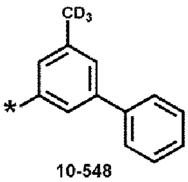
10-548

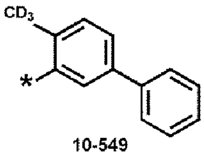
10-549

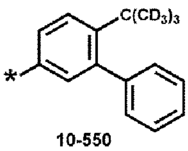
10-550

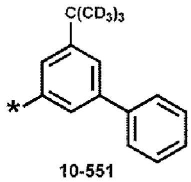
10-551

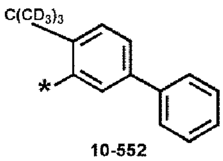
10-552

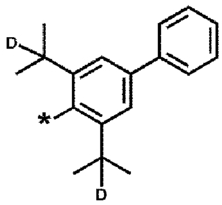
10-553

The "group represented by one of Formulae 10-1 to 10-130 in which at least one hydrogen is substituted with -F" and the "group represented by one of Formulae 10-201 to 10-358 in which at least one hydrogen is substituted with -F" may each be, for example, a group represented by one of Formulae 10-601 to 617:

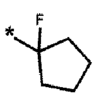
10-601

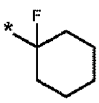
10-602

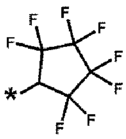
10-603

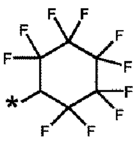
10-604

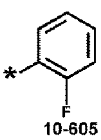
10-605

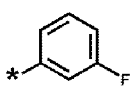
10-606

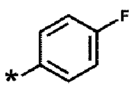
10-607

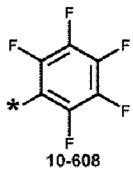
10-608

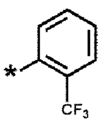
10-609

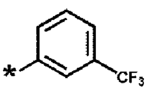
10-610

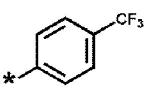
10-611

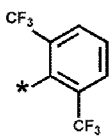
10-612

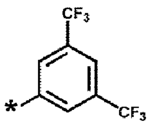
10-613

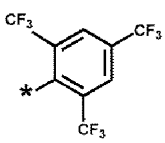
10-614

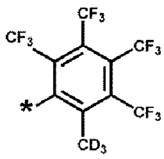
10-615

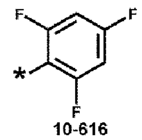
10-616

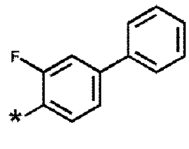
10-617

In some embodiments, in Formula 2,
$R_2$ may be hydrogen, deuterium, -F, a cyano group, a substituted or unsubstituted $C_1$-$C_{60}$ alkyl group, a substituted or unsubstituted $C_3$-$C_{10}$ cycloalkyl group, -Si($Q_3$)($Q_4$)($Q_5$), or -Ge($Q_3$)($Q_4$)($Q_5$).

In Formula 2, b1 indicates the number of $R_1$ groups, and b1 is an integer from 0 to 20. When b1 is an integer of 2 or greater, at least two $R_1$ groups may be identical to or different from each other. In some embodiments, b1 may be an integer from 0 to 10.

In Formula 2, b2 indicates the number of $R_2$ groups, and b2 is an integer from 0 to 4. When b2 is 2 or greater, at least two $R_2$ groups may be identical to different from each other. In some embodiments, b2 may be 0, 1, or 2.

In an embodiment, a group represented by

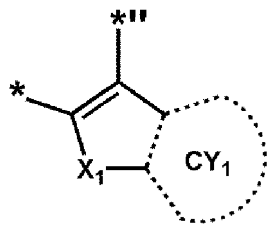

in Formula 2 may be represented by one of Formulae 2(1) to 2(31):

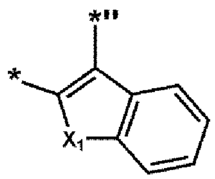
2(1)

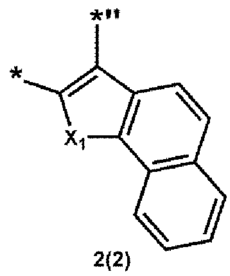
2(2)

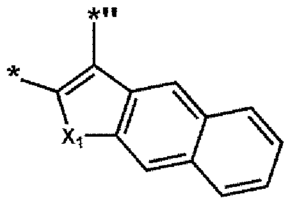
2(3)

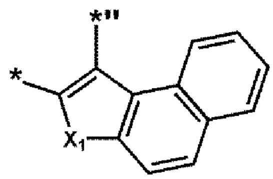
2(4)

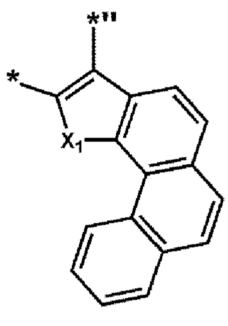
2(5)

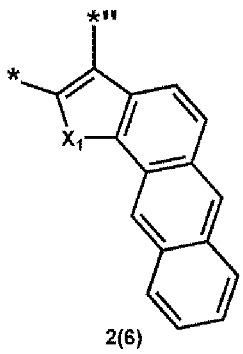
2(6)

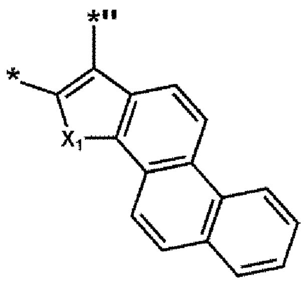
2(7)

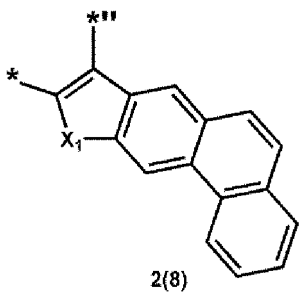
2(8)

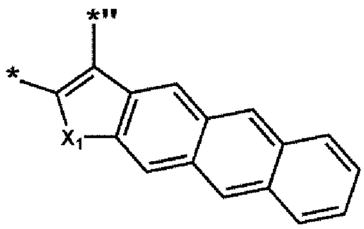
2(9)

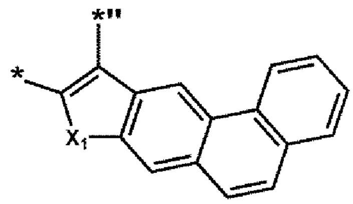
2(10)

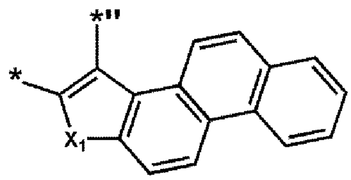
2(11)

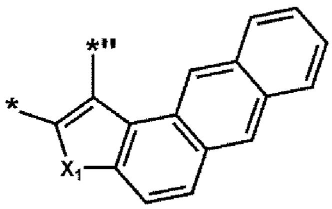
2(12)

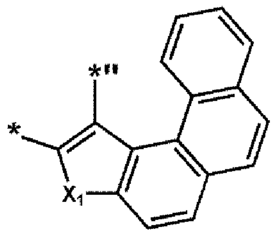
2(13)

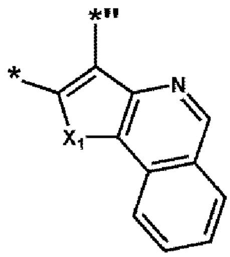
2(14)

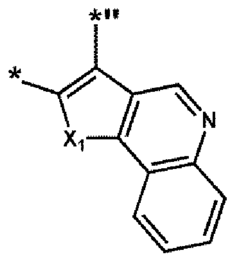
2(15)

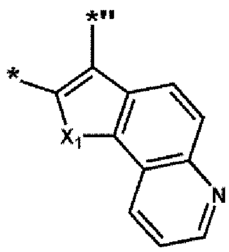
2(16)

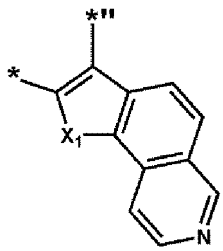
2(17)

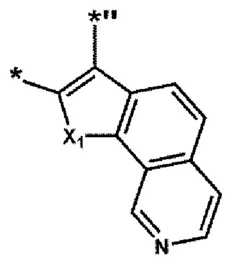
2(18)

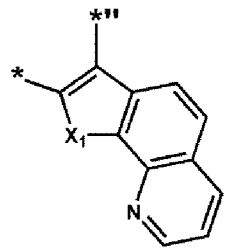
2(19)

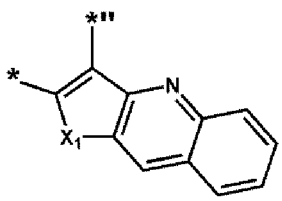
2(20)

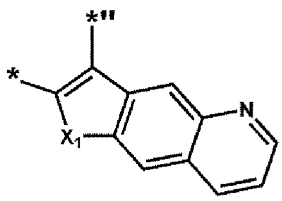
2(21)

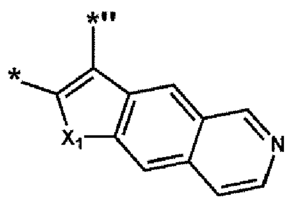
2(22)

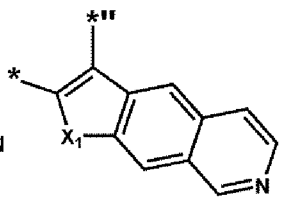
2(23)

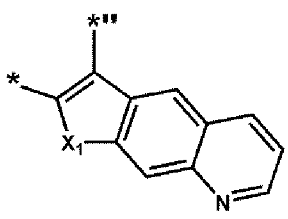
2(24)

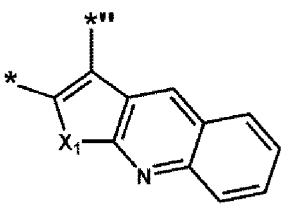
2(25)

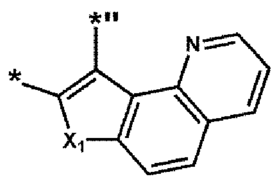
2(26)

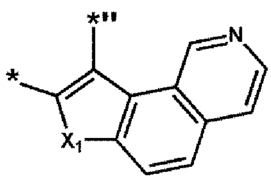
2(27)

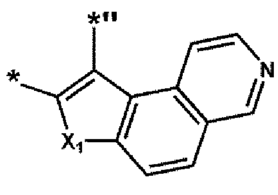
2(28)

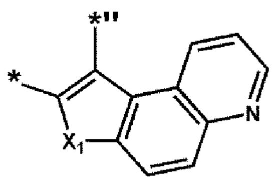
2(29)

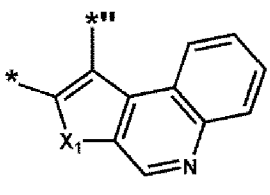
2(30)

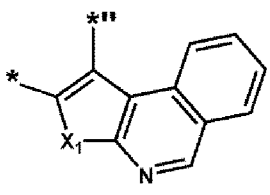
2(31)

wherein, in Formulae 2(1) to 2(31),

$X_1$ may be understood by referring to the description of $X_1$ provided herein,
* indicates a bonding site to M in Formula 1, and
*" indicates a bonding site to an adjacent carbon atom.

In one or more embodiments, a group represented by

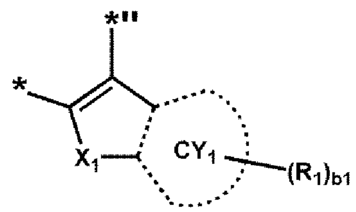

in Formula 2 may be represented by one of Formulae 2-1 to 2-57:

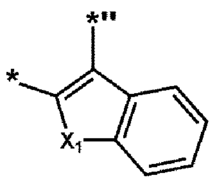
2-1

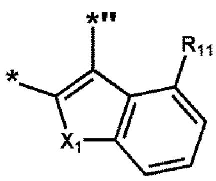
2-2

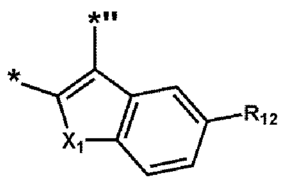
2-3

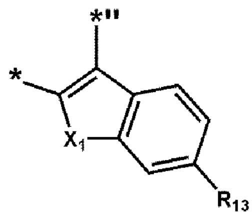
2-4

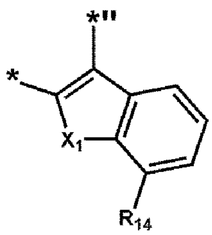
2-5

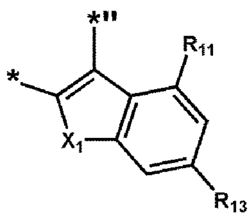
2-6

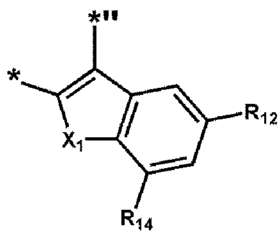
2-7

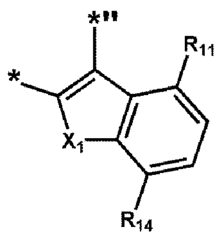
2-8

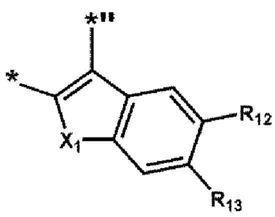
2-9

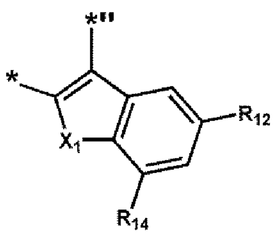
2-10

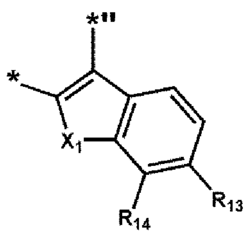
2-11

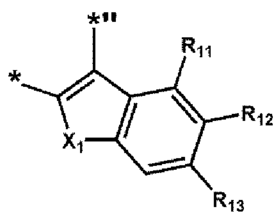
2-12

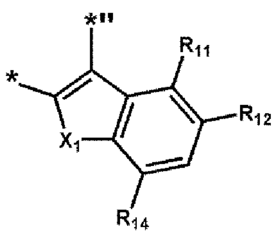
2-13

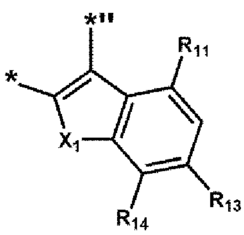
2-14

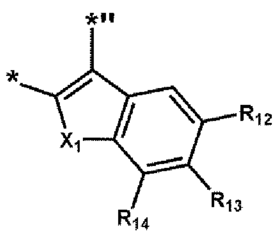
2-15

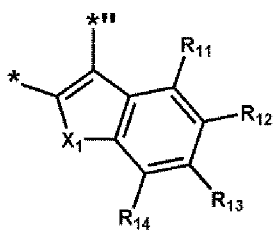
2-16

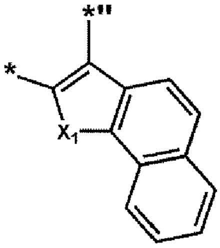
2-17

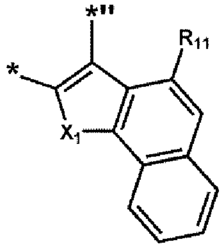
2-18

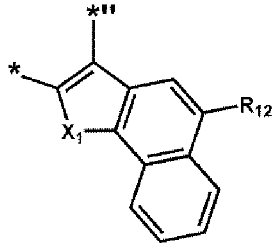
2-19

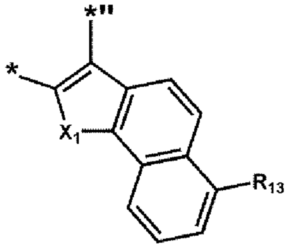
2-20

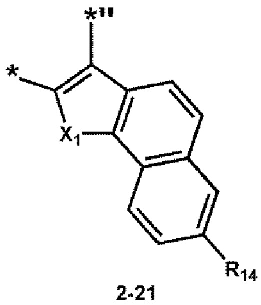
2-21

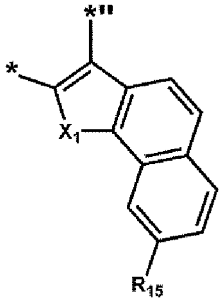
2-22

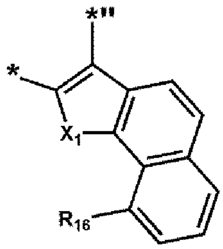
2-23

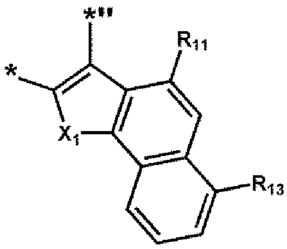
2-24

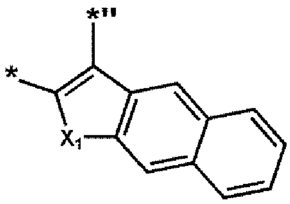
2-25

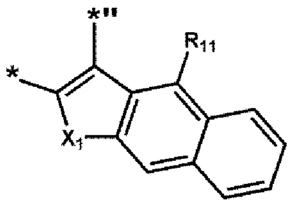
2-26

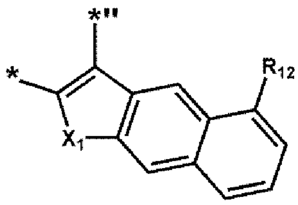
2-27

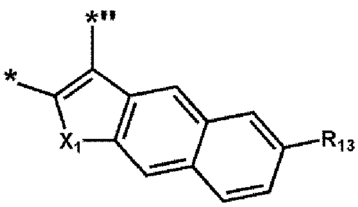
2-28

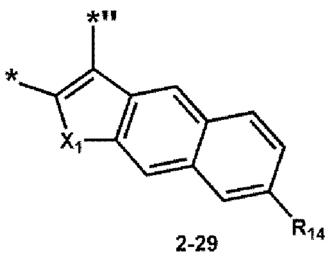
2-29

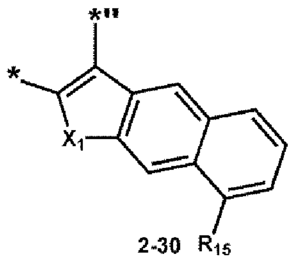
2-30

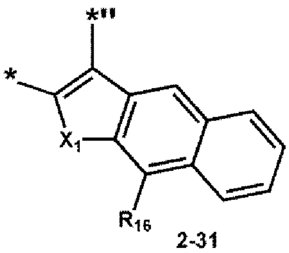
2-31

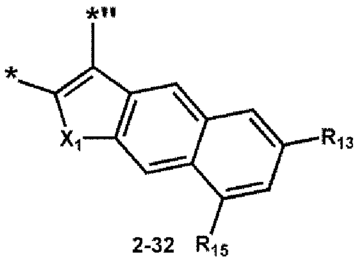
2-32

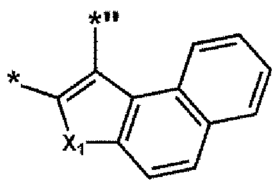
2-33

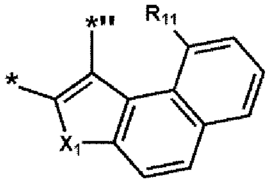
2-34

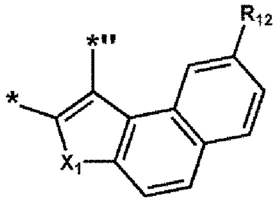
2-35

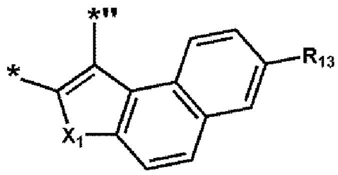
2-36

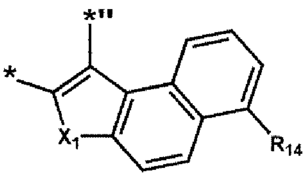
2-37

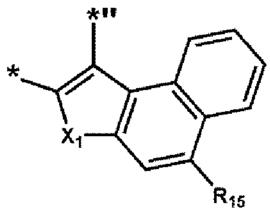
2-38

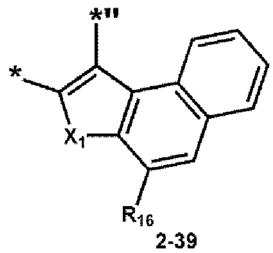
2-39

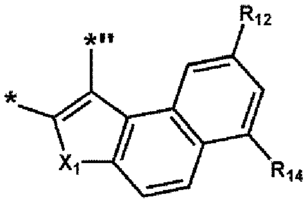
2-40

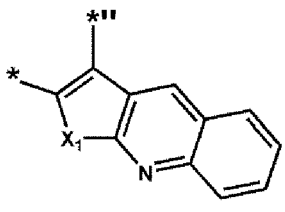
2-41

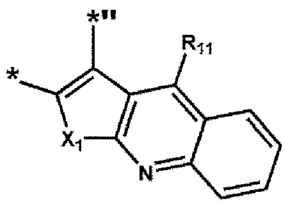
2-42

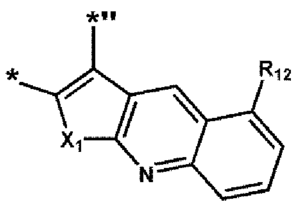
2-43

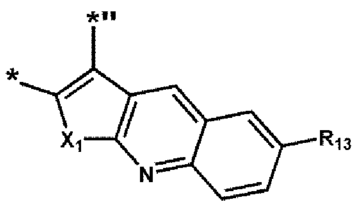
2-44

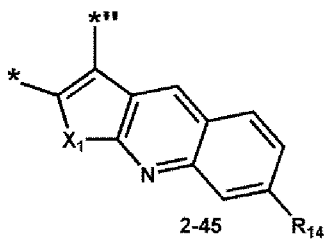
2-45

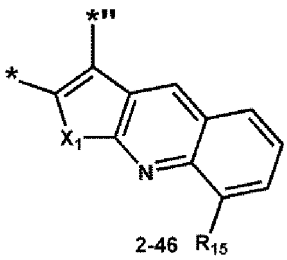
2-46

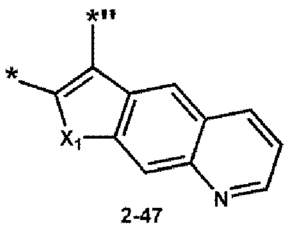
2-47

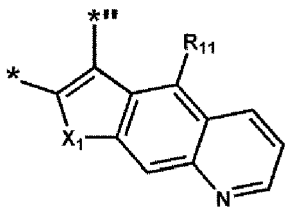
2-48

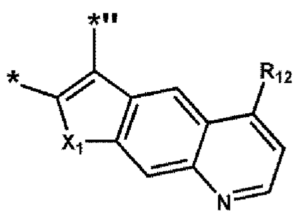
2-49

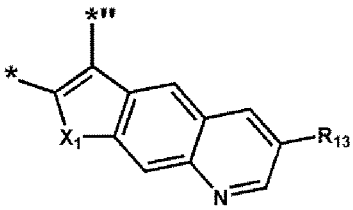
2-50

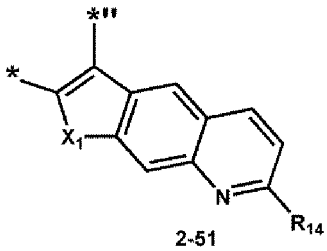
2-51

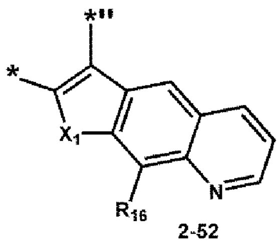
2-52

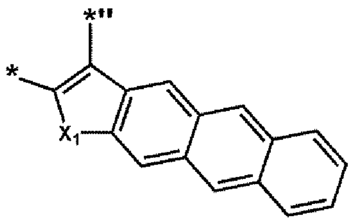
2-53

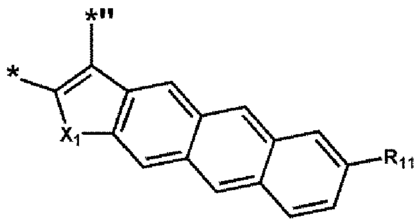
2-54

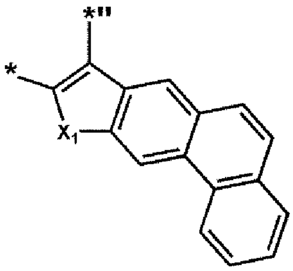
2-55

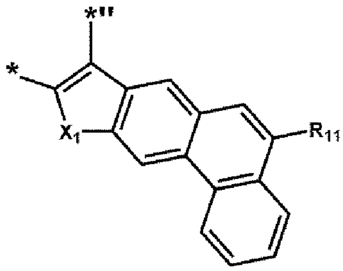
2-56

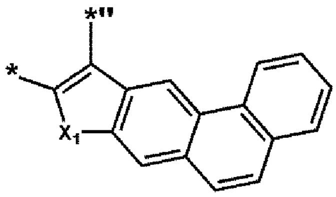
2-57

wherein, in Formulae 2-1 to 2-57,

$X_1$ may be understood by referring to the description of $X_1$ provided herein,
$R_{11}$ to $R_{16}$ may each be understood by referring to the description of $R_1$ provided herein, wherein $R_{11}$ to $R_{16}$ may each not be hydrogen,
* indicates a bonding site to M in Formula 1, and
*" indicates a bonding site to an adjacent carbon atom.

In some embodiments, $L_2$ in Formula 1 may be a bidentate ligand each bonded to M in Formula 1 via O, S, Se, N, C, P, Si, As, or a combination thereof.
In some embodiments, $L_2$ in Formula 1 may be a bidentate ligand each bonded to M in Formula 1 via N and C or a bidentate ligand each bonded to M in Formula 1 via two O atoms.
In one or more embodiments, $L_2$ in Formula 1 may be a group represented by one of Formulae 3A to 3F:

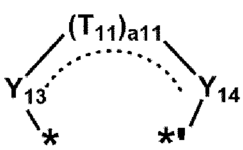
3A

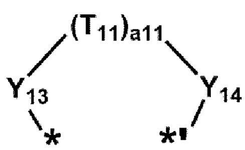
3B

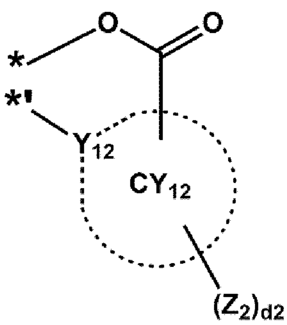
3C

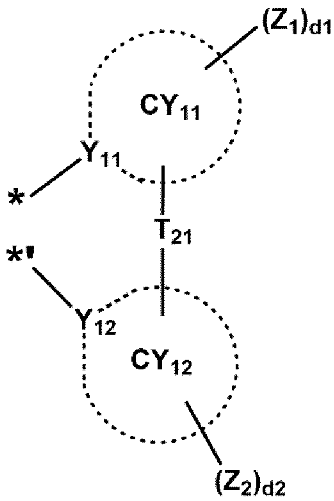
3D

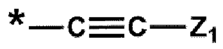 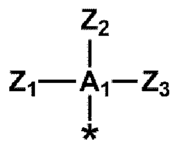

3E 3F

wherein, in Formulae 3A to 3F,

$Y_{13}$ may be O, N, $N(Z_1)$, $P(Z_1)(Z_2)$, or $As(Z_1)(Z_2)$,
$Y_{14}$ may be O, N, $N(Z_3)$, $P(Z_3)(Z_4)$, or $As(Z_3)(Z_4)$,
$T_{11}$ may be a single bond, a double bond, *-C($Z_{11}$)($Z_{12}$)-*', *-C($Z_{11}$)=C($Z_{12}$)-*', *=C($Z_{11}$)-*', *-C(Zn)=*', *=C($Z_{11}$)-C($Z_{12}$)=C($Z_{13}$)-*', *-C($Z_{11}$ )=C($Z_{12}$)-C($Z_{13}$)=*', *-N($Z_{11}$)-*', or a $C_5$-$C_{30}$ carbocyclic group unsubstituted or substituted with at least one $Z_{11}$,
a11 may be an integer from 1 to 10, and when a11 is 2 or greater, at least two $T_{11}$ groups may be identical to or different from each other,
$Y_{11}$ and $Y_{12}$ may each independently be C or N,
$T_{21}$ may be a single bond, a double bond, O, S, C($Z_{11}$)($Z_{12}$), Si($Z_{11}$)($Z_{12}$), or N($Z_{11}$),
ring $CY_{11}$ and ring $CY_{12}$ may each independently be a $C_5$-$C_{30}$ carbocyclic group or a $C_1$-$C_{30}$ heterocyclic group,
$A_1$ may be P or As,
$Z_1$ to $Z_4$ and $Z_{11}$ to $Z_{13}$ may each be understood by referring to the descriptions of $R_1$ provided herein,
d1 and d2 may each independently be an integer from 0 to 20, and
* and *' each indicate a bonding site to M in Formula 1.

In some embodiments, a group represented by

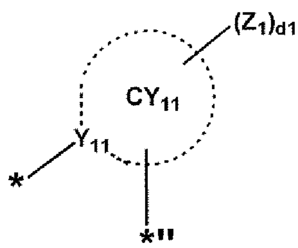

in Formula 3D may be represented by one of Formulae CY11-1 to CY11-34, and/(or), a group represented by

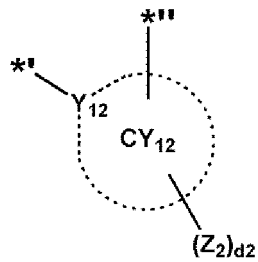

in Formulae 3C and 3D may be represented by one of Formulae CY12-1 to CY12-34:

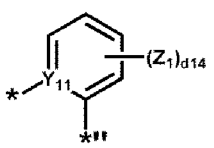

CY11-1

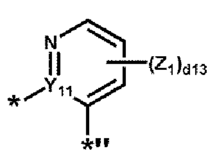

CY11-2

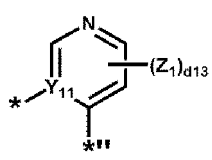

CY11-3

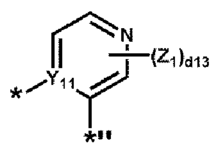

CY11-4

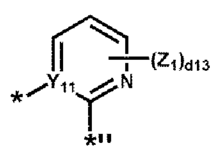

CY11-5

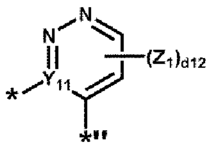
CY11-6

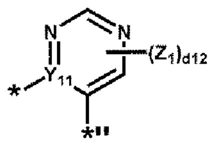
CY11-7

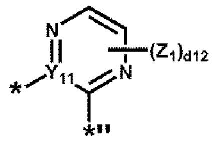
CY11-8

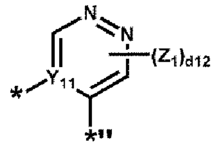
CY11-9

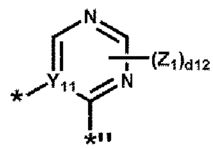
CY11-10

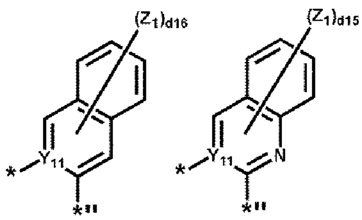
CY11-11 CY11-12

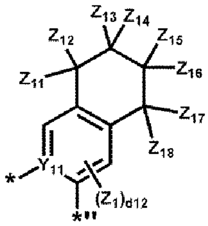
CY11-13

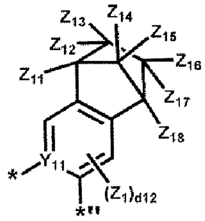
CY11-14

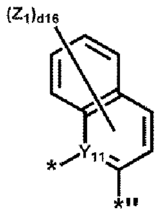
CY11-15

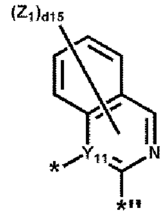
CY11-16

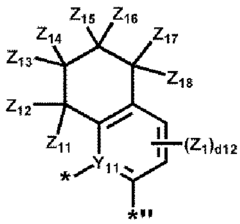
CY11-17

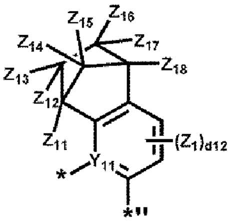
CY11-18

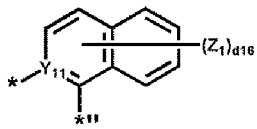
CY11-19

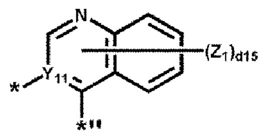
CY11-20

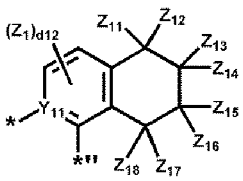
CY11-21

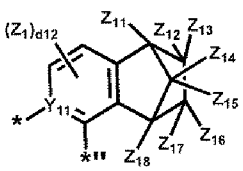
CY11-22

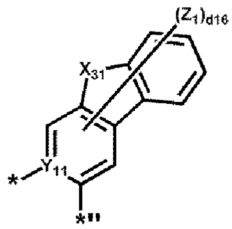
CY11-23

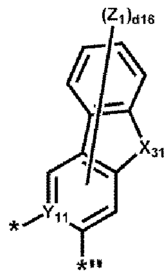
CY11-24

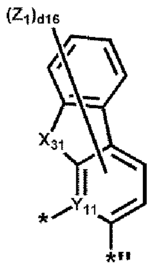
CY11-25

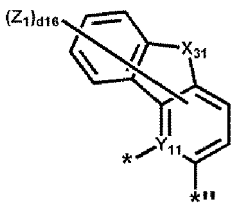
CY11-26

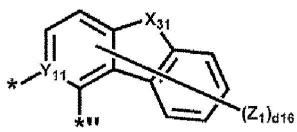
CY11-27

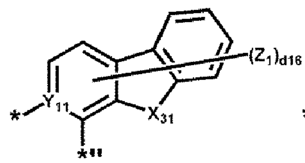
CY11-28

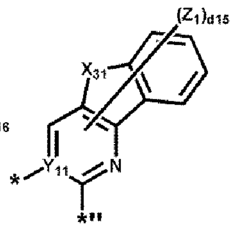
CY11-29

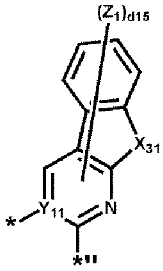
CY11-30

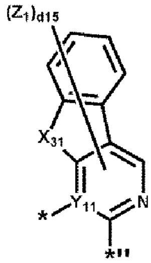
CY11-31

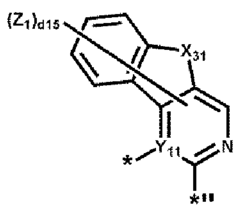
CY11-32

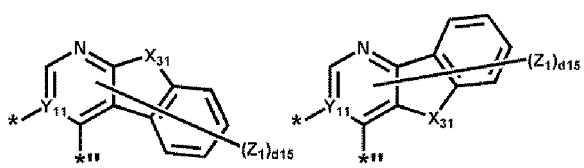
CY11-33 CY11-34

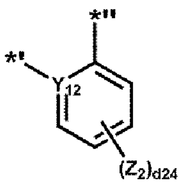
CY12-1

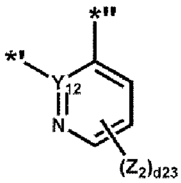
CY12-2

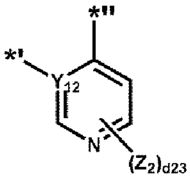
CY12-3

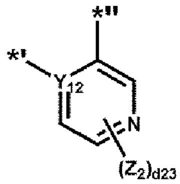
CY12-4

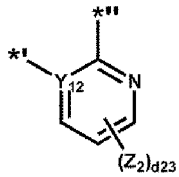
CY12-5

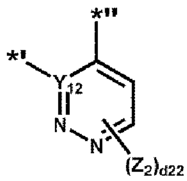
CY12-6

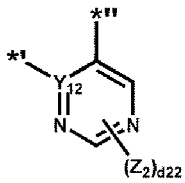
CY12-7

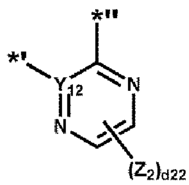
CY12-8

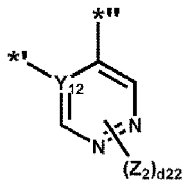
CY12-9

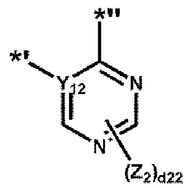
CY12-10

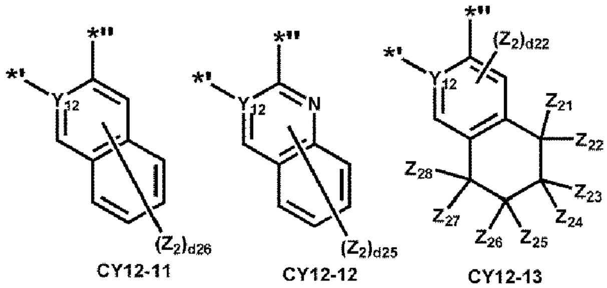
CY12-11

CY12-12

CY12-13

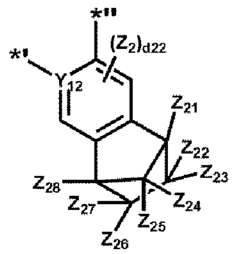
CY12-14

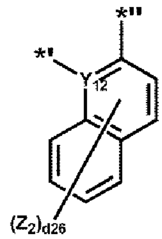
CY12-15

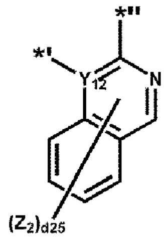
CY12-16

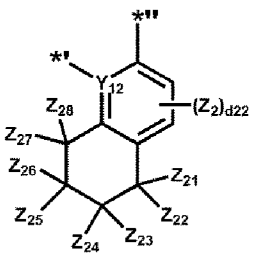
CY12-17

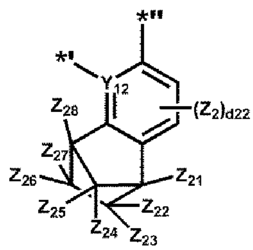
CY12-18

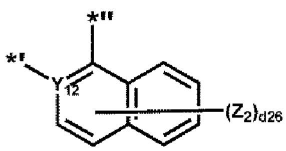
CY12-19

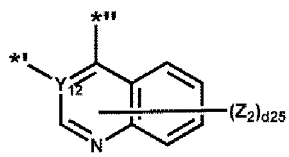
CY12-20

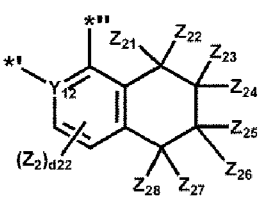
CY12-21

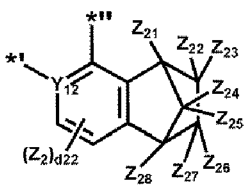
CY12-22

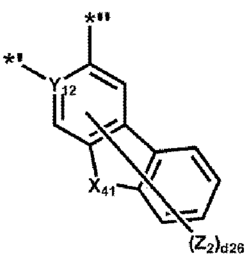
CY12-23

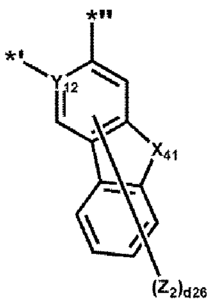
CY12-24

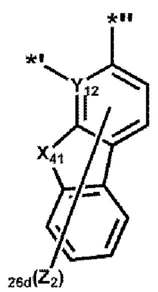
CY12-25

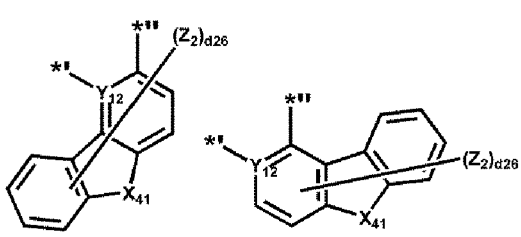

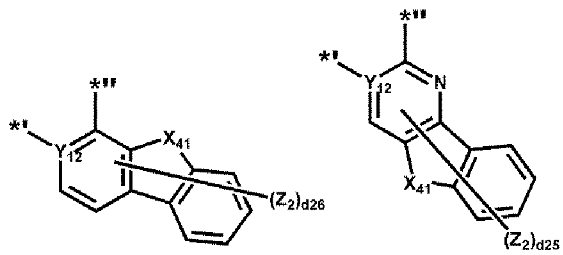

CY12-26 CY12-27 CY12-28 CY12-29

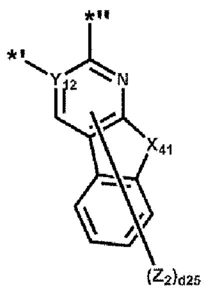

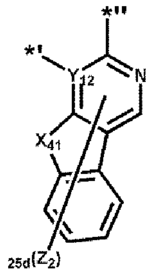

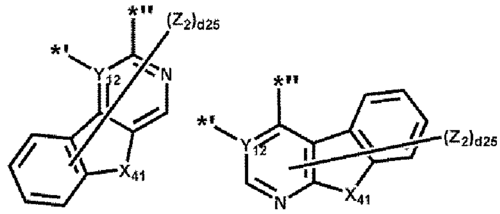

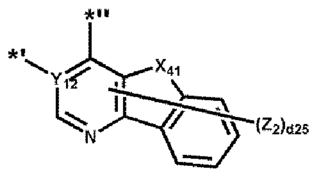

CY12-30 CY12-31 CY12-32 CY12-33 CY12-34

wherein, in Formulae CY11-1 to CY11-34 and CY12-1 to CY12-34,

$X_{31}$ may be O, S, $N(Z_{11})$, $C(Z_{11})(Z_{12})$, or $Si(Z_{11})(Z_{12})$,
$X_{41}$ may be O, S, $N(Z_{21})$, $C(Z_{21})(Z_{22})$, or $Si(Z_{21})(Z_{22})$,
$Y_{11}$, $Y_{12}$, $Z_1$, and $Z_2$ may respectively be understood by referring to the descriptions of $Y_{11}$, $Y_{12}$, $Z_1$, and $Z_2$ provided herein,
$Z_{11}$ to $Z_{18}$ and $Z_{21}$ to $Z_{28}$ may each be understood by referring to the descriptions of $R_1$ provided herein,
d12 and d22 may each independently be an integer from 0 to 2,
d13 and d23 may each independently be an integer from 0 to 3,
d14 and d24 may each independently be an integer from 0 to 4,
d15 and d25 may each independently be an integer from 0 to 5,
d16 and d26 may each independently be an integer from 0 to 6,
in the Formulae CY11-1 to CY11-34 and CY12-1 to CY12-34, * and *' each indicate a bonding site to M in Formula 1, and *" indicates a bonding site to an adjacent atom in Formula 3C or $T_{21}$ in Formula 3D.

In one or more embodiments, $L_2$ in Formula 1 may be a ligand represented by Formula 3D, and at least one of $Z_1$ and $Z_2$ in Formula 3D may each independently be deuterium; $-Si(Q_3)(Q_4)(Q_5)$; $-Ge(Q_3)(Q_4)(Q_5)$; or a $C_1$-$C_{60}$ alkyl group substituted with at least one deuterium.

In one or more embodiments, $L_2$ in Formula 1 may be a ligand represented by one of Formulae 3-1 and 3-101 to 3-112:

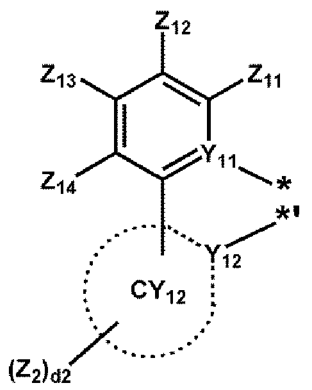

3-1

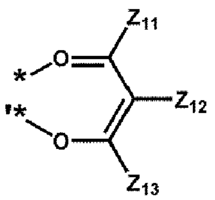
3-101

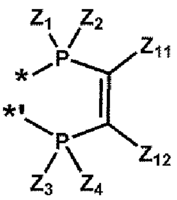
3-102

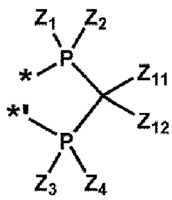
3-103

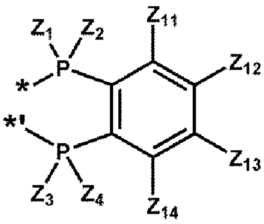
3-104

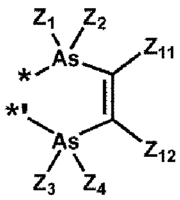
3-105

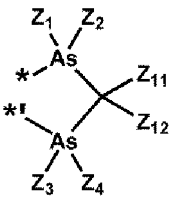
3-106

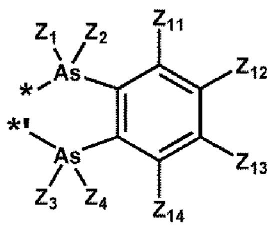
3-107

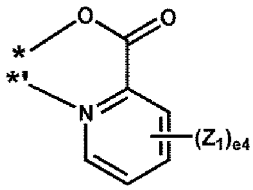
3-108

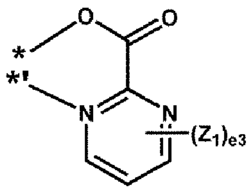
3-109

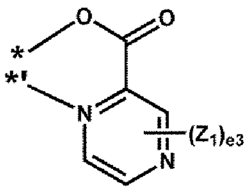
3-110

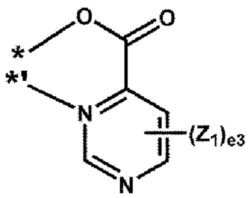
3-111

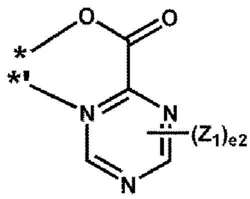
3-112

wherein, in Formulae 3-1 and 3-101 to 3-112,

$Y_{11}$, $Y_{12}$, ring $CY_{12}$, $Z_1$ to $Z_4$, $Z_{11}$ to $Z_{13}$, and d2 may respectively be understood by referring to the descriptions of $Y_{11}$, $Y_{12}$, ring $CY_{12}$, $Z_1$ to $Z_4$, $Z_{11}$ to $Z_{13}$, and d2 provided herein,
$Z_{14}$ may be understood by referring to the descriptions for $Z_1$ provided herein,
e2 may be an integer from 0 to 2,
e3 may be an integer from 0 to 3,
e4 may be an integer from 0 to 4, and
* and *' each indicate a bonding site to M in Formula 1.

In some embodiments, in Formula 3-1, $Y_{11}$ may be N, and $Y_{12}$ may be C.
In some embodiments, $Z_{12}$ in Formula 3-1 may be -Si($Q_3$)($Q_4$)($Q_5$); - Ge($Q_3$)($Q_4$)($Q_5$); or a $C_1$-$C_{60}$ alkyl group substituted with at least one deuterium.
In some embodiments, $Z_{12}$ in Formula 3-1 may be -Si($Q_3$)($Q_4$)($Q_5$) or - Ge($Q_3$)($Q_4$)($Q_5$), and $Z_{13}$ may not be hydrogen and a methyl group.
In some embodiments, a group represented by

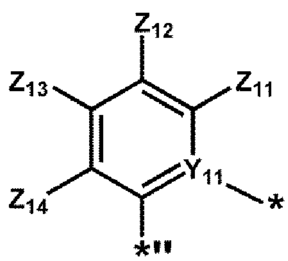

in Formula 3-1 may be represented by one of Formulae 3-1-1 to 3-1-16, and/(or) a group represented by

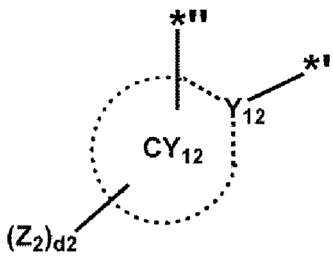

in Formula 3-1 may be represented by one of Formulae 3-1(1) to 3-1(16):

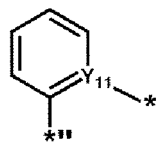
3-1-1

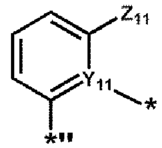
3-1-2

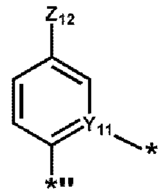
3-1-3

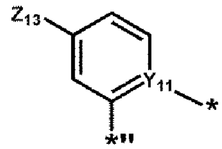
3-1-4

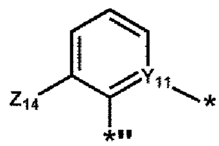
3-1-5

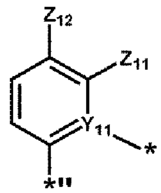
3-1-6

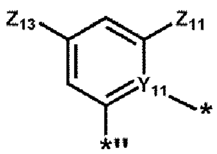
3-1-7

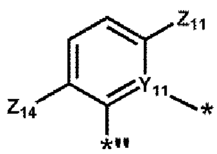
3-1-8

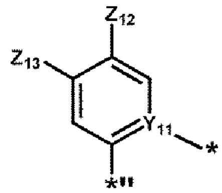
3-1-9

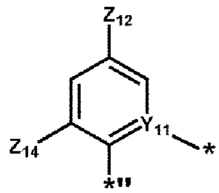
3-1-10

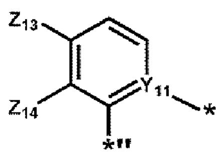
3-1-11

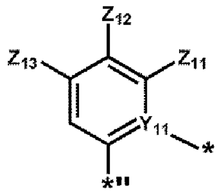
3-1-12

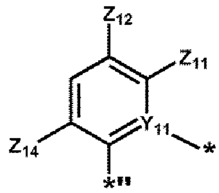
3-1-13

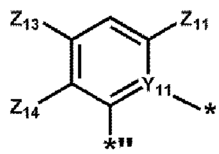
3-1-14

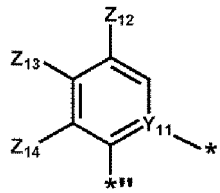
3-1-15

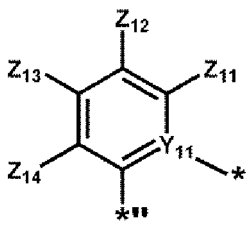
3-1-16

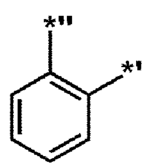
3-1(1)

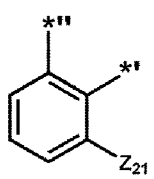
3-1(2)

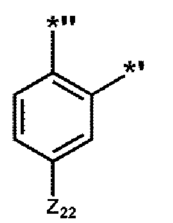
3-1(3)

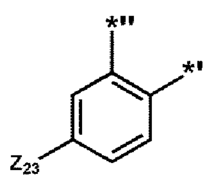
3-1(4)

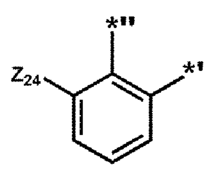
3-1(5)

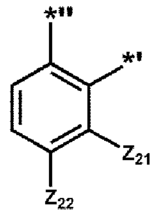
3-1(6)

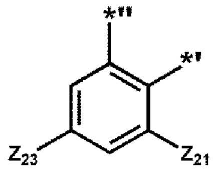
3-1(7)

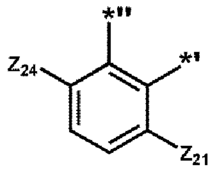
3-1(8)

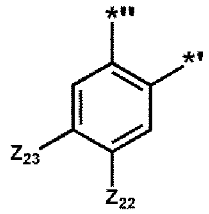
3-1(9)

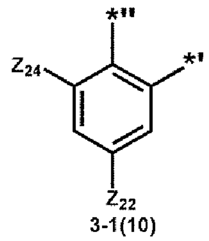
3-1(10)

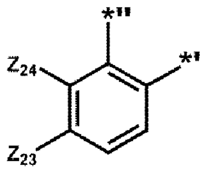
3-1(11)

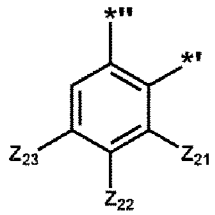
3-1(12)

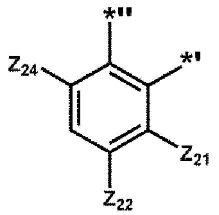
3-1(13)

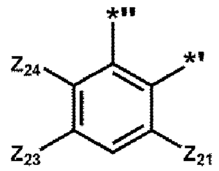
3-1(14)

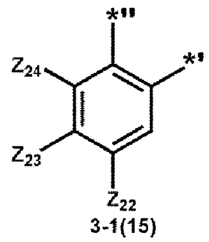
3-1(15)

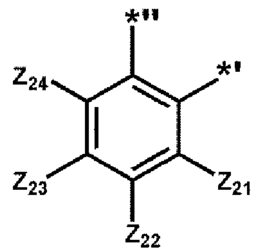
3-1(16)

wherein, in Formulae 3-1-1 to 3-1-16 and 3-1(1) to 3-1(16),

$Z_{11}$ to $Z_{14}$ may respectively be understood by referring to the descriptions of $Z_{11}$ to $Z_{14}$ provided herein, $Z_{21}$ to $Z_{24}$ may each be understood by referring to the descriptions of $Z_2$ provided herein, wherein $Z_{11}$ to $Z_{14}$ and $Z_{21}$ to $Z_{24}$ may not each be hydrogen,

* and *' each indicate a bonding site to M in Formula 1, and

*" indicates a bonding site to an adjacent atom.

In Formula 2, i) at least two groups from a plurality of $R_1$ groups are optionally bonded to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, ii) at least two groups from a plurality of $R_2$ groups are optionally bonded to from a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$, and/or iii) $R_3$ and one of $R_1$ and $R_2$ are optionally bonded to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

$R_{10a}$ as used herein is understood by referring to the description of $R_1$ provided herein.

In Formula 2, * and *' each indicate a bonding site to M in Formula 1.

In one or more embodiments, the organometallic compound represented by Formula 1 may include at least one deuterium.

In some embodiments, $L_1$ in Formula 1 may include at least one deuterium.

In some embodiments, in Formula 1, n2 may not be 0, and $L_2$ may include at least one deuterium.

In some embodiments, the organometallic compound represented by Formula 1 may be one of Compounds 1 to 2023:

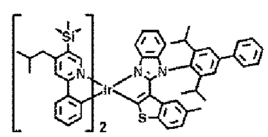
1

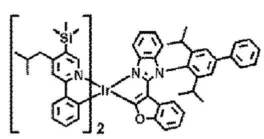
2

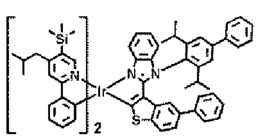
3

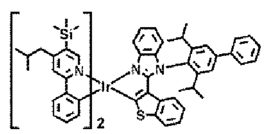
4

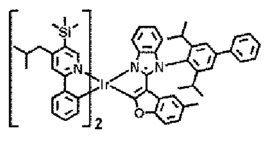
5

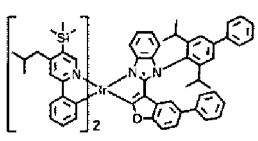
6

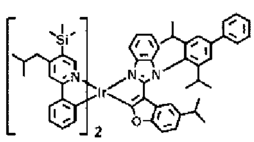
7

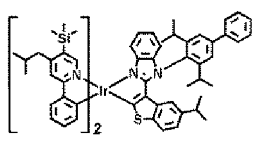
8

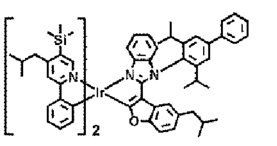
9

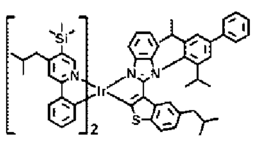
10

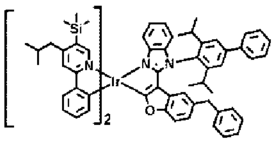
11

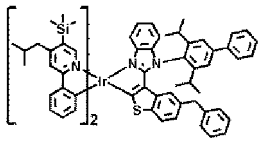
12

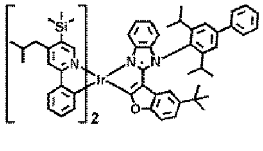
13

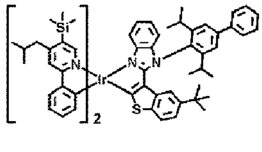
14

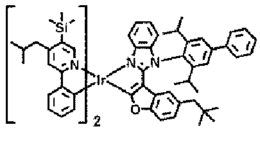
15

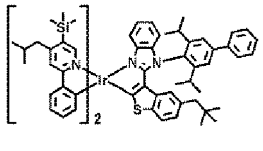
16

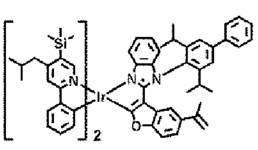
17

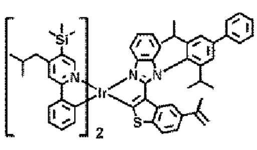
18

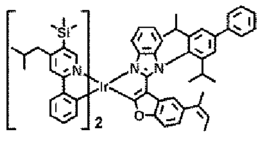
19

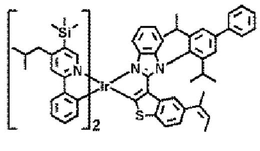
20

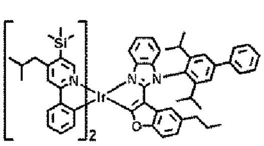
21

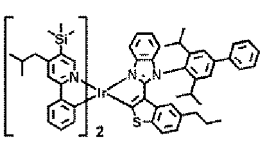
22

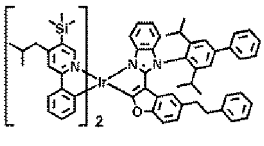
23

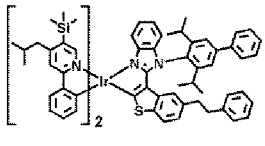
24

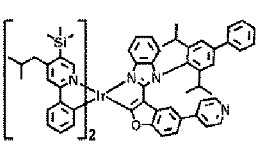
25

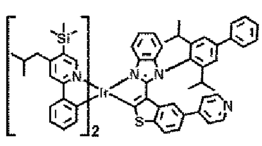
26

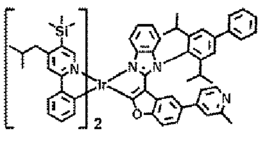
27

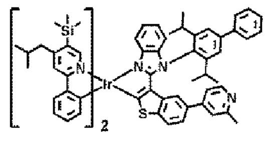
28

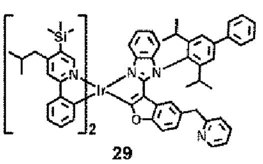
29

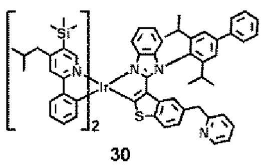
30

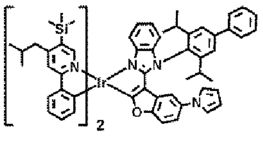
31

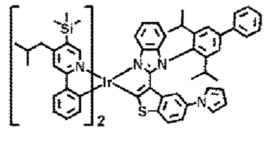
32

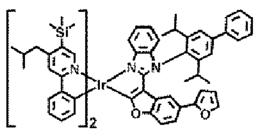
33

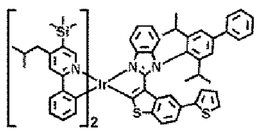
34

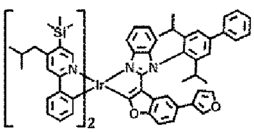
35

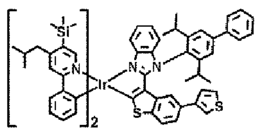
36

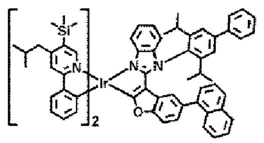
37

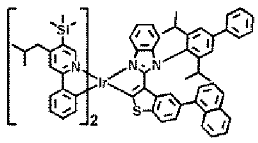
38

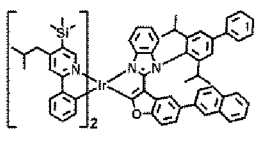
39

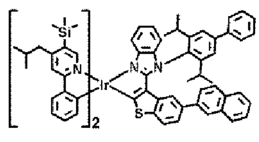
40

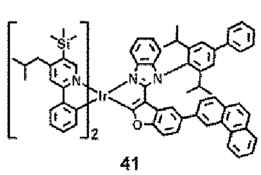
41

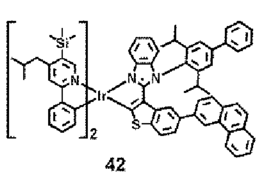
42

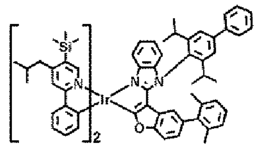
43

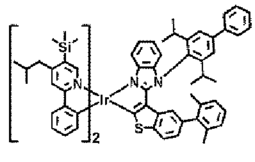
44

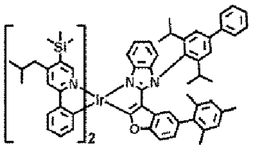
45

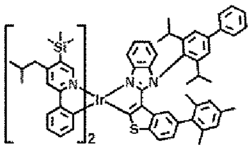
46

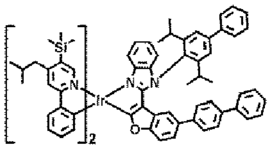
47

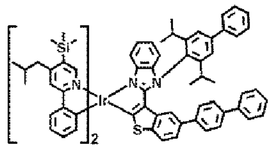
48

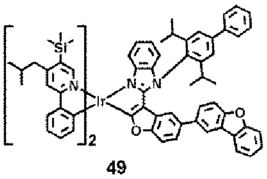
49

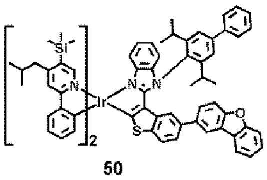
50

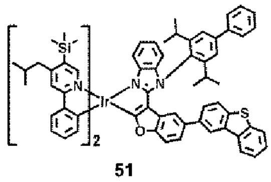
51

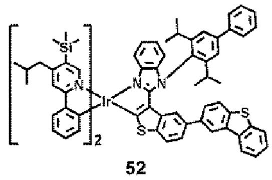
52

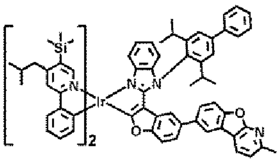
53

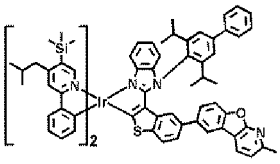
54

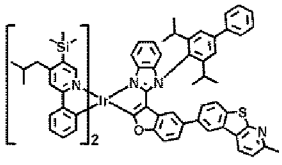
55

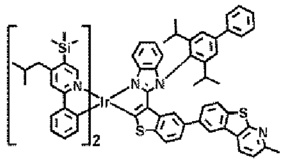
56

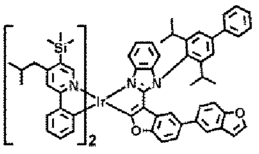
57

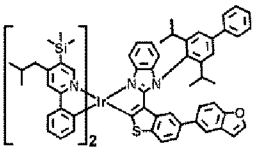
58

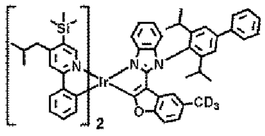
59

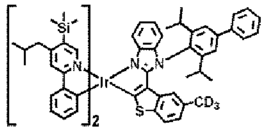
60

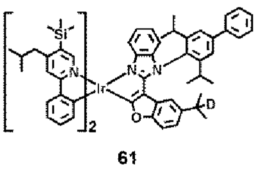
61

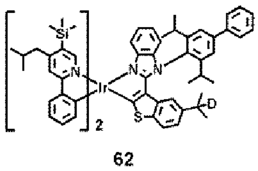
62

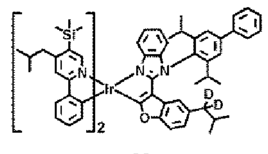
63

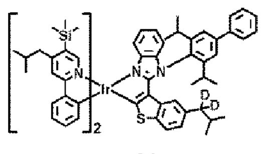
64

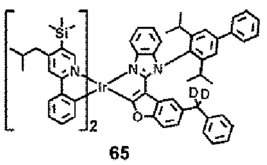
65

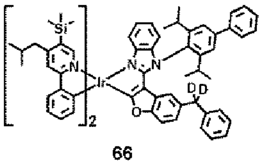
66

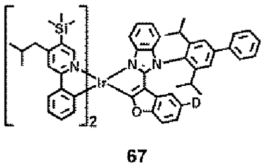
67

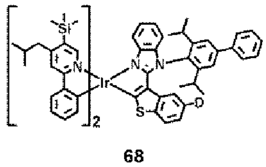
68

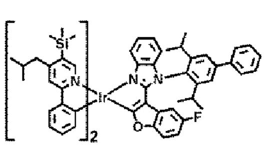
69

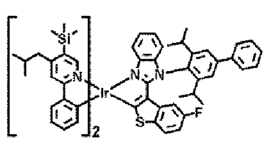
70

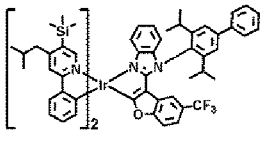
71

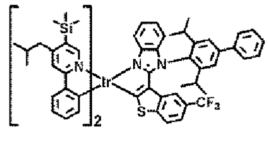
72

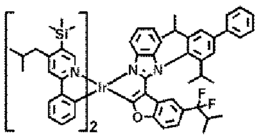
73

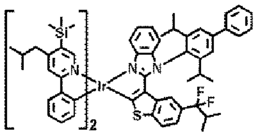
74

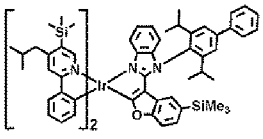
75

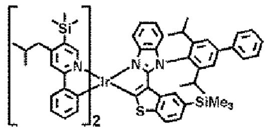
76

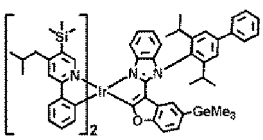
77

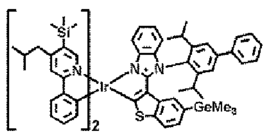
78

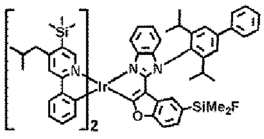
79

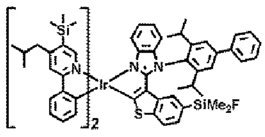
80

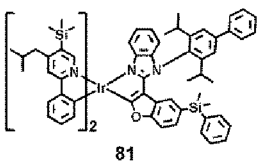
81

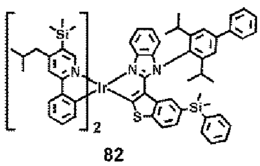
82

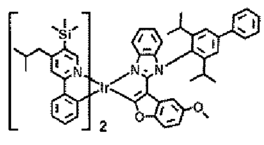
83

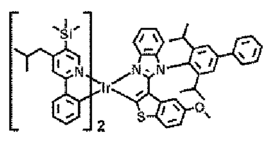
84

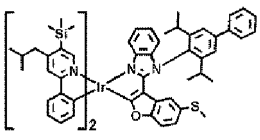
85

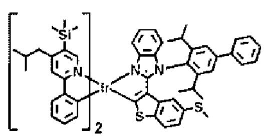
86

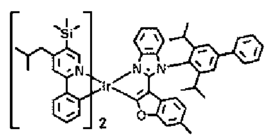
87

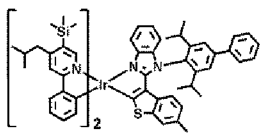
88

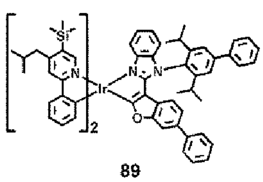
89

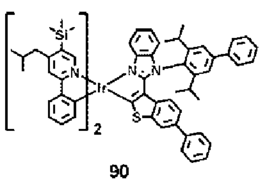
90

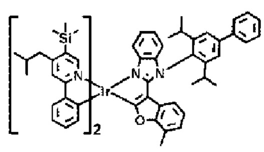
91

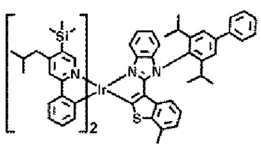
92

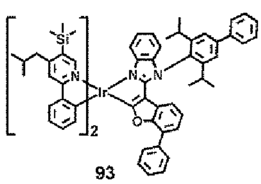
93

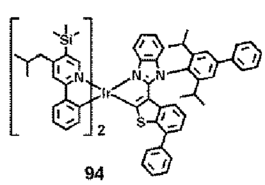
94

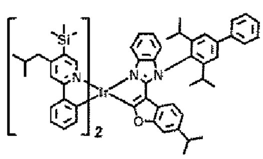
95

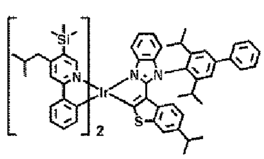
96

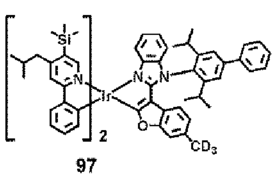
97

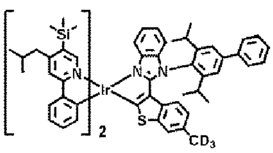
98

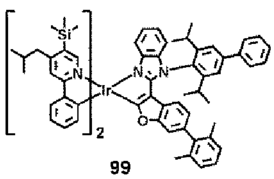
99

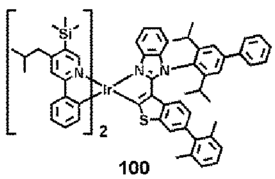
100

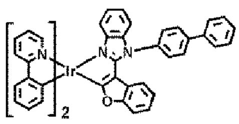
101
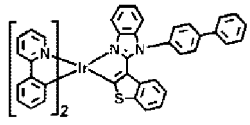
102
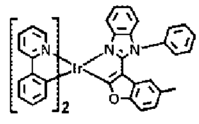
103
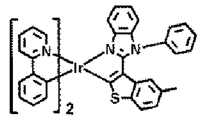
104

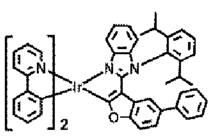
105
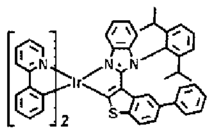
106
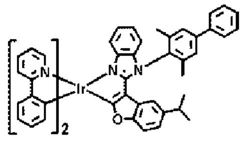
107
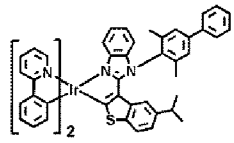
108

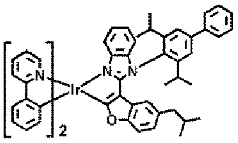
109
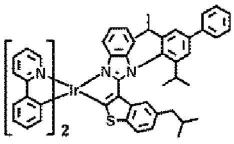
110
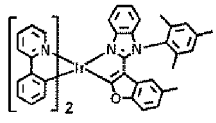
111
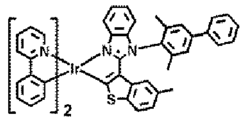
112

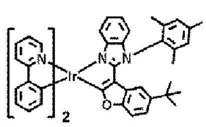
113
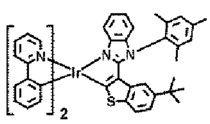
114
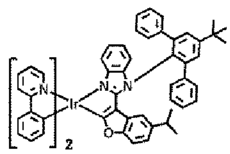
115
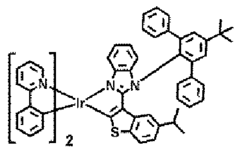
116

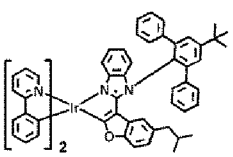
117
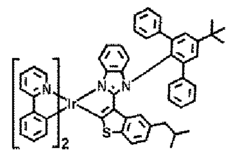
118
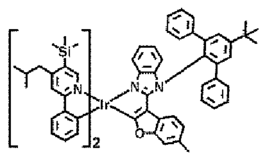
119
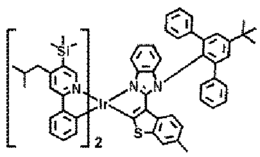
120

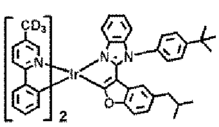
121
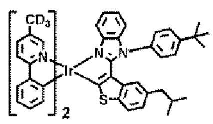
122
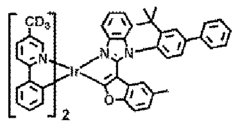
123
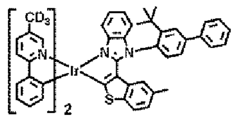
124

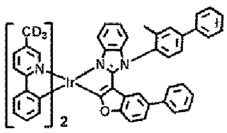
125
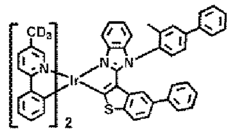
126
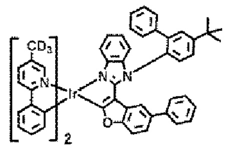
127
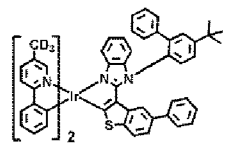
128

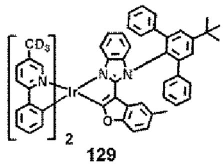
129
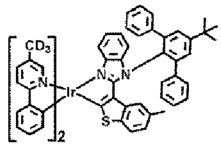
130
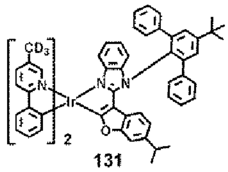
131
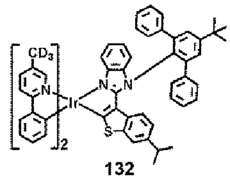
132

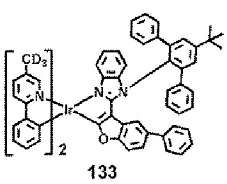
133

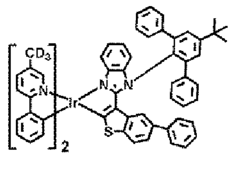
134

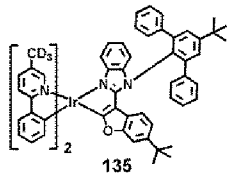
135

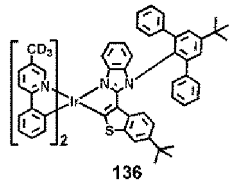
136

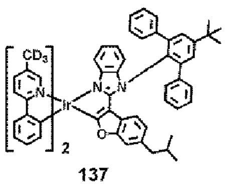
137

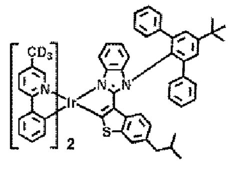
138

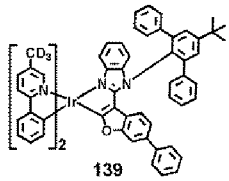
139

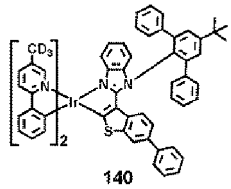
140

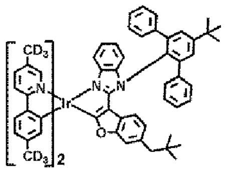
141

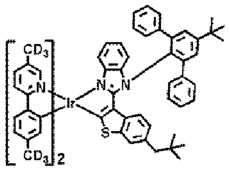
142

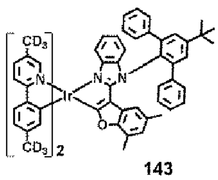
143

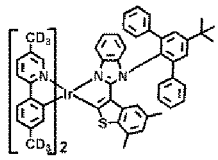
144

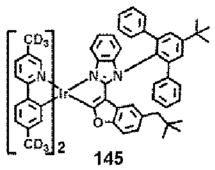
145

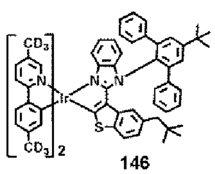
146

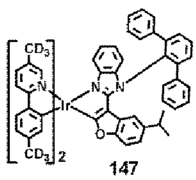
147

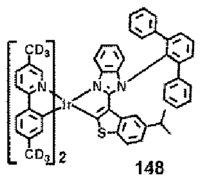
148

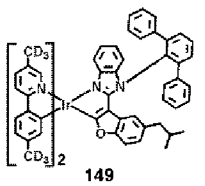
149

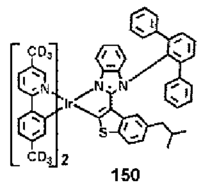
150

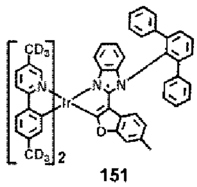
151

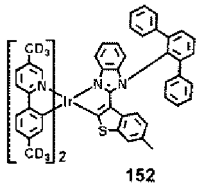
152

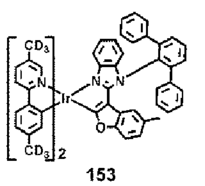
153

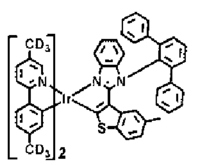
154

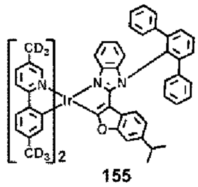
155

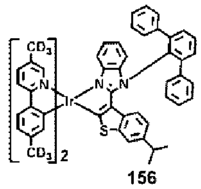
156

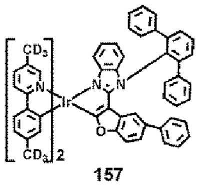
157

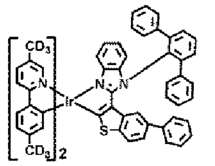
158

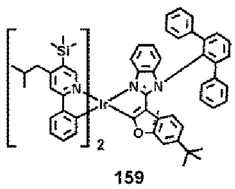
159

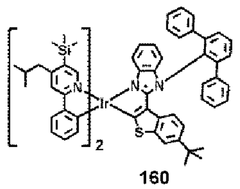
160

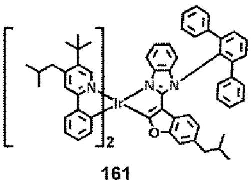
161

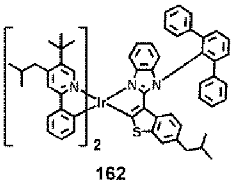
162

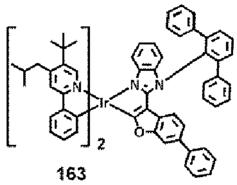
163

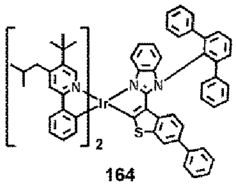
164

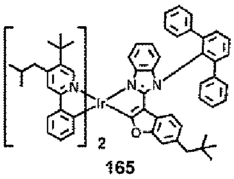
165

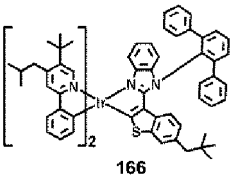
166

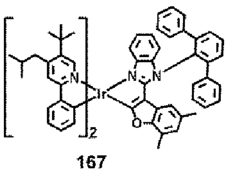
167

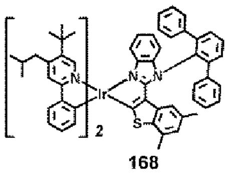
168

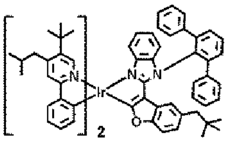
169

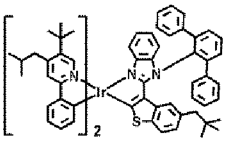
170

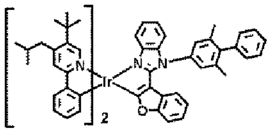
171

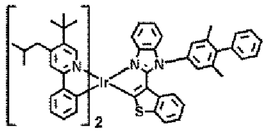
172

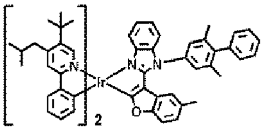
173

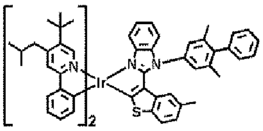
174

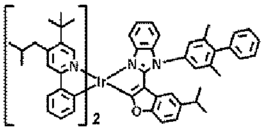
175

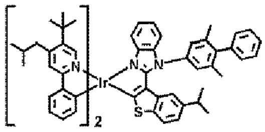
176

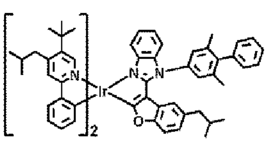
177

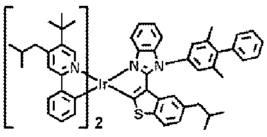
178

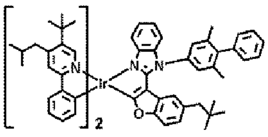
179

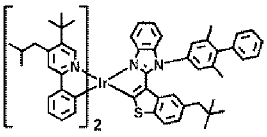
180

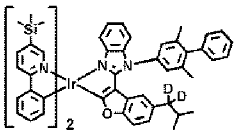
181

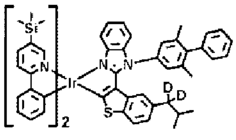
182

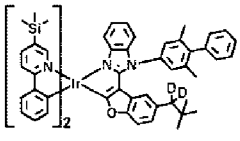
183

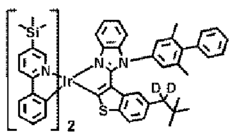
184

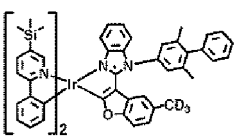
185

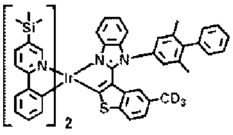
186

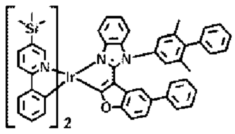
187

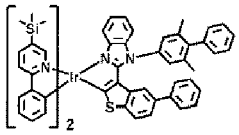
188

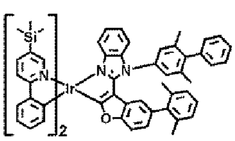
189

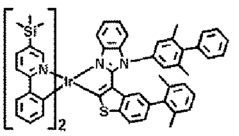
190

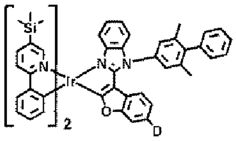
191

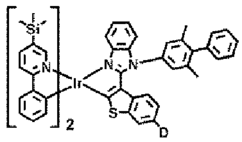
192

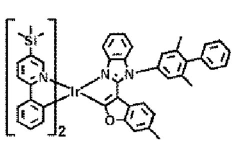
193

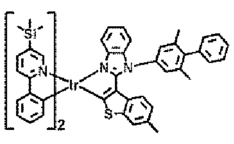
194

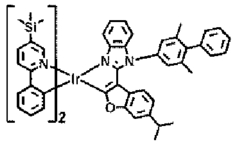
195

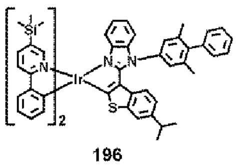
196

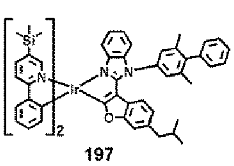
197

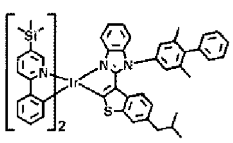
198

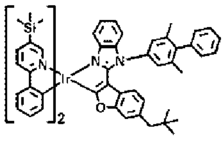
199

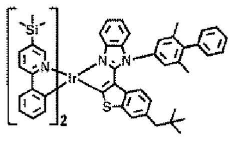
200

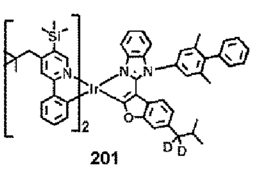
201

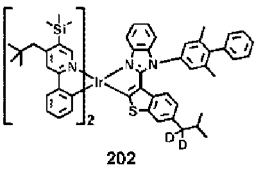
202

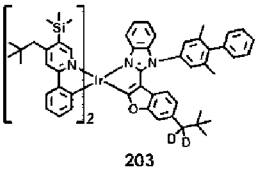
203

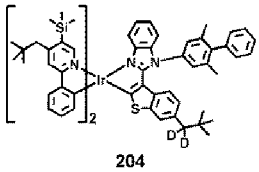
204

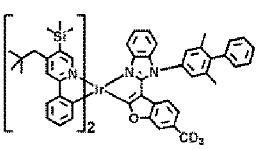
205

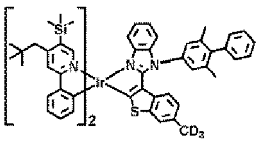
206

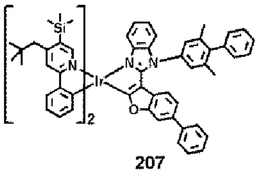
207

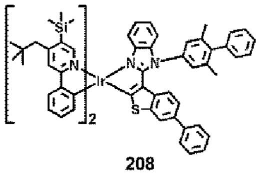
208

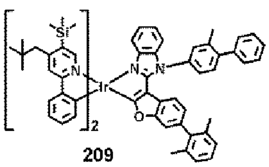
209

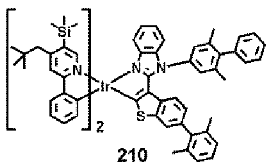
210

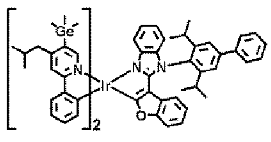
211

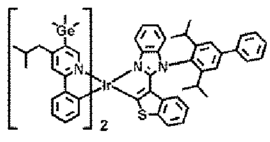
212

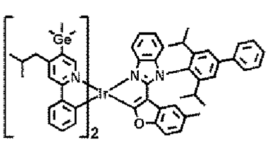
213

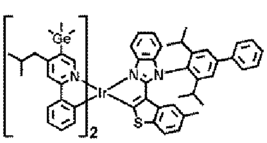
214

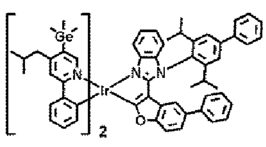
215

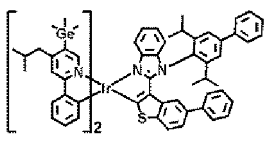
216

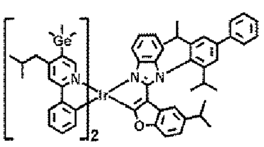
217

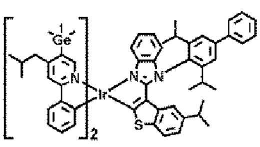
218

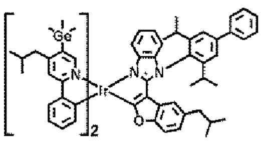
219

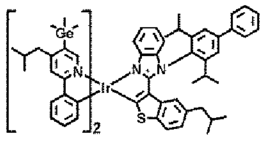
220

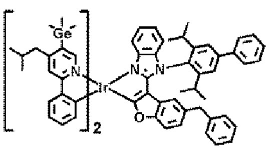
221

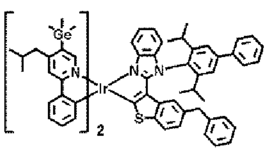
222

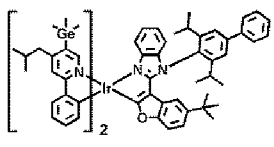
223

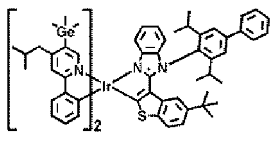
224

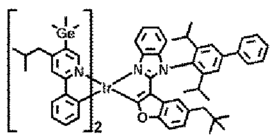

225

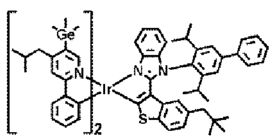

226

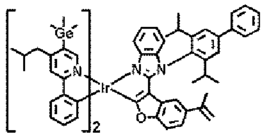

227

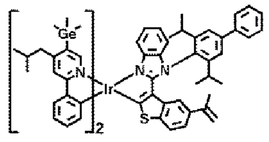

228

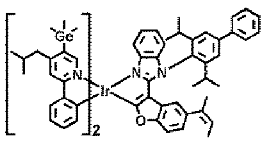

229

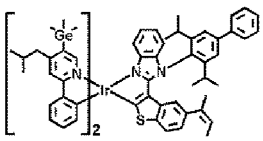

230

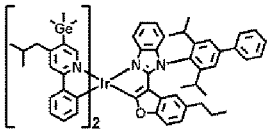

231

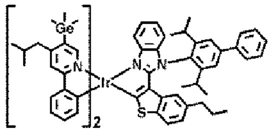

232

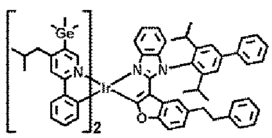

233

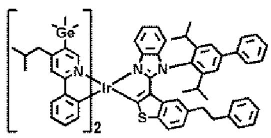

234

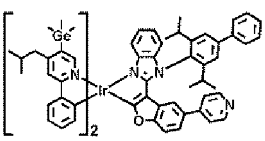

235

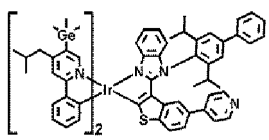

236

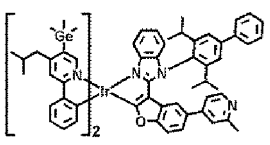

237

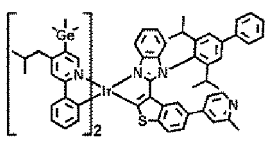

238

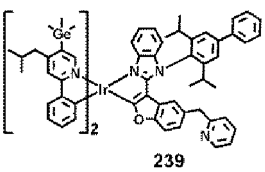

239

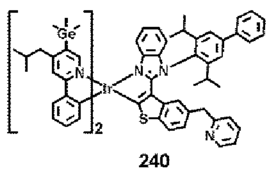

240

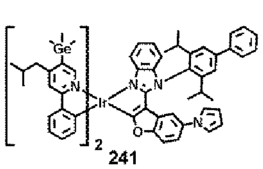

241

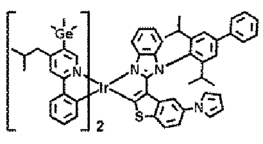

242

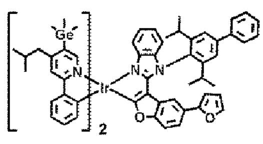

243

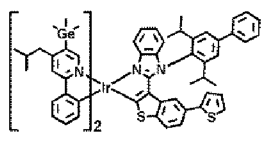

244

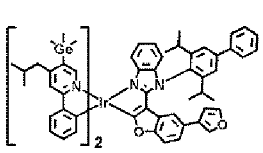

245

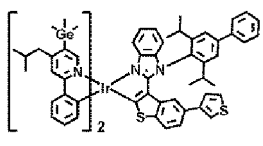

246

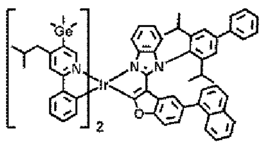

247

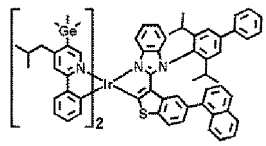

248

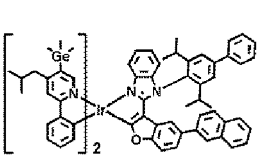

249

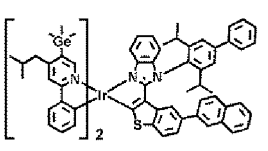

250

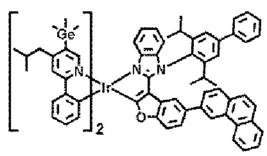

251

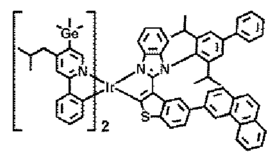

252

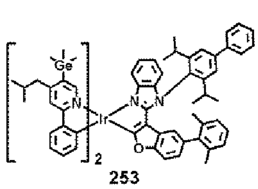

253

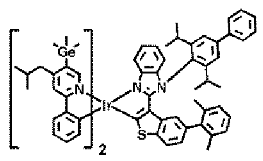

254

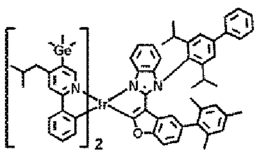

255

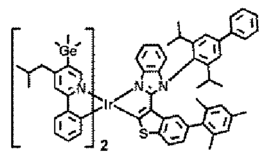

256

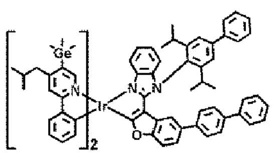
257

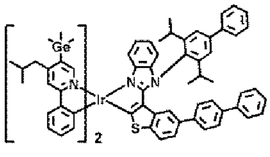
258

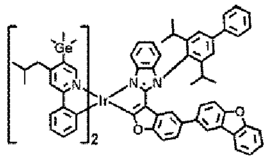
259

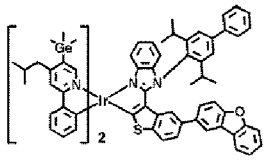
260

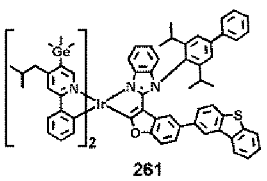
261

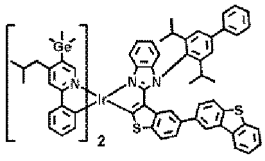
262

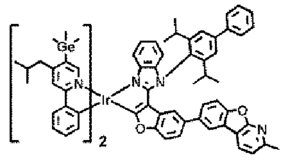
263

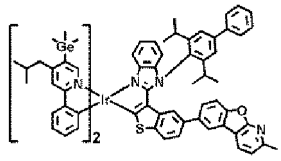
264

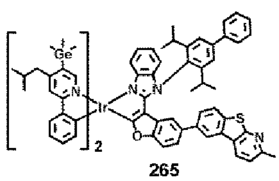
265

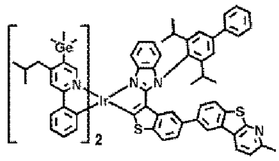
266

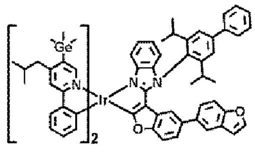
267

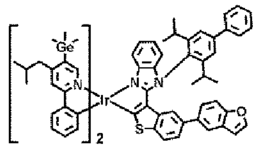
268

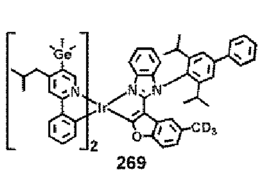
269

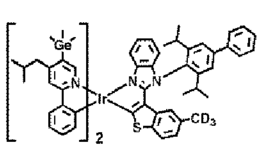
270

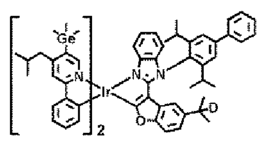
271

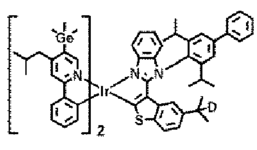
272

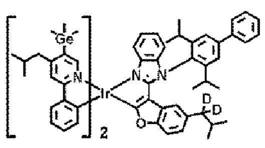
273

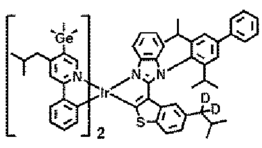
274

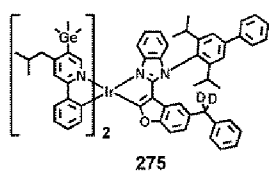
275

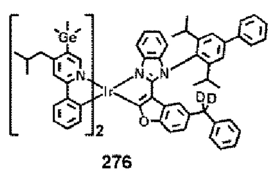
276

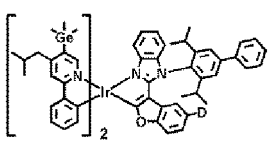
277

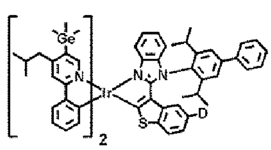
278

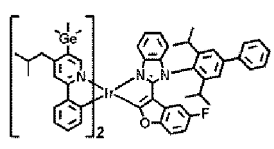
279

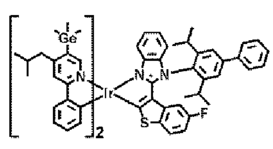
280

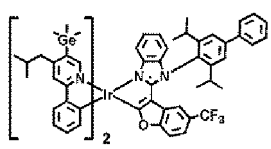
281

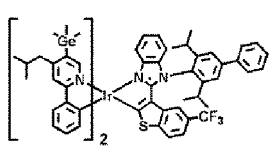
282

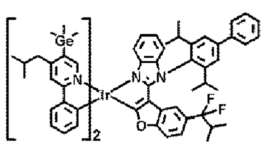
283

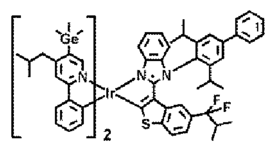
284

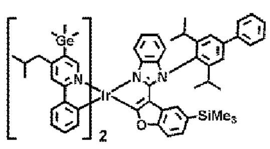
285

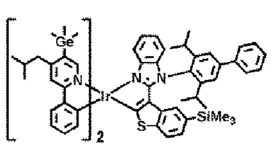
286

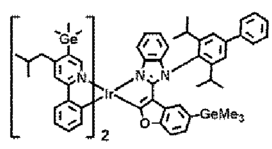
287

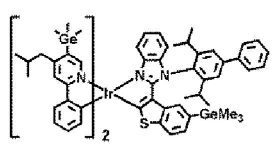
288

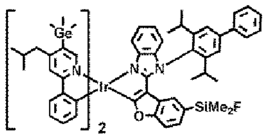
289
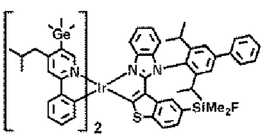
290
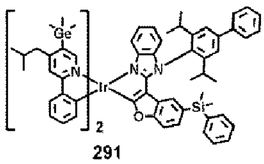
291
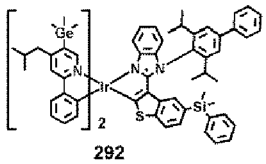
292

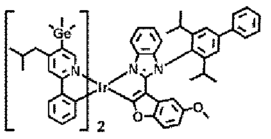
293
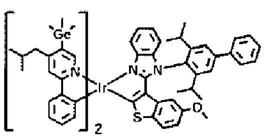
294
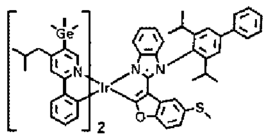
295
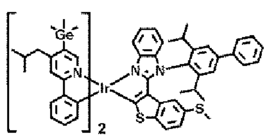
296

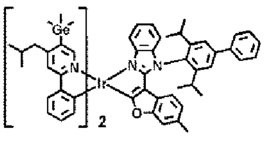
297
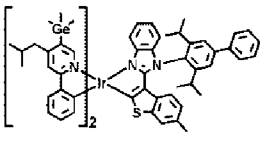
298
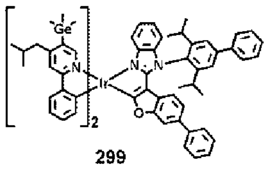
299
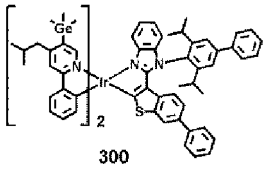
300

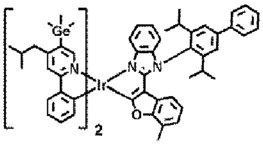
301
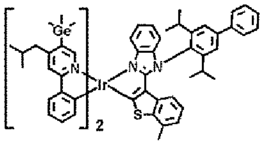
302
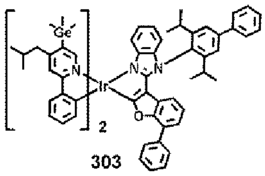
303
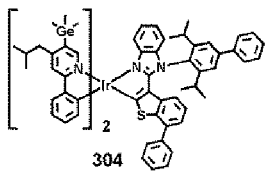
304

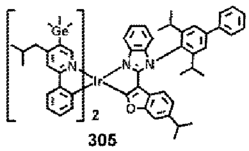
305
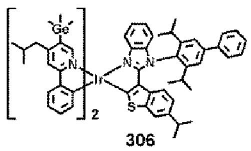
306
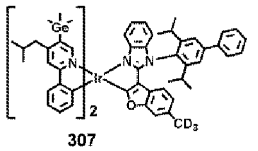
307
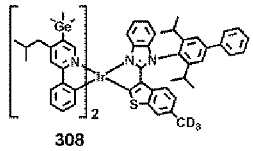
308

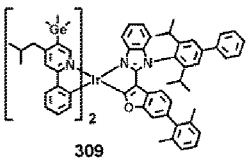
309
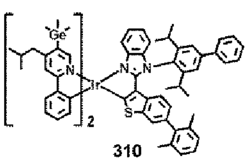
310
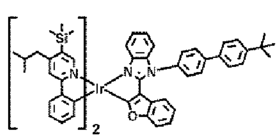
311
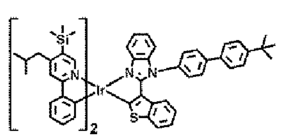
312

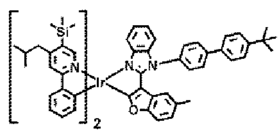
313
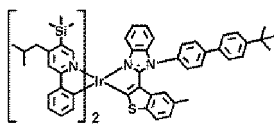
314
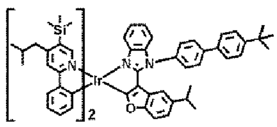
315
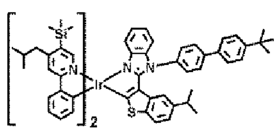
316

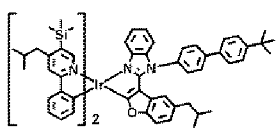
317
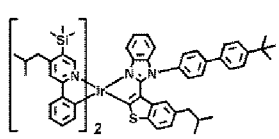
318
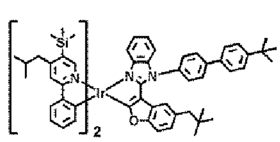
319
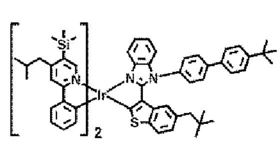
320

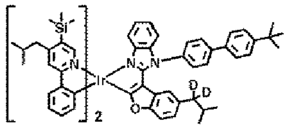
321
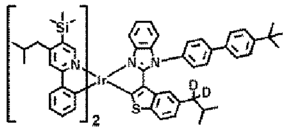
322
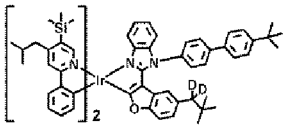
323
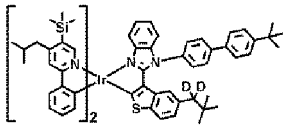
324

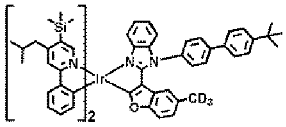
325
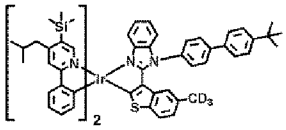
326
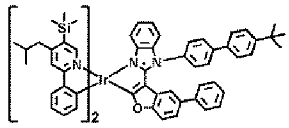
327
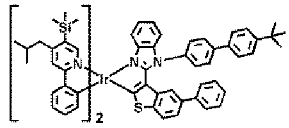
328

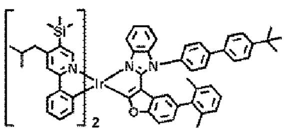
329
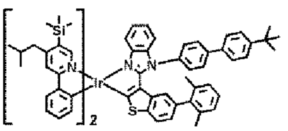
330
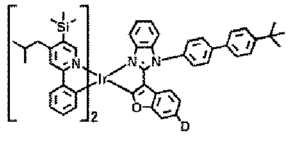
331
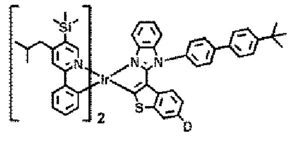
332

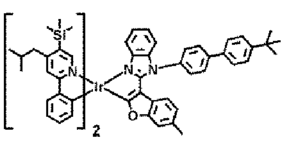
333
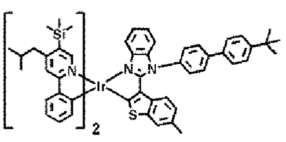
334
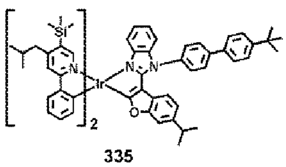
335
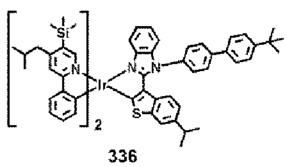
336

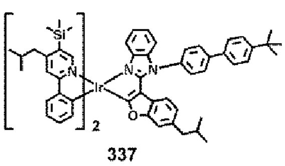
337
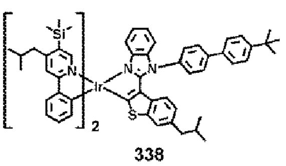
338
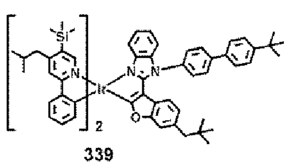
339
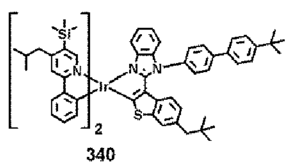
340

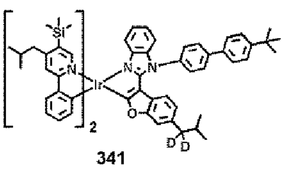
341
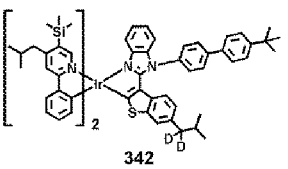
342
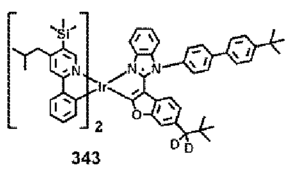
343
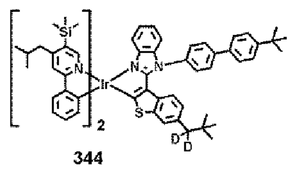
344

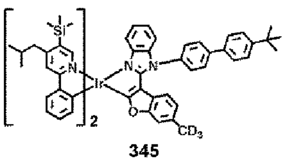
345
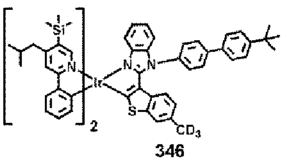
346
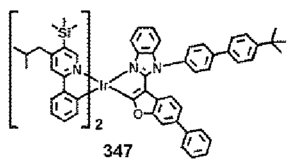
347
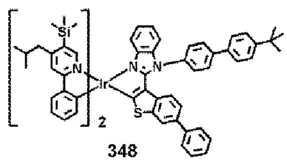
348

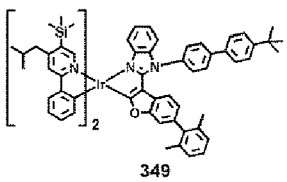
349
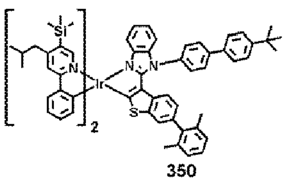
350
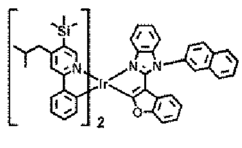
351
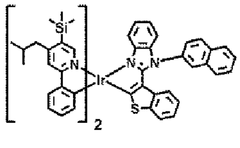
352

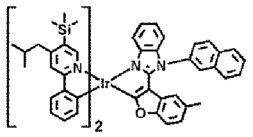
353
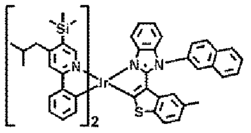
354
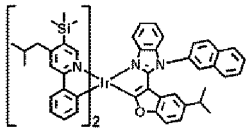
355
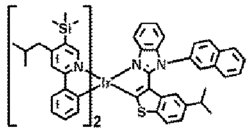
356
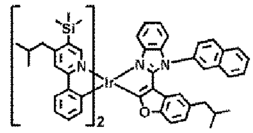
357
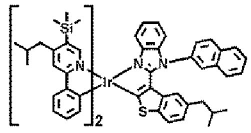
358
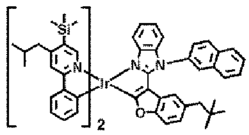
359
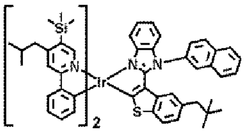
360
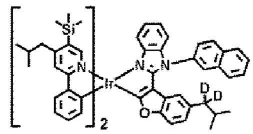
361
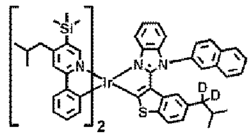
362
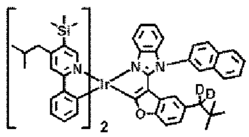
363
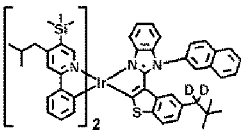
364
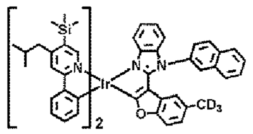
365
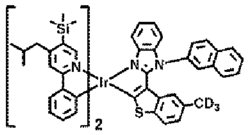
366
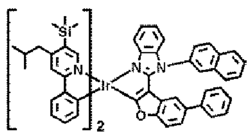
367
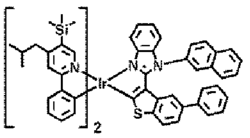
368
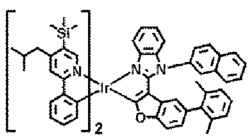
369
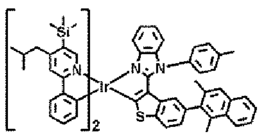
370
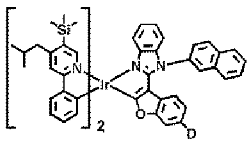
371
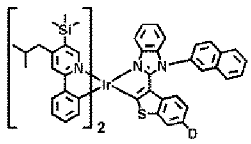
372
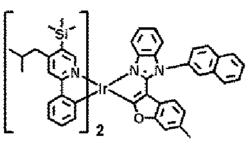
373
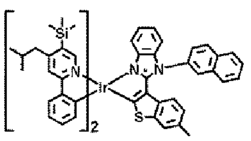
374
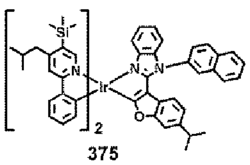
375
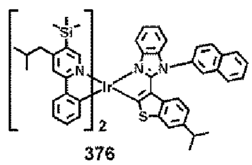
376
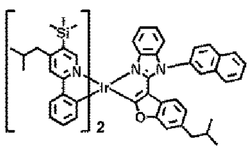
377
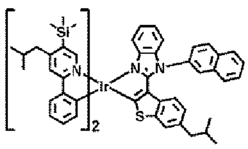
378
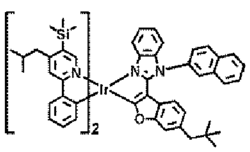
379
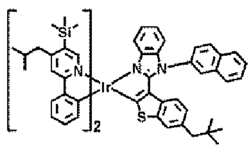
380
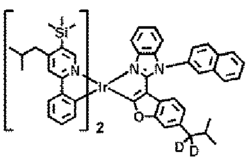
381
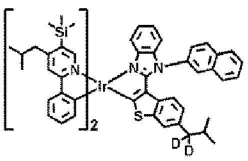
382
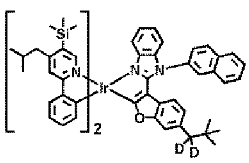
383
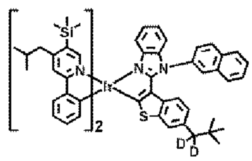
384

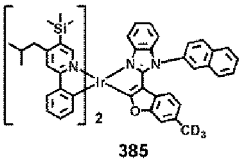
385

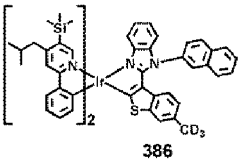
386

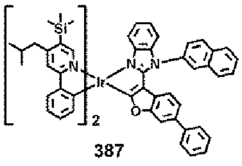
387

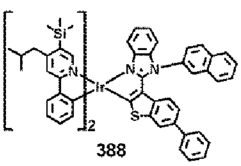
388

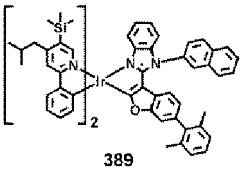
389

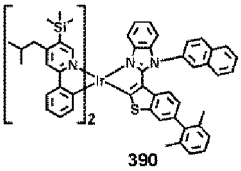
390

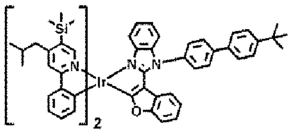
391

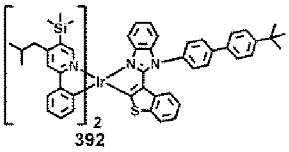
392

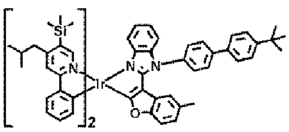
393

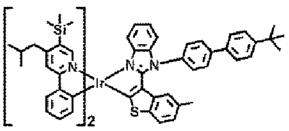
394

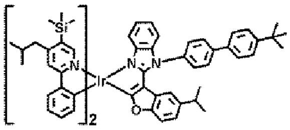
395

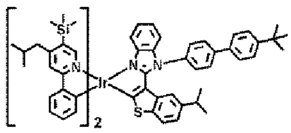
396

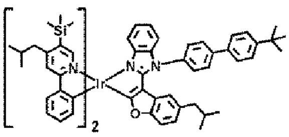
397

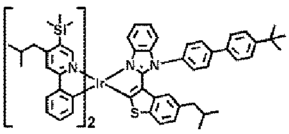
398

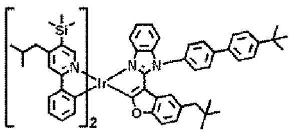
399

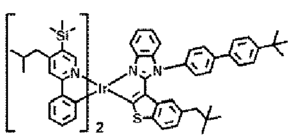
400

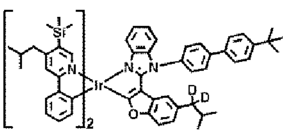
401

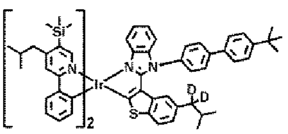
402

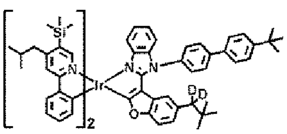
403

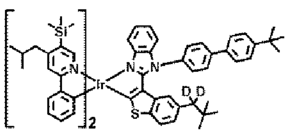
404

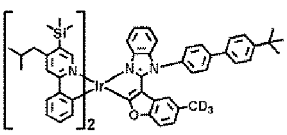
405

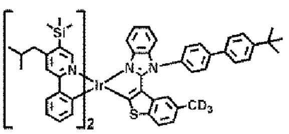
406

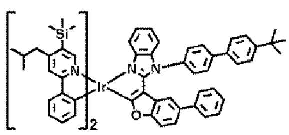
407

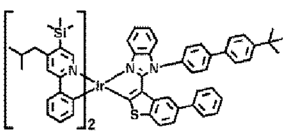
408

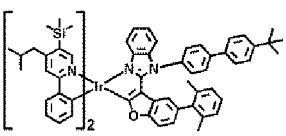
409

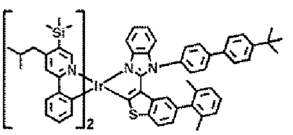
410

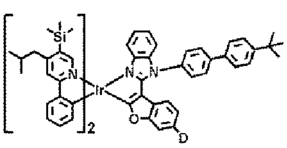
411

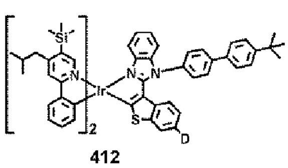
412

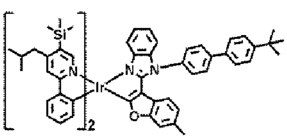
413

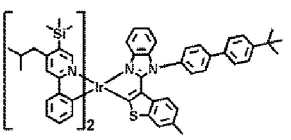
414

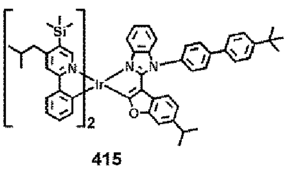
415

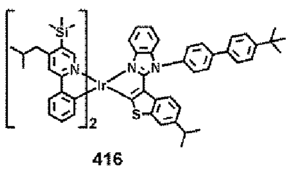
416

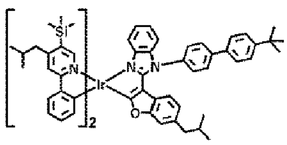
417

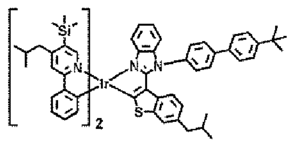
418

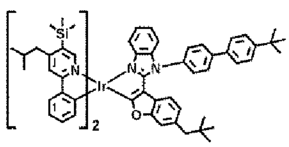
419

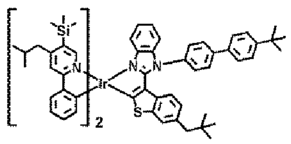
420

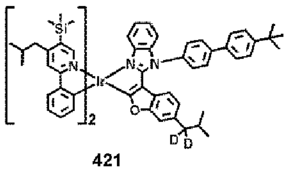
421

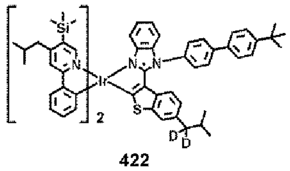
422

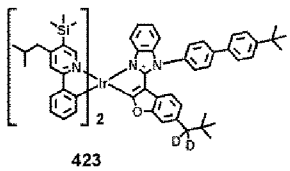
423

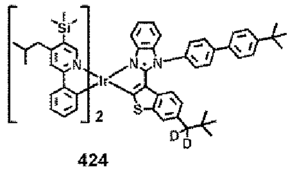
424

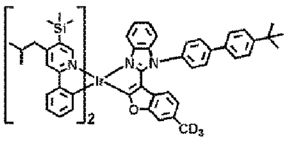
425

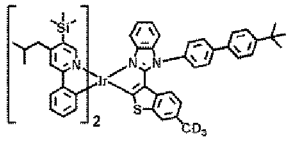
426

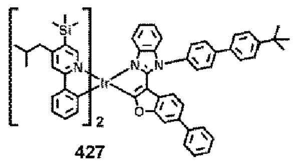
427

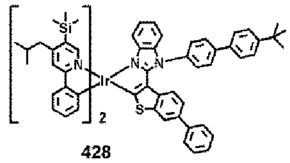
428

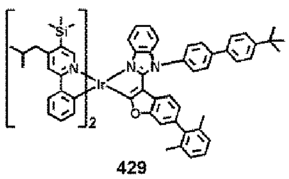
429

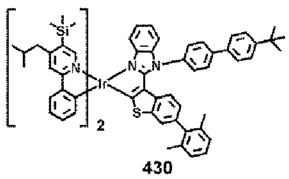
430

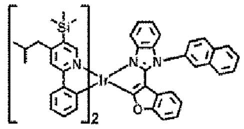
431

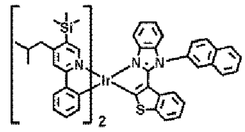
432

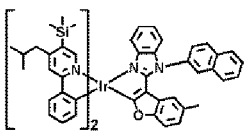
433

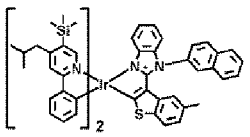
434

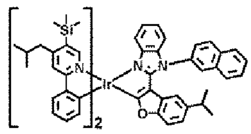
435

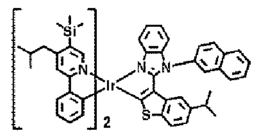
436

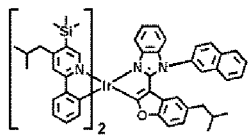
437

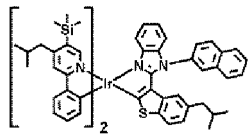
438

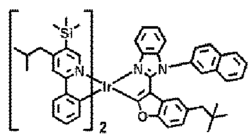
439

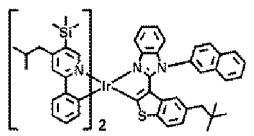
440

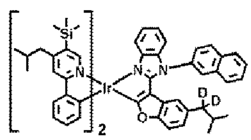
441

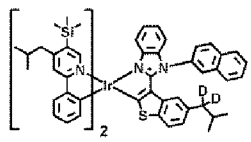
442

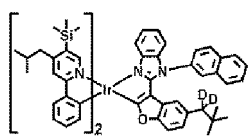
443

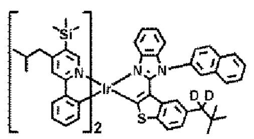
444

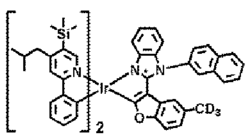
445

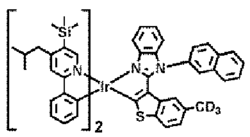
446

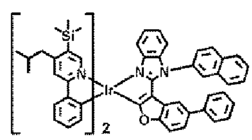
447

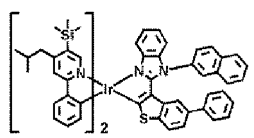
448

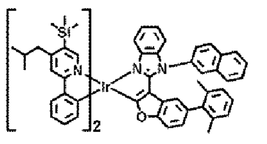

449

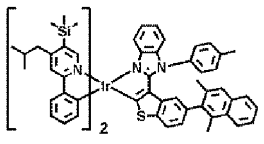

450

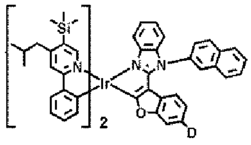

451

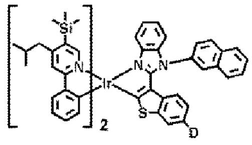

452

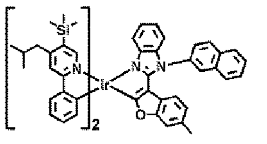

453

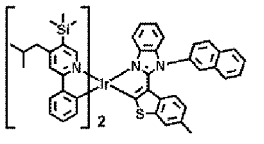

454

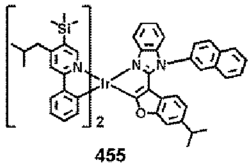

455

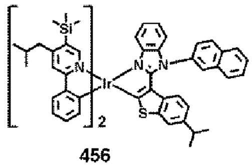

456

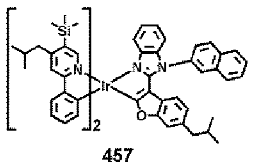

457

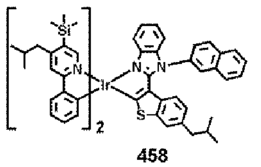

458

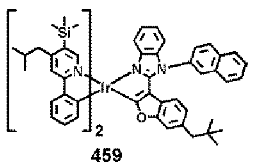

459

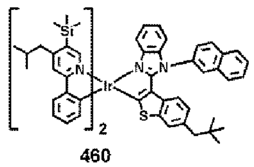

460

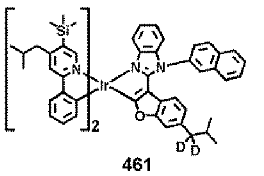

461

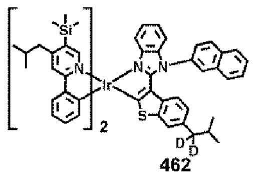

462

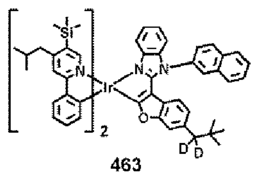

463

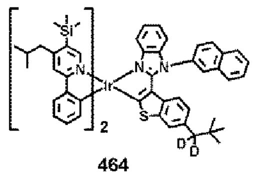

464

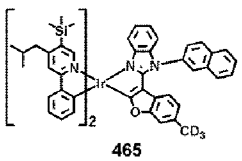

465

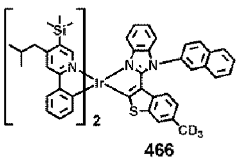

466

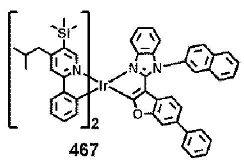

467

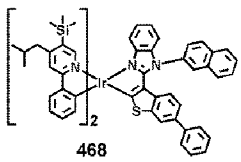

468

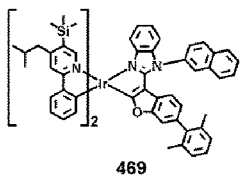

469

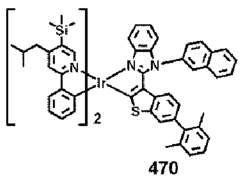

470

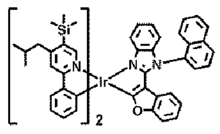

471

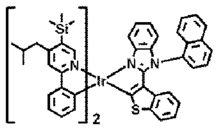

472

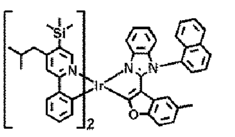

473

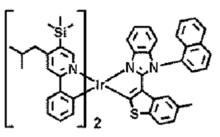

474

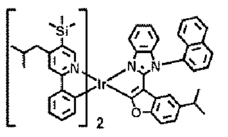

475

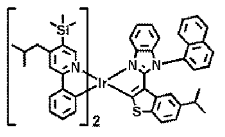

476

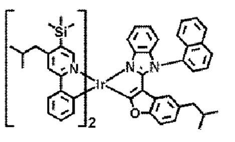

477

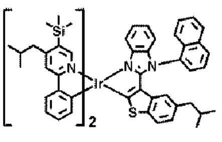

478

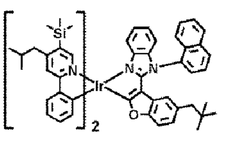

479

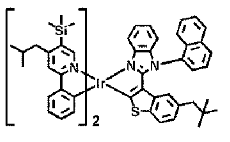

480

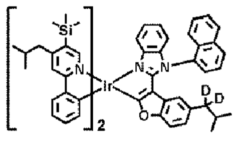
481
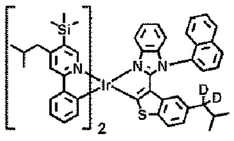
482
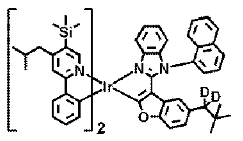
483
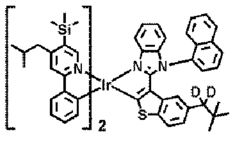
484

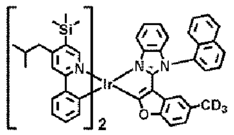
485
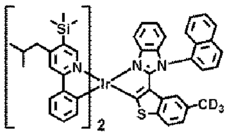
486
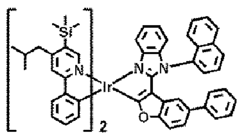
487
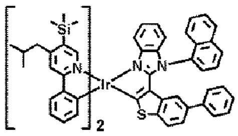
488

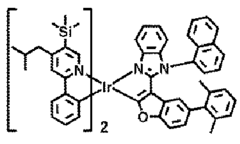
489
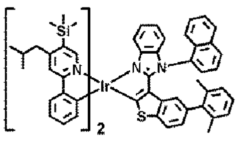
490
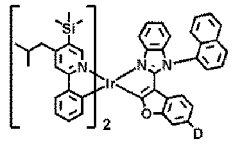
491
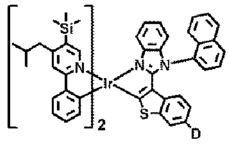
492

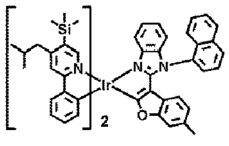
493
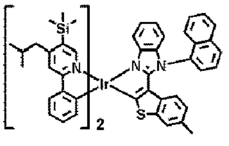
494
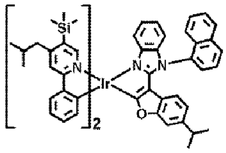
495
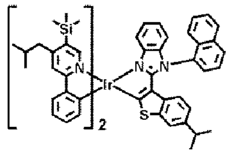
496

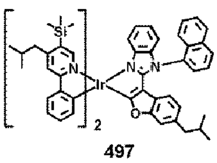
497
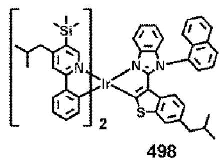
498
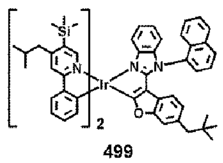
499
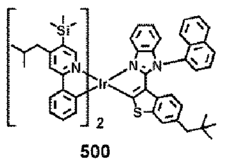
500

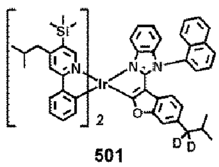
501
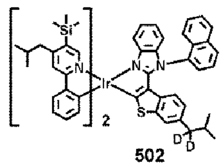
502
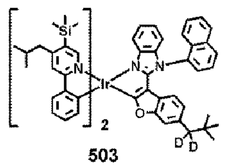
503
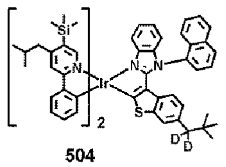
504

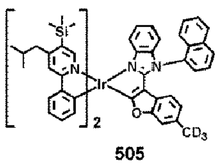
505
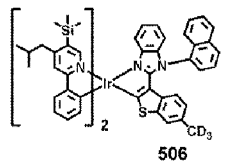
506
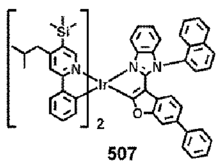
507
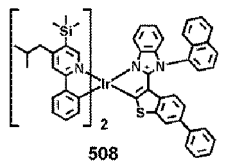
508

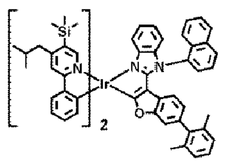
509
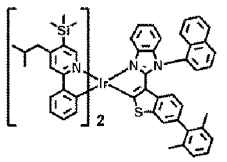
510
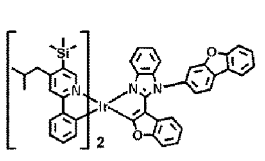
511
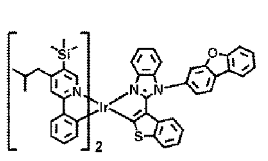
512

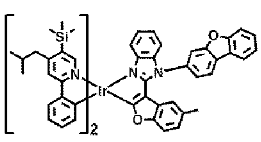
513

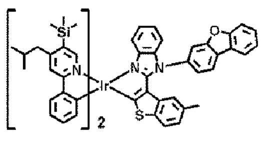
514

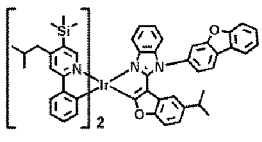
515

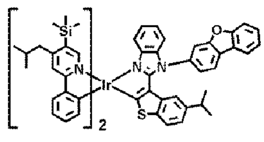
516

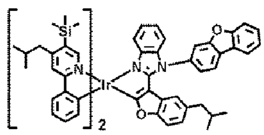
517

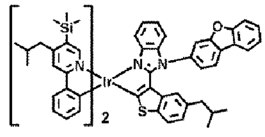
518

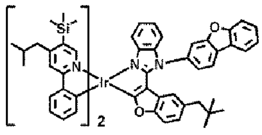
519

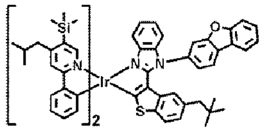
520

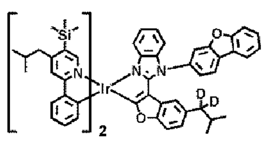
521

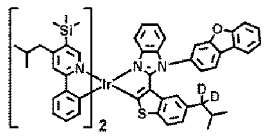
522

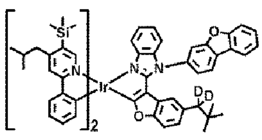
523

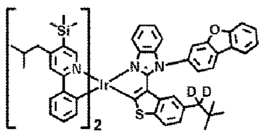
524

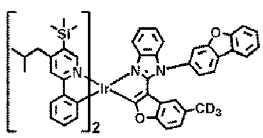
525

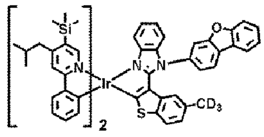
526

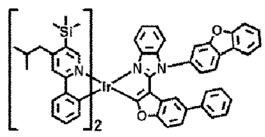
527

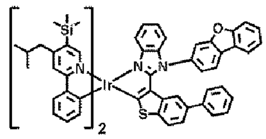
528

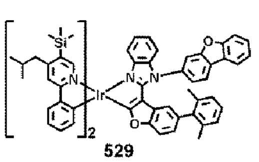
529

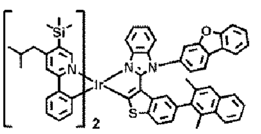
530

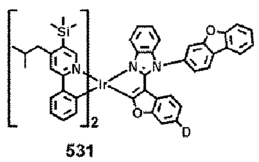
531

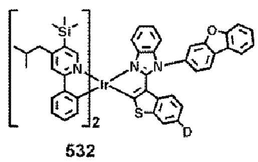
532

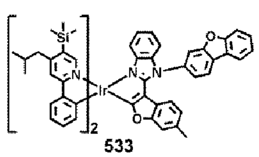
533

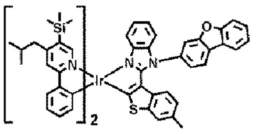
534

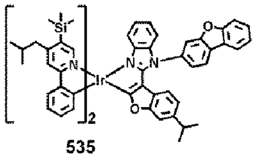
535

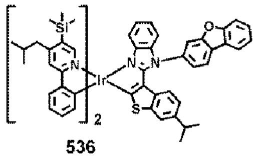
536

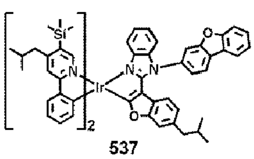
537

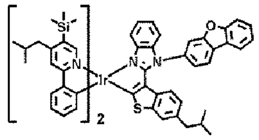
538

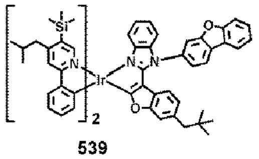
539

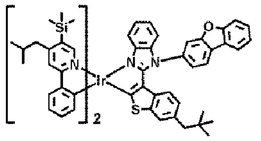
540

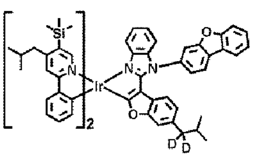
541

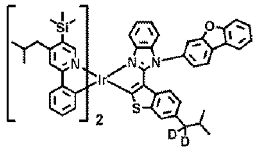
542

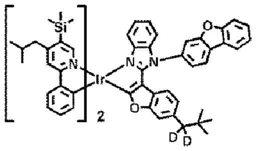
543

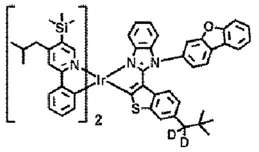
544

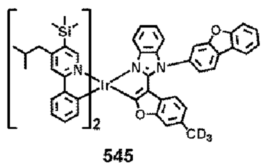
545

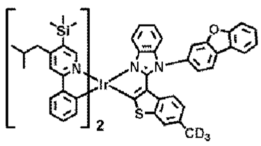
546

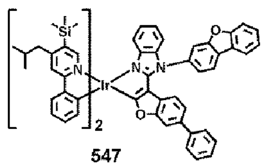
547

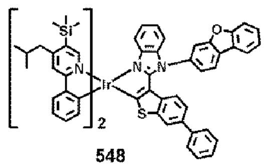
548

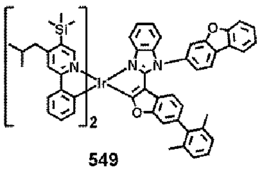
549

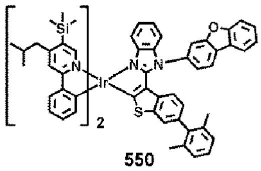
550

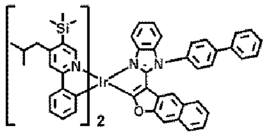
551

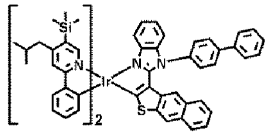
552

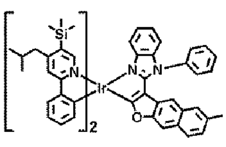
553

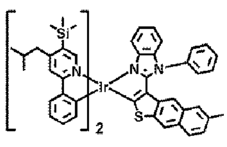
554

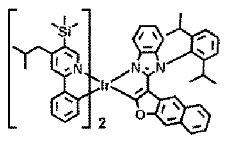
555

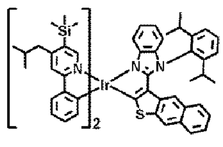
556

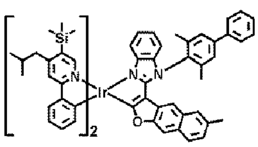
557

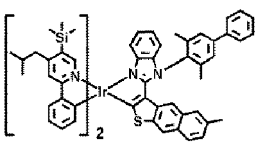
558

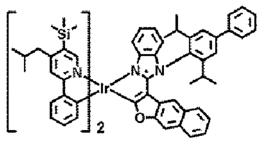
559

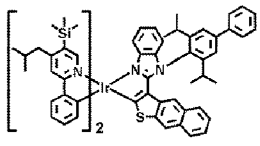
560

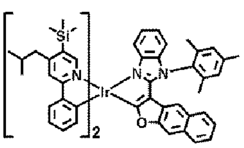
561

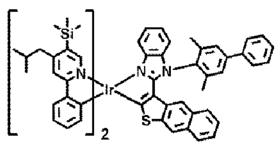
562

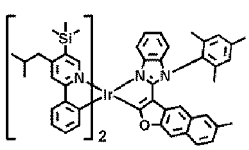
563

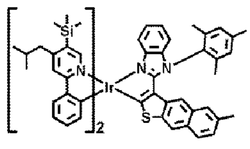
564

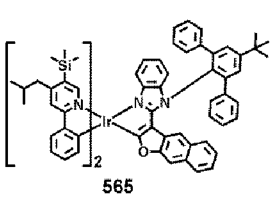
565

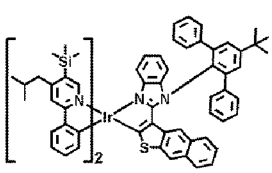
566

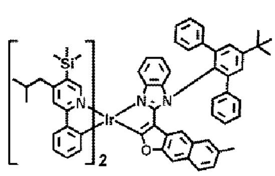
567

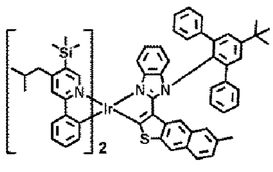
568

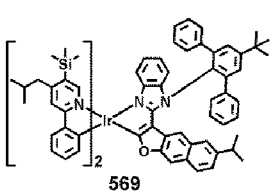
569

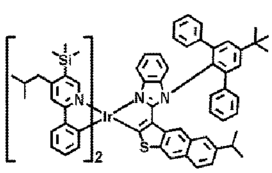
570

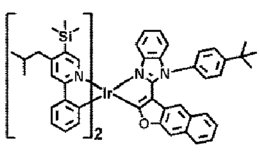
571

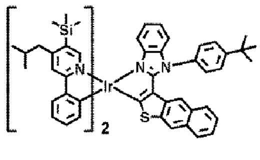
572

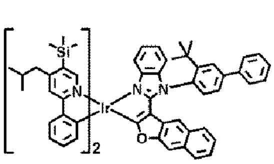
573

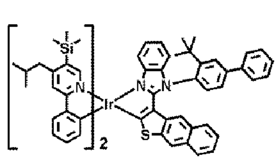
574

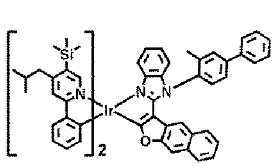
575

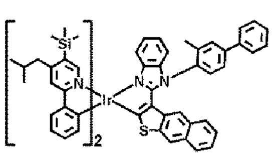
576

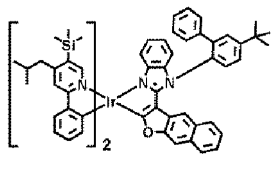
577
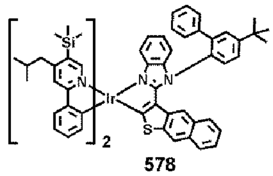
578
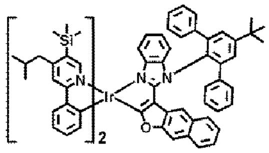
579
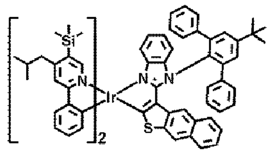
580

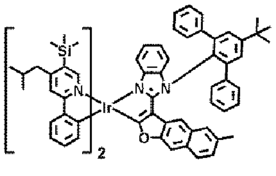
581
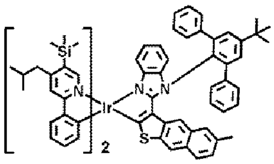
582
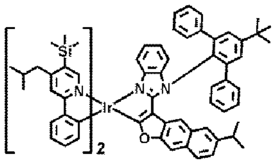
583
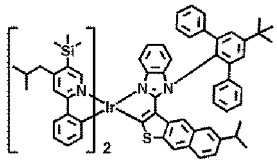
584

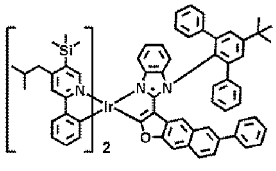
585
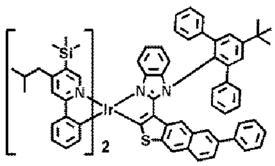
586
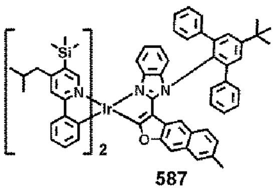
587
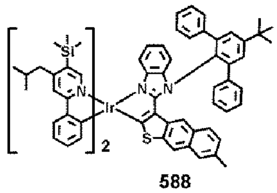
588

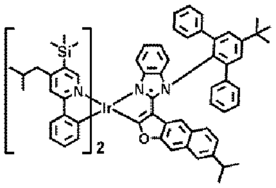
589
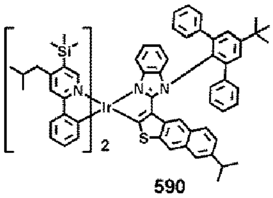
590
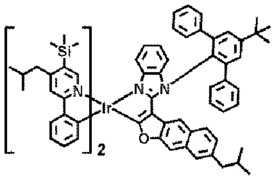
591
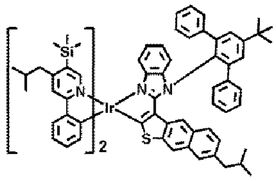
592

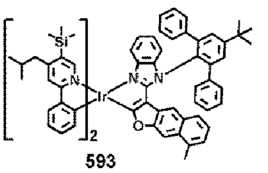
593
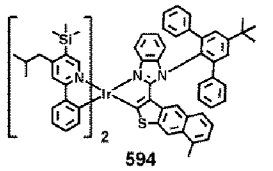
594
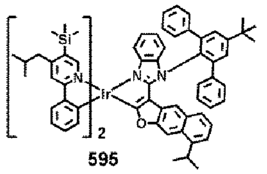
595
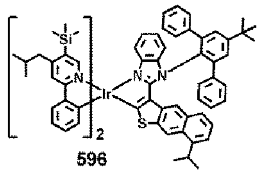
596

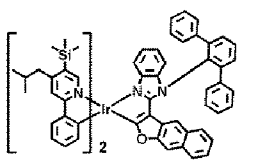
597
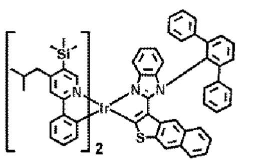
598
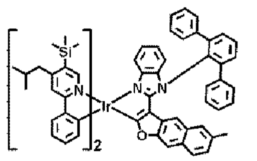
599
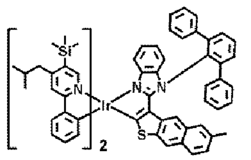
600

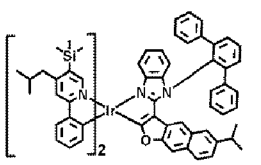
601
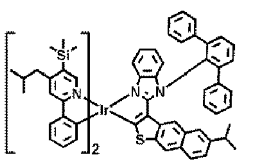
602
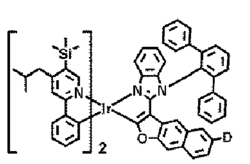
603
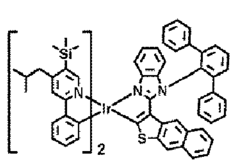
604

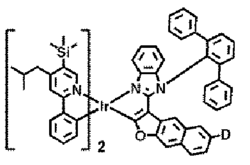
605

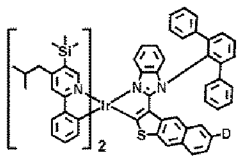
606

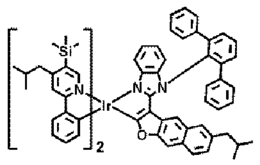
607

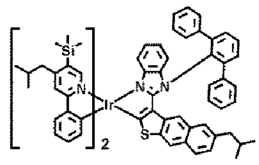
608

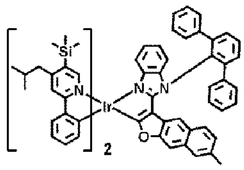
609

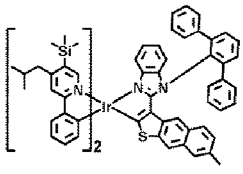
610

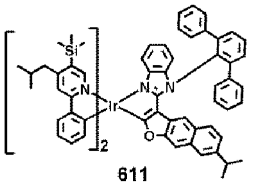
611

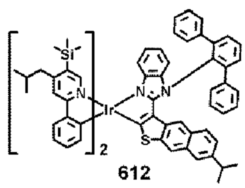
612

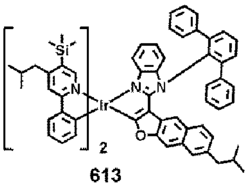
613

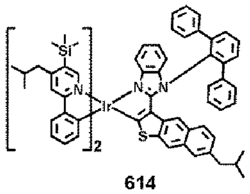
614

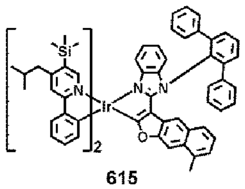
615

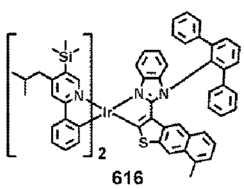
616

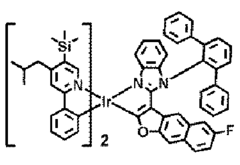
617

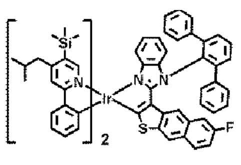
618

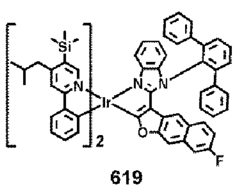
619

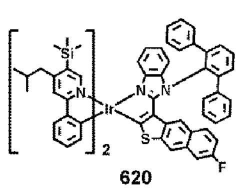
620

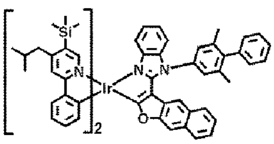
621

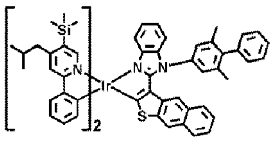
622

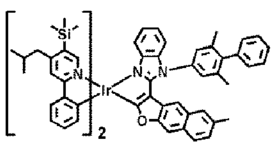
623

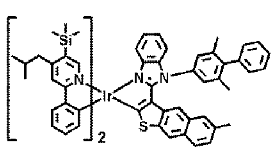
624

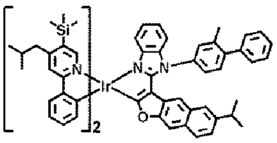
625

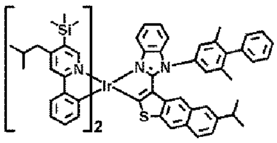
626

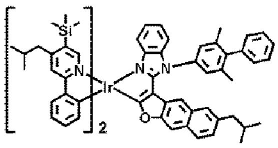
627

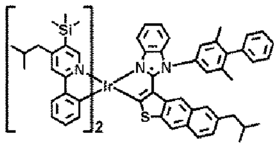
628

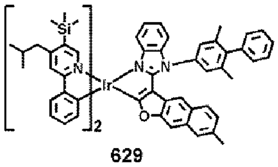
629

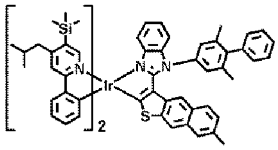
630

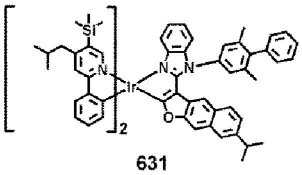
631

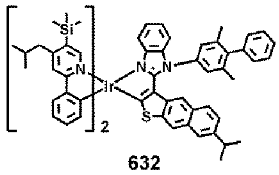
632

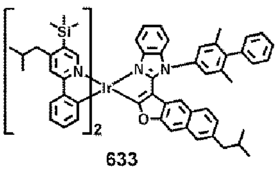
633

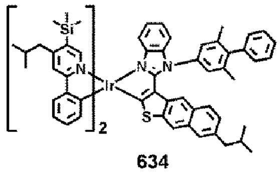
634

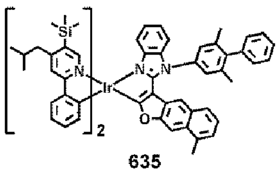
635

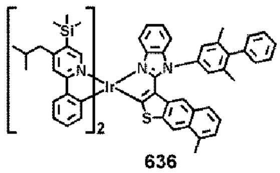
636

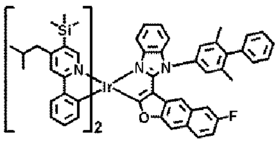
637
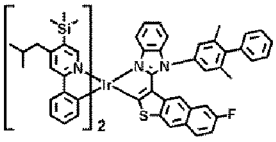
638
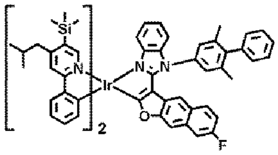
639
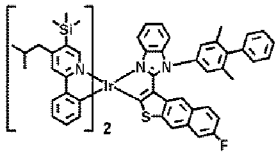
640

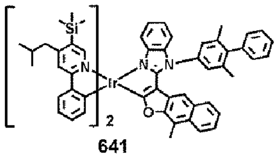
641
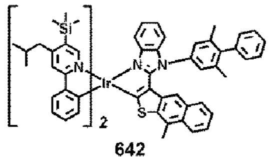
642
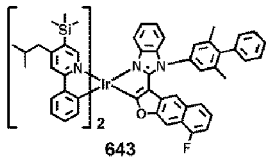
643
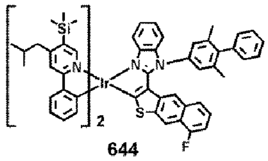
644

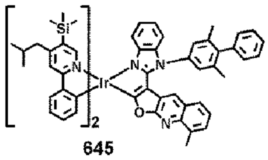
645
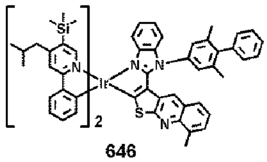
646
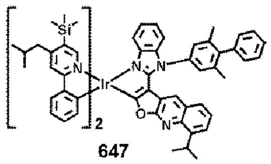
647
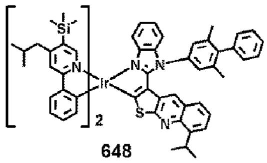
648

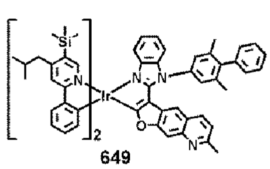
649
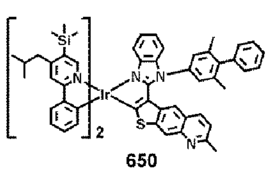
650
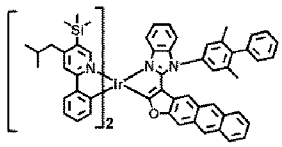
651
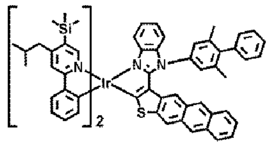
652

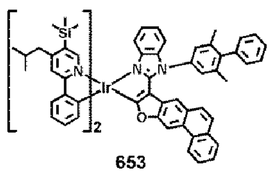
653
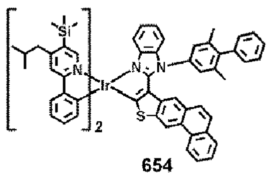
654
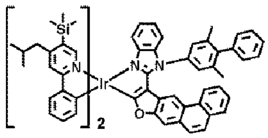
655
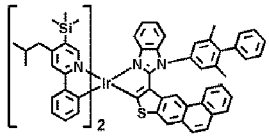
656

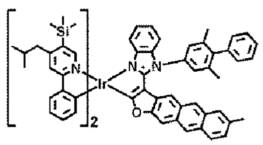
657
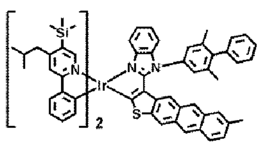
658
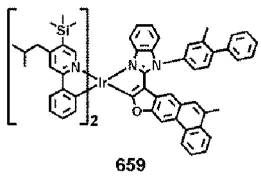
659
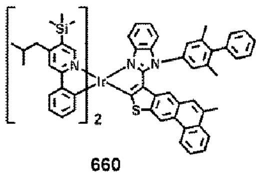
660

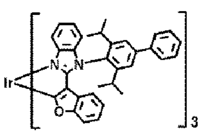
661
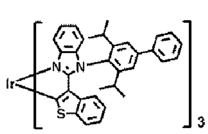
662
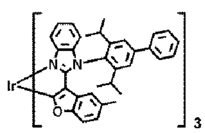
663
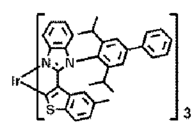
664
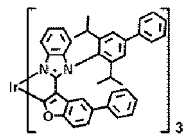
665

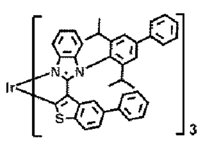
666
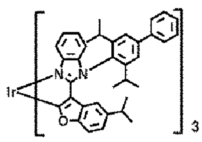
667
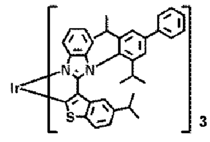
668
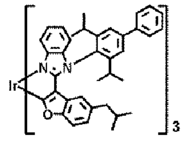
669
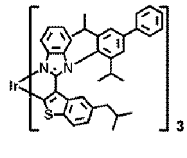
670

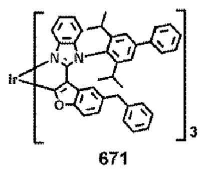
671
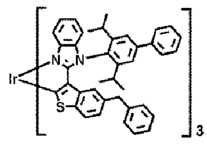
672
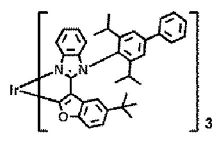
673
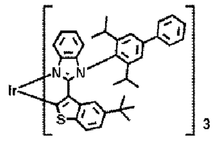
674
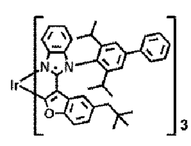
675

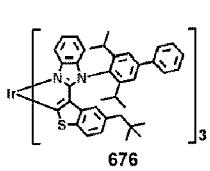
676
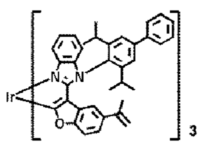
677
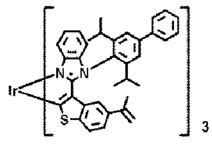
678
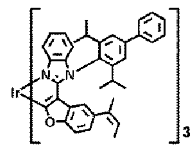
679
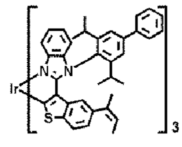
680

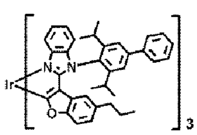
681
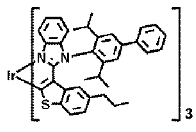
682
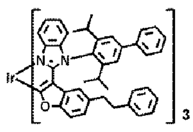
683
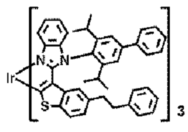
684
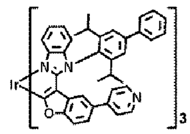
685

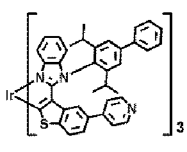
686
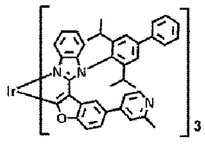
687
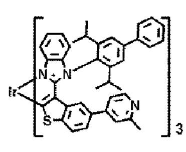
688
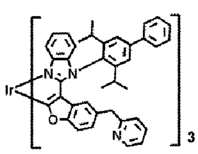
689
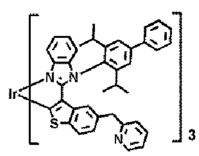
690

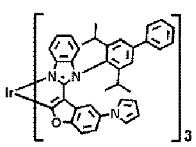
691
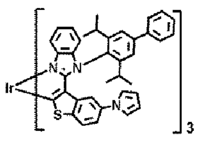
692
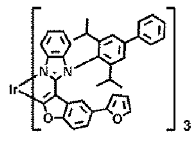
693
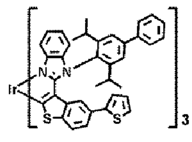
694
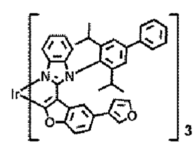
695

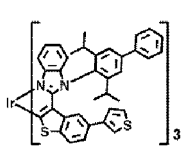
696
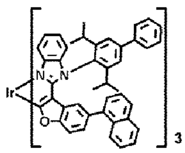
697
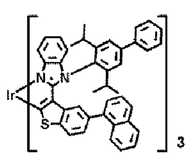
698
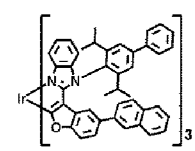
699
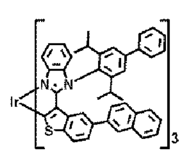
700

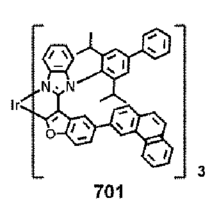
701
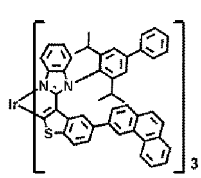
702
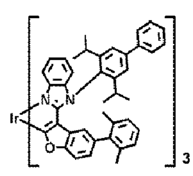
703
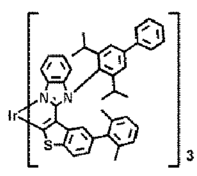
704
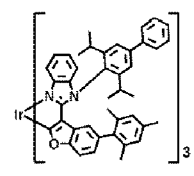
705

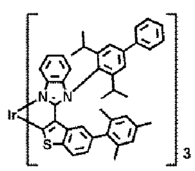
706
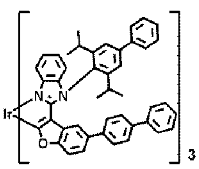
707
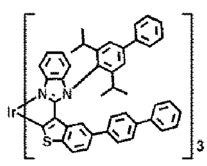
708
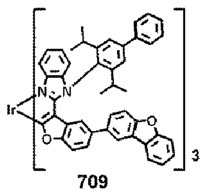
709
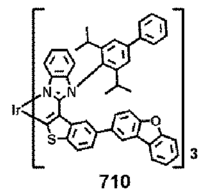
710

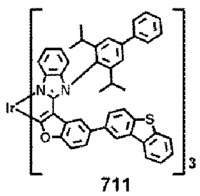
711

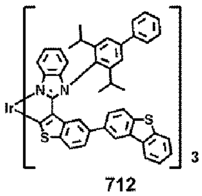
712

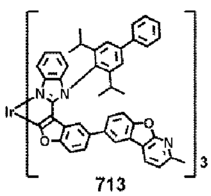
713

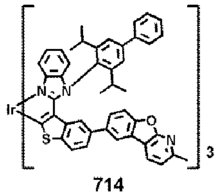
714

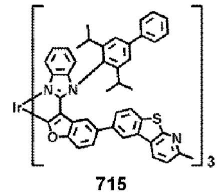
715

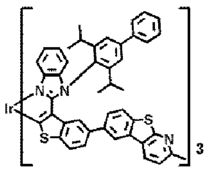
716

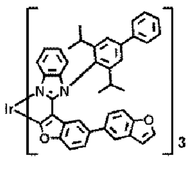
717

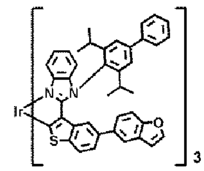
718

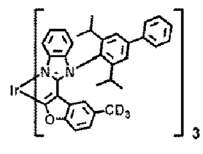
719

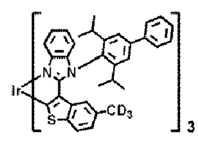
720

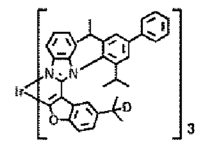
721

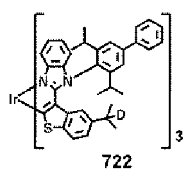
722

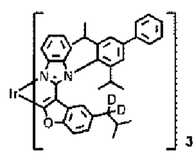
723

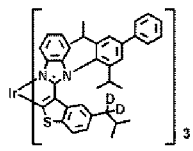
724

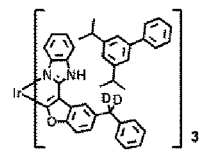
725

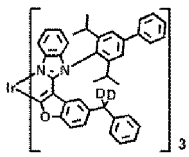
726

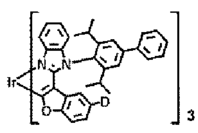
727

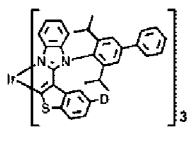
728

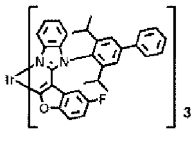
729

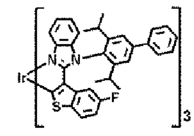
730

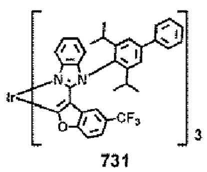
731

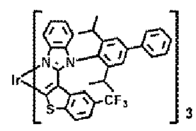
732

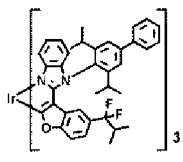
733

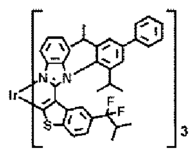
734

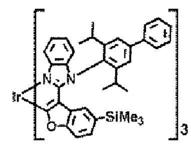
735

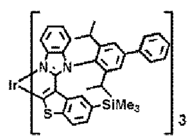
736

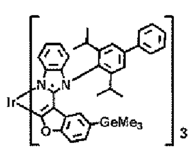
737

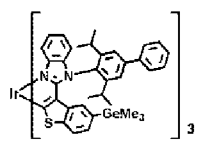
738

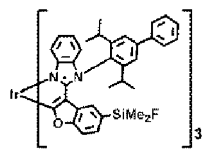
739

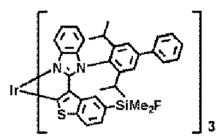
740

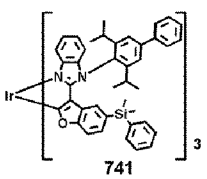
741

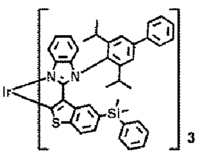
742

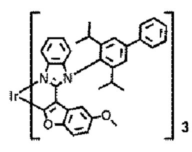
743

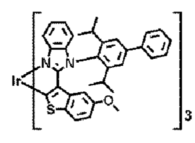
744

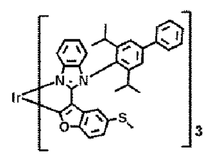
745

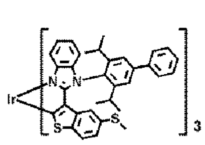
746

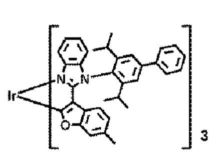
747

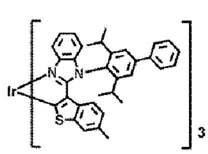
748

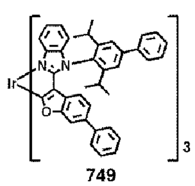
749

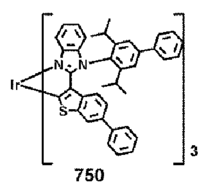
750

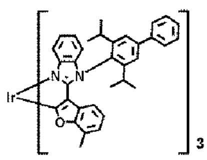
751

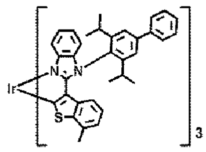
752

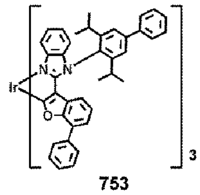
753

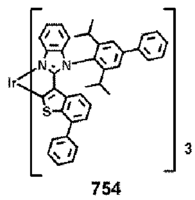
754

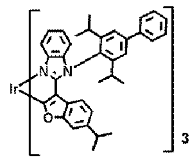
755

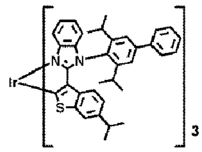
756

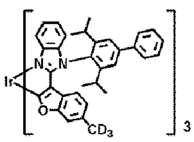
757

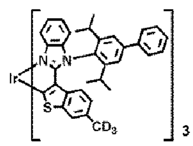
758

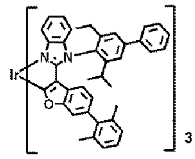
759

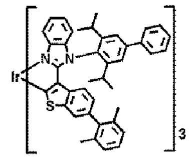
760

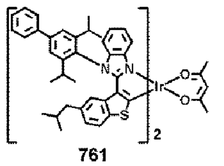
761

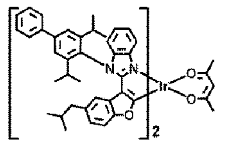
762

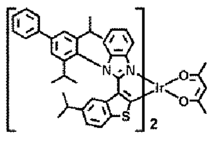
763

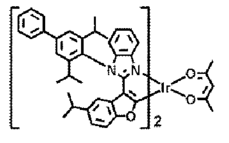
764

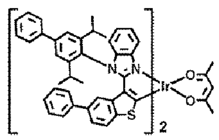
765

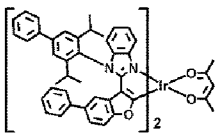
766

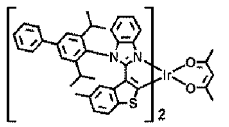
767

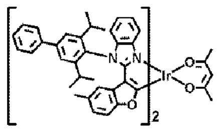
768

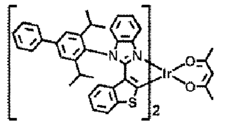
769

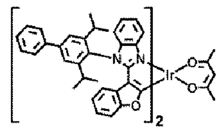
770

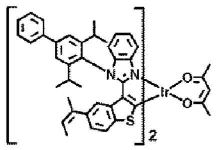
771

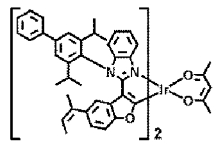
772

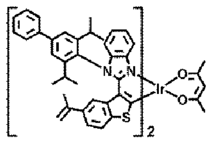
773

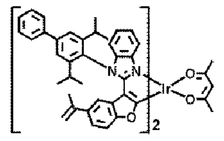
774

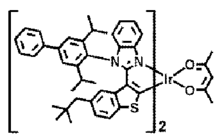
775

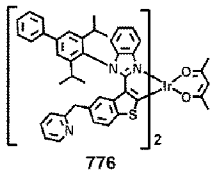
776

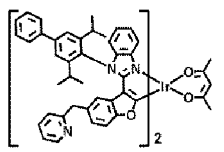
777

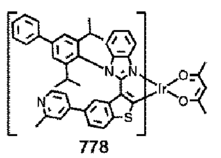
778

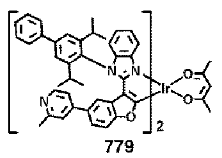
779

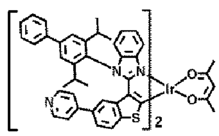
780

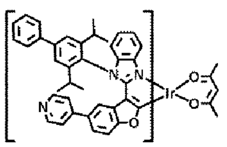
781

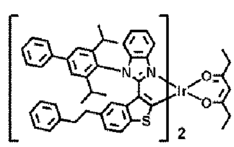
782

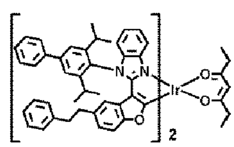
783

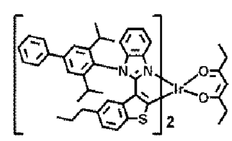
784

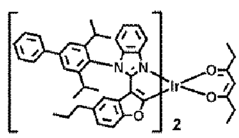
785

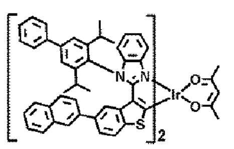
786

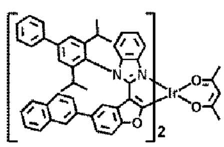
787

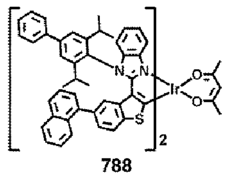
788

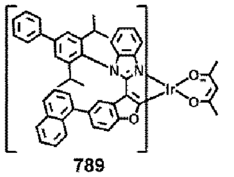
789

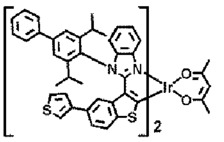
790

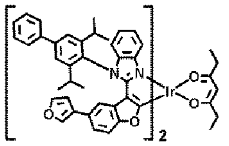
791

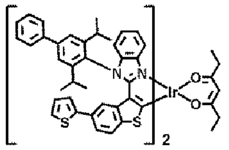
792

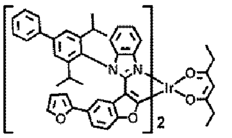
793

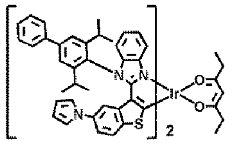
794

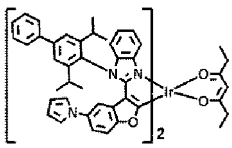
795

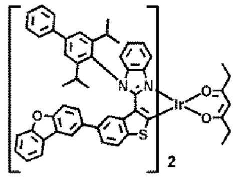
796

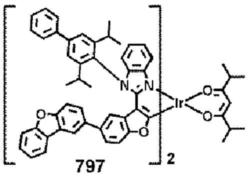
797

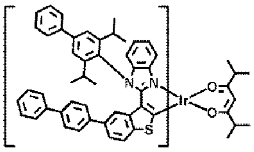
798

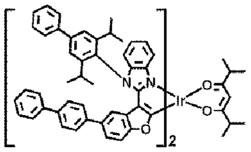
799

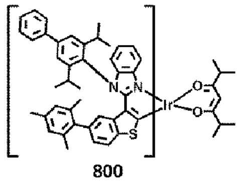
800

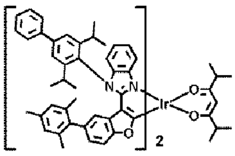
801

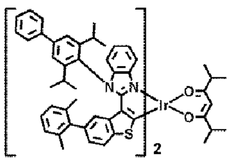
802

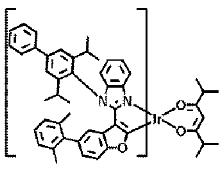
803

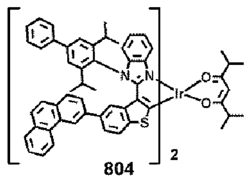
804

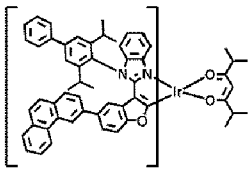
805

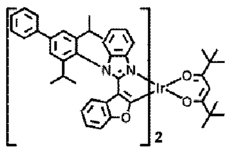
806

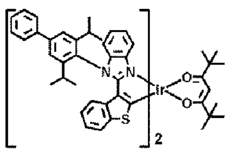
807

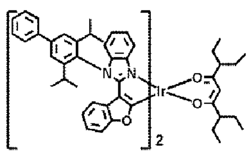
808

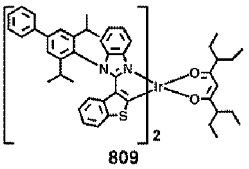
809

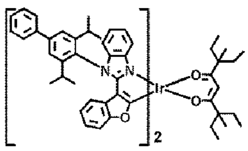
810

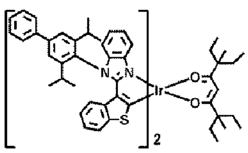
811

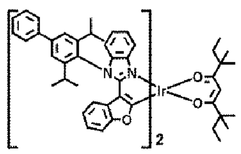
812

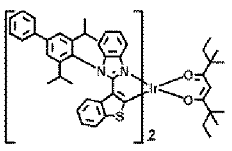
813

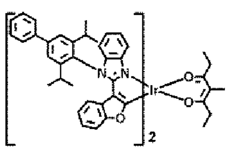
814

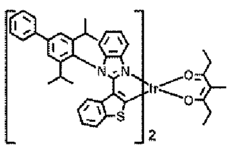
815

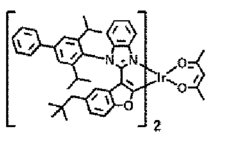
816

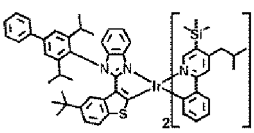
817

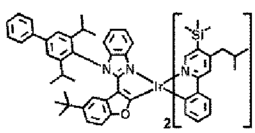
818

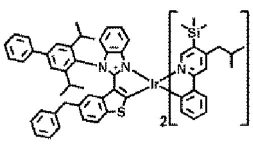
819

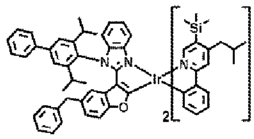
820

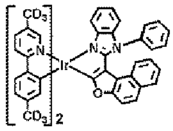
821

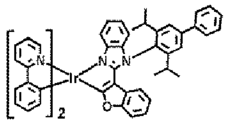
822

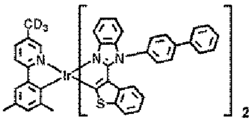
823

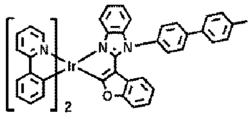
824

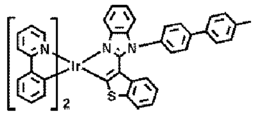
825

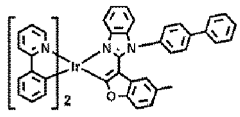
826

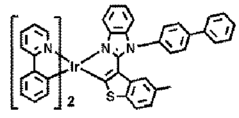
827

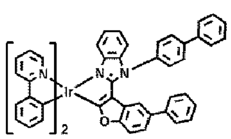
828

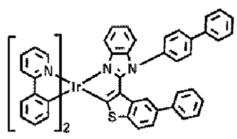
829

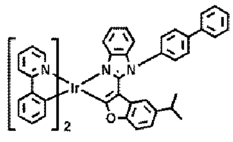
830

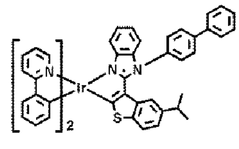
831

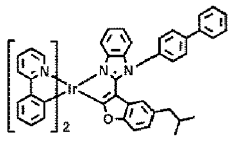
832

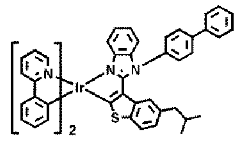
833

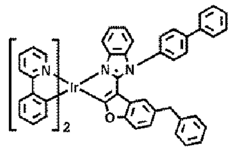
834

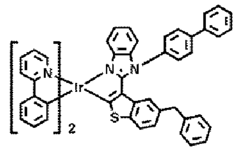
835

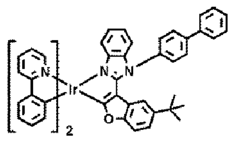
836

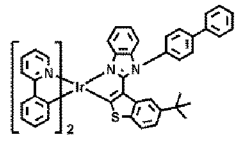
837

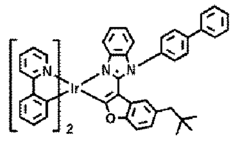
838

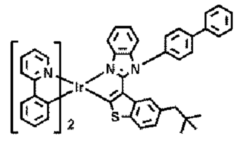
839

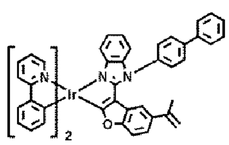
840

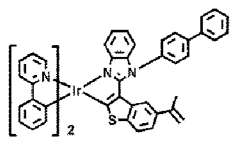
841

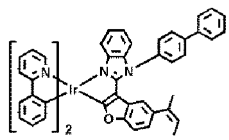
842

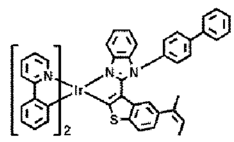
843

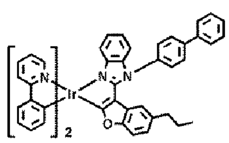
844

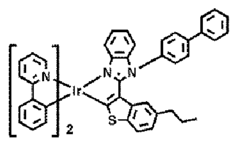
845

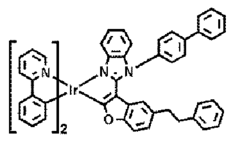
846

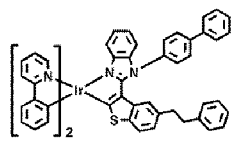
847

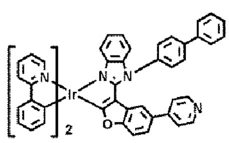
848

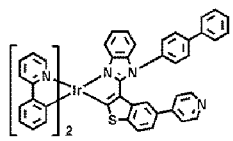
849

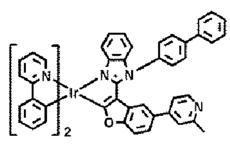
850

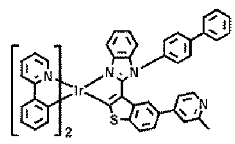
851

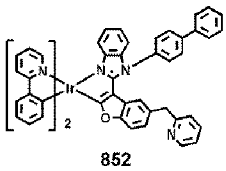
852
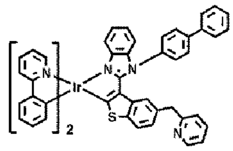
853
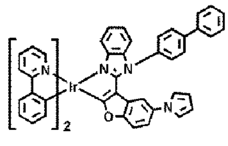
854
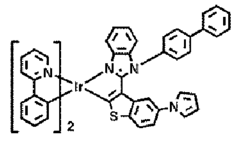
855

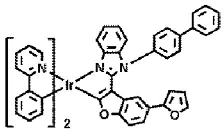
856
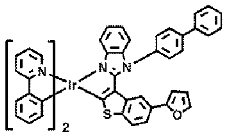
857
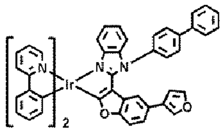
858
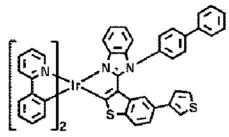
859

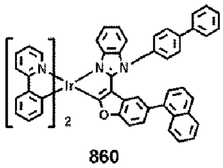
860
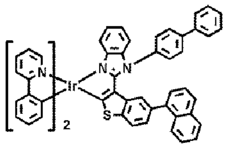
861
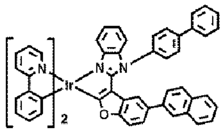
862
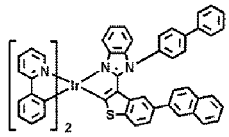
863

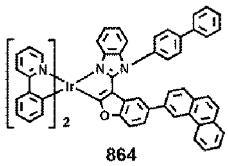
864
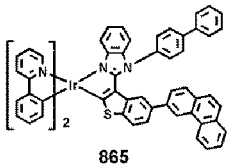
865
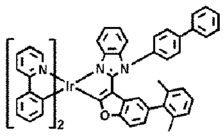
866
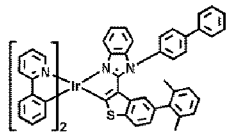
867

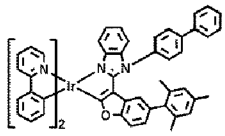
868
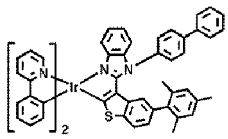
869
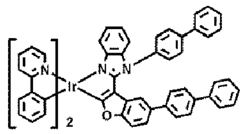
870
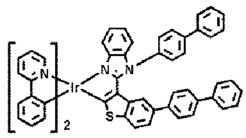
871

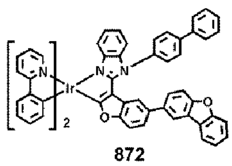
872
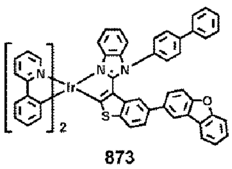
873
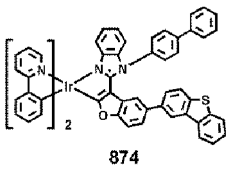
874
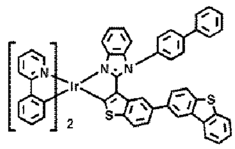
875

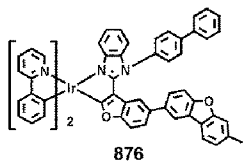
876
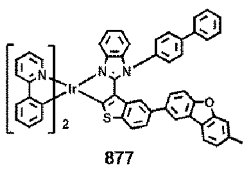
877
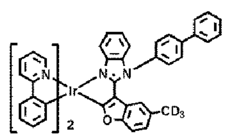
878
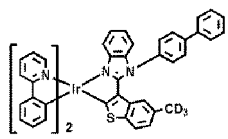
879

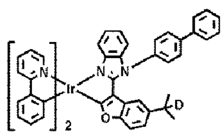
880
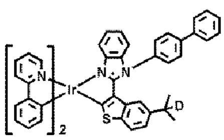
881
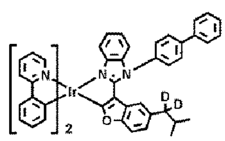
882
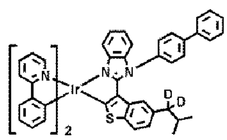
883

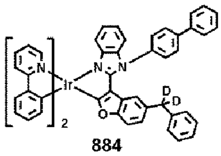
884

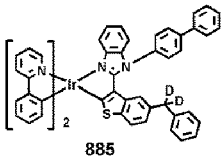
885

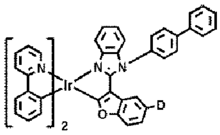
886

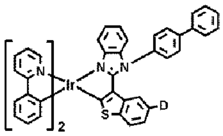
887

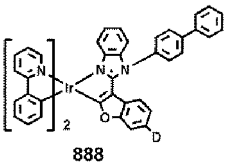
888

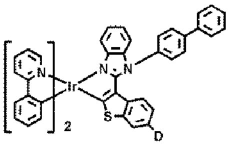
889

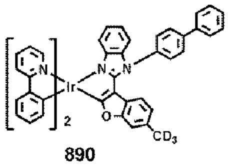
890

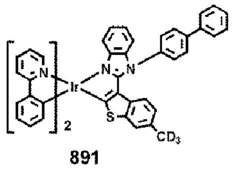
891

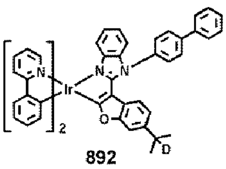
892

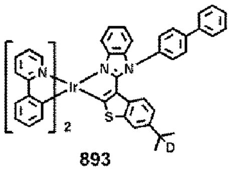
893

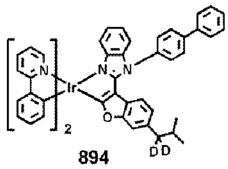
894

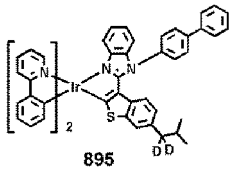
895

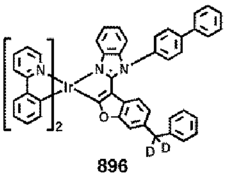
896

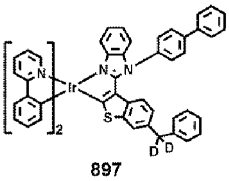
897

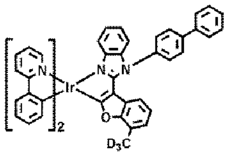
898

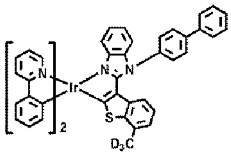
899

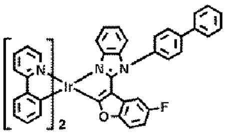
900

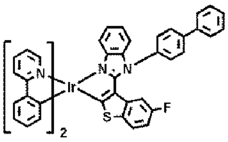
901

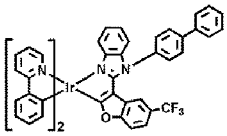
902

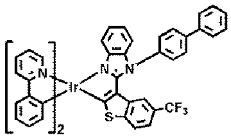
903

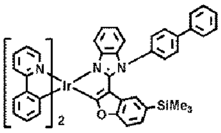
904

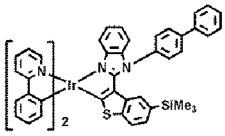
905

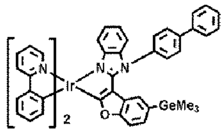
906

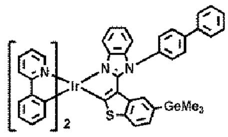
907

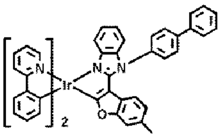
908

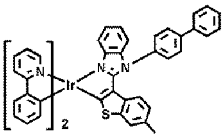
909

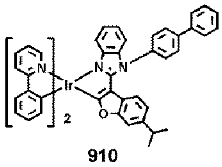
910

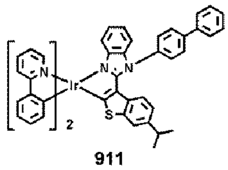
911

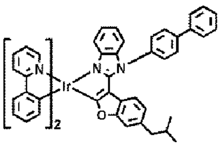
912

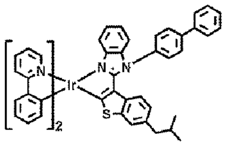
913

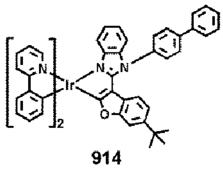
914

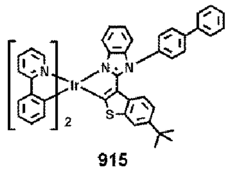
915

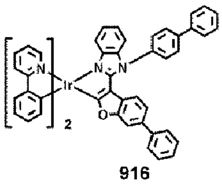
916
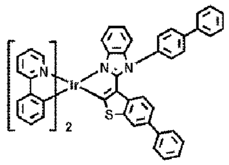
917
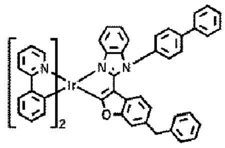
918
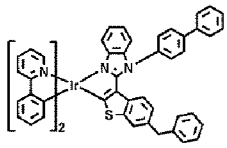
919

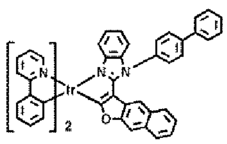
920
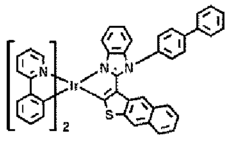
921
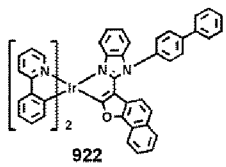
922
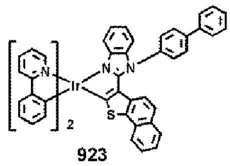
923

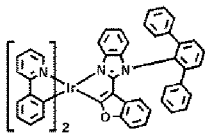
924
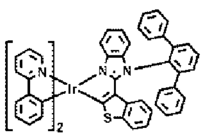
925
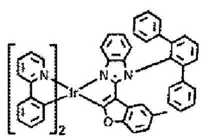
926
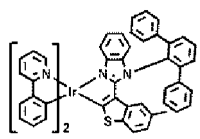
927

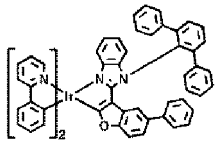
928
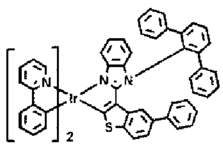
929
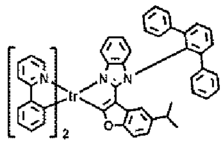
930
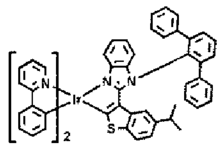
931

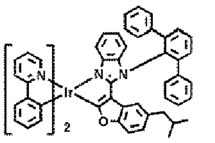
932
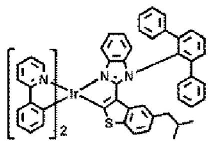
933
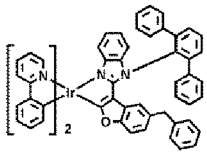
934
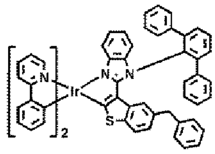
935

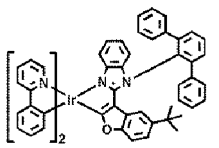
936
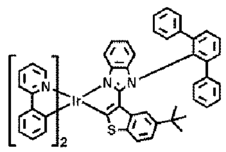
937
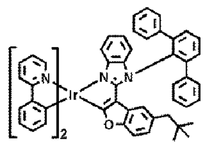
938
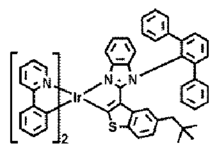
939

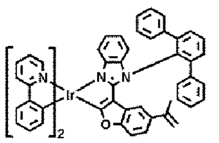
940
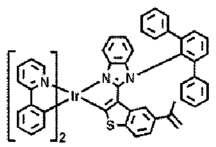
941
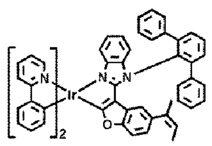
942
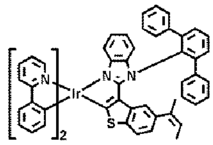
943

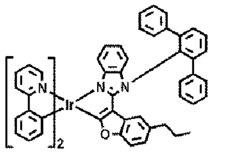
944
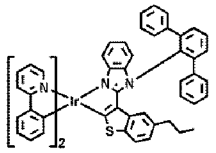
945
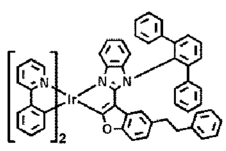
946
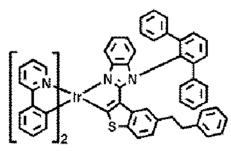
947

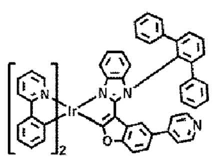
948

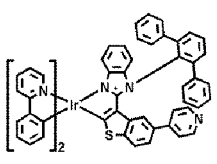
949

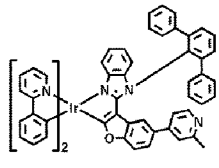
950

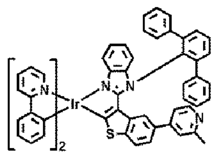
951

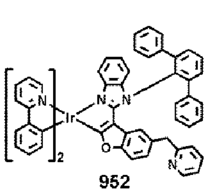
952

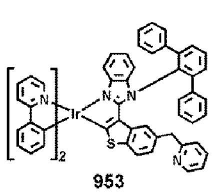
953

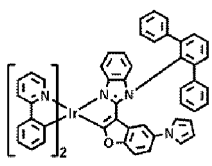
954

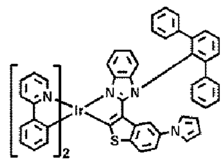
955

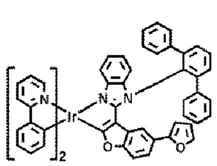
956

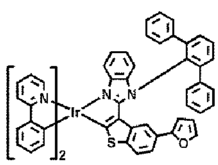
957

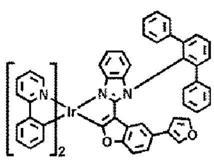
958

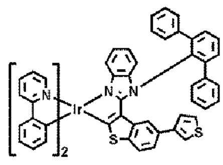
959

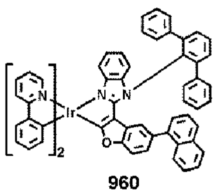
960

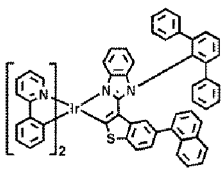
961

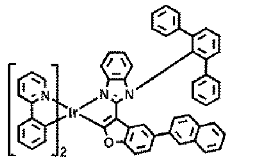
962

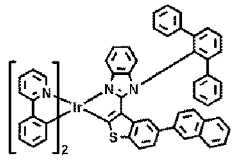
963

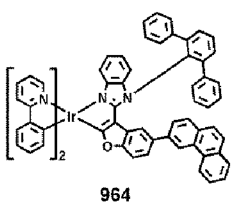
964

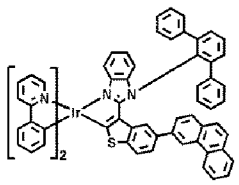
965

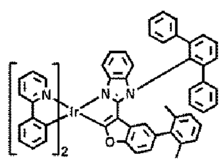
966

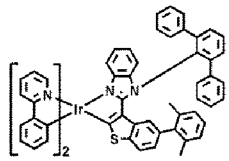
967

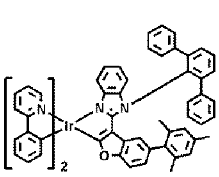
968

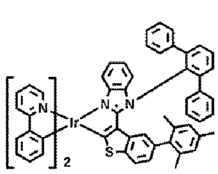
969

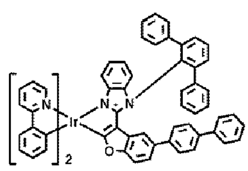
970

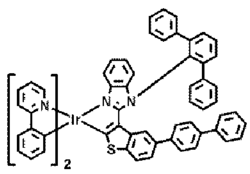
971

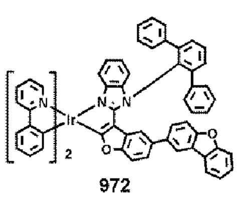
972

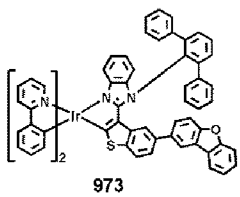
973

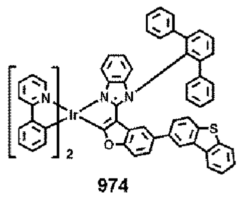
974

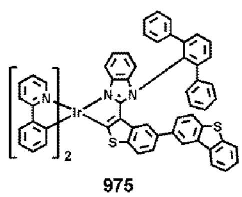
975

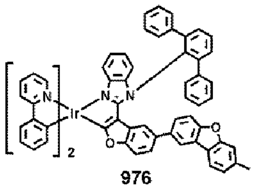
976

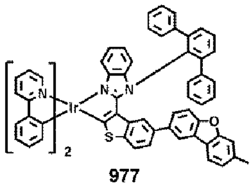
977

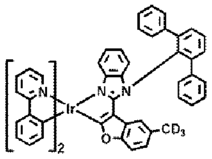
978

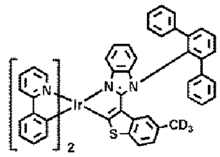
979

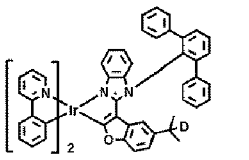
980

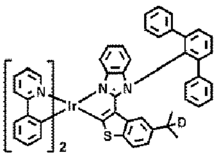
981

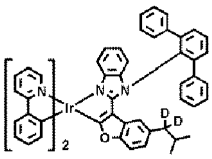
982

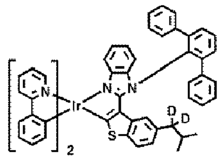
983

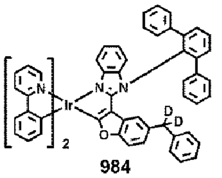
984

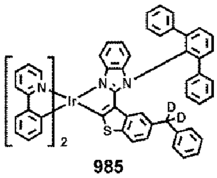
985

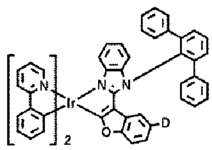
986

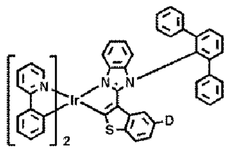
987

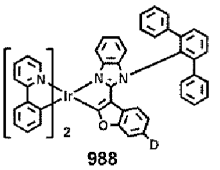
988

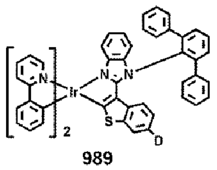
989

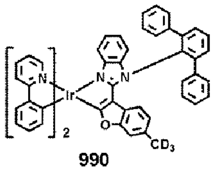
990

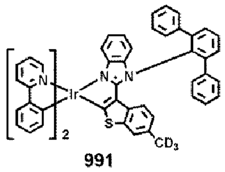
991

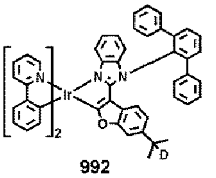
992

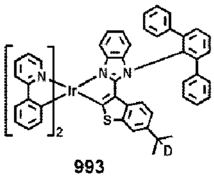
993

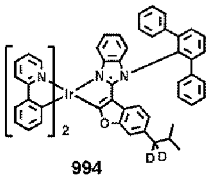
994

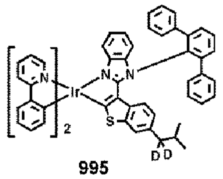
995

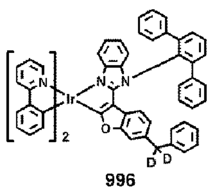
996

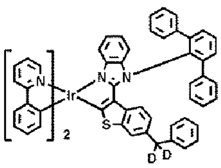
997

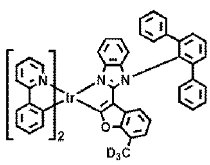
998

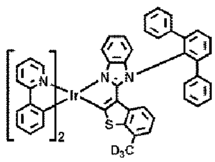
999

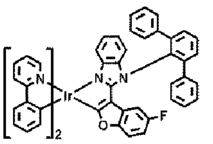
1000

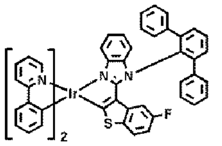
1001

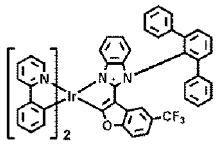
1002

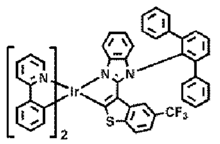
1003

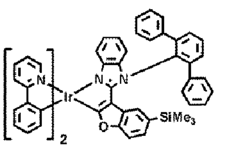
1004

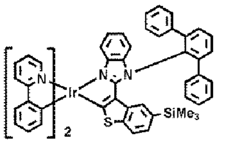
1005

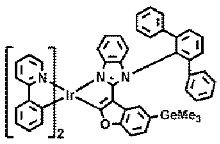
1006

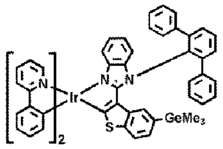
1007

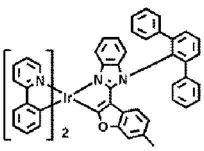
1008

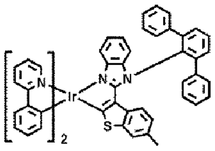
1009

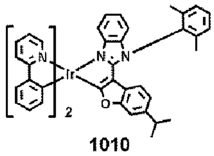
1010

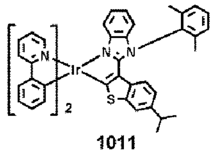
1011

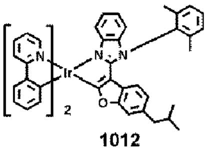
1012

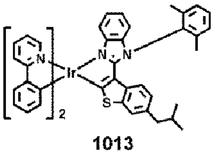
1013

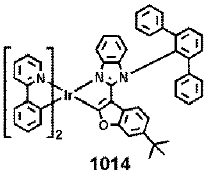
1014

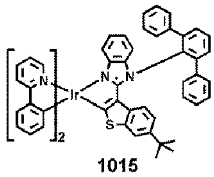
1015

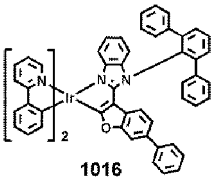
1016

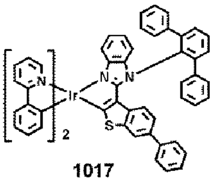
1017

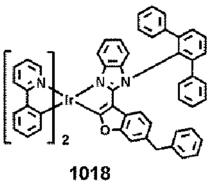
1018

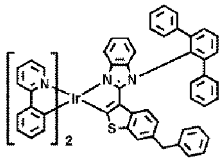
1019

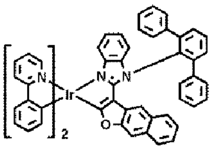
1020

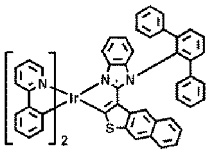
1021

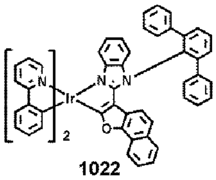
1022

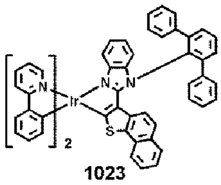
1023

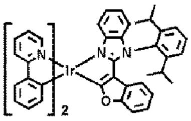
1024

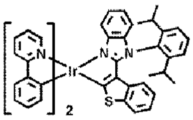
1025

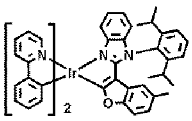
1026

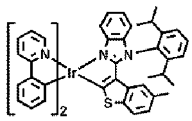
1027

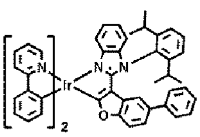
1028

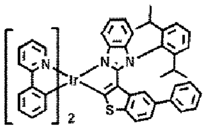
1029

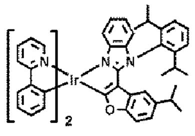
1030

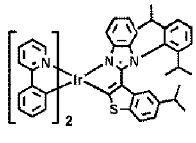
1031

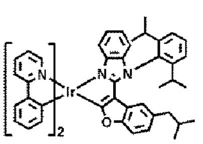
1032

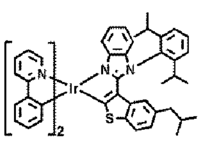
1033

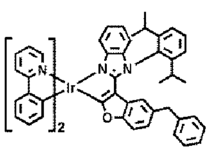
1034

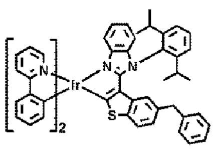
1035

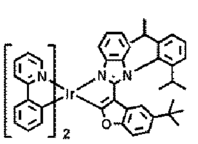
1036

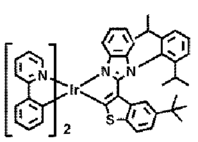
1037

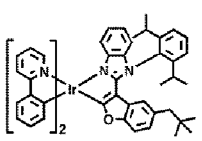
1038

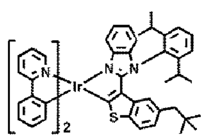
1039

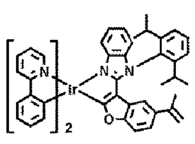
1040

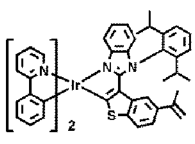
1041

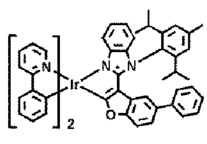
1042

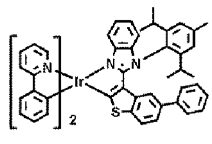
1043

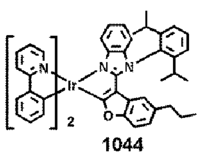
1044

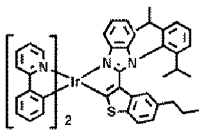
1045

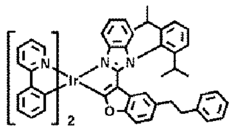
1046

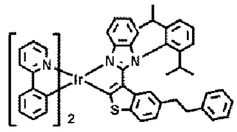
1047

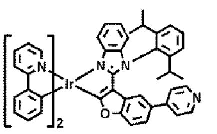
1048

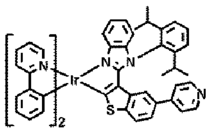
1049

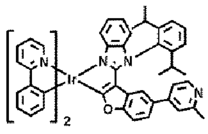
1050

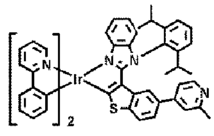
1051

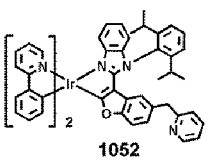
1052

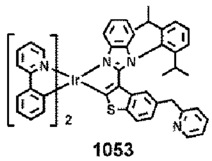
1053

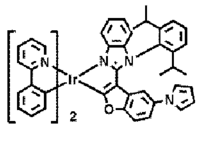
1054

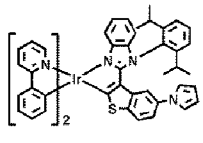
1055

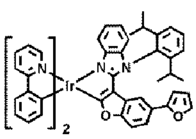
1056

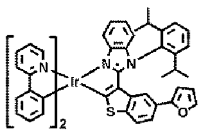
1057

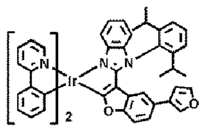
1058

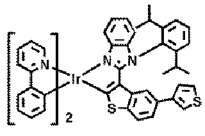
1059

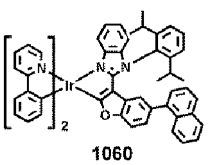
1060

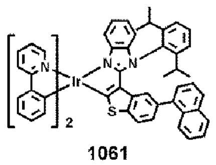
1061

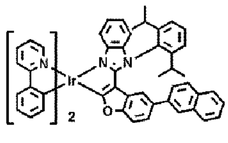
1062

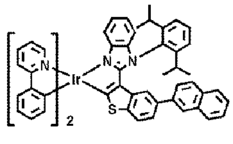
1063

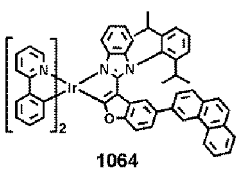
1064

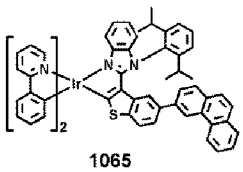
1065

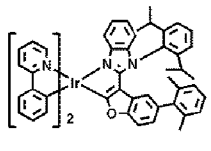
1066

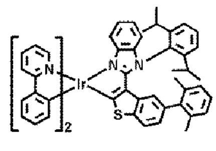
1067

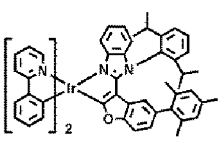
1068

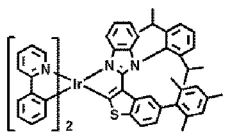
1069

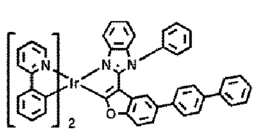
1070

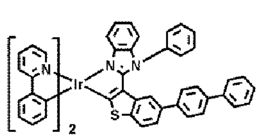
1071

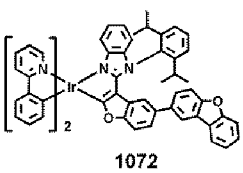
1072

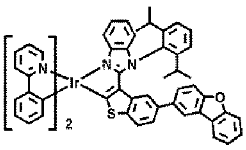
1073

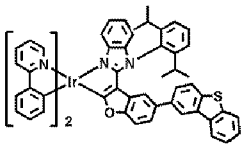
1074

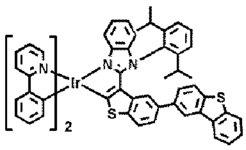
1075

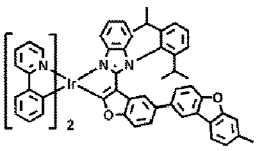
1076

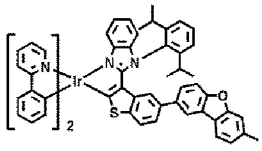
1077

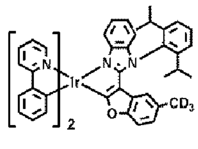
1078

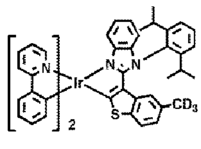
1079

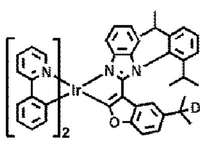
1080

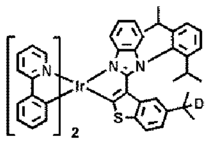
1081

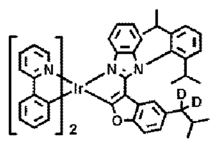
1082

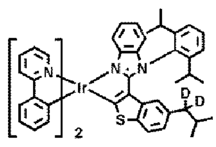
1083

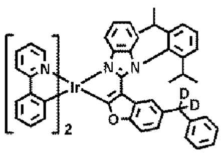
1084

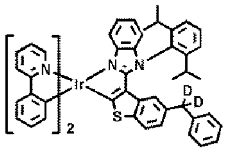
1085

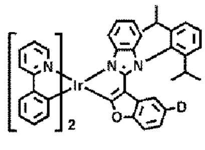
1086

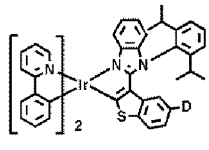
1087

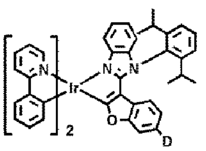
1088

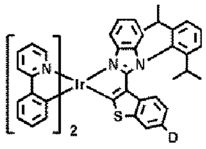
1089

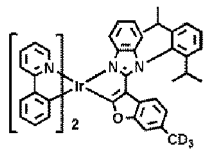
1090

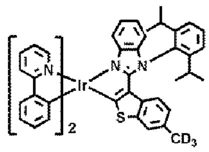
1091

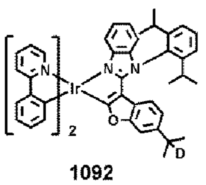
1092

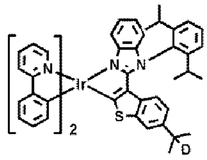
1093

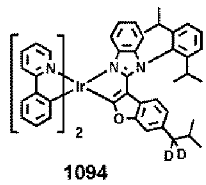
1094

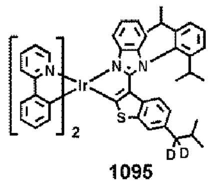
1095

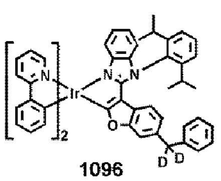
1096

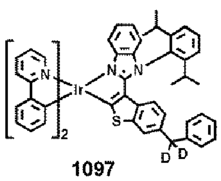
1097

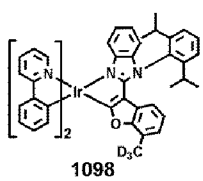
1098

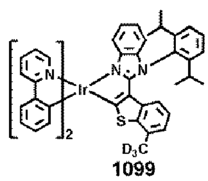
1099

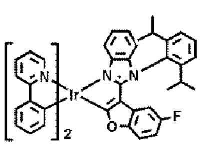
1100

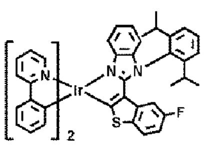
1101

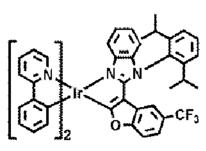
1102

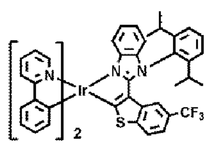
1103

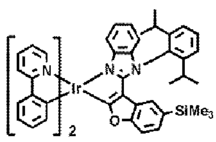
1104

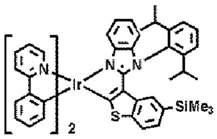
1105

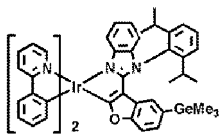
1106

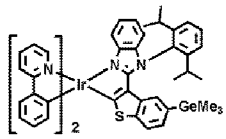
1107

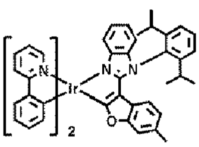
1108

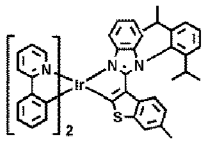
1109

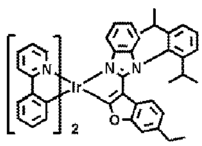
1110

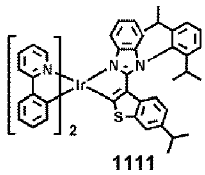
1111

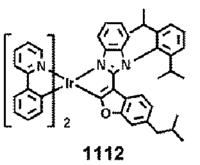
1112

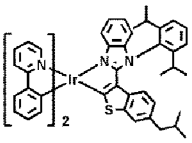
1113

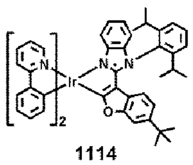
1114

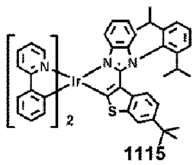
1115

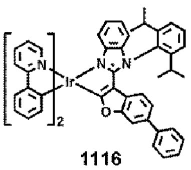
1116

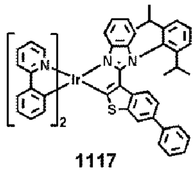
1117

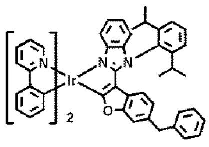
1118

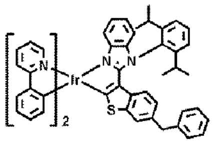
1119

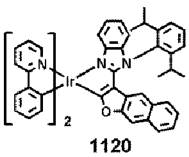
1120

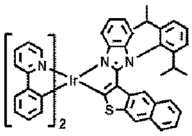
1121

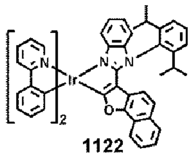
1122

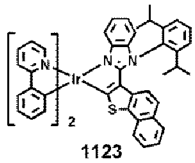
1123

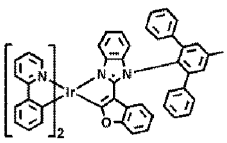
1124

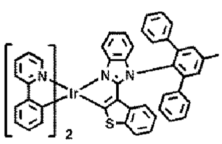
1125

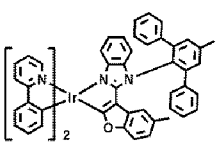
1126

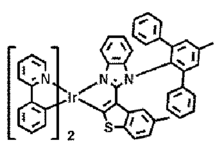
1127

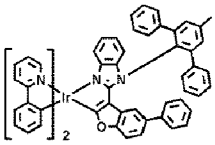
1128

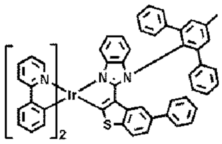
1129

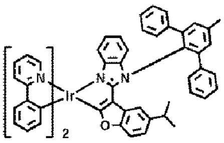
1130

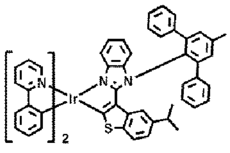
1131

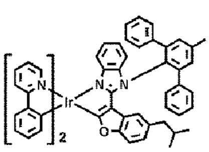
1132

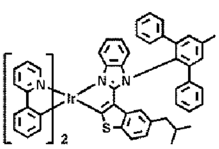
1133

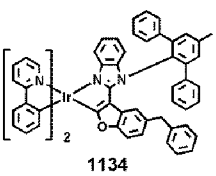
1134

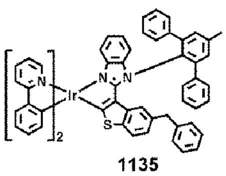
1135

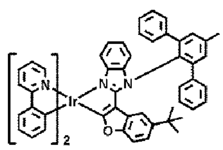
1136
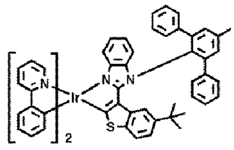
1137
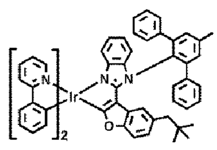
1138
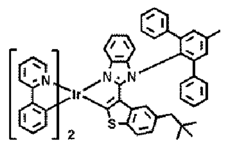
1139

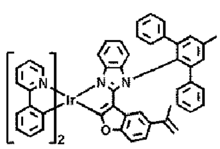
1140
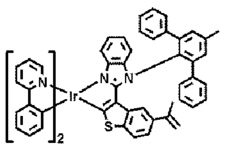
1141
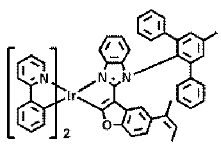
1142
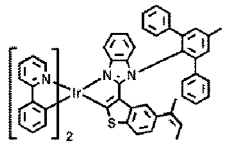
1143

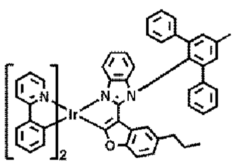
1144
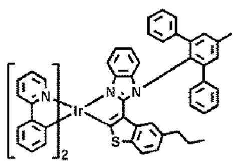
1145
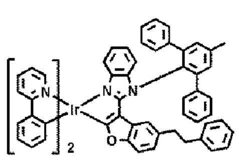
1146
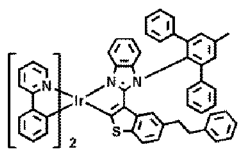
1147

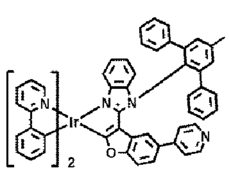
1148
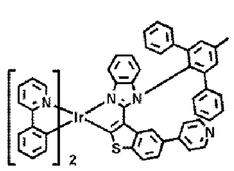
1149
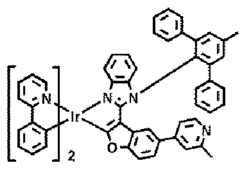
1150
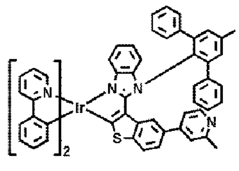
1151

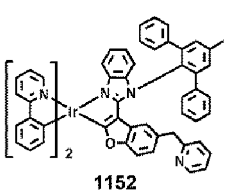
1152
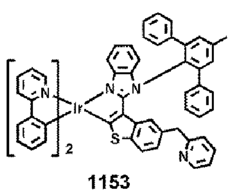
1153
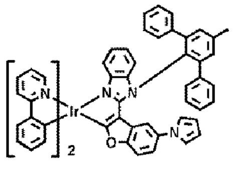
1154
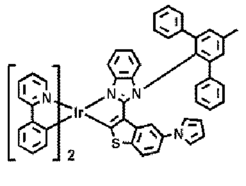
1155

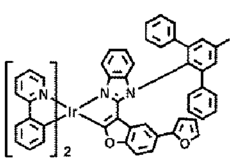
1156
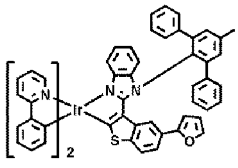
1157
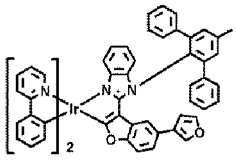
1158
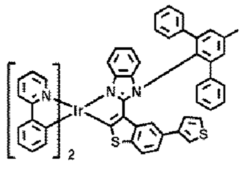
1159

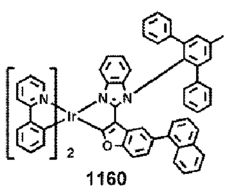
1160
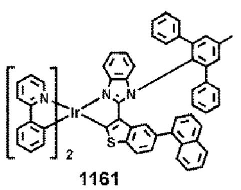
1161
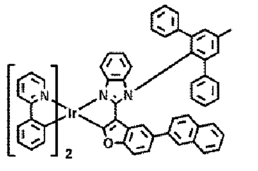
1162
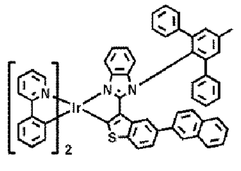
1163

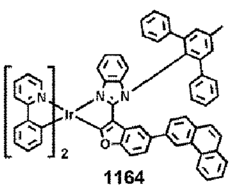
1164

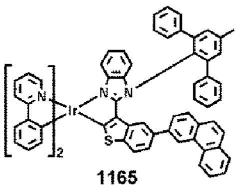
1165

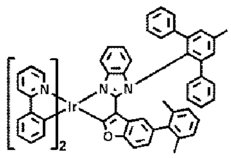
1166

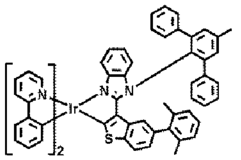
1167

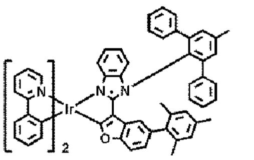
1168

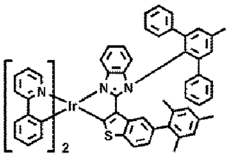
1169

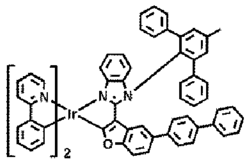
1170

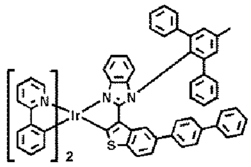
1171

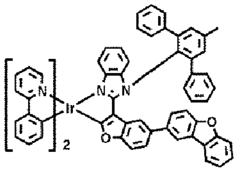
1172

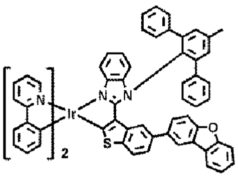
1173

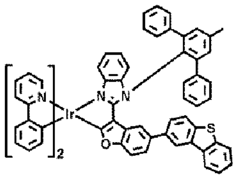
1174

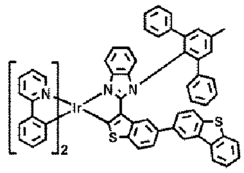
1175

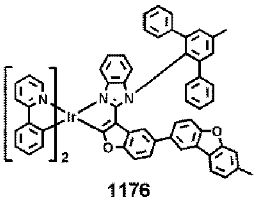
1176

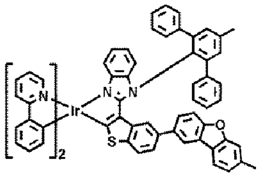
1177

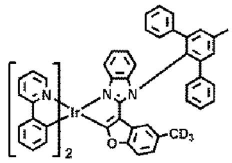
1178

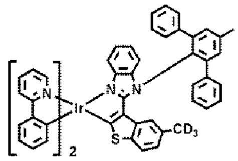
1179

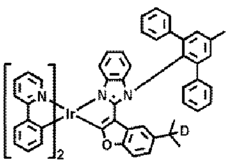
1180

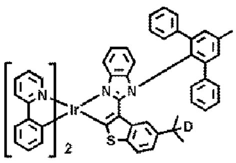
1181

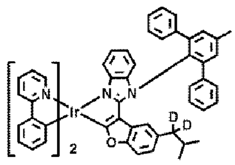
1182

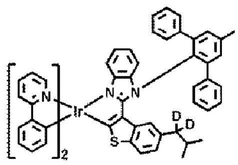
1183

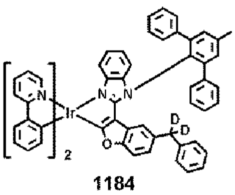
1184

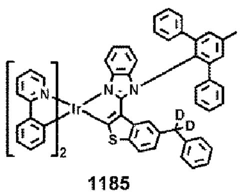
1185

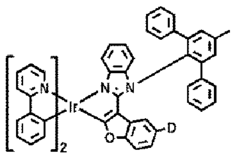
1186

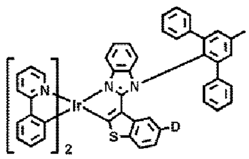
1187

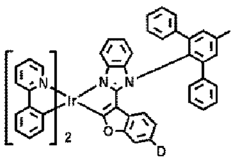
1188

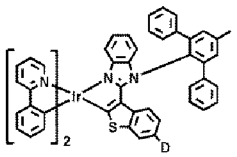
1189

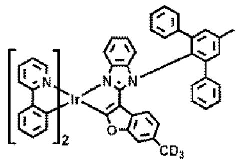
1190

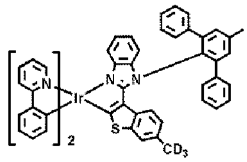
1191

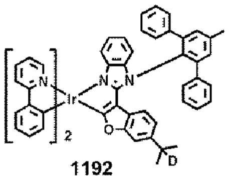
1192

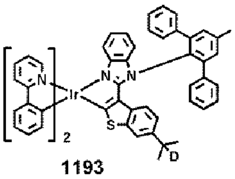
1193

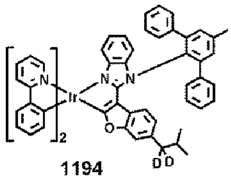
1194

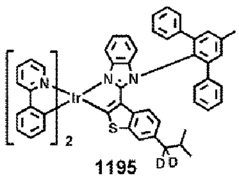
1195

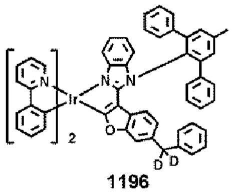
1196

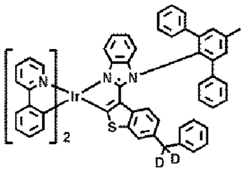
1197

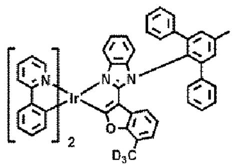
1198

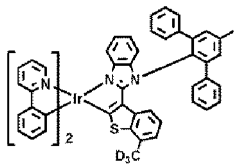
1199

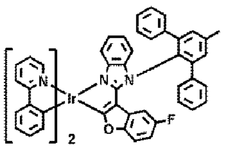
1200

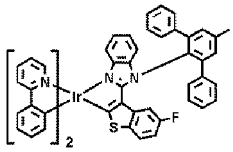
1201

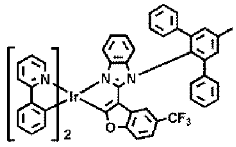
1202

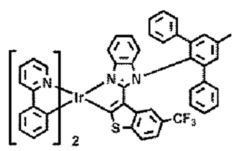
1203

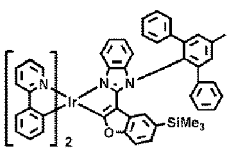
1204

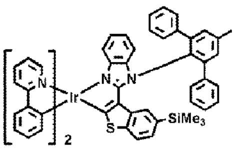
1205

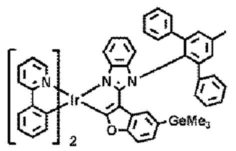
1206

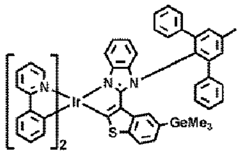
1207

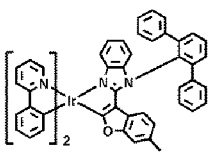
1208

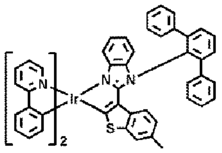
1209

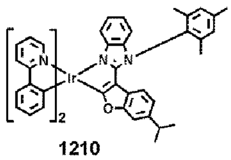
1210

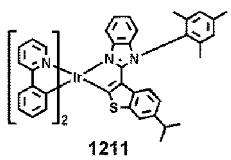
1211

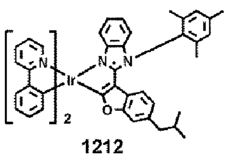
1212

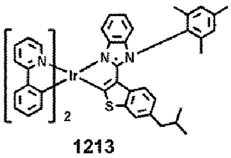
1213

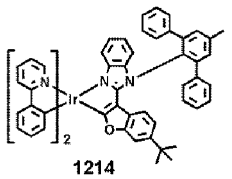
1214

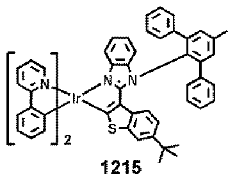
1215

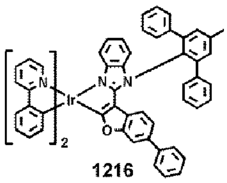
1216

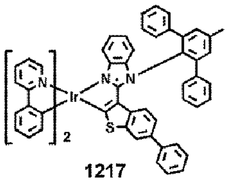
1217

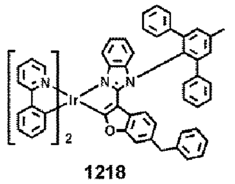
1218

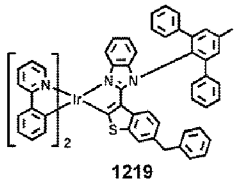
1219

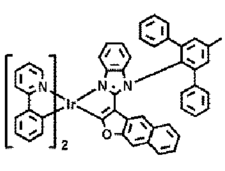
1220

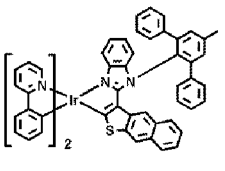
1221

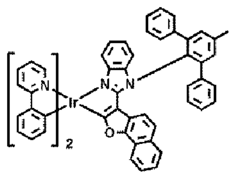
1222

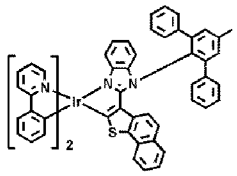
1223

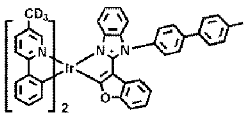
1224

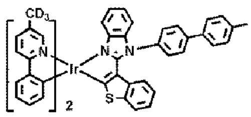
1225

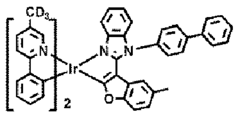
1226

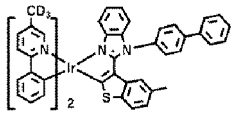
1227

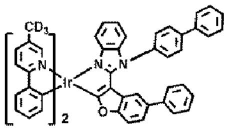
1228

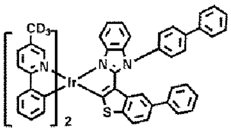
1229

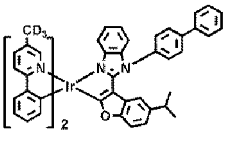
1230

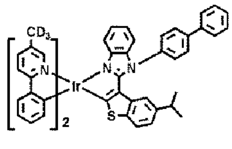
1231

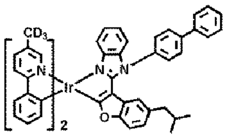
1232

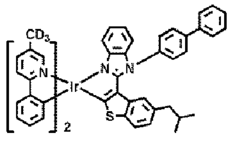
1233

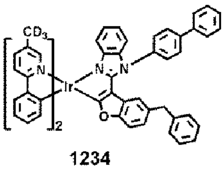
1234

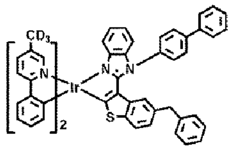
1235

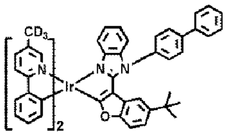
1236

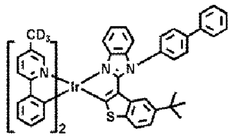
1237

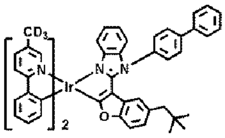
1238

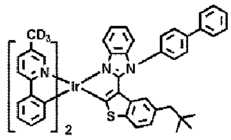
1239

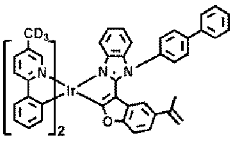
1240

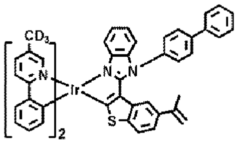
1241

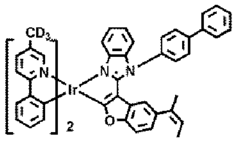
1242

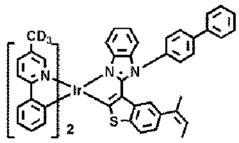
1243

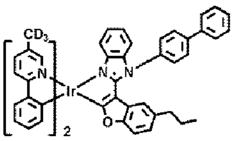
1244

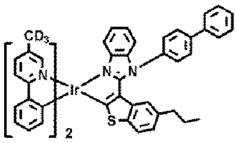
1245

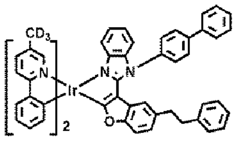
1246

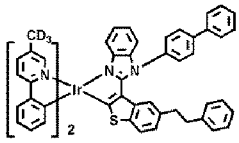
1247

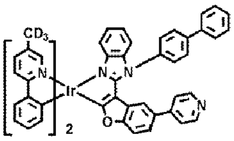
1248

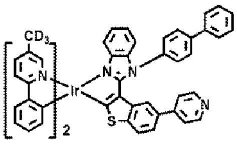
1249

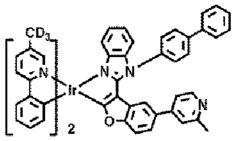
1250

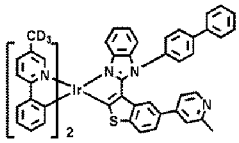
1251

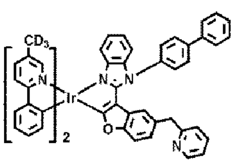
1252

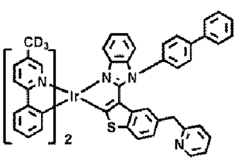
1253

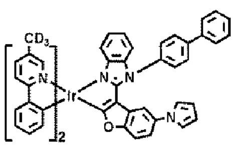
1254

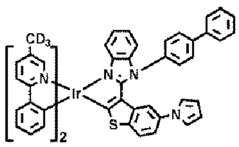
1255

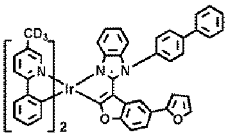
1256

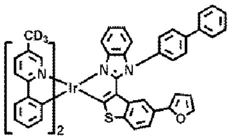
1257

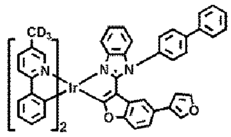
1258

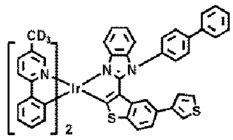
1259

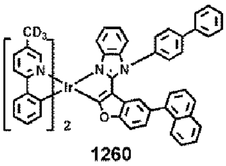
1260

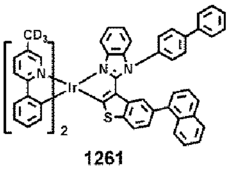
1261

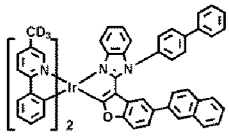
1262

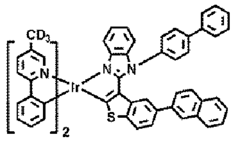
1263

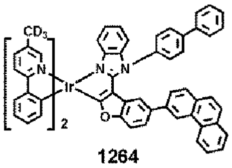
1264

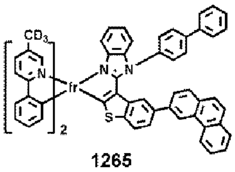
1265

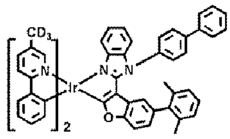
1266

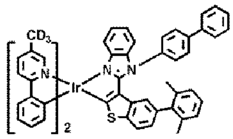
1267

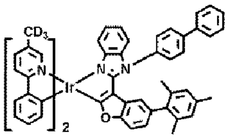
1268

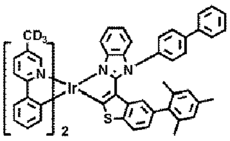
1269

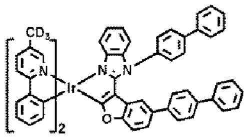
1270

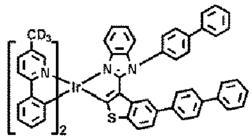
1271

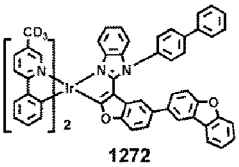
1272

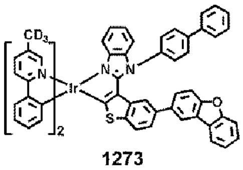
1273

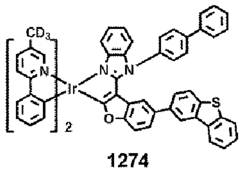
1274

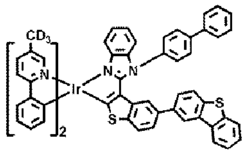
1275

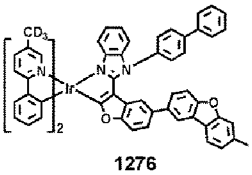
1276

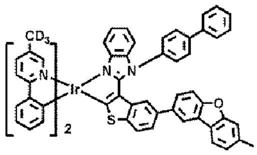
1277

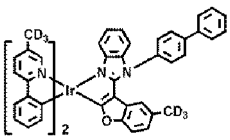
1278

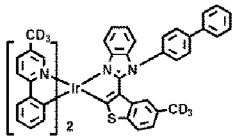
1279

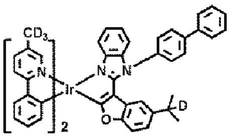
1280

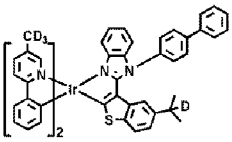
1281

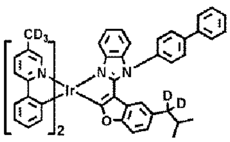
1282

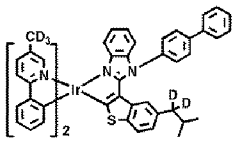
1283

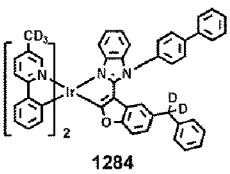
1284

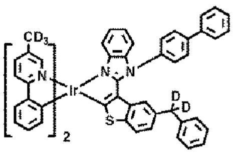
1285

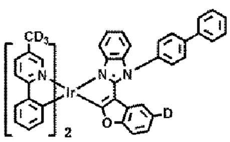
1286

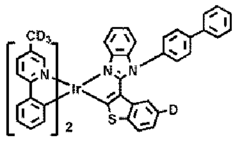
1287

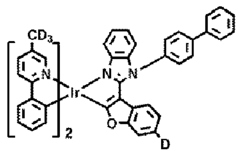
1288

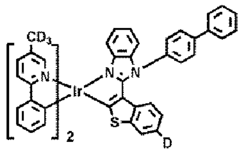
1289

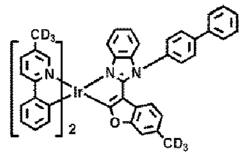
1290

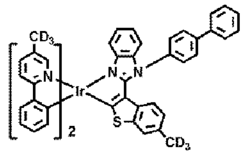
1291

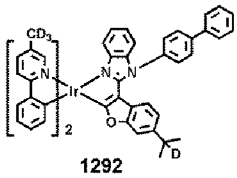
1292

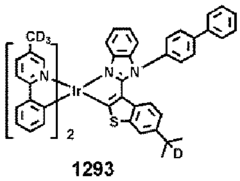
1293

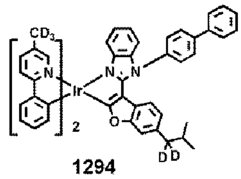
1294

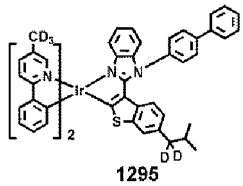
1295

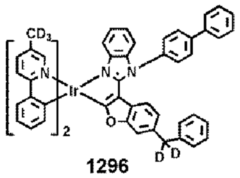
1296

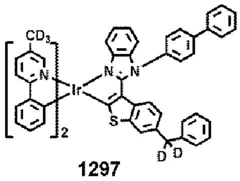
1297

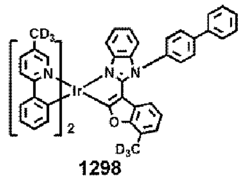
1298

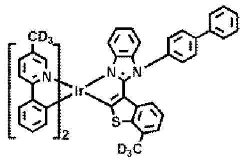
1299

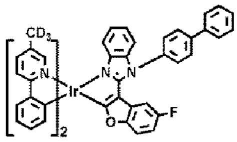
1300

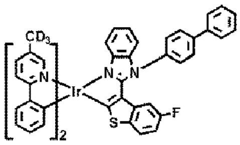
1301

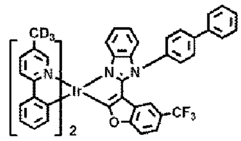
1302

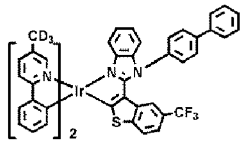
1303

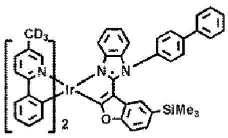
1304

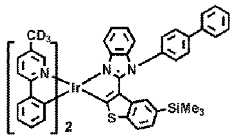
1305

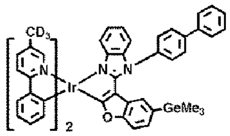
1306

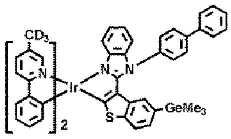
1307

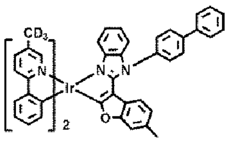
1308

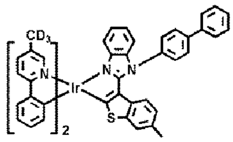
1309

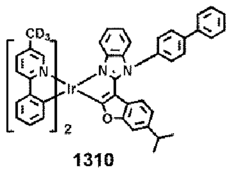
1310

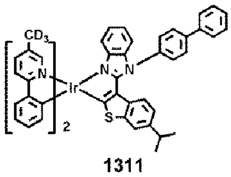
1311

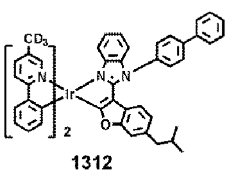
1312

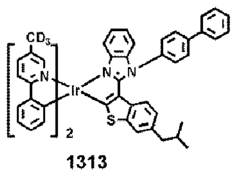
1313

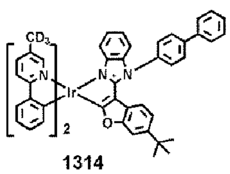
1314

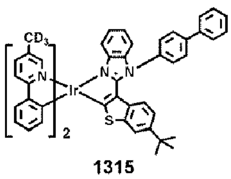
1315

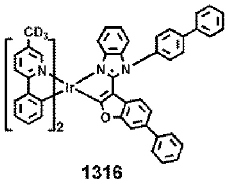
1316

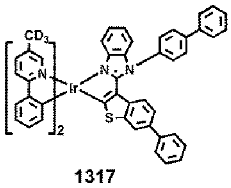
1317

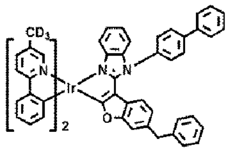
1318

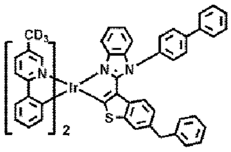
1319

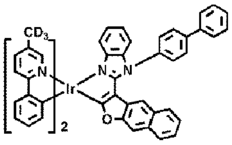
1320

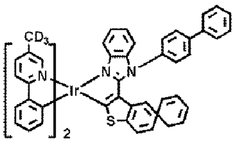
1321

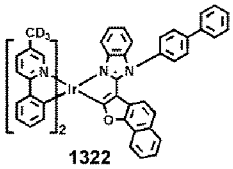
1322

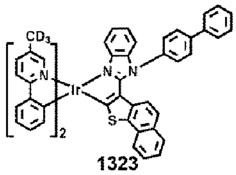
1323

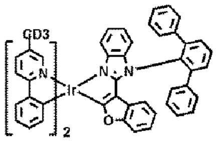
1324

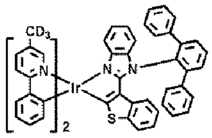
1325

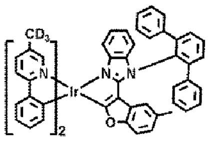
1326

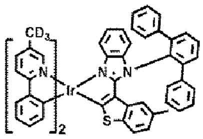
1327

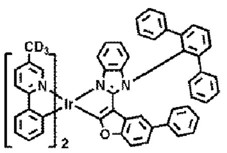
1328

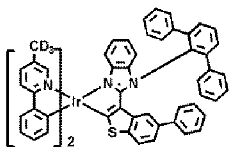
1329

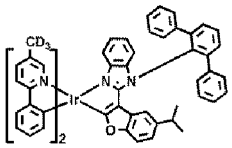
1330

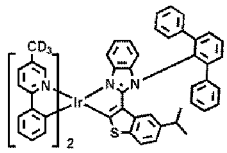
1331

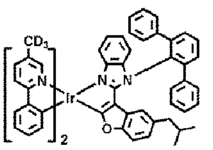
1332

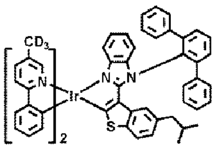
1333

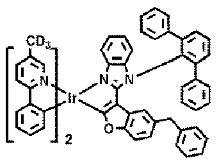
1334

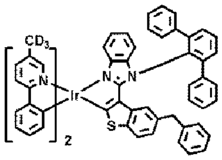
1335

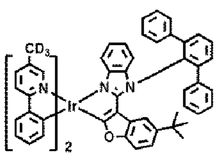
1336

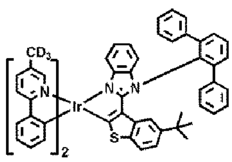
1337

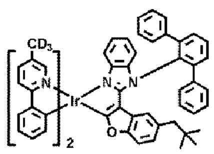
1338

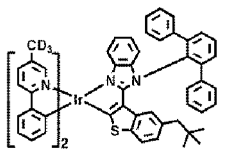
1339

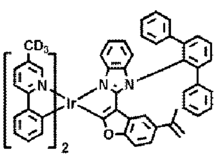
1340

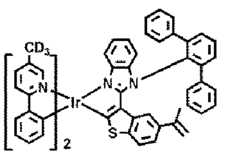
1341

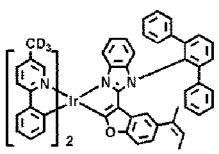
1342

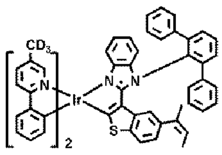
1343

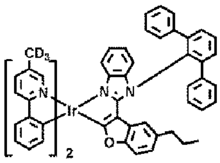
1344

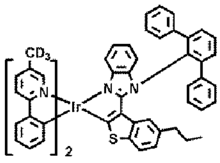
1345

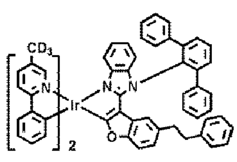
1346

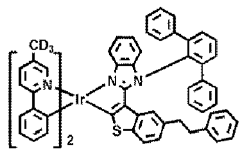
1347

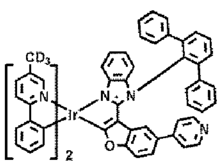
1348

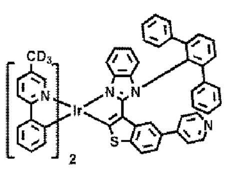
1349

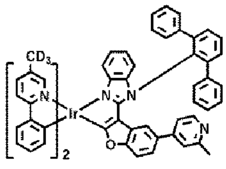
1350

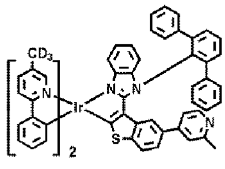
1351

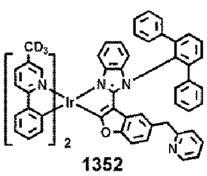
1352

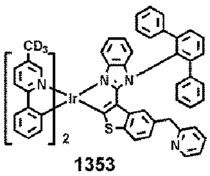
1353

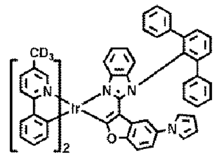
1354

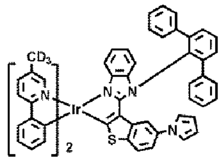
1355

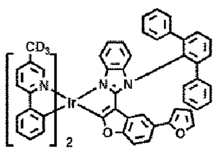
1356

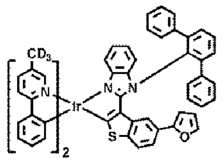
1357

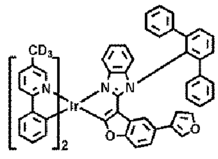
1358

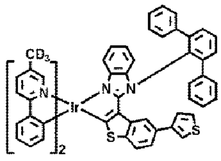
1359

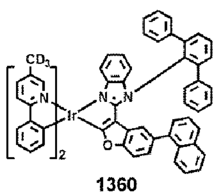
1360

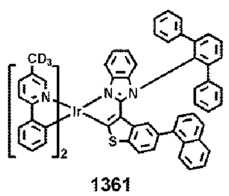
1361

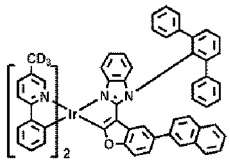
1362

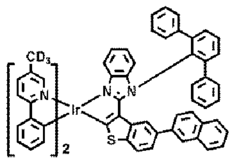
1363

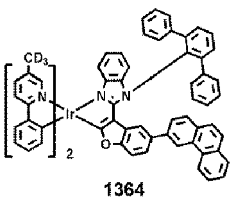
1364

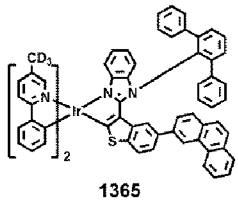
1365

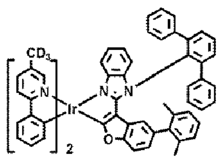
1366

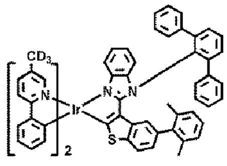
1367

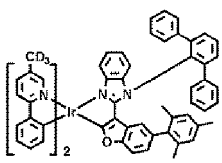
1368

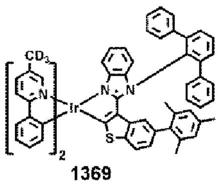
1369

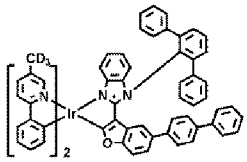
1370

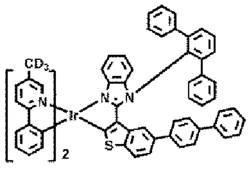
1371

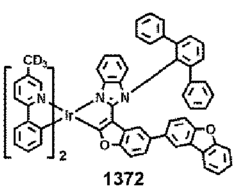
1372

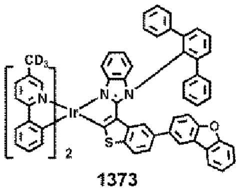
1373

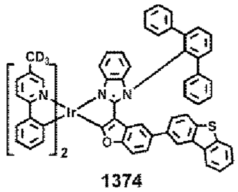
1374

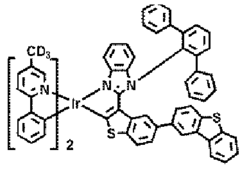
1375

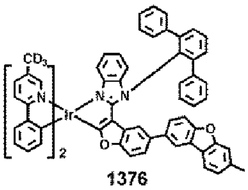
1376

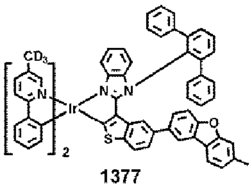
1377

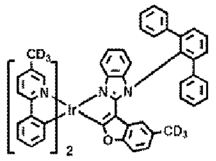
1378

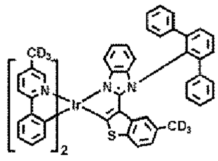
1379

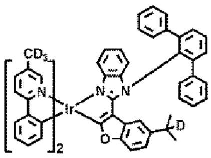
1380

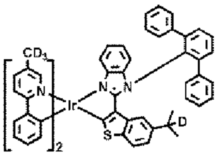
1381

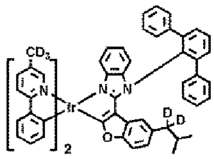
1382

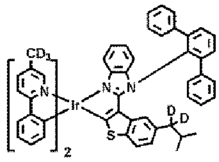
1383

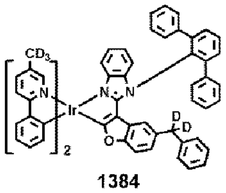
1384

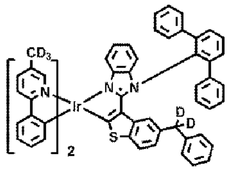
1385

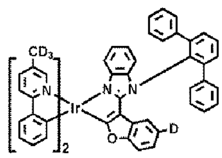
1386

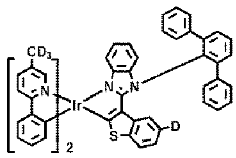
1387

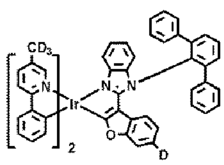
1388

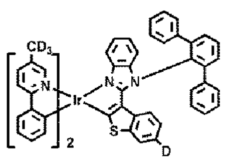
1389

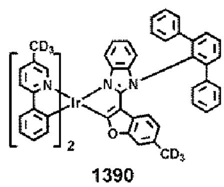
1390

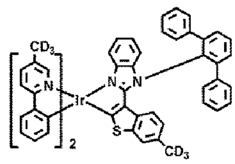
1391

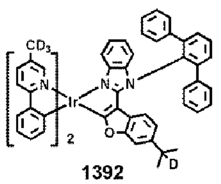
1392

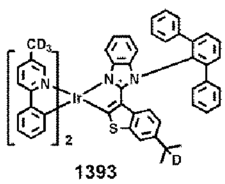
1393

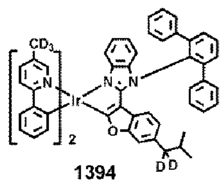
1394

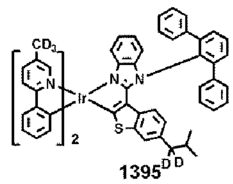
1395

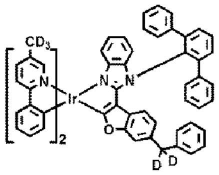
1396

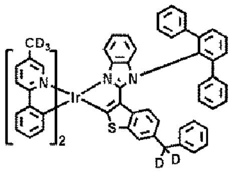
1397

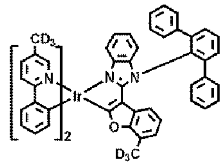
1398

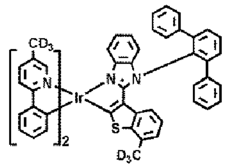
1399

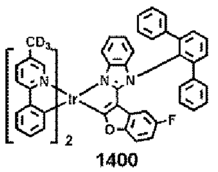
1400

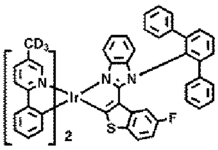
1401

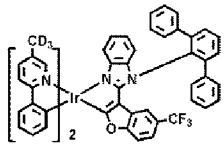
1402

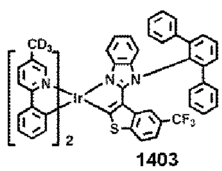
1403

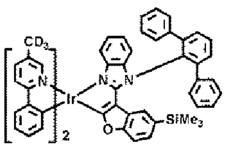
1404

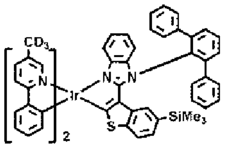
1405

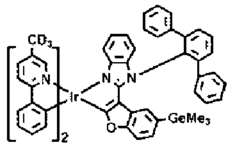
1406

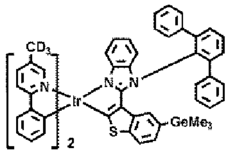
1407

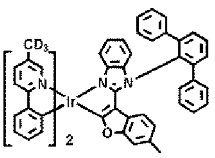
1408

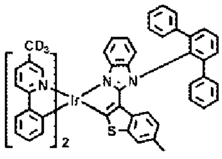
1409

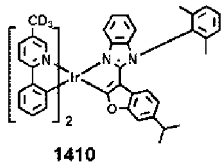
1410

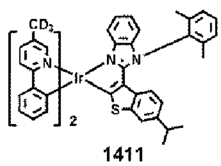
1411

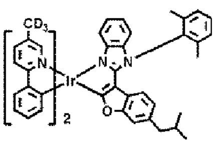
1412

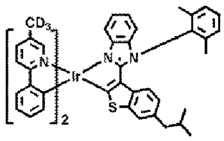
1413

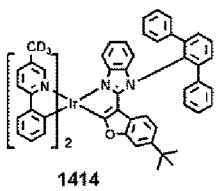
1414

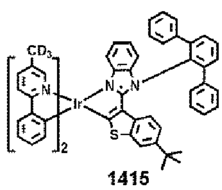
1415

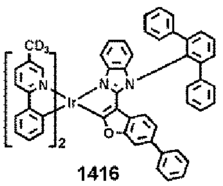
1416

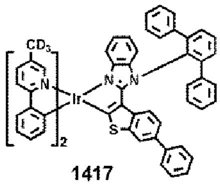
1417

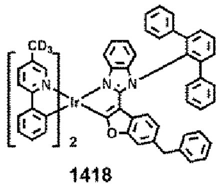
1418

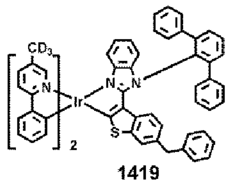
1419

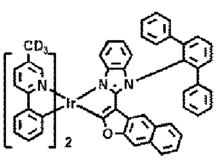
1420

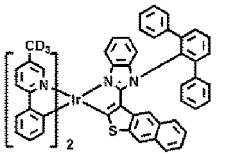
1421

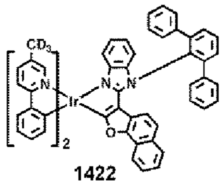
1422

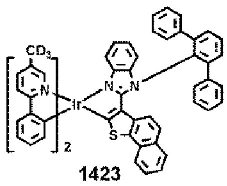
1423

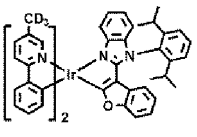
1424

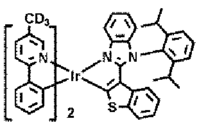
1425

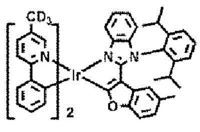
1426

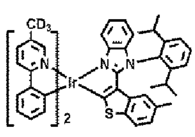
1427

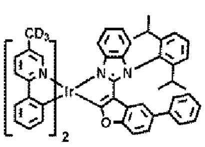
1428

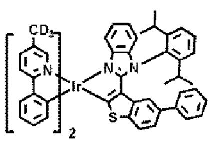
1429

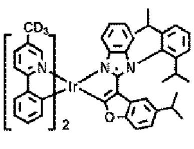
1430

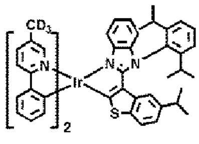
1431

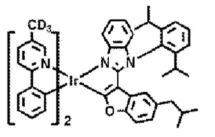
1432

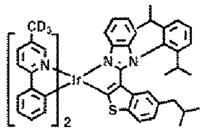
1433

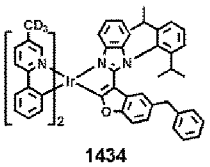
1434

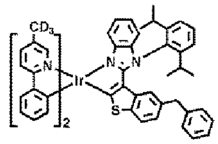
1435

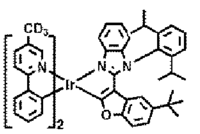
1436

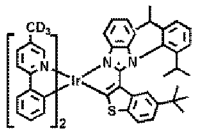
1437

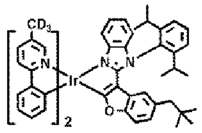
1438

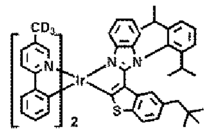
1439

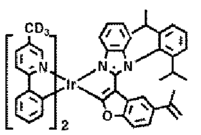
1440

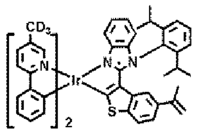
1441

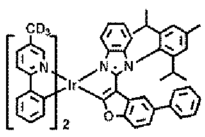
1442

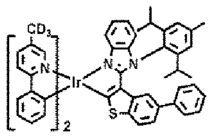
1443

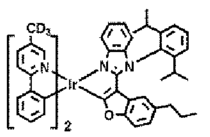
1444

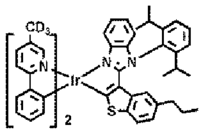
1445

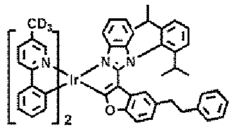
1446

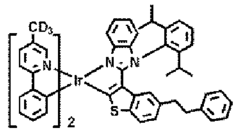
1447

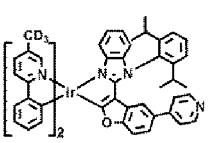
1448

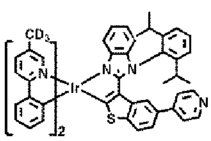
1449

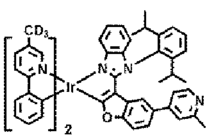
1450

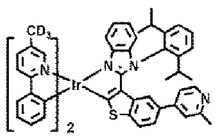
1451

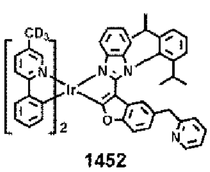
1452

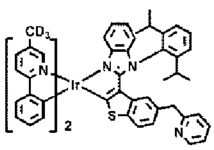
1453

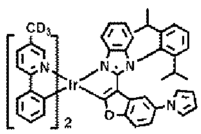
1454

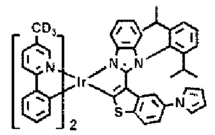
1455

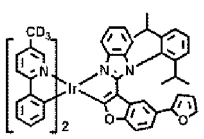
1456

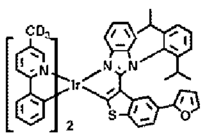
1457

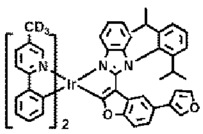
1458

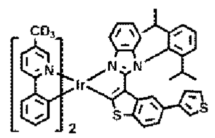
1459

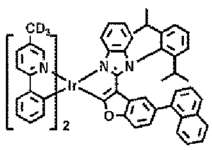
1460

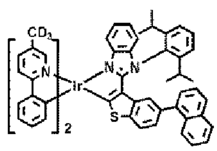
1461

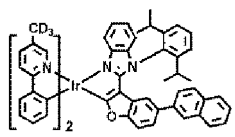
1462

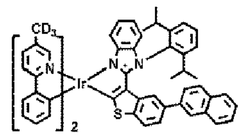
1463

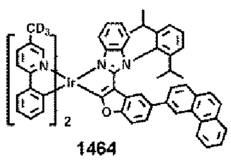
1464

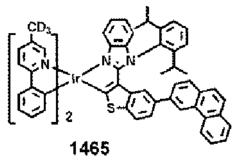
1465

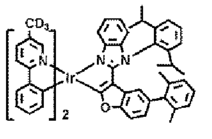
1466

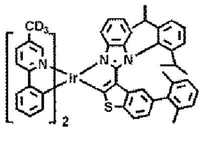
1467

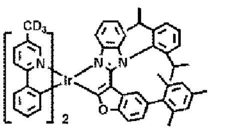
1468

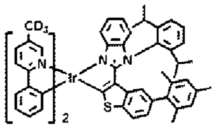
1469

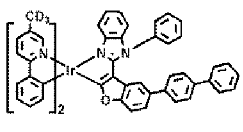
1470

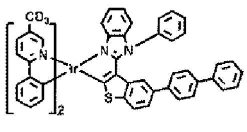
1471

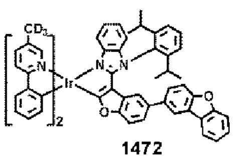
1472

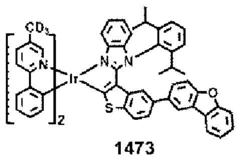
1473

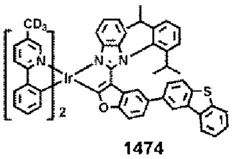
1474

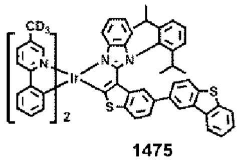
1475

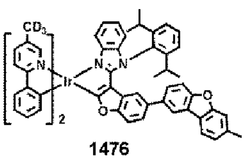
1476

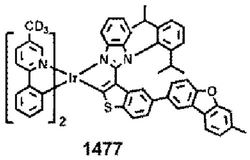
1477

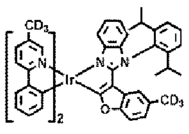
1478

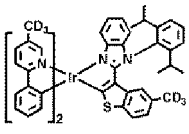
1479

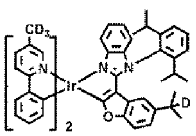
1480

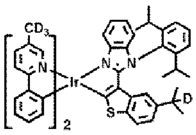
1481

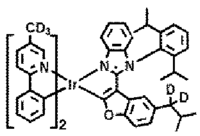
1482

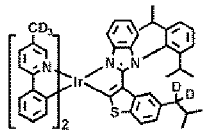
1483

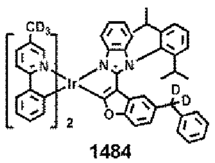
1484

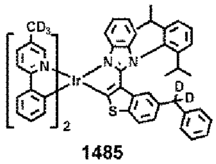
1485

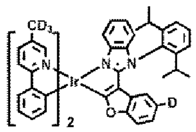
1486

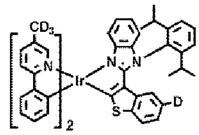
1487

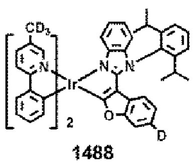
1488

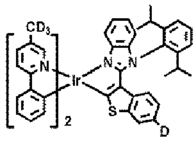
1489

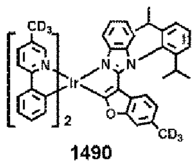
1490

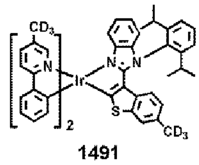
1491

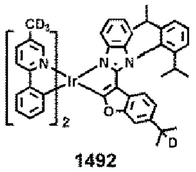
1492

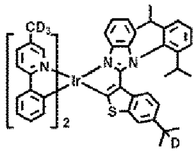
1493

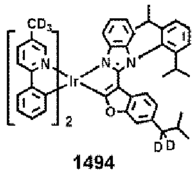
1494

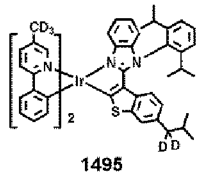
1495

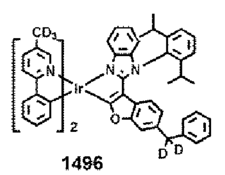
1496

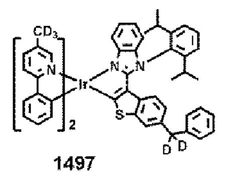
1497

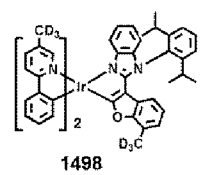
1498

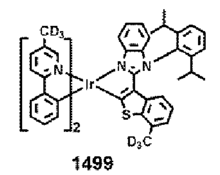
1499

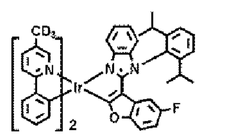
1500

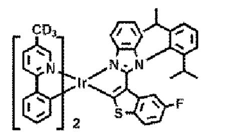
1501

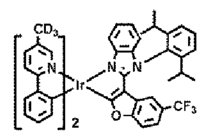
1502

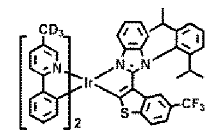
1503

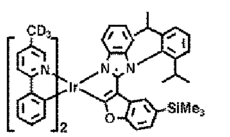
1504

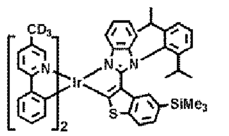
1505

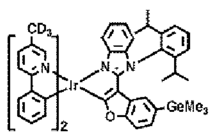
1506

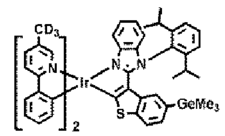
1507

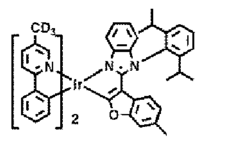
1508

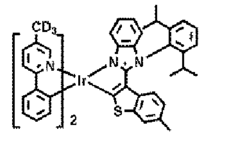
1509

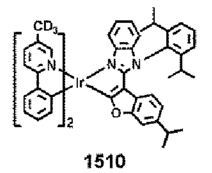
1510

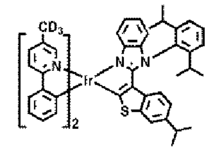
1511

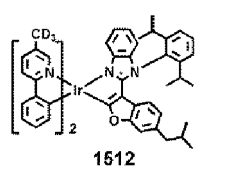
1512

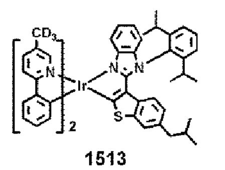
1513

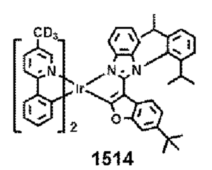
1514

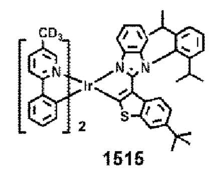
1515

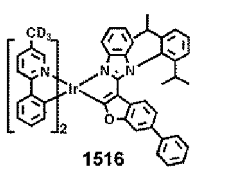
1516

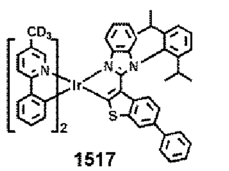
1517

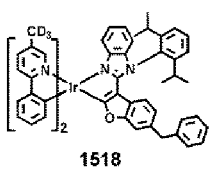
1518

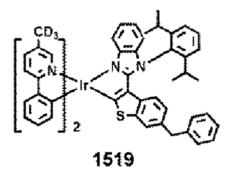
1519

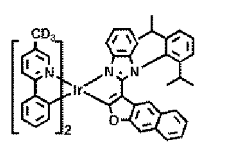
1520

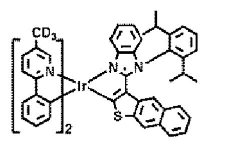
1521

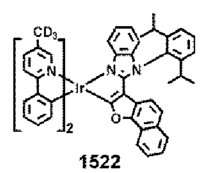
1522

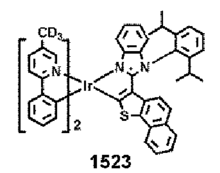
1523

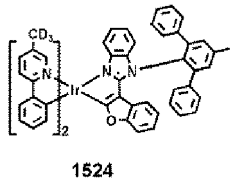
1524

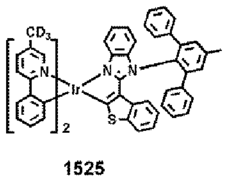
1525

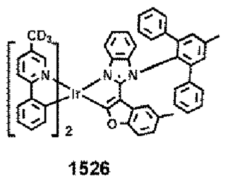
1526

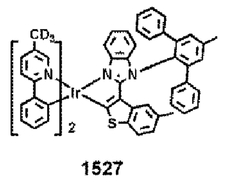
1527

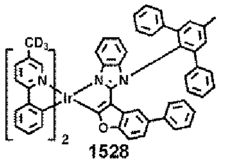
1528

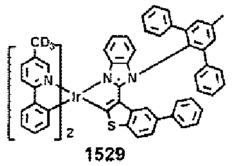
1529

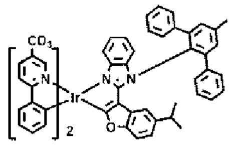
1530

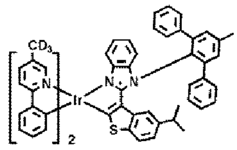
1531

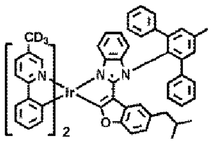
1532

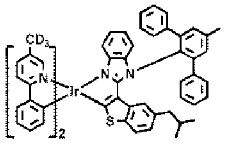
1533

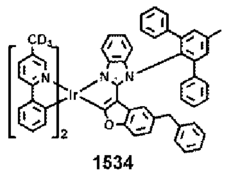
1534

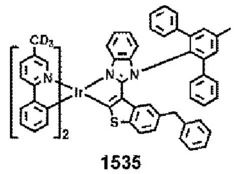
1535

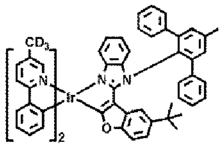
1536

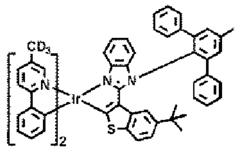
1537

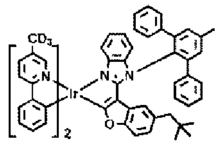
1538

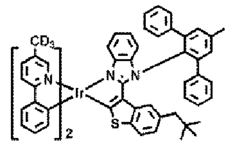
1539

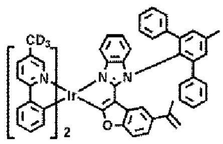
1540

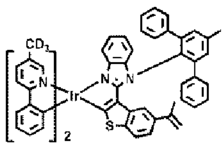
1541

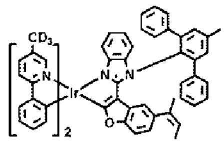
1542

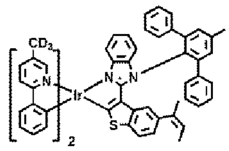
1543

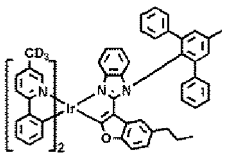
1544

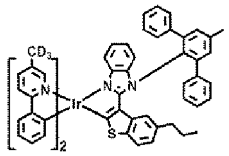
1545

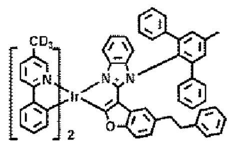
1546

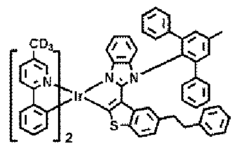
1547

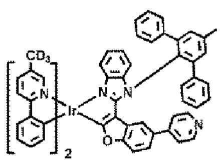
1548

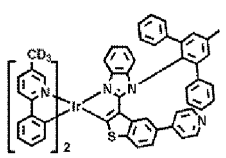
1549

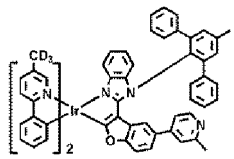
1550

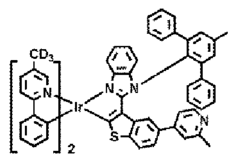
1551

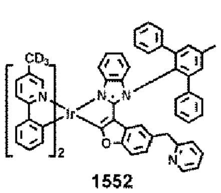
1552

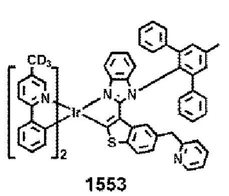
1553

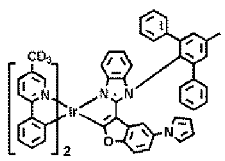
1554

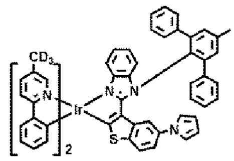
1555

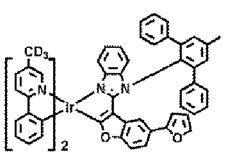
1556

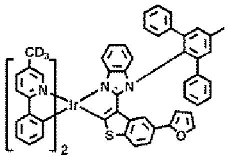
1557

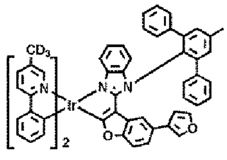
1558

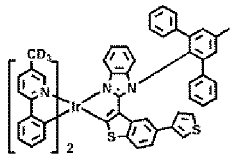
1559

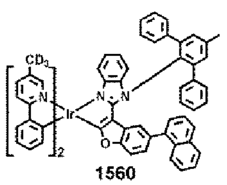
1560

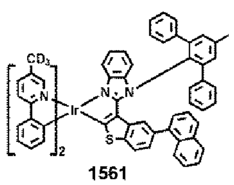
1561

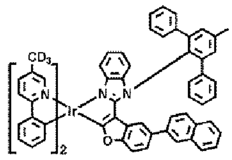
1562

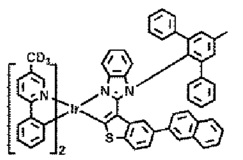
1563

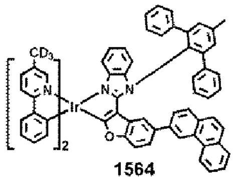
1564

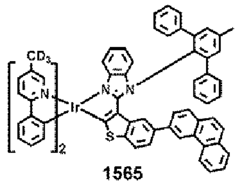
1565

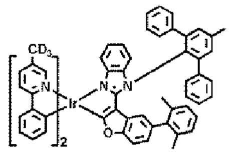
1566

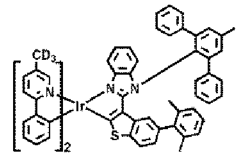
1567

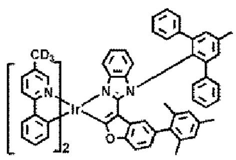
1568

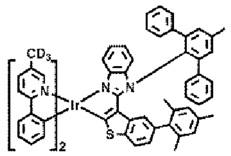
1569

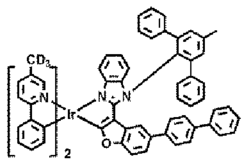
1570

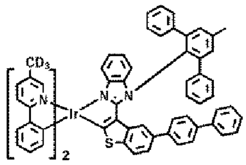
1571

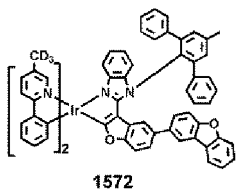
1572

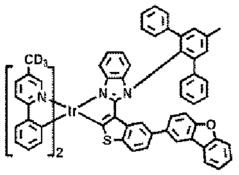
1573

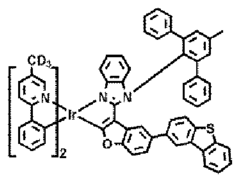
1574

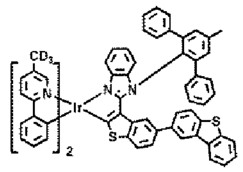
1575

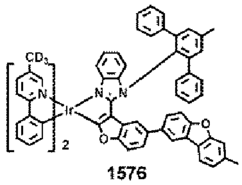
1576

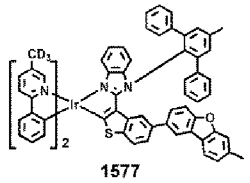
1577

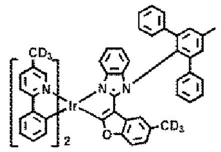
1578

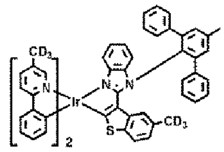
1579

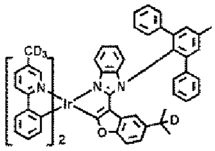
1580

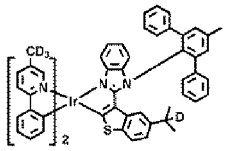
1581

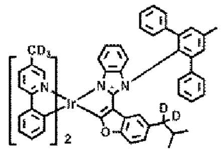
1582

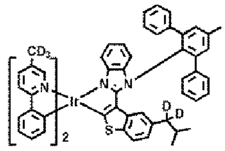
1583

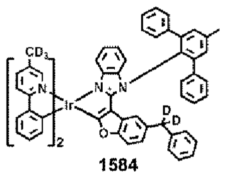
1584

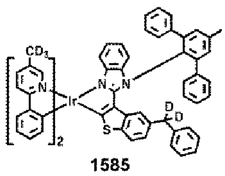
1585

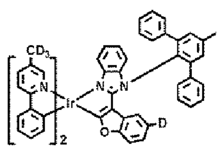
1586

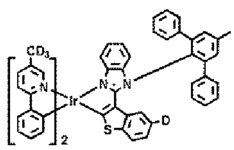
1587

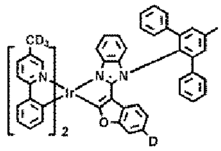
1588

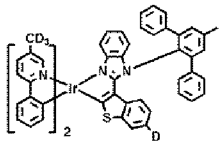
1589

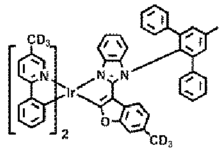
1590

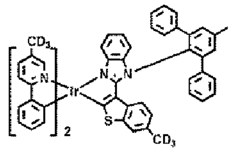
1591

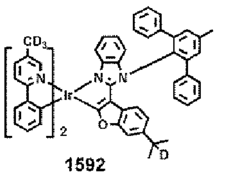
1592

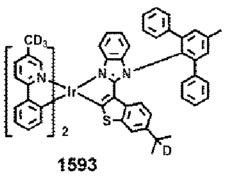
1593

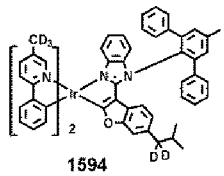
1594

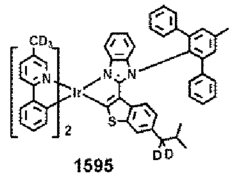
1595

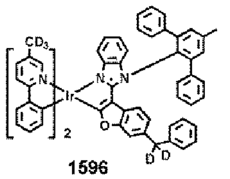
1596

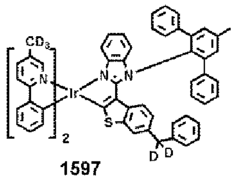
1597

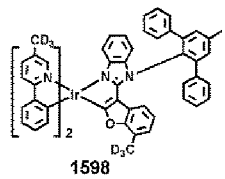
1598

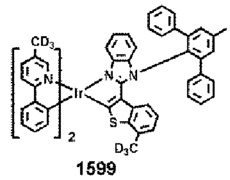
1599

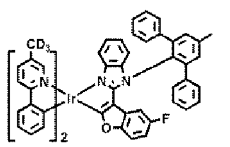
1600

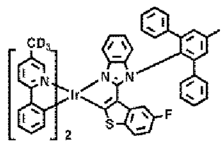
1601

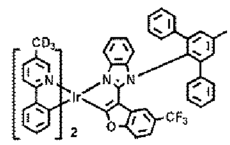
1602

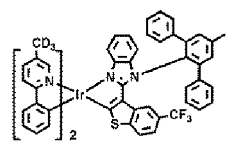
1603

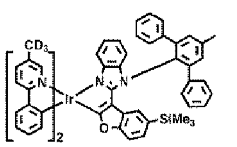
1604

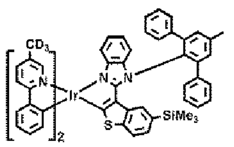
1605

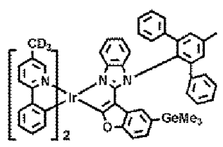
1606

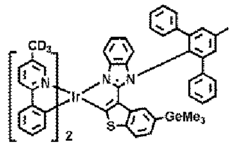
1607

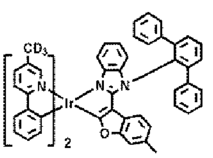
1608

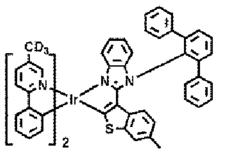
1609

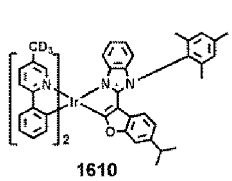
1610

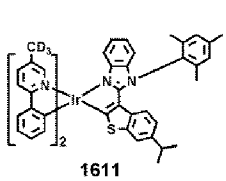
1611

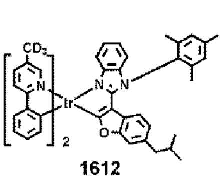
1612

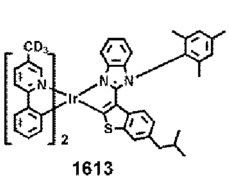
1613

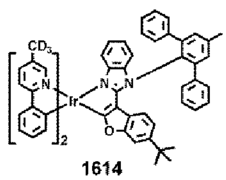
1614

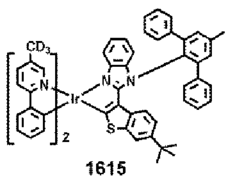
1615

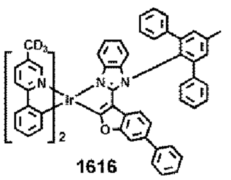
1616
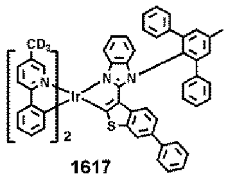
1617
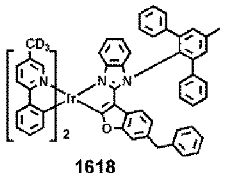
1618
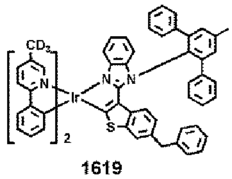
1619

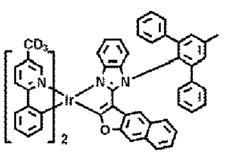
1620
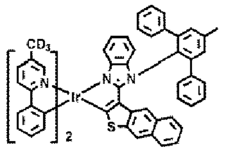
1621
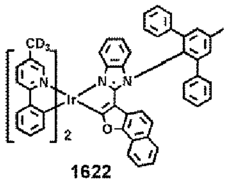
1622
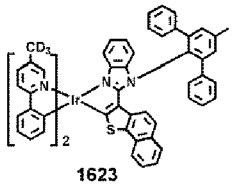
1623

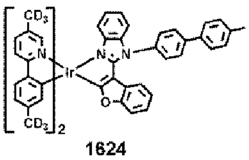
1624
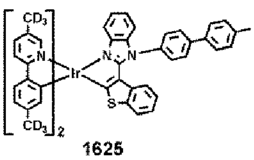
1625
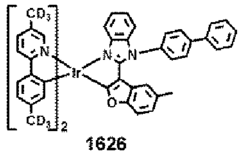
1626
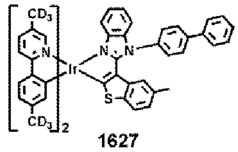
1627

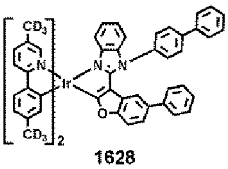
1628
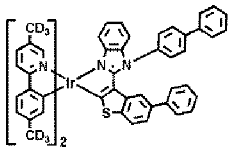
1629
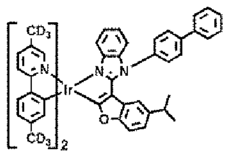
1630
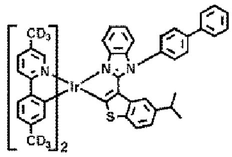
1631

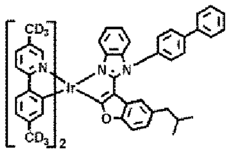
1632
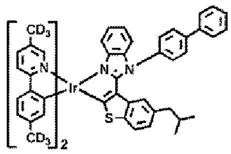
1633
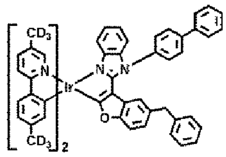
1634
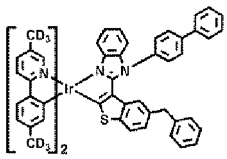
1635

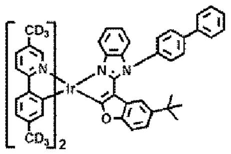
1636
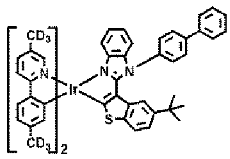
1637
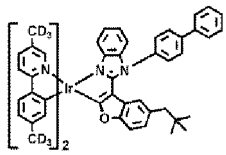
1638
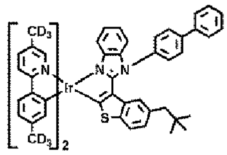
1639

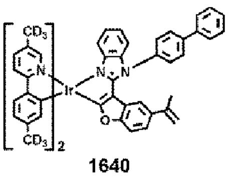
1640
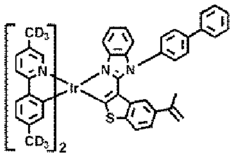
1641
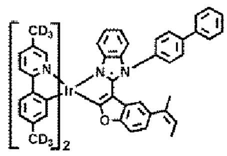
1642
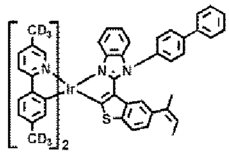
1643

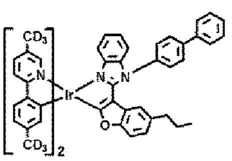
1644
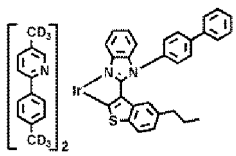
1645
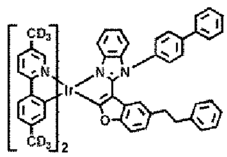
1646
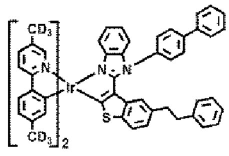
1647

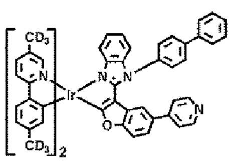 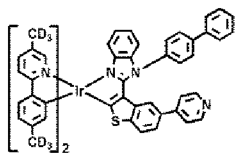 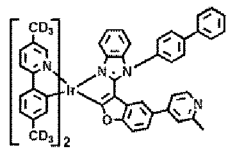 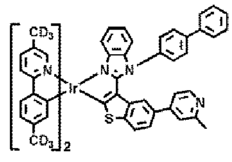

1648 1649 1650 1651

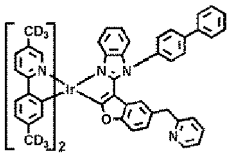 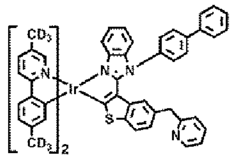 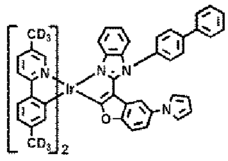 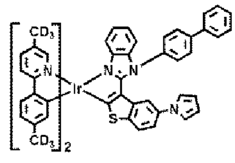

1652 1653 1654 1655

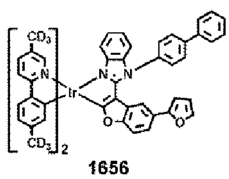 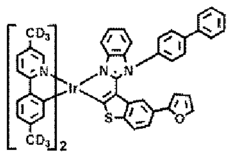 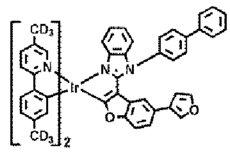 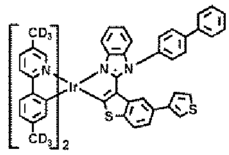

1656 1657 1658 1659

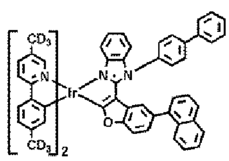 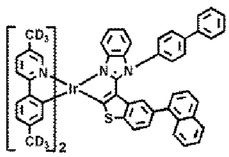 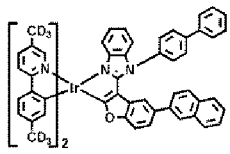 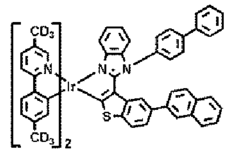

1660 1661 1662 1663

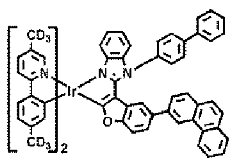 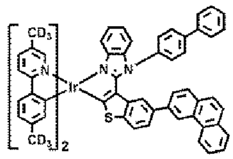 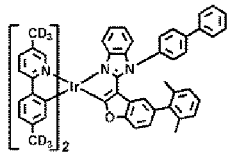 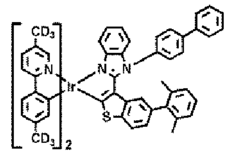

1664 1665 1666 1667

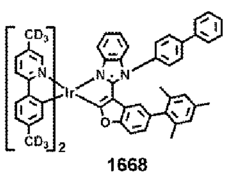 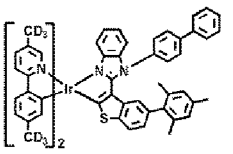 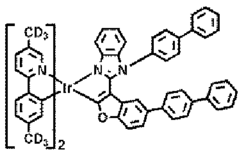 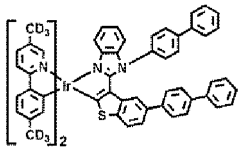

1668 1669 1670 1671

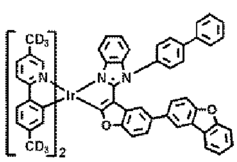 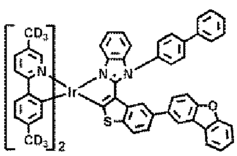 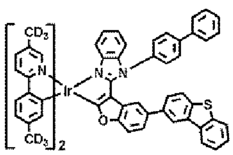 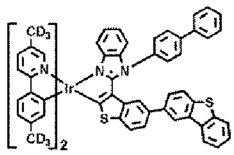

1672 1673 1674 1675

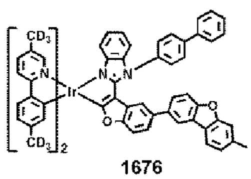 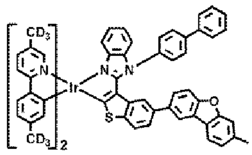 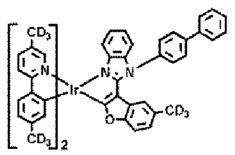 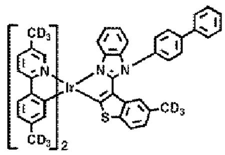

1676 1677 1678 1679

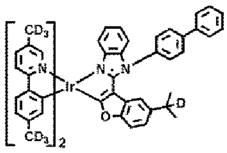
1680

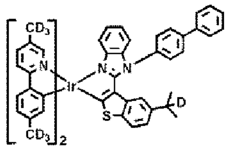
1681

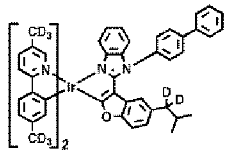
1682

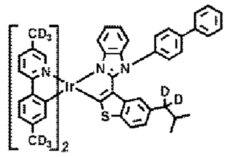
1683

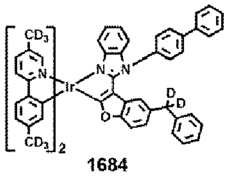
1684

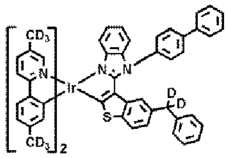
1685

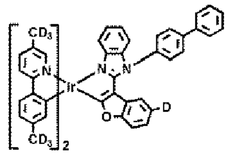
1686

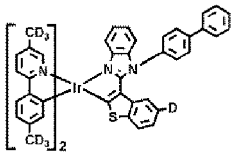
1687

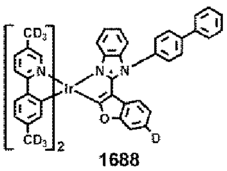
1688

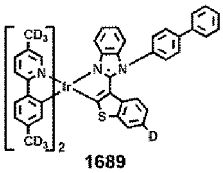
1689

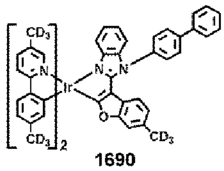
1690

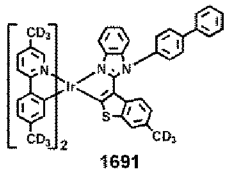
1691

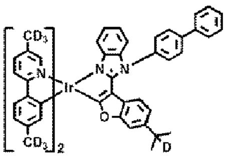
1692

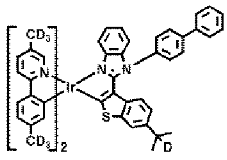
1693

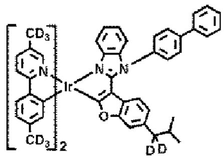
1694

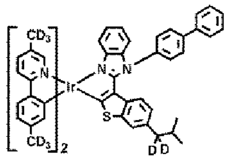
1695

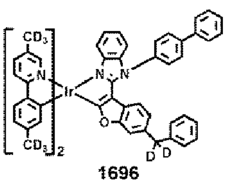
1696

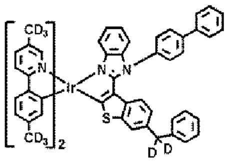
1697

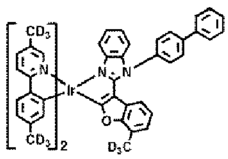
1698

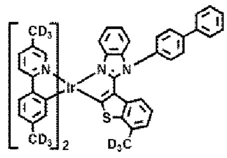
1699

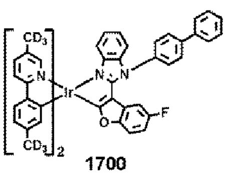
1700

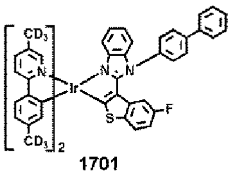
1701

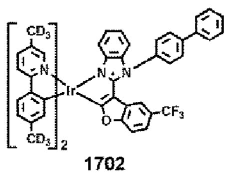
1702

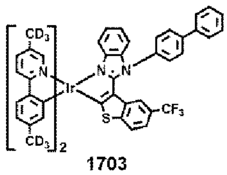
1703

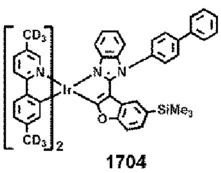
1704

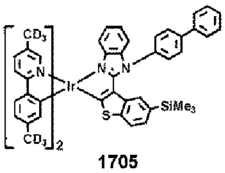
1705

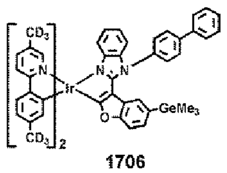
1706

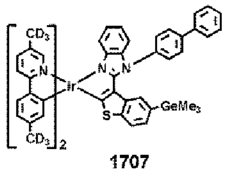
1707

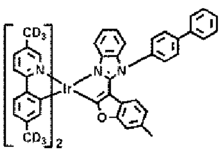
1708

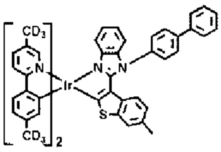
1709

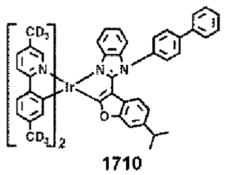
1710

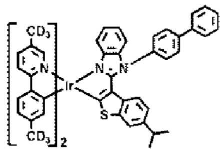
1711

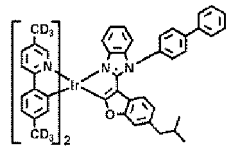
1712

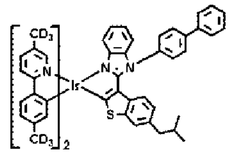
1713

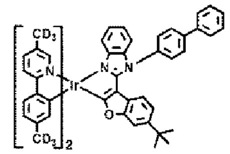
1714

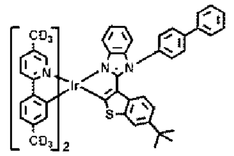
1715

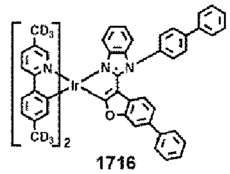
1716

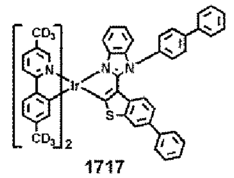
1717

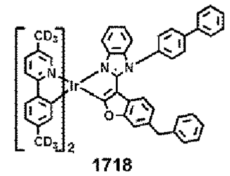
1718

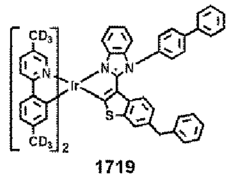
1719

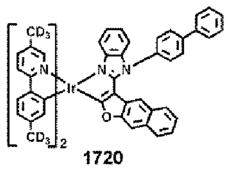
1720

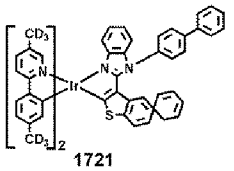
1721

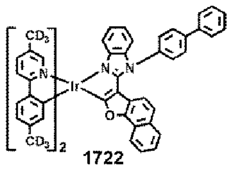
1722

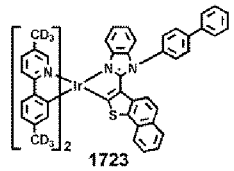
1723

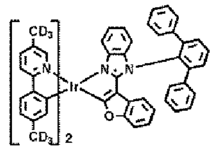
1724

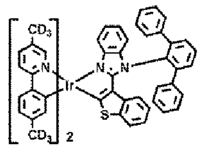
1725

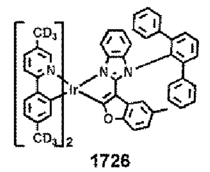
1726

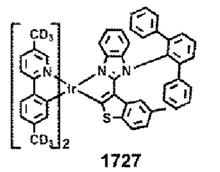
1727

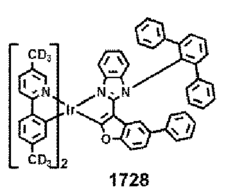
1728

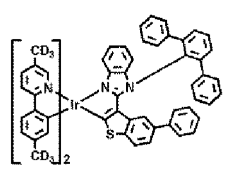
1729

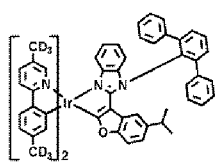
1730

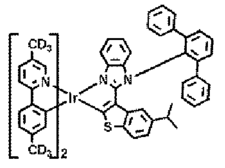
1731

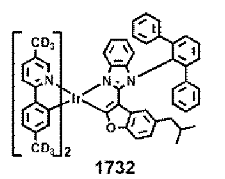
1732

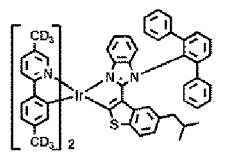
1733

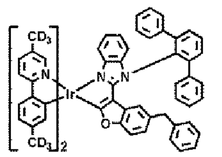
1734

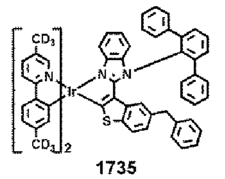
1735

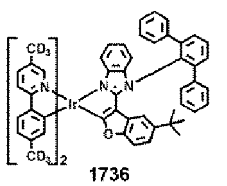
1736

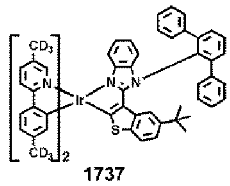
1737

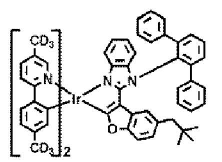
1738

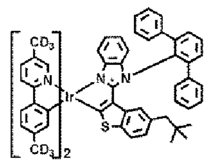
1739

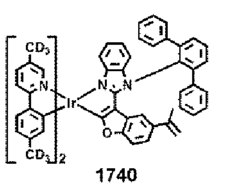
1740

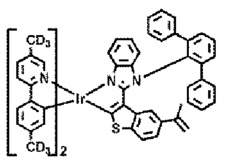
1741

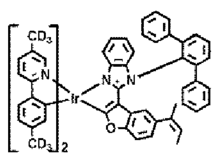
1742

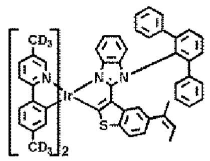
1743

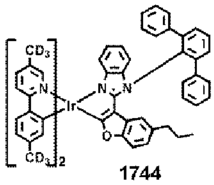
1744

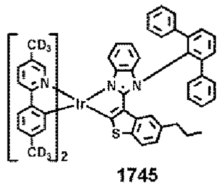
1745

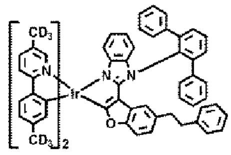
1746

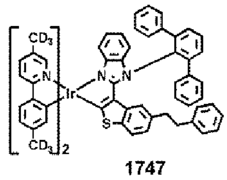
1747

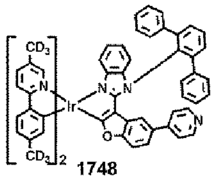
1748

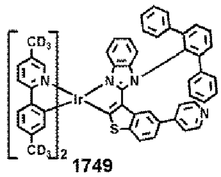
1749

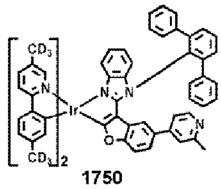
1750

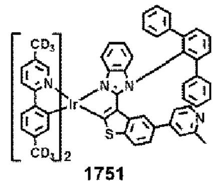
1751

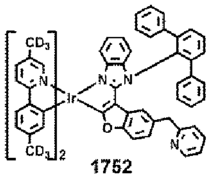
1752

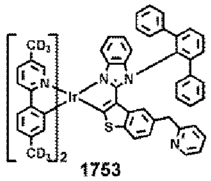
1753

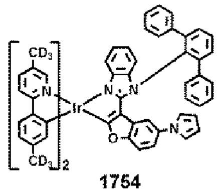
1754

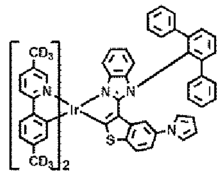
1755

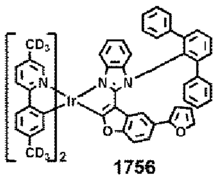
1756

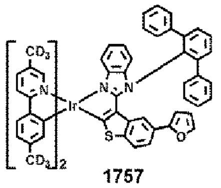
1757

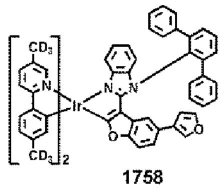
1758

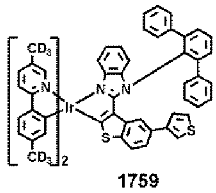
1759

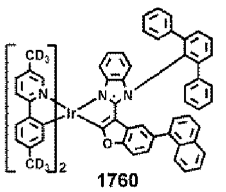
1760

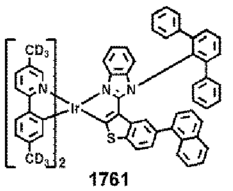
1761

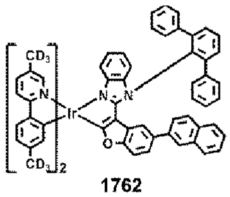
1762

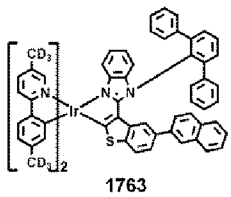
1763

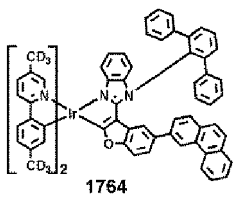
1764

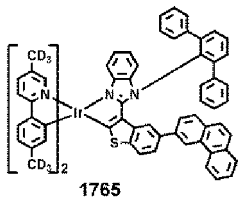
1765

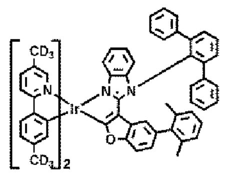
1766

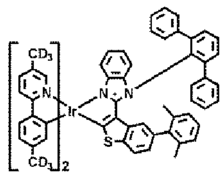
1767

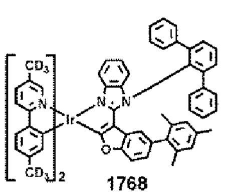
1768

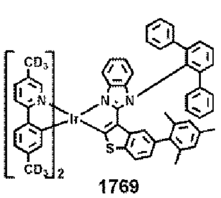
1769

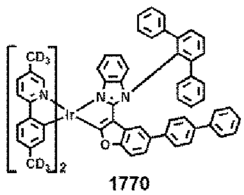
1770

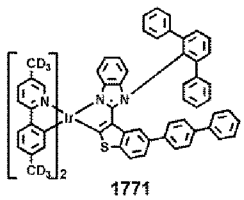
1771

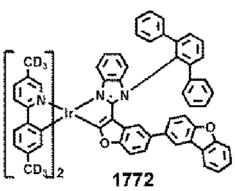
1772

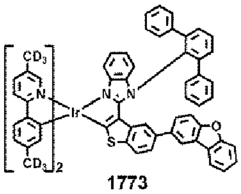
1773

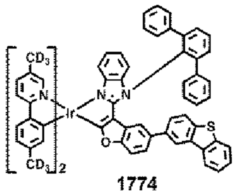
1774

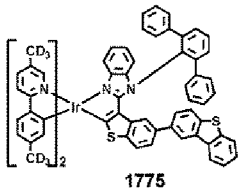
1775

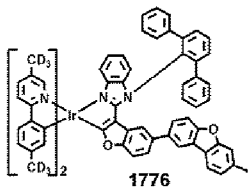
1776

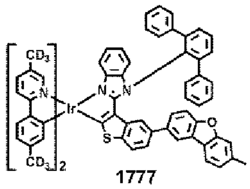
1777

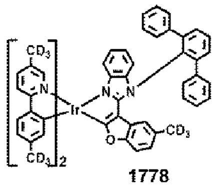
1778

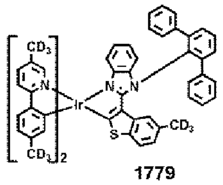
1779

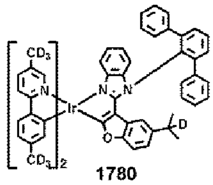
1780

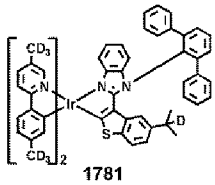
1781

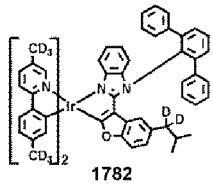
1782

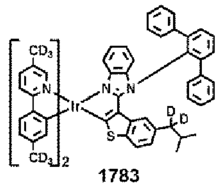
1783

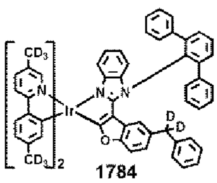
1784

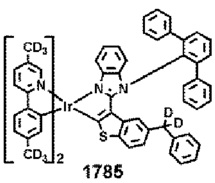
1785

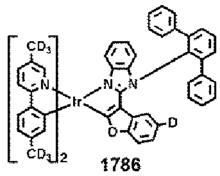
1786

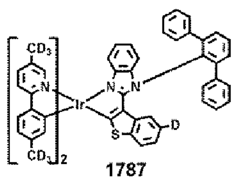
1787

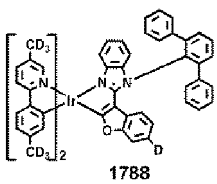
1788

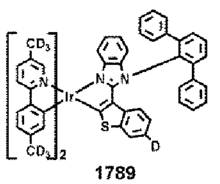
1789

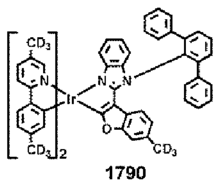
1790

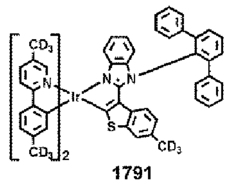
1791

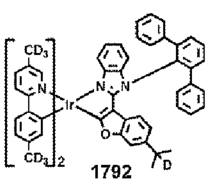
1792

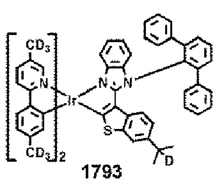
1793

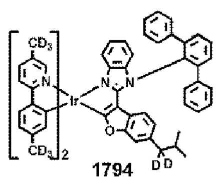
1794

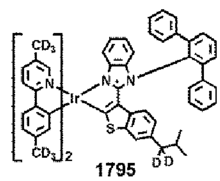
1795

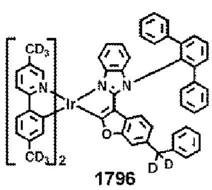
1796

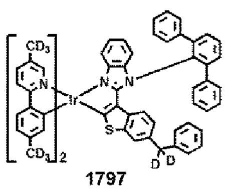
1797

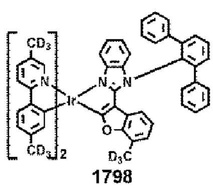
1798

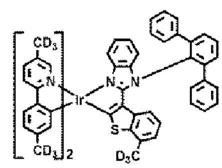
1799

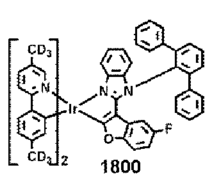
1800

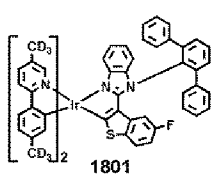
1801

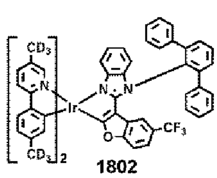
1802

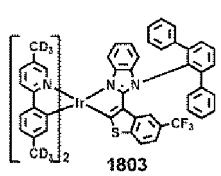
1803

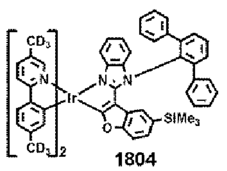
1804
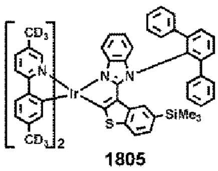
1805
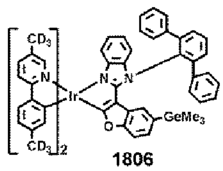
1806
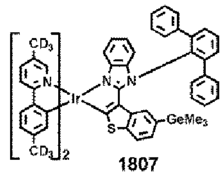
1807

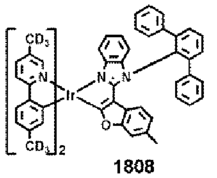
1808
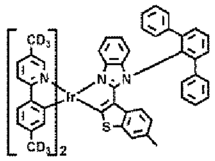
1809
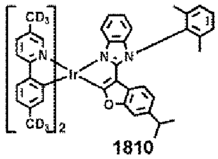
1810
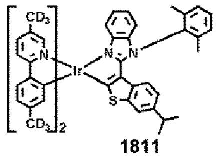
1811

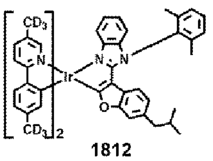
1812
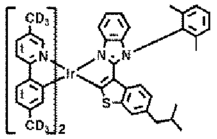
1813
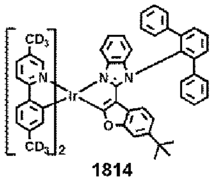
1814
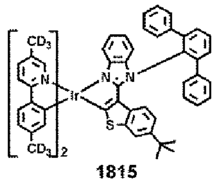
1815

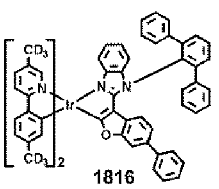
1816
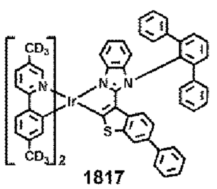
1817
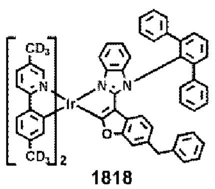
1818
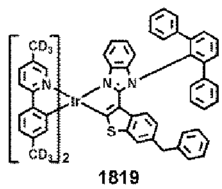
1819

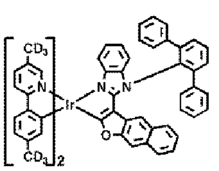
1820
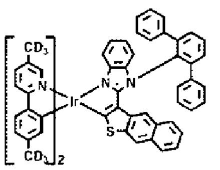
1821
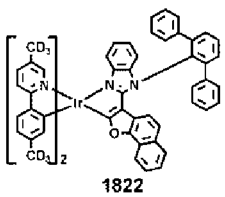
1822
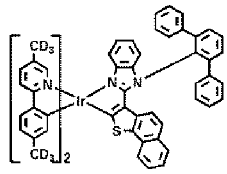
1823

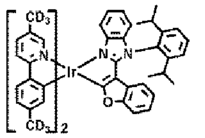
1824
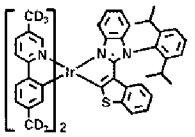
1825
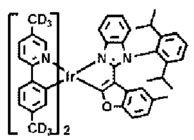
1826
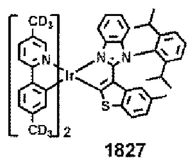
1827

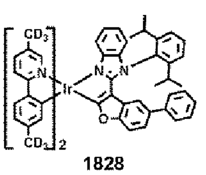
1828
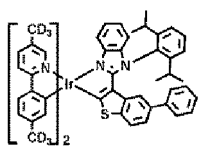
1829
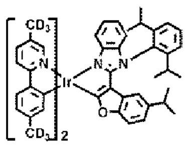
1830
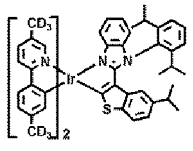
1831

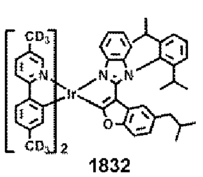
1832
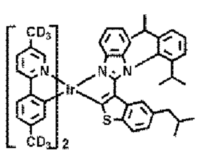
1833
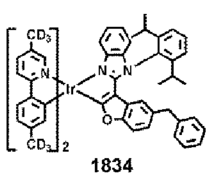
1834
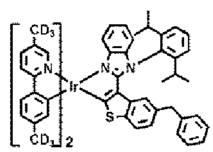
1835

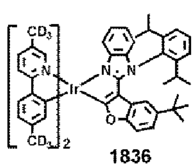
1836

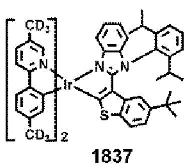
1837

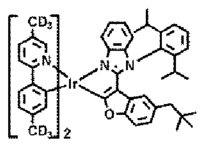
1838

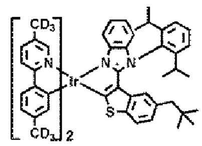
1839

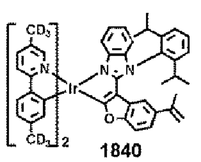
1840

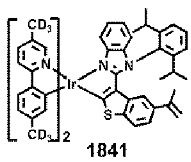
1841

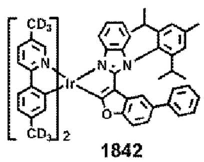
1842

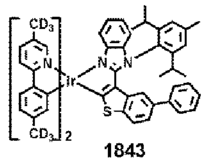
1843

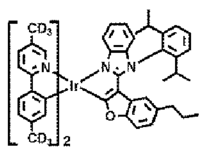
1844

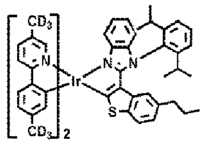
1845

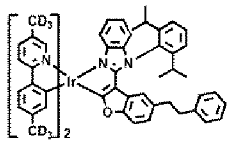
1846

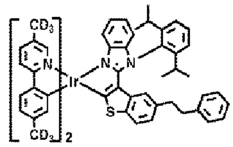
1847

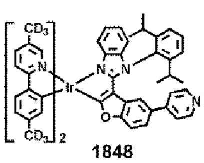
1848

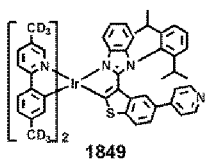
1849

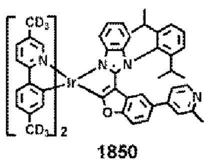
1850

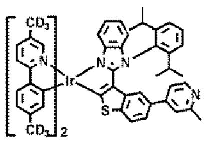
1851

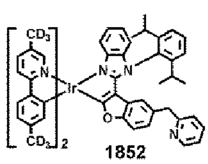
1852

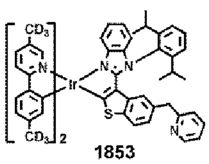
1853

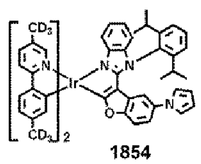
1854

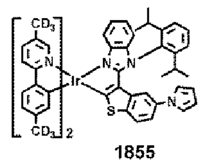
1855

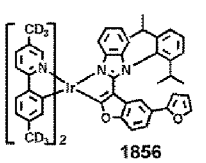
1856

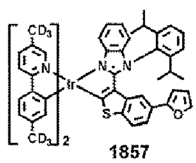
1857

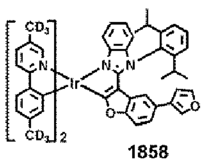
1858

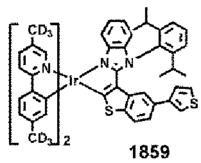
1859

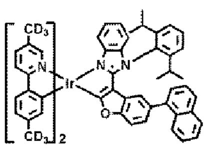
1860

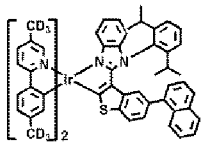
1861

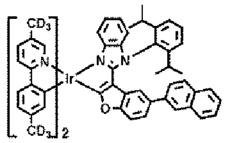
1862

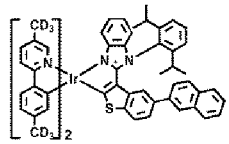
1863

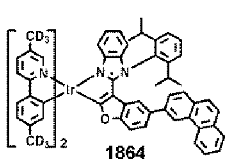
1864

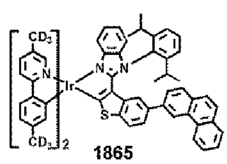
1865

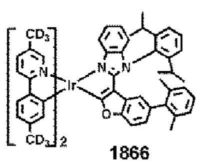
1866

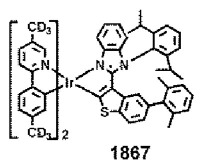
1867

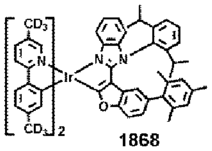
1868

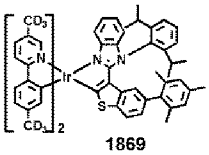
1869

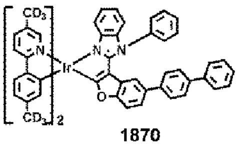
1870

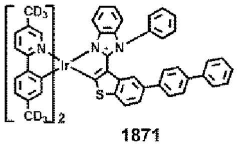
1871

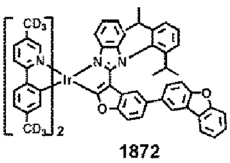
1872

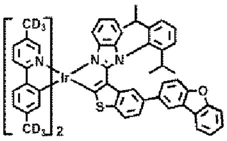
1873

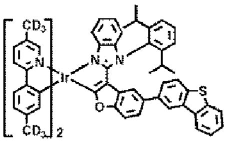
1874

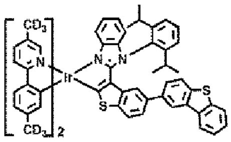
1875

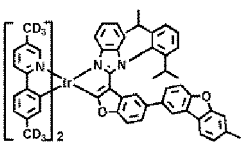
1876

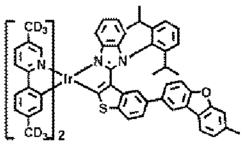
1877

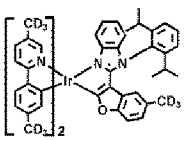
1878

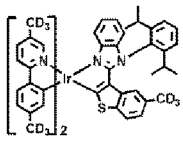
1879

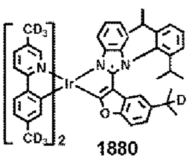
1880

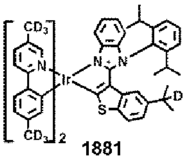
1881

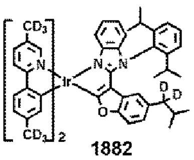
1882

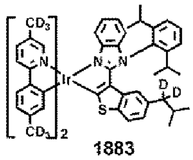
1883

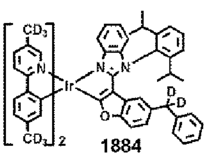
1884

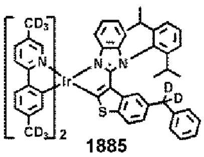
1885

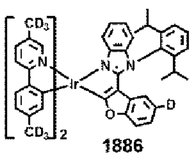
1886

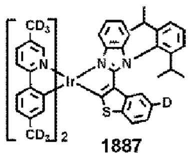
1887

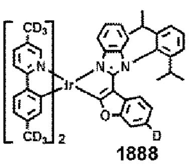
1888

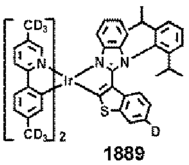
1889

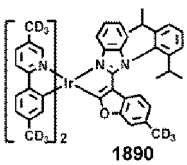
1890

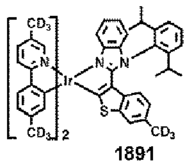
1891

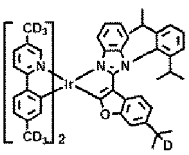
1892

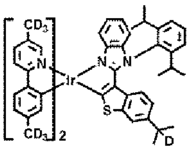
1893

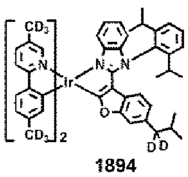
1894

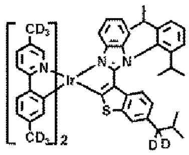
1895

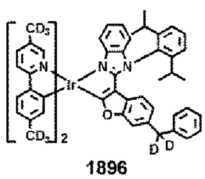
1896

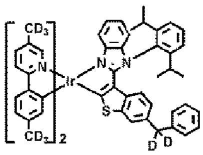
1897

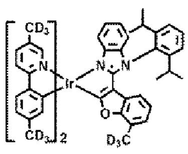
1898

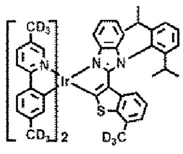
1899

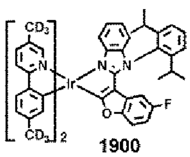
1900

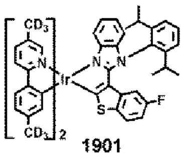
1901

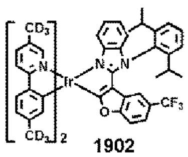
1902

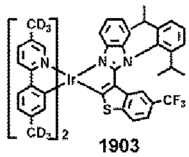
1903

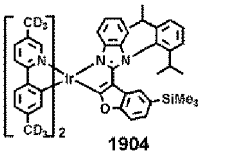
1904

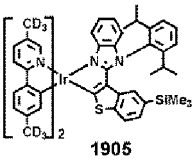
1905

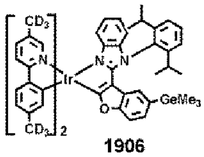
1906

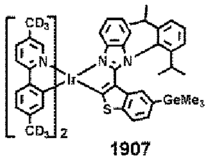
1907

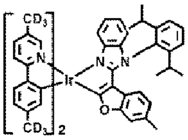
1908

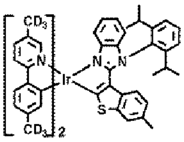
1909

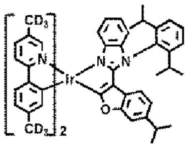
1910

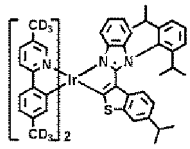
1911

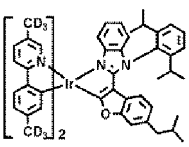
1912

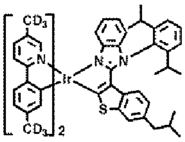
1913

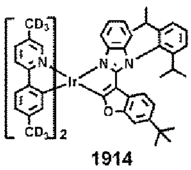
1914

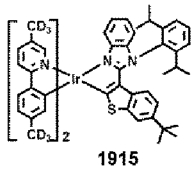
1915

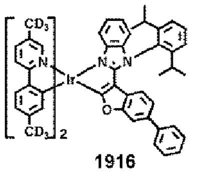
1916

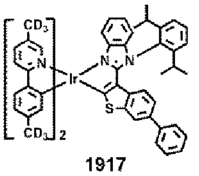
1917

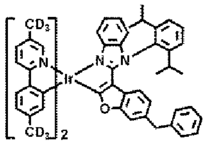
1918

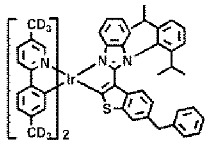
1919

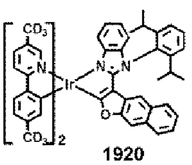
1920

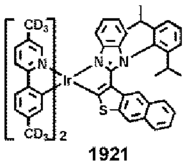
1921

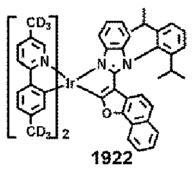
1922

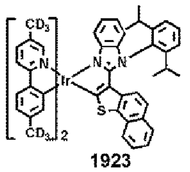
1923

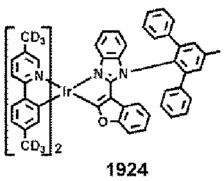
1924

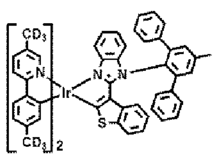
1925

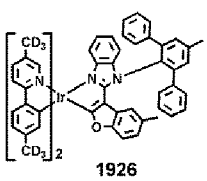
1926

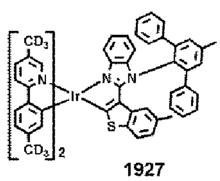
1927

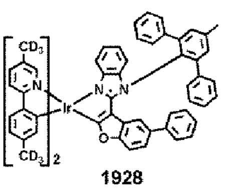
1928

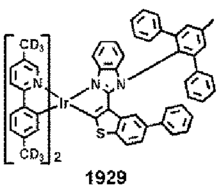
1929

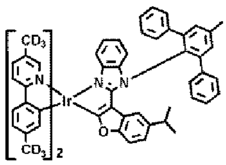
1930

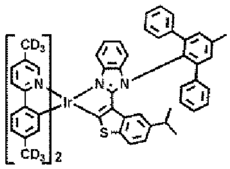
1931

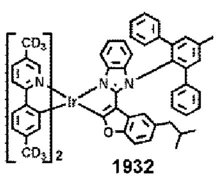
1932

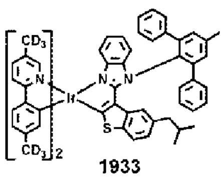
1933

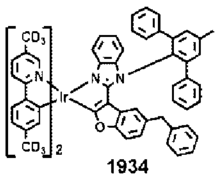
1934

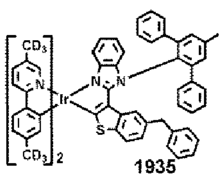
1935

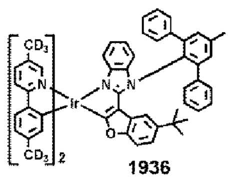
1936

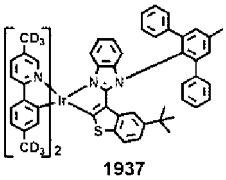
1937

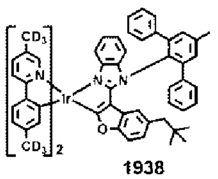
1938

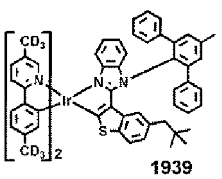
1939

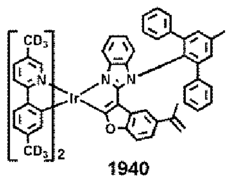
1940

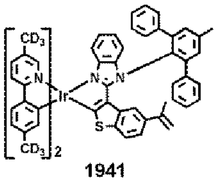
1941

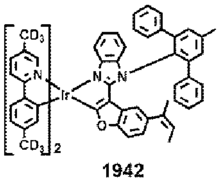
1942

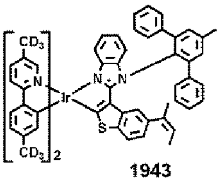
1943

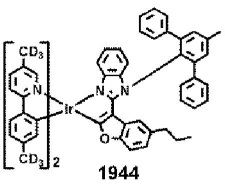
1944

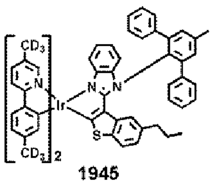
1945

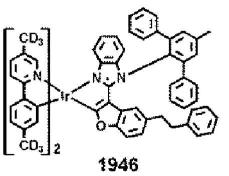
1946

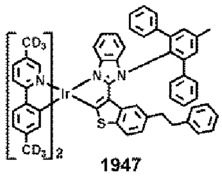
1947

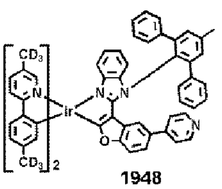
1948

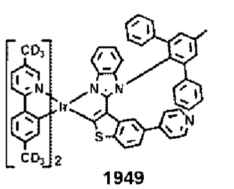
1949

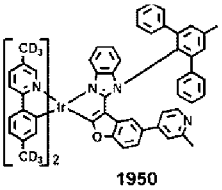
1950

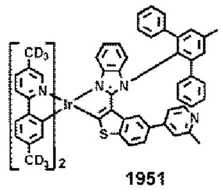
1951

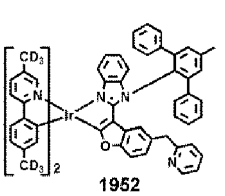
1952

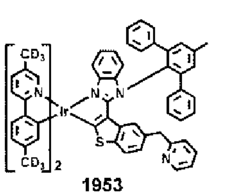
1953

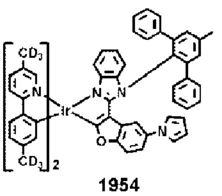
1954

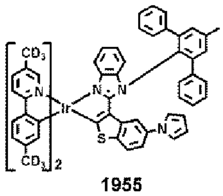
1955

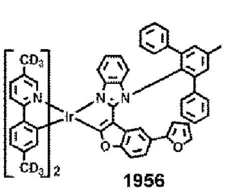
1956

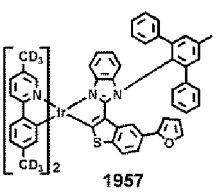
1957

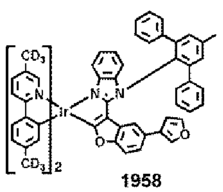
1958

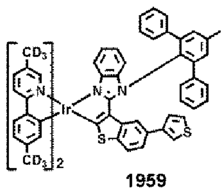
1959

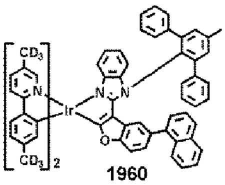
1960

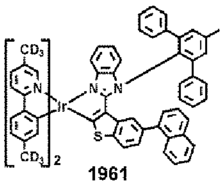
1961

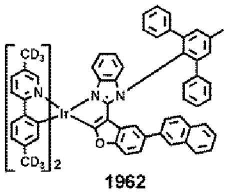
1962

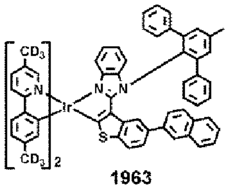
1963

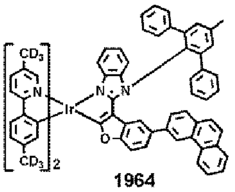
1964

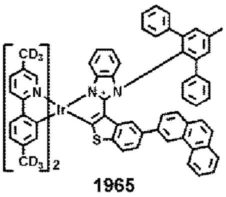
1965

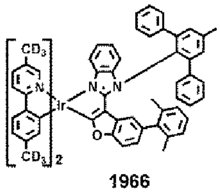
1966

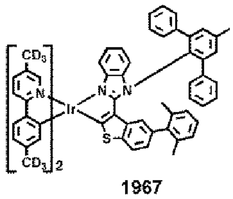
1967

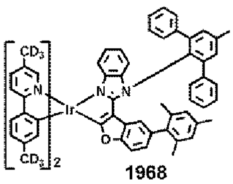
1968

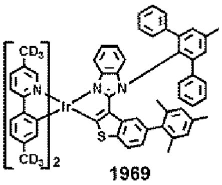
1969

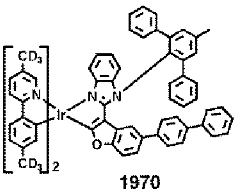
1970

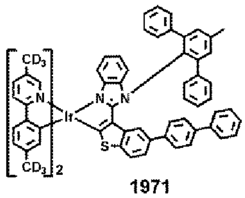
1971

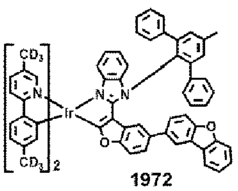
1972

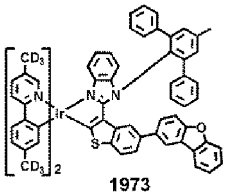
1973

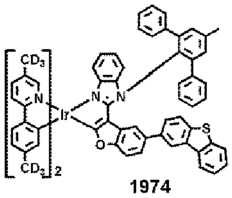
1974

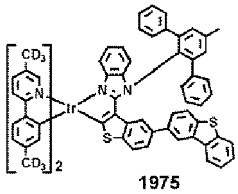
1975

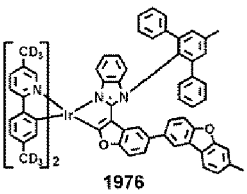
1976

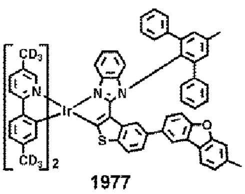
1977

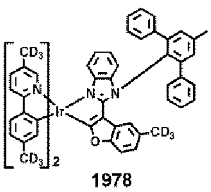
1978

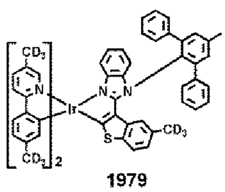
1979

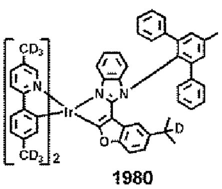
1980

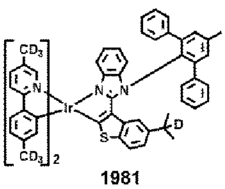
1981

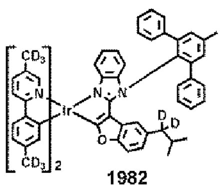
1982

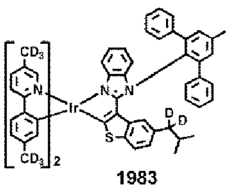
1983

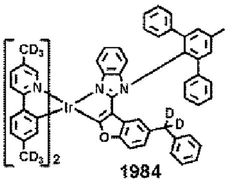
1984

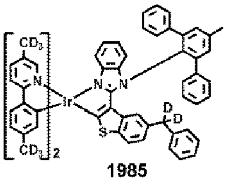
1985

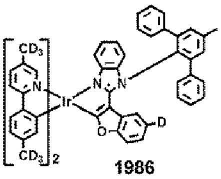
1986

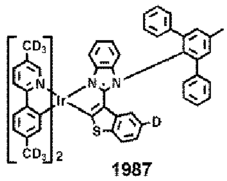
1987

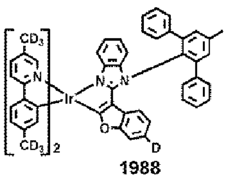
1988

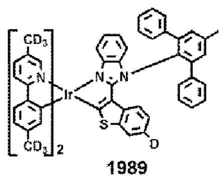
1989

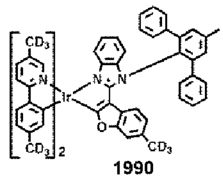
1990

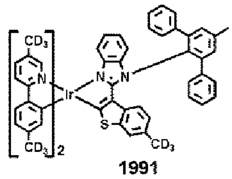
1991

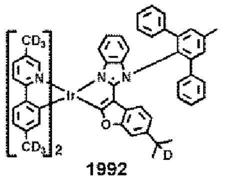
1992

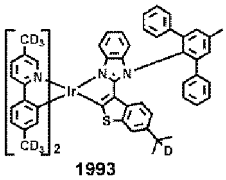
1993

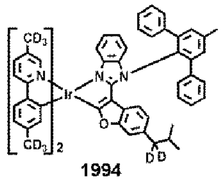
1994

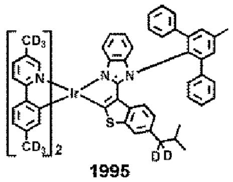
1995

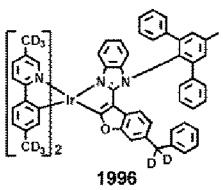
1996

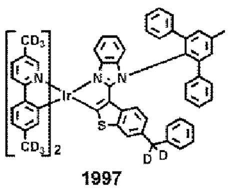
1997

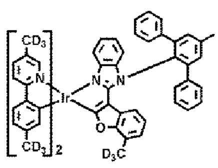
1998

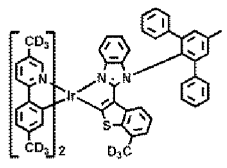
1999

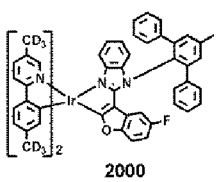
2000

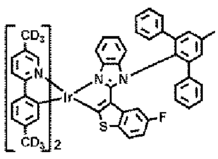
2001

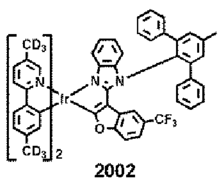
2002

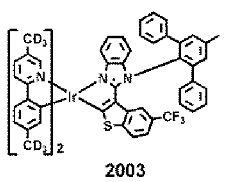
2003

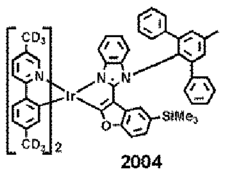
2004

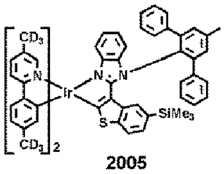
2005

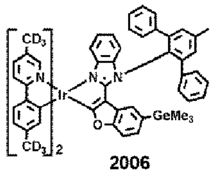
2006

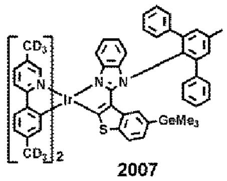
2007

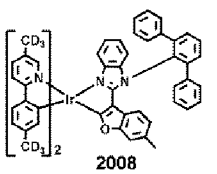
2008

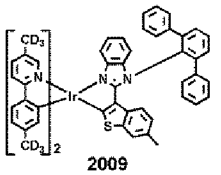
2009

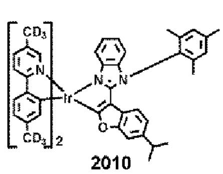
2010

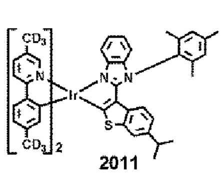
2011

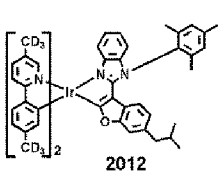
2012

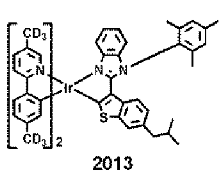
2013

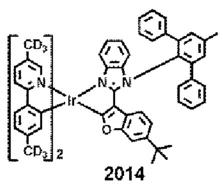
2014

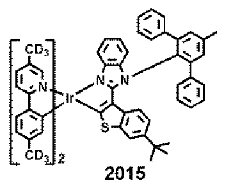
2015

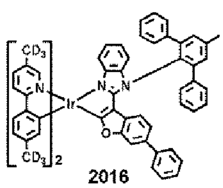
2016

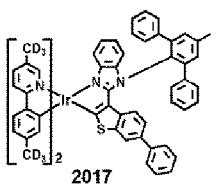
2017

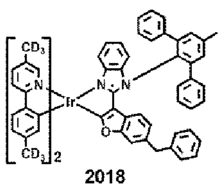
2018

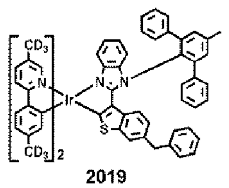
2019

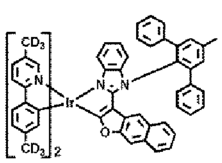

2020

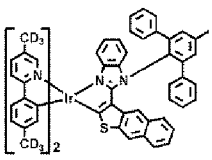

2021

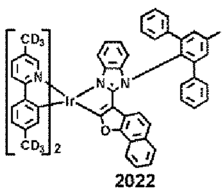

2022

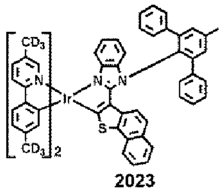

2023

The group $L_1$ in the organometallic compound represented by Formula 1 is a ligand represented by Formula 2, and n1, i.e., the number of $L_1$ groups, is 1, 2, or 3. That is, the organometallic compound essentially includes at least one ligand represented by Formula 2, as a ligand bonded to metal M.

In the ligand represented by Formula 2, ring A is a condensed ring in which a 6-membered ring is condensed with an imidazole ring, and ring B is a condensed ring in which ring $CY_1$ is condensed with a 5-membered ring including $X_1$ (see Formula 2' below). By including ring A having excellent stability and ring B having a long conjugation length, the organometallic compound represented by Formula 1 may have improved stability, and the organometallic compound represented by Formula 1 may have relatively small full widths at half maximum (FWHM) of emission peaks of a photoluminescence (PL) spectrum and/or electroluminescence (EL) spectrum. Thus, an electronic device, e.g., an organic light-emitting device, including the organometallic compound represented by Formula 1 may have improved lifespan.

Formula 2'

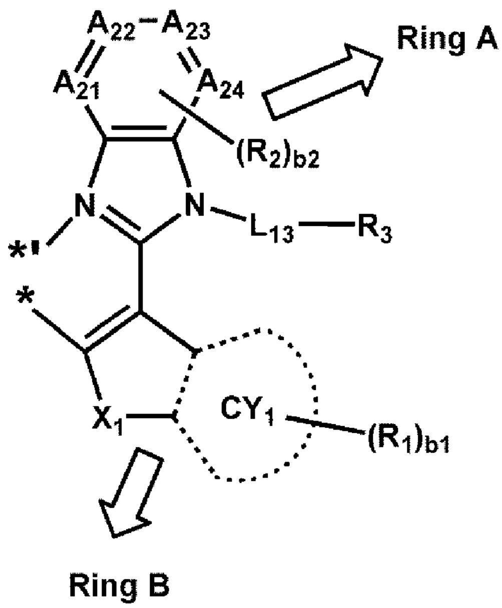

The highest occupied molecular orbital (HOMO) energy level, lowest unoccupied molecular orbital (LUMO) energy level, $S_1$ energy level, and $T_1$ energy level of some of the organometallic compounds represented by Formula 1 were evaluated by using Gaussian 09 program that performs molecular structure optimizations according to density functional theory (DFT) at a level of B3LYP. The results thereof are shown in Table 1.

Table 1

| Compound No. | HOMO (eV) | LUMO (eV) | $S_1$ (eV) | $T_1$ (eV) |
|---|---|---|---|---|
| 1 | -4.592 | -1.178 | 2.797 | 2.635 |
| 2 | -4.559 | -1.183 | 2.777 | 2.642 |
| 3 | -4.658 | -1.209 | 2.824 | 2.643 |
| 4 | -4.618 | -1.191 | 2.809 | 2.639 |
| 5 | -4.529 | -1.172 | 2.758 | 2.636 |

(continued)

| Compound No. | HOMO (eV) | LUMO (eV) | $S_1$ (eV) | $T_1$ (eV) |
|---|---|---|---|---|
| 822 | -4.493 | -1.134 | 2.776 | 2.480 |
| 823 | -4.642 | -1.242 | 2.784 | 2.647 |

Referring to the results shown in Table 1, the organometallic compound represented by Formula 1 was found to have suitable electrical characteristics for use as a dopant in an electronic device, e.g., an organic light-emitting device.

A method of synthesizing the organometallic compound represented by Formula 1 may be apparent to one of ordinary skill in the art by referring to Synthesis Examples provided herein.

The organometallic compound represented by Formula 1 may be suitable for use in an organic layer of an organic light-emitting device, e.g., as a dopant in the organic layer. Thus, according to another aspect, there is provided an organic light-emitting device that may include a first electrode; a second electrode; and an organic layer disposed between the first electrode and the second electrode and including an emission layer, wherein the organic layer may include at least one organometallic compound represented by Formula 1.

Since the organic light-emitting device has an organic layer including the organometallic compound represented by Formula 1, the organic light-emitting device may have a low driving voltage, high external quantum efficiency, and a low roll-off ratio.

The organometallic compound represented by Formula 1 may be used between a pair of electrodes of an organic light-emitting device. For example, the organometallic compound represented by Formula 1 may be included in the emission layer. In this embodiment, the organometallic compound may serve as a dopant and the emission layer may further include a host (that is, an amount of the organometallic compound represented by Formula 1 may be smaller than that of the host). The emission layer may emit red light or green light.

As used herein, the expression the "(organic layer) includes at least one organometallic compound" may be construed as meaning the "(organic layer) may include one organometallic compound of Formula 1 or two different organometallic compounds of Formula 1".

For example, Compound 1 may only be included in the organic layer as an organometallic compound. In this embodiment, Compound 1 may be included in the emission layer of the organic light-emitting device. In some embodiments, Compounds 1 and 2 may be included in the organic layer as organometallic compounds. In this embodiment, Compounds 1 and 2 may both be included in the same layer (for example, both Compounds 1 and 2 may be included in the emission layer).

The first electrode may be an anode, which is a hole injection electrode, and the second electrode may be a cathode, which is an electron injection electrode. In some embodiments, the first electrode may be a cathode, which is an electron injection electrode, and the second electrode may be an anode, which is a hole injection electrode.

For example, in the organic light-emitting device, the first electrode may be an anode, the second electrode may be a cathode, and the organic layer may further include a hole transport region disposed between the first electrode and the emission layer and an electron transport region disposed between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single and/or a plurality of layers disposed between the first electrode and the second electrode in an organic light-emitting device. The "organic layer" may include not only organic compounds but also organometallic complexes including metals.

The FIGURE illustrates a schematic cross-sectional view of an organic light-emitting device 10 according to an embodiment. Hereinafter, a structure of an organic light-emitting device according to one or more embodiments and a method of manufacturing the organic light-emitting device will be described with reference to the FIGURE. The organic light-emitting device 10 may include a first electrode 11, an organic layer 15, and a second electrode 19, which may be sequentially layered in this stated order.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and water repellency.

The first electrode 11 may be formed by depositing or sputtering, onto the substrate, a material for forming the first electrode 11. The first electrode 11 may be an anode. The material for forming the first electrode 11 may include a material with a high work function for easy hole injection. The first electrode 11 may be a reflective electrode, a semi-transmissive electrode, or a transmissive electrode. The material for forming the first electrode 11 may be indium tin

oxide (ITO), indium zinc oxide (IZO), tin oxide ($SnO_2$), or zinc oxide (ZnO). In some embodiments, the material for forming the first electrode 11 may be a metal, such as magnesium (Mg), aluminum (Al), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. In some embodiments, the first electrode 11 may have a triple-layered structure of ITO/Ag/ITO.

The organic layer 15 may be on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or a combination thereof.

The hole transport region may include a hole injection layer only or a hole transport layer only. In some embodiments, the hole transport region may include a hole injection layer and a hole transport layer which are sequentially stacked on the first electrode 11. In some embodiments, the hole transport region may include a hole injection layer, a hole transport layer, and an electron blocking layer, which are sequentially stacked on the first electrode 11.

When the hole transport region includes a hole injection layer, the hole injection layer may be formed on the first electrode 11 by using one or more suitable methods, such as vacuum deposition, spin coating, casting, and Langmuir-Blodgett (LB) deposition.

When a hole injection layer is formed by vacuum-deposition, for example, the vacuum deposition may be performed at a temperature in a range of about 100°C to about 500°C, at a vacuum degree in a range of about $10^{-8}$ torr to about $10^{-3}$ torr, 1 torr = 133,322 Pa), and at a rate in a range of about 0.01 Angstroms per second (Å/sec) to about 100 Å/sec, though the conditions may vary depending on a compound used as a hole injection material and a structure and thermal properties of a desired hole injection layer.

When a hole injection layer is formed by spin coating, the spin coating may be performed at a rate in a range of about 2,000 revolutions per minute (rpm) to about 5,000 rpm and at a temperature in a range of about 80°C to 200°C to facilitate removal of a solvent after the spin coating, though the conditions may vary depending on a compound used as a hole injection material and a structure and thermal properties of a desired hole injection layer.

The conditions for forming a hole transport layer and an electron blocking layer may be inferred from the conditions for forming the hole injection layer.

The hole transport region may include at least one of m-MTDATA, TDATA, 2-TNATA, NPB, β-NPB, TPD, spiro-TPD, spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor-sulfonic acid (PANI/CSA), polyaniline/poly(4-styrene sulfonate) (PANI/PSS), a compound represented by Formula 201, a compound represented by Formula 202, or a combination thereof:

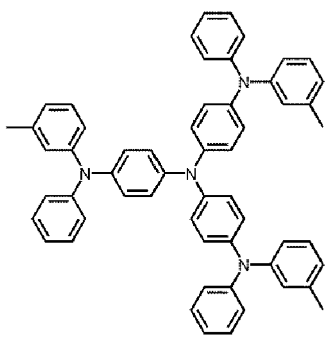
m-MTDATA

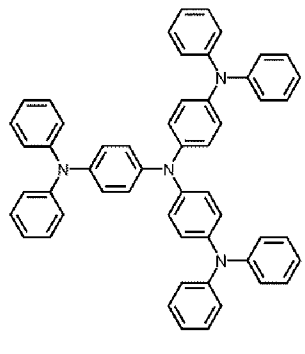
TDATA

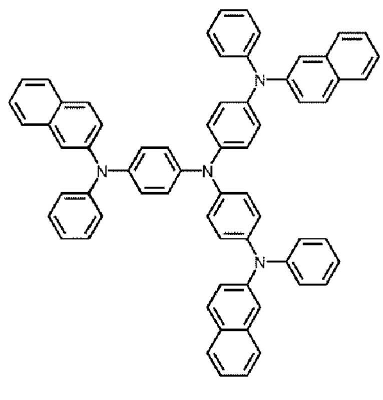
2-TNATA

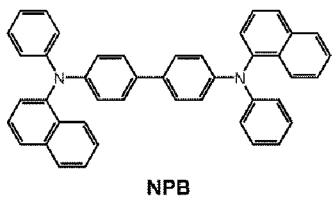
NPB

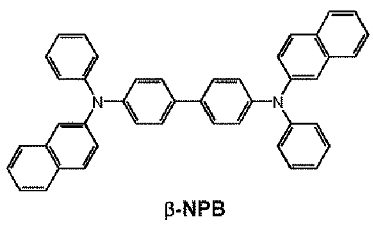
β-NPB

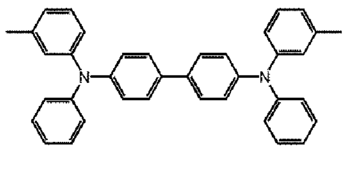
TPD

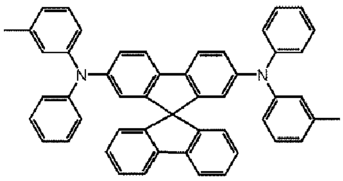

Spiro-TPD

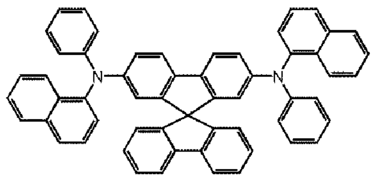

Spiro-NPB

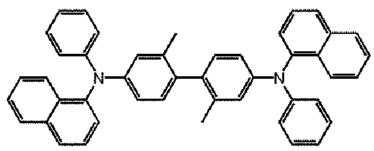

methylated NPB

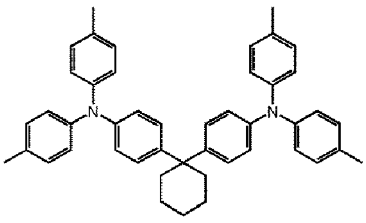

TAPC

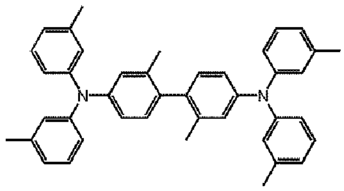

HMTPD

Formula 201

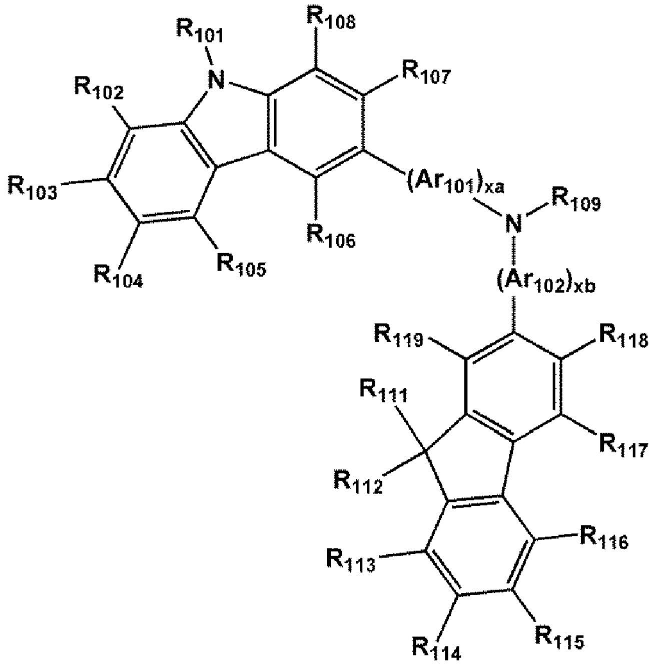

Formula 202

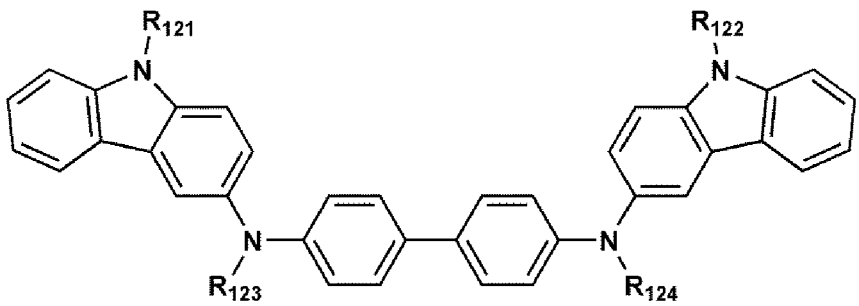

In Formula 201, $Ar_{101}$ and $Ar_{102}$ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or a combination thereof.

In Formula 201, xa and xb may each independently be an integer from 0 to 5. In some embodiments, xa and xb may each independently be an integer from 0 to 2. In some embodiments, xa may be 1, and xb may be 0.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (e.g., a methyl group, an ethyl group, a propyl group, a butyl group, pentyl group, or a hexyl group), or a $C_1$-$C_{10}$ alkoxy group (e.g., a methoxy group, an ethoxy group, a propoxy group, a butoxy group, or a pentoxy group);

a $C_1$-$C_{10}$ alkyl group or a $C_1$-$C_{10}$ alkoxy group, each substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or

a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or a combination thereof.

In Formula 201, $R_{109}$ may be a phenyl group, a naphthyl group, an anthracenyl group, or a pyridinyl group, each unsubstituted or substituted with deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or a combination thereof.

In some embodiments, the compound represented by Formula 201 may be represented by Formula 201A:

Formula 201A

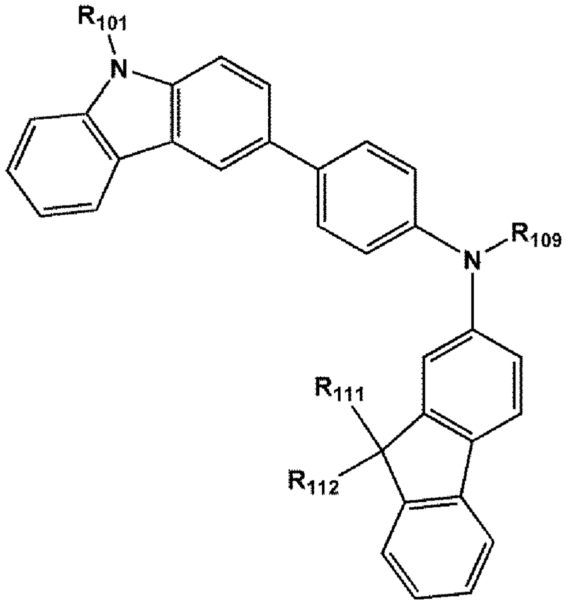

wherein, in Formula 201A, $R_{101}$, $R_{111}$, $R_{112}$, and $R_{109}$ may respectively be understood by referring to the descriptions of $R_{101}$, $R_{111}$, $R_{112}$, and $R_{109}$ provided herein.

In some embodiments, the hole transport region may include at least one of Compounds HT1 to HT20:

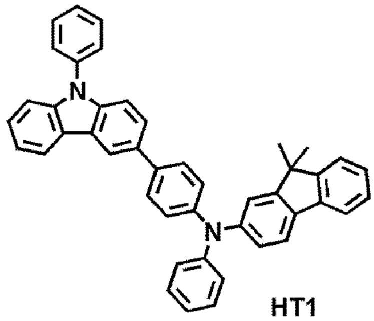

HT1

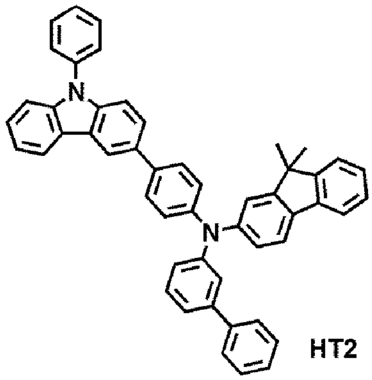

HT2

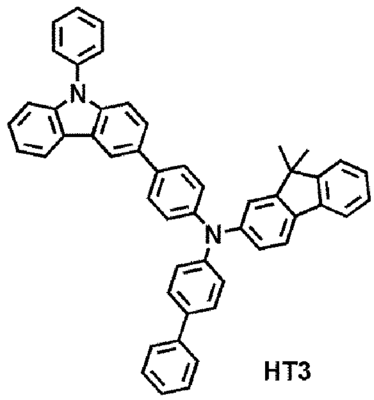

HT3

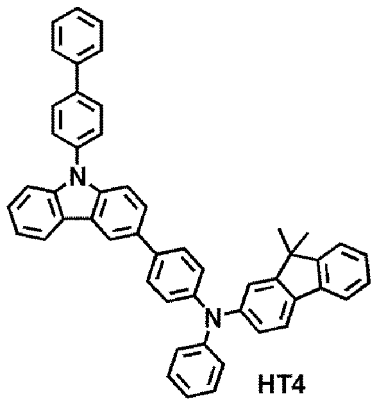

HT4

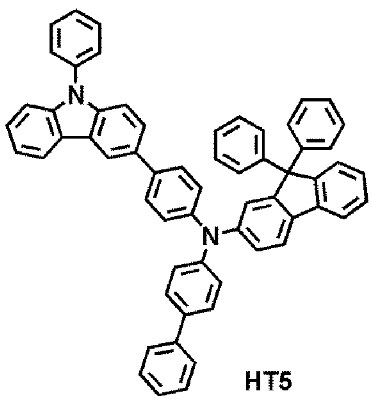

HT5

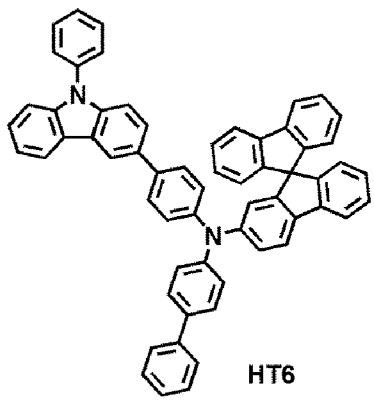

HT6

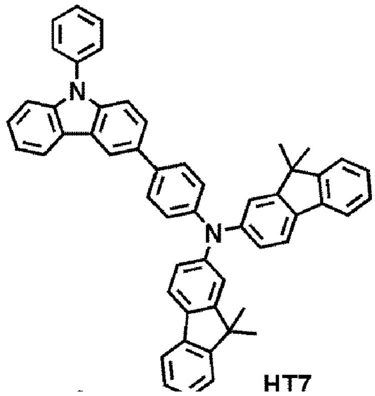

HT7

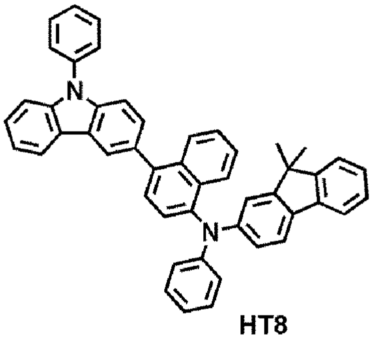

HT8

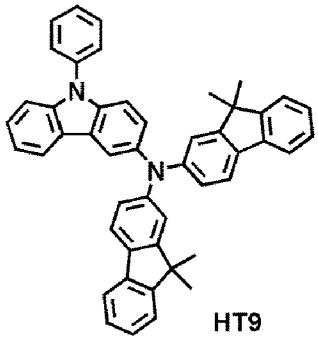

HT9

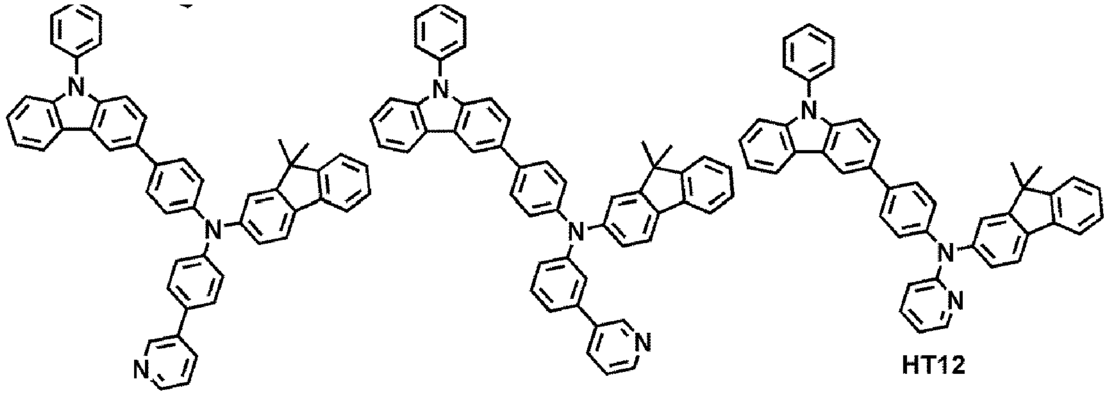

HT10 HT11 HT12

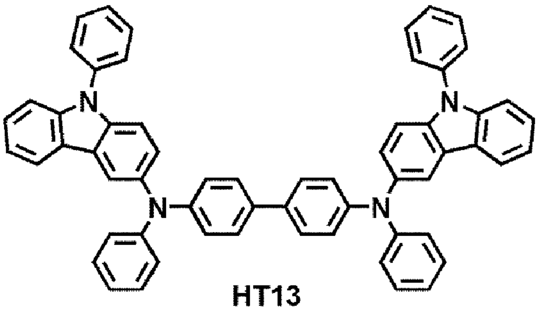

HT13

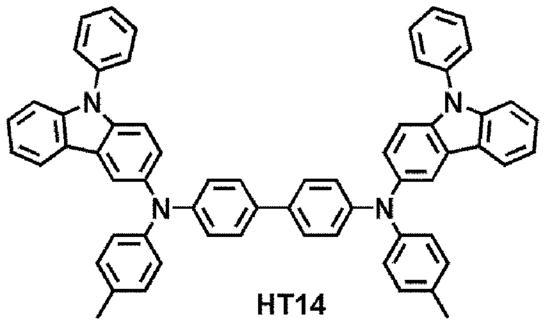

HT14

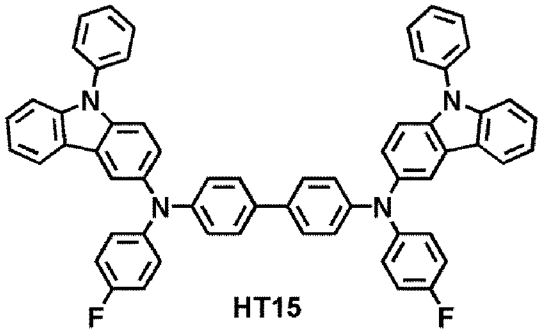

HT15

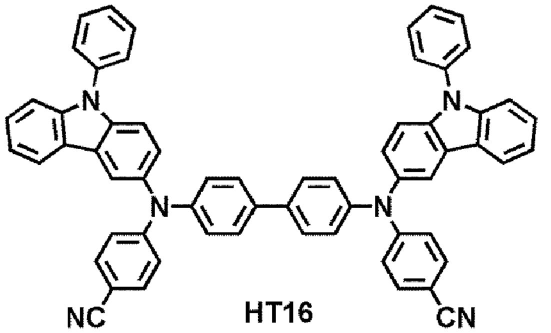

HT16

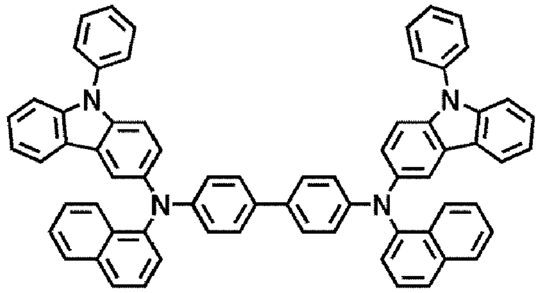

HT17

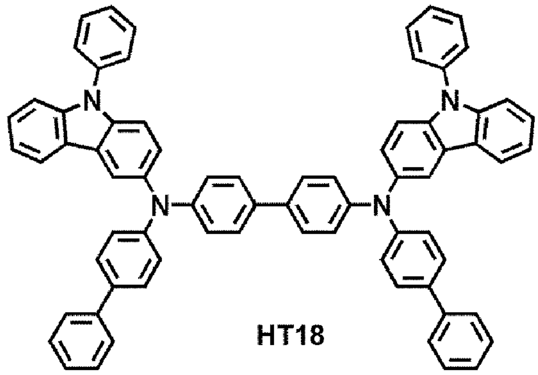

HT18

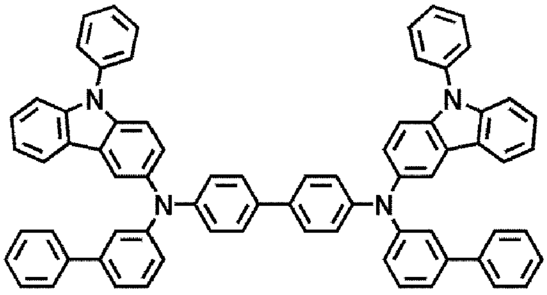

HT19

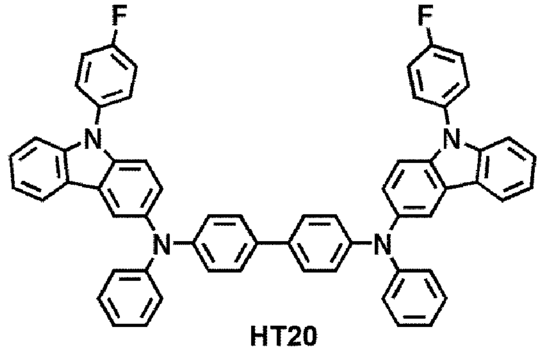

HT20

The thickness of the hole transport region may be in a range of about 100 Angstroms (Å) to about 10,000 Å, for example, about 100 Å to about 1,000 Å. When the hole transport region includes a hole injection layer, a hole transport layer, or a combination thereof, the thickness of the hole injection layer may be in a range of about 100 Å to about 10,000 Å, for example, about 100 Å to about 1,000 Å, the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, excellent hole transport characteristics may be obtained without a substantial increase in driving voltage.

The hole transport region may include a charge generating material as well as the aforementioned materials, to improve conductive properties of the hole transport region. The charge generating material may be substantially homogeneously or non-homogeneously dispersed in the hole transport region.

The charge generating material may include, for example, a p-dopant. The p-dopant may include one of a quinone derivative, a metal oxide, and a compound containing a cyano group. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), or F6-TCNNQ; a metal oxide, such as a tungsten oxide or a molybdenum oxide; and a compound containing a cyano group, such as Compound HT-D1:

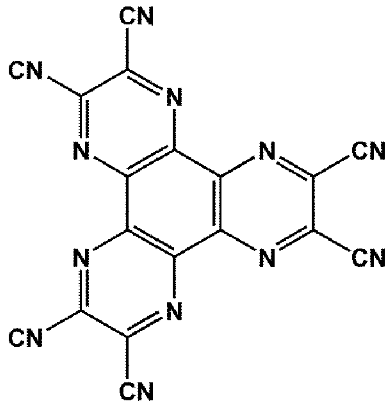

HT-D1

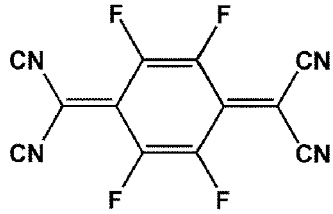

F4-TCNQ

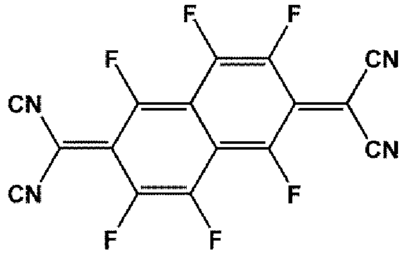

F6-TCNNQ

The hole transport region may further include a buffer layer.

The buffer layer may compensate for an optical resonance distance depending on a wavelength of light emitted from the emission layer to improve the efficiency of an organic light-emitting device.

When the hole transport region includes an electron blocking layer, a material for forming the electron blocking layer may include the material for forming a hole transport region, the host material described herein, or a combination thereof. In some embodiments, when the hole transport region includes an electron blocking layer, mCP described herein may be used for forming the electron blocking layer.

An emission layer may be formed on the hole transport region by using one or more suitable methods, such as vacuum deposition, spin coating, casting, or LB deposition. When the emission layer is formed by vacuum deposition or spin coating, vacuum deposition and coating conditions for forming the emission layer may be generally similar to those conditions for forming a hole injection layer, though the conditions may vary depending on a compound that is used.

The emission layer may include a host and a dopant, and the dopant may include the organometallic compound represented by Formula 1.

The host may include TPBi, TBADN, ADN (also known as "DNA"), CBP, CDBP, TCP, mCP, Compound H50, Compound H51, or a combination thereof:

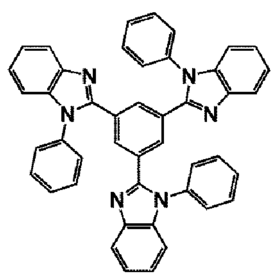

TPBi

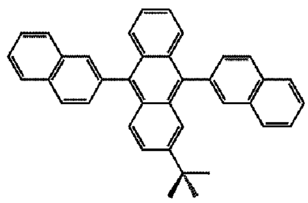

TBADN

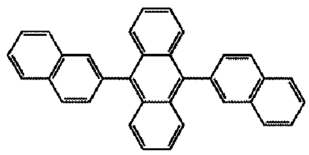

ADN

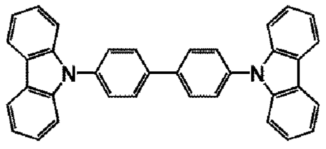

CBP

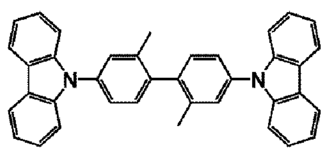

CDBP

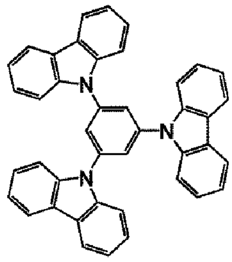

TCP

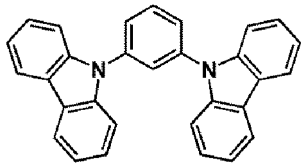

mCP

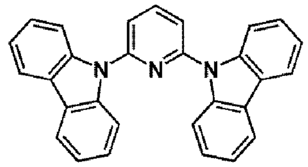

H50

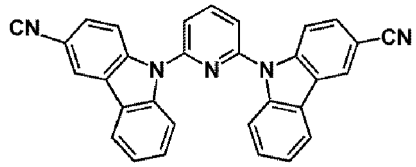

H51

When the organic light-emitting device 10 is a full-color organic light-emitting device, the emission layer may be patterned into a red emission layer, a green emission layer, and/or a blue emission layer. In some embodiments, the emission layer may have a structure in which the red emission layer, the green emission layer, and/or the blue emission layer are layered to emit white light. In some embodiments, the structure of the emission layer may vary.

When the emission layer includes the host and the dopant, an amount of the dopant may be in a range of about 0.01 parts to about 15 parts by weight based on about 100 parts by weight of the host.

The dopant may be the organometallic compound represented by Formula 1 described herein. In some embodiments, the dopant may be a green phosphorescent dopant.

The thickness of the emission layer may be in a range of about 100 Å to about 1,000 Å, and in some embodiments, about 200 Å to about 600 Å. When the thickness of the emission layer is within any of these ranges, improved luminescence characteristics may be obtained without a substantial increase in driving voltage.

An electron transport region may be over the emission layer.

The electron transport region may include a hole blocking layer, an electron transport layer, an electron injection layer, or a combination thereof.

In some embodiments, the electron transport region may have a hole blocking layer/an electron transport layer/an electron injection layer structure or an electron transport layer/an electron injection layer structure. The electron transport layer may have a single-layered structure or a multi-layered structure including two or more different materials.

The conditions for forming a hole blocking layer, an electron transport layer, and an electron injection layer may be inferred based on the conditions for forming the hole injection layer.

When the electron transport region includes a hole blocking layer, the hole blocking layer may include, for example, BCP, BPhen, BAlq or a combination thereof:

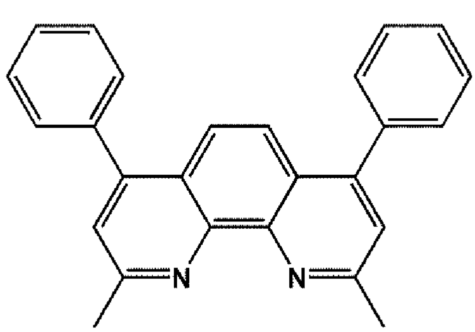

BCP

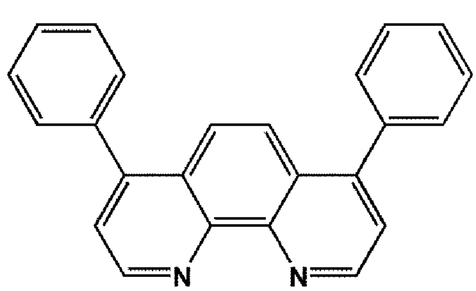

Bphen

The thickness of the hole blocking layer may be in a range of about 20 Å to about 1,000 Å, for example, about 30 Å to about 300 Å. When the thickness of the hole blocking layer is within any of these ranges, excellent hole blocking characteristics may be obtained without a substantial increase in driving voltage.

The electron transport layer may include BCP, BPhen, $Alq_3$, BAlq, TAZ, NTAZ, or a combination thereof:

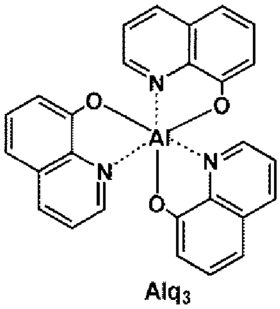

Alq3

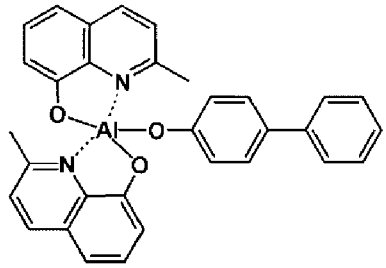

BAlq

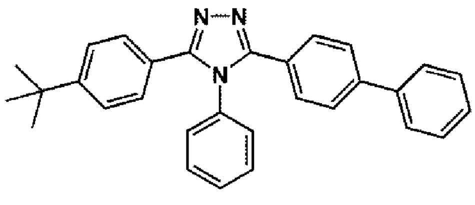

TAZ

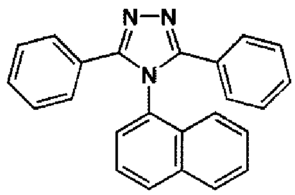

NTAZ

In some embodiments, the electron transport layer may include at least one of Compounds ET1 to ET25:

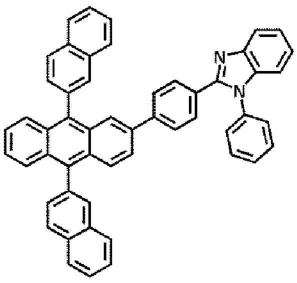

ET1

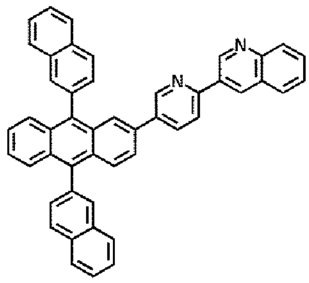

ET2

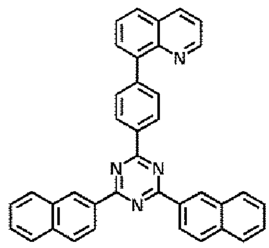

ET3

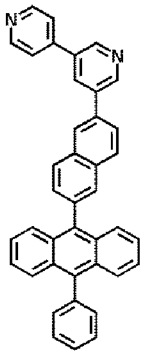

ET4

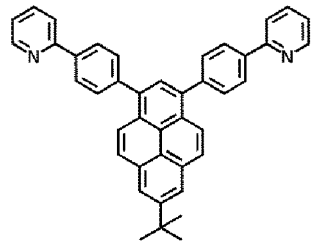

ET5

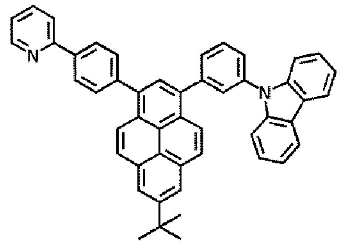

ET6

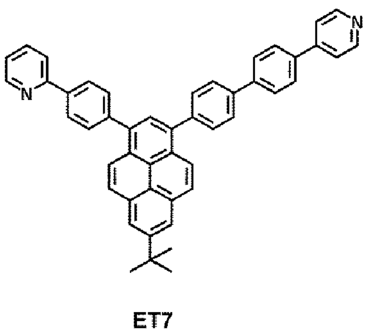

ET7

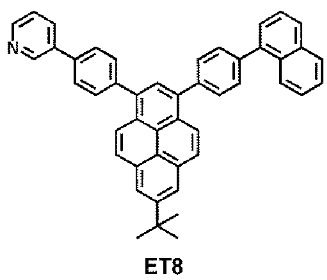

ET8

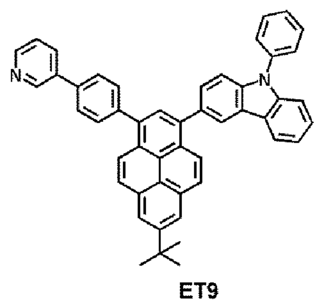

ET9

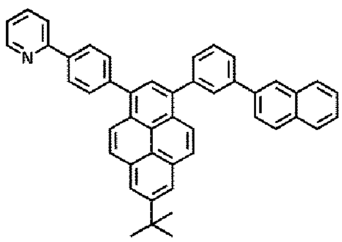

ET10

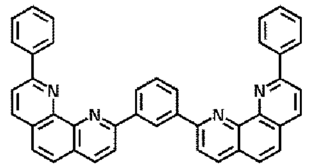

ET11

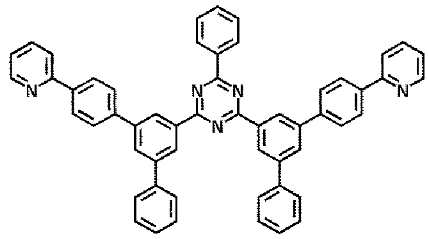

ET12

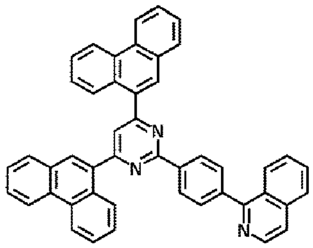

ET13

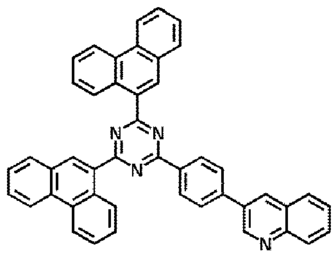

ET14

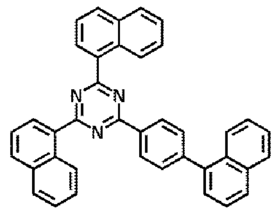

ET15

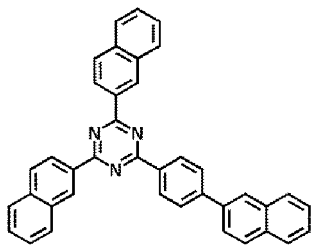

ET16

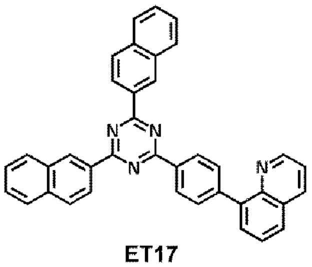

ET17

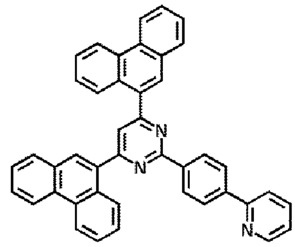

ET18

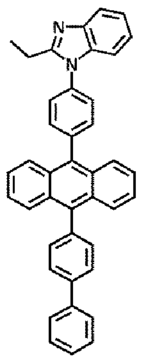

ET19

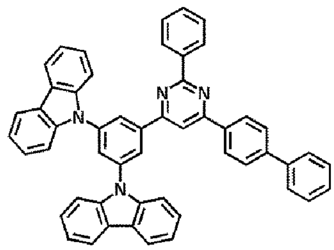

ET20

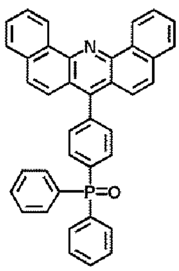

ET21

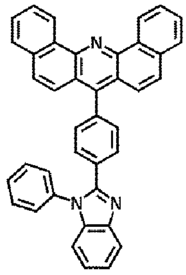

ET22

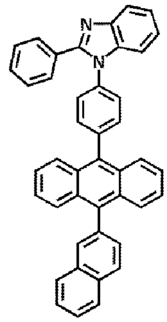

ET23

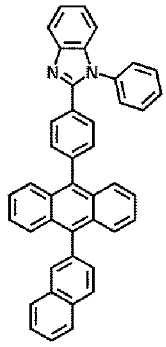

ET24

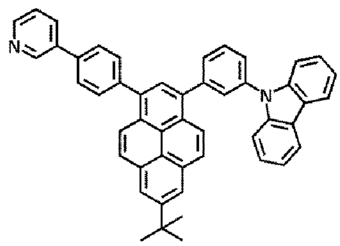

ET25

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport layer may further include a material containing metal, in addition to the materials described above.

The material containing metal may include a Li complex. The Li complex may include, e.g., Compound ET-D1 (LiQ) or Compound ET-D2:

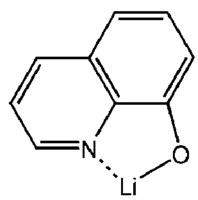

ET-D1

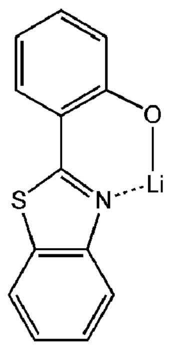

ET-D2

The electron transport region may include an electron injection layer that facilitates electron injection from the second electrode 19.

The electron injection layer may include LiF, NaCl, CsF, $Li_2O$, BaO, or a combination thereof.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

The second electrode 19 may be on the organic layer 15. The second electrode 19 may be a cathode. A material for forming the second electrode 19 may be a material with a relatively low work function, such as a metal, an alloy, an electrically conductive compound, or a mixture thereof. Examples of the material for forming the second electrode 19 may include lithium (Li), magnesium (Mg), aluminum (Al), aluminum-lithium (Al-Li), calcium (Ca), magnesium-indium (Mg-In), and magnesium-silver (Mg-Ag). In some embodiments, ITO or IZO may be used to form a transmissive second electrode 19 to manufacture a top emission light-emitting device. In some embodiments, the material for forming the second electrode 19 may vary.

Hereinbefore the organic light-emitting device 10 has been described with reference to the FIGURE, but embodiments are not limited thereto.

According to an aspect of another embodiment, an electronic apparatus including the organic light-emitting device may be provided. The electronic apparatus may be used for various purposes such as a display, lighting, and a mobile phone.

According to an aspect of still another embodiment, a diagnostic composition may include at least one organometallic compound represented by Formula 1.

Since the organometallic compound represented by Formula 1 provides high luminescence efficiency, the diagnostic efficiency of the diagnostic composition that includes the organometallic compound represented by Formula

1 may be excellent.

The diagnostic composition may be applied in various ways, such as in a diagnostic kit, a diagnostic reagent, a biosensor, or a biomarker.

The term "$C_1$-$C_{60}$ alkyl group" as used herein refers to a linear or branched saturated aliphatic hydrocarbon monovalent group having 1 to 60 carbon atoms. The term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group as used herein may include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group or a tert-decyl group, each unsubstituted or substituted with a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, or a combination thereof. In some embodiments, Formula 9-33 may be a branched $C_6$ alkyl group. Formula 9-33 may be a tert-butyl group substituted with two methyl groups.

The term "$C_1$-$C_{60}$ alkoxy group" as used herein refers to a monovalent group represented by $-OA_{101}$ (wherein $A_{101}$ is a $C_1$-$C_{60}$ alkyl group).

Examples of the $C_1$-$C_{60}$ alkoxy group, the $C_1$-$C_{20}$ alkoxy group, or the $C_1$-$C_{10}$ alkoxy group as used herein may include a methoxy group, an ethoxy group, a propoxy group, a butoxy group, or a pentoxy group.

The term "$C_2$-$C_{60}$ alkenyl group" as used herein refers to a group formed by placing at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a group formed by placing at least one carbon-carbon triple bond in the middle or at the terminus of the $C_2$-$C_{60}$ alkyl group. Examples thereof include an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent cyclic saturated hydrocarbon group including 3 to 10 carbon atoms. The term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group as used herein may include a cyclopropyl group, a cyclobutyl group, a cyclopentyl group, a cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, or a bicyclo[2.2.2]octyl group.

The term "$C_1$-$C_{10}$ heterocycloalkyl group" as used herein refers to a monovalent monocyclic group including at least one heteroatom that can be N, O, P, Si, Se, Ge, B, or S as a ring-forming atom and 1 to 10 carbon atoms. The term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group as used herein may include a silolanyl group, a silinanyl group, a tetrahydrofuranyl group, a tetrahydro-2H-pyranyl group, or a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group including at least one heteroatom that is N, O, P, Si, Se, Ge, B, or S as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkylene group" as used herein refers to a divalent group having the same structure as the $C_1$-$C_{10}$ heterocycloalkyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a

carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include a plurality of rings, the plurality of rings may be fused to each other.

The term "$C_7$-$C_{60}$ alkylaryl group" as used herein refers to a $C_6$-$C_{60}$ aryl group substituted with at least one $C_1$-$C_{60}$ alkyl group. The term "$C_7$-$C_6$o arylalkyl group" as used herein refers to a $C_1$-$C_{60}$ alkyl group substituted with a $C_6$-$C_{60}$ aryl group.

The term "$C_1$-$C_{60}$ heteroaryl group" as used herein refers to a monovalent group having a heterocyclic aromatic system having at least one heteroatom that is N, O, P, Si, Se, Ge, B, or S as a ring-forming atom and 1 to 60 carbon atoms. The term "$C_1$-$C_{60}$ heteroarylene group" as used herein refers to a divalent group having a heterocyclic aromatic system having at least one heteroatom that is N, O, P, Si, Se, Ge, B, or S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include a plurality of rings, the plurality of rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_6$-$C_{60}$ aryloxy group" as used herein is represented by $-OA_{102}$ (wherein $A_{102}$ is the $C_6$-$C_{60}$ aryl group). The term "$C_6$-$C_{60}$ arylthio group" as used herein is represented by $-SA_{103}$ (wherein $A_{103}$ is the $C_6$-$C_{60}$ aryl group). The term "$C_1$-$C_{60}$ alkylthio group" as used herein is represented by $-SA_{104}$ (wherein $A_{104}$ is the $C_1$-$C_{60}$ alkyl group).

The term "$C_1$-$C_{60}$ heteroaryloxy group" as used herein refers to $-OA_{106}$ (wherein $A_{106}$ is the $C_1$-$C_{60}$ heteroaryl group), the term "$C_1$-$C_{60}$ heteroarylthio group" as used herein indicates $-SA_{107}$ (wherein $A_{107}$ is the $C_1$-$C_{60}$ heteroaryl group), and the term "$C_2$-$C_{60}$ heteroarylalkyl group" as used herein refers to $-A_{108}A_{109}$ ($A_{109}$ is a $C_1$-$C_{59}$ heteroaryl group, and $A_{108}$ is a $C_1$-$C_{59}$ alkylene group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and at least one heteroatom that is N, O, P, Si, Se, Ge, B, or S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group. Examples of the "$C_5$-$C_{30}$ carbocyclic group (unsubstituted or substituted with at least one $R_{1Oa}$)" may include an adamantane group, a norbornene group, a norbornane group (a bicyclo[2.2.1]heptane group), a bicyclo[1.1.1]pentane group, a bicyclo[2.1.1]hexane group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a silole group, or a fluorene group, (each unsubstituted or substituted with at least one $R_{10a}$).

The term "$C_1$-$C_{30}$ heterocyclic group" as used herein refers to saturated or unsaturated cyclic group including 1 to 30 carbon atoms and at least one heteroatom that is N, O, P, Si, Se, Ge, B, or S as ring-forming atoms. The $C_1$-$C_{30}$ heterocyclic group may be a monocyclic group or a polycyclic group. Examples of the "$C_1$-$C_{30}$ heterocyclic group (unsubstituted or substituted with at least one $R_{1Oa}$)" may include a thiophene group, a furan group, a pyrrole group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophenegroup, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, (each unsubstituted or substituted with at least one $R_{1Oa}$).

The "deuterated $C_1$-$C_{60}$ alkyl group (or, deuterated $C_1$-$C_{20}$ alkyl group, deuterated $C_2$-$C_{20}$ alkyl group, or the like)" as used herein refers to a $C_1$-$C_{60}$ alkyl group substituted with at least one deuterium (or, a $C_1$-$C_{20}$ alkyl group substituted with at least one deuterium, a $C_2$-$C_{20}$ alkyl group substituted with at least one deuterium, or the like). Examples of the "deuterated $C_1$ alkyl group (e.g., a deuterated a methyl group)" include $-CD_3$, $-CD_2H$, and $-CDH_2$.

The "deuterated $C_3$-$C_{10}$ cycloalkyl group" as used herein refers to a $C_3$-$C_{10}$ cycloalkyl group substituted with at least one deuterium. Examples of the "deuterated $C_3$-$C_{10}$ cycloalkyl group" include Formula 10-501.

The "fluorinated $C_1$-$C_{60}$ alkyl group (or fluorinated $C_1$-$C_{20}$ alkyl group or the like)", "fluorinated $C_3$-$C_{10}$ cycloalkyl group", "fluorinated $C_1$-$C_{10}$ heterocycloalkyl group", and "fluorinated phenyl group" as used herein may respectively be a $C_1$-$C_{60}$ alkyl group (or $C_1$-$C_{20}$ alkyl group or the like), $C_3$-$C_{10}$ cycloalkyl group, a $C_1$-$C_{10}$ heterocycloalkyl group, and a phenyl group, each substituted with at least one fluoro group (-F). Examples of the "fluorinated $C_1$ alkyl group (i.e., a fluorinated methyl group)" may include $-CF_3$, $-CF_2H$, and $-CFH_2$. The "fluorinated $C_1$-$C_{60}$ alkyl group (or fluorinated $C_1$-$C_{20}$ alkyl group or the like)", "fluorinated $C_3$-$C_{10}$ cycloalkyl group", or "fluorinated $C_1$-$C_{10}$ heterocycloalkyl group" may respectively be: i) a fully fluorinated $C_1$-$C_{60}$ alkyl group (or fully fluorinated $C_1$-$C_{20}$ alkyl group or the like), fully fluorinated $C_3$-$C_{10}$ cycloalkyl group, or fully fluorinated $C_1$-$C_{10}$ heterocycloalkyl group, in which all hydrogen atoms are substituted with fluoro groups; or ii) a partially fluorinated $C_1$-$C_{60}$ alkyl group (or partially fluorinated $C_1$-$C_{20}$ alkyl group or the like), partially fluorinated $C_3$-$C_{10}$ cycloalkyl group, or partially fluorinated $C_1$-$C_{10}$ heterocycloalkyl group, in which some of hydrogen atoms are substituted with fluoro groups.

The "($C_1$-$C_{20}$ alkyl)'X' group" refers to a 'X' group substituted with at least one $C_1$-$C_{20}$ alkyl group. For example, The "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the "($C_1$-$C_{20}$ alkyl)phenyl group" as used herein refers to a phenyl group substituted with at least one $C_1$-$C_{20}$ alkyl group. Examples of the ($C_1$ alkyl)phenyl group may include a toluyl group.

As used herein, "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refer to a heterocyclic ring in which at least one ring-forming carbon atom is replaced with a nitrogen atom and respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, and a dibenzothiophene 5,5-dioxide group".

At least one substitutent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alklythio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted monovalent non-aromatic condensed polycyclic group, and the substituted monovalent non-aromatic condensed heteropolycyclic group are each independently:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or $C_1$-$C_{60}$ alkoxy group, each substituted with deuterium, -F, -Cl, -Br, -I, $-CD_3$, $-CD_2H$, $-CDH_2$, - $CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$

heteroaryloxy group, a $C_1$-$C_{60}$ heteroarylthio group, a $C_2$-$C_{60}$ heteroarylalkyl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, $-P(=O)(Q_{28})(Q_{29})$, $-P(Q_{28})(Q_{29})$, or a combination thereof;
$-N(Q_{31})(Q_{32})$, $-Si(Q_{33})(Q_{34})(Q_{35})$, $-B(Q_{36})(Q_{37})$, $-P(=O)(Q_{38})(Q_{39})$, or - $P(Q_{38})(Q_{39})$; or
a combination thereof.

In the formulae of the present disclosure, $Q_1$ to $Q_9$, $Q_{11}$ to $Q_{19}$, $Q_{21}$ to $Q_{29}$, and $Q_{31}$ to $Q_{39}$ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_7$-$C_{60}$ arylalkyl group, a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

Hereinafter, an exemplary compound and an exemplary organic light-emitting device according to one or more embodiments will be described in detail with reference to Synthesis Examples and Examples. However, the present disclosure is not limited thereto. The wording "compound B was used instead of compound A" used in describing Synthesis Examples means that an amount of compound B used was identical to an amount of compound A used based on molar equivalence, wherein compounds A and B are not the same.

EXAMPLES

Synthesis Example 1 (Synthesis of Compound 1)

The synthesis of Compound 1 is shown in Scheme 1.

Scheme 1

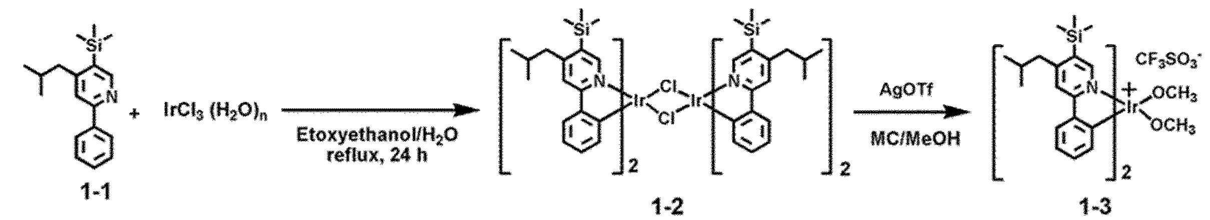


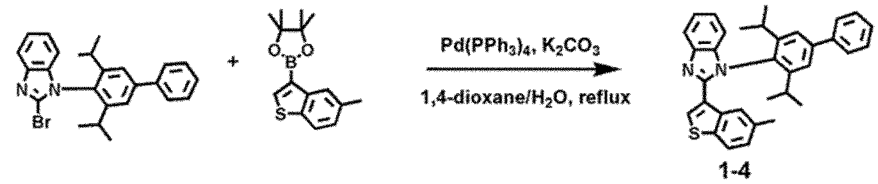


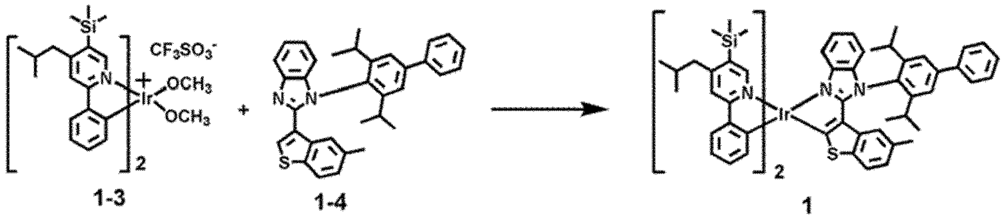


Synthesis of Compound 1-2

10 grams (g) (35.33 millimoles, mmol) of Compound 1-1 and 6.17 g (17.50 mmol) of iridium chloride were mixed with 90 milliliters (mL) of ethoxyethanol and 30 mL of distilled water. Then, the mixture was stirred under reflux for 24 hours, and then the temperature was dropped to room temperature. A solid was formed therefrom and separated by filtration. The solid was sufficiently washed with water, methanol, and hexane in this stated order and dried in a vacuum oven to thereby obtain 11.5 g of Compound 1-2 (83%).

Synthesis of Compound 1-3

45 mL of methylene chloride (MC) was mixed with 5.00 g (3.16 mmol) of Compound 1-2, and a mixture of 1.70 g (6.62 mmol) of silver triflate (AgOTf) and 15 mL of methanol was added thereto. Then, the mixture was stirred for about 18 hours at room temperature while blocking light by using an aluminum foil. The resultant was filtered using diatomaceous earth to remove a solid formed therefrom and the solvent in the resulting filtrate was removed under reduced pressure to thereby obtain a solid (Compound 1-3). The solid was used in the following reaction without any further purification.

Synthesis of Compound 1-4

10 g (23.07 mmol) of 2-bromo-1-(3,5-diisopropyl-[1,1'-biphenyl]-4-yl)-1H-benzo[d]imidazole), 6.33 g (23.07 mmol) of 4,4,5,5-tetramethyl-2-(5-methylbenzo[b]thiophen-3-yl)-1,3,2-dioxaborolane, 0.80 g (0.69 mmol) of $Pd(PPh_3)_4$, and 15.94 g (117.27 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using ethyl acetate (EA) and hexane at a ratio (volume ratio, the same below) of 1:3 to thereby obtain 10.51 g of Compound 1-4 (91%).

Synthesis of Compound 1

5.00 g (5.15 mmol) of Compound 1-3 and 2.84 g (5.67 mmol) of Compound 1-4 were mixed with 50 mL of 2-ethoxyethanol and 50 mL of N,N-dimethylformamide. Then, the mixture was stirred under reflux for 18 hours at 120°C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 2.20 g of Compound 1 (31%). The resulting compound was identified by using mass spectroscopy and high-performance liquid chromatography (HPLC) analysis. HRMS(MALDI) calculated for $C_{70}H_{79}IrN_4SSi_2$: m/z 1256.5193, Found: 1256.5198.

Synthesis Example 2 (Synthesis of Compound 2)

The synthesis of Compound 2 is shown in Scheme 2.

Scheme 2

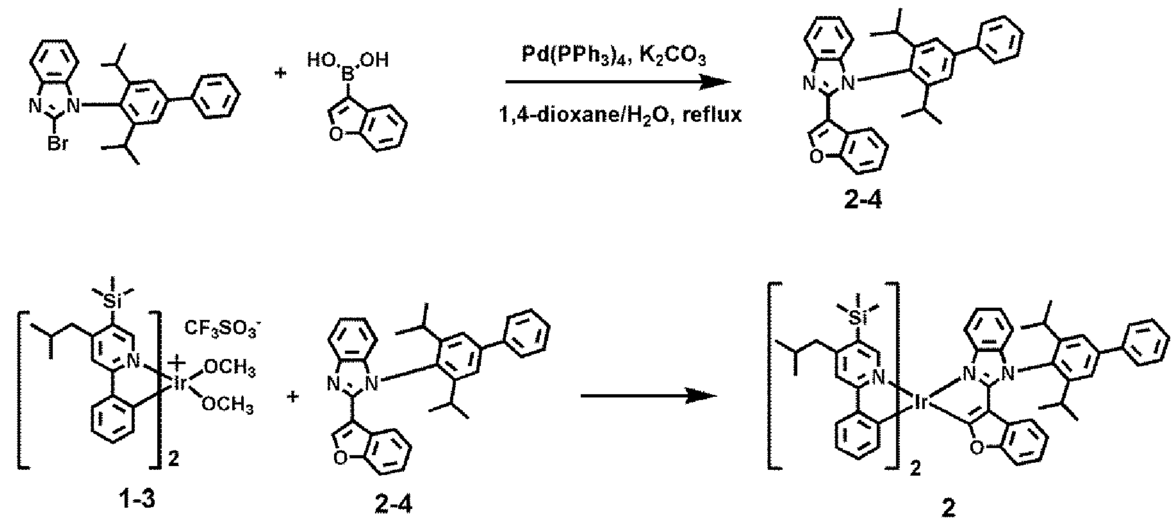


2-4

1-3 2-4 2

Synthesis of Compound 2-4

10 g (23.07 mmol) of 2-bromo-1-(3,5-diisopropyl-[1,1'-biphenyl]-4-yl)-1H-benzo[d]imidazole), 3.74 g (23.07 mmol) of benzofuran-3-ylboronic acid, 0.80 g (0.69 mmol) of $Pd(PPh_3)_4$, and 15.94 g (117.27 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using EA and hexane at a ratio of 1:3 to thereby obtain 8.69 g of Compound 2-4 (80 %).

Synthesis of Compound 2

3.00 g (3.09 mmol) of Compound 1-3 and 1.60 g (3.40 mmol) of Compound 2-4 were mixed with 50 mL of 2-ethoxyethanol and 50 mL of N,N-dimethylformamide. Then, the mixture was stirred under reflux for 18 hours at 120°C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 1.06 g of Compound 2 (28 %). The resulting compound was identified by using mass spectroscopy and high-performance liquid chromatography (HPLC) analysis. HRMS(MALDI) calcd. for $C_{69}H_{77}IrN_4OSi_2$: m/z 1226.5265, Found: 1226.5269.

Synthesis Example 3 (Synthesis of Compound 3)

The synthesis of Compound 3 is shown in Scheme 3.

Scheme 3

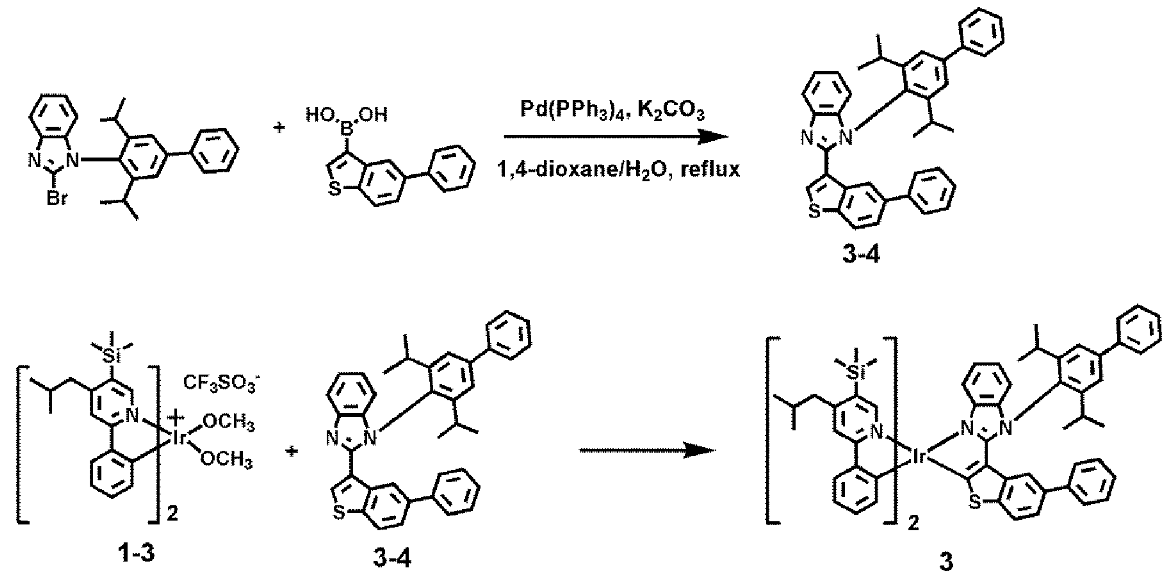


3-4

1-3 3-4 3

Synthesis of Compound 3-4

5 g (11.54 mmol) of 2-bromo-1-(3,5-diisopropyl-[1,1'-biphenyl]-4-yl)-1H-benzo[d]imidazole), 2.93 g (11.54 mmol) of 5-phenylbenzothiophene-3-ylboronic acid, 0.40 g (0.35 mmol) of $Pd(PPh_3)_4$, and 7.97 g (58.63 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using EA and hexane at a ratio of 1:3 to thereby obtain 5.46 g of Compound 3-4 (84%).

Synthesis of Compound 3

2.20 g (2.27 mmol) of Compound 1-3 and 1.41 g (2.50 mmol) of Compound 3-4 were mixed with 50 mL of 2-ethoxyethanol and 50 mL of N,N-dimethylformamide. Then, the mixture was stirred under reflux for 18 hours at 120°C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 0.87 g of Compound 3 (29%). The resulting compound was identified by using mass spectroscopy and high-performance liquid chromatography (HPLC) analysis. HRMS(MALDI) calcd. for $C_{75}H_8IrN_4SSi_2$: m/z 1318.5350, Found: 1318.5352

Synthesis Example 4 (Synthesis of Compound 4)

The synthesis of Compound 4 is shown in Scheme 4.

Scheme 4

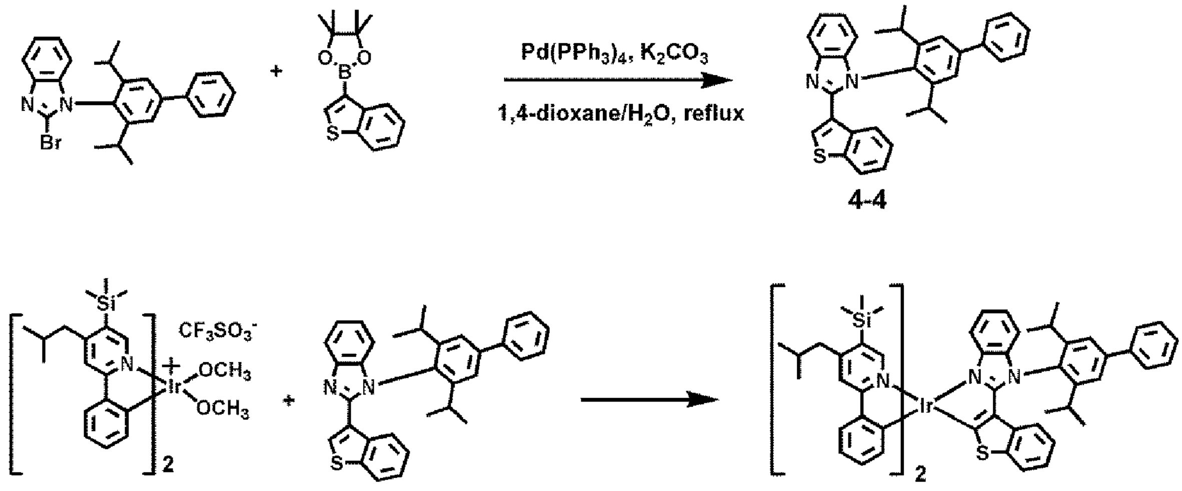


4-4

1-3

4-4

4

Synthesis of Compound 4-4

6.32 g (14.59 mmol) of 2-bromo-1-(3,5-diisopropyl-[1,1'-biphenyl]-4-yl)-1H-benzo[d]imidazole), 3.80 g (14.59 mmol) of 2-(benzo[b]thiophen-3-yl)-4,4,5,5-tetramethyl-1,3,2-dioxaborolane, 0.42 g (0.36 mmol) of $Pd(PPh_3)_4$, and 10.08 g (72.95 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using EA and hexane at a ratio of 1:3 to thereby obtain 5.33 g of Compound 4-4 (75%).

Synthesis of Compound 4

1.50 g (1.55 mmol) of Compound 1-3 and 0.75 g (1.55 mmol) of Compound 4-4 were mixed with 50 mL of 2-ethoxyethanol and 50 mL of N,N-dimethylformamide. Then, the mixture was stirred under reflux for 18 hours at 120 °C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 0.40 g of Compound 4 (21%). The resulting compound was identified by using mass spectroscopy and HPLC analysis. HRMS (MALDI) calcd. for $C_{69}H_{77}IrN_4SSi_2$: m/z 1242.5037, Found: 1242.5041

Synthesis Example 5 (Synthesis of Compound 5)

The synthesis of Compound 5 is shown in Scheme 5.

Scheme 5

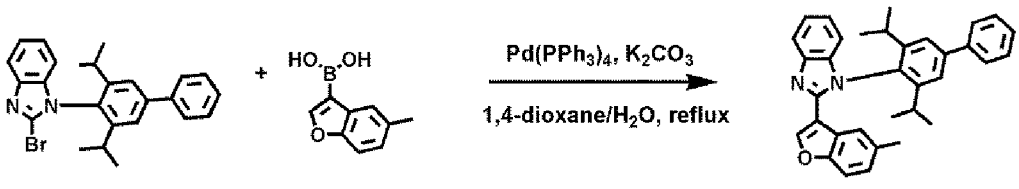


5-4

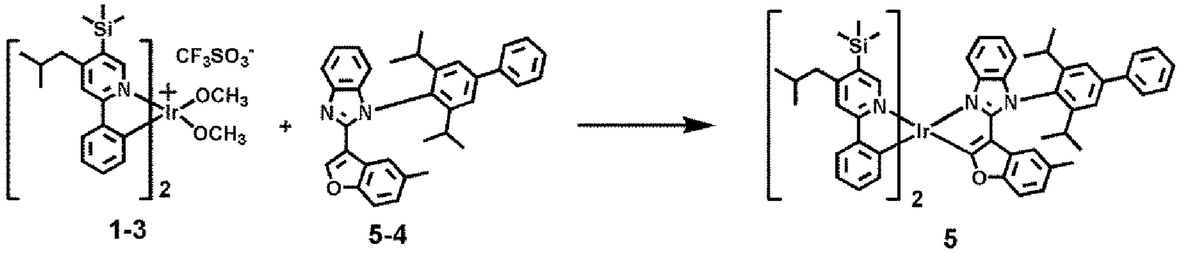

1-3 5-4 5

Synthesis of Compound 5-4

3.00 g (6.92 mmol) of 2-bromo-1-(3,5-diisopropyl-[1,1'-biphenyl]-4-yl)-1H-benzo[d]imidazole), 1.22 g (6.92 mmol) of (5-methylbenzofuran-3-yl)boronic acid, 0.16 g (0.14 mmol) of $Pd(PPh_3)_4$, and 4.78 g (34.60 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using EA and hexane at a ratio of 1:3 to thereby obtain 2.92 g of Compound 5-4 (87%).

Synthesis of Compound 5

2.00 g (2.06 mmol) of Compound 1-3 and 1.10 g (2.27 mmol) of Compound 5-4 were mixed with 50 mL of 2-ethoxyethanol and 50 mL of N,N-dimethylformamide. Then, the mixture was stirred under reflux for 18 hours at 120 °C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 0.89 g of Compound 5 (35%). The resulting compound was identified by using mass spectroscopy and HPLC analysis. HRMS (MALDI) calcd. for $C_{70}H_{79}IrN_4OSi_2$: m/z 1240.5422, Found: 1240.5422

Synthesis Example 6 (Synthesis of Compound 821)

The synthesis of Compound 821 is shown in Scheme 6.

Scheme 6

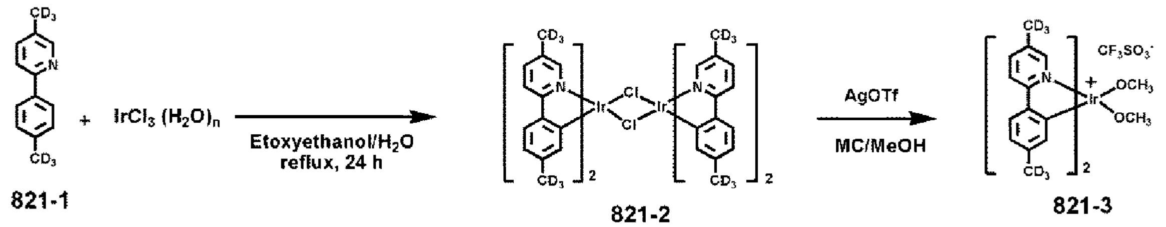


821-1 821-2 821-3

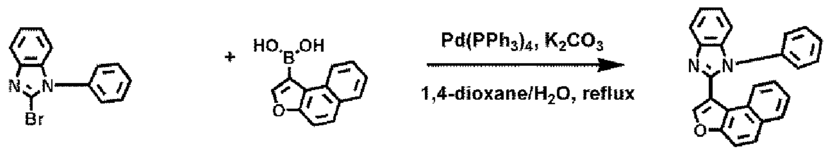


821-4

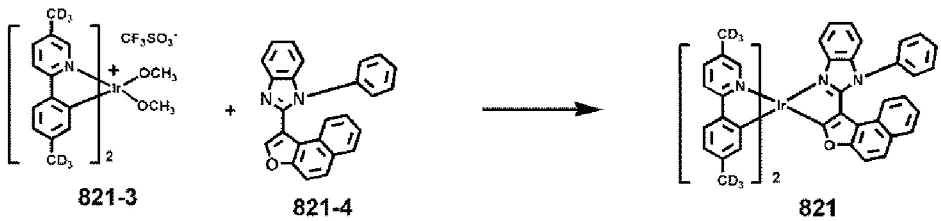

821-3 821-4 821

Synthesis of Compound 821-2

10 g (52.83 mmol) of Compound 821-1 (5-(methyl-d3)-2-(4-(methyl-d3)phenyl)pyridine) and 8.47 g (24.01 mmol) of iridium chloride were mixed with 90 mL of ethoxyethanol and 30 mL of distilled water. Then, the mixture was stirred under reflux for 24 hours to carry out the reaction, and then the temperature was dropped to room temperature. A solid was formed therefrom and separated by filtration. The solid was sufficiently washed with water, methanol, and hexane in this stated order and dried in a vacuum oven to thereby obtain 12.04 g of Compound 821-2 (83%).

Synthesis of Compound 821-3

45 mL of MC was mixed with 3.00 g (2.48 mmol) of Compound 821-2, and a solution, in which 1.40 g (5.46 mmol) of AgOTf is dissolved in 15 mL of methanol, was added thereto. Then, the mixture was stirred for about 18 hours to carry out a reaction at room temperature while blocking light by using an aluminum foil. The resultant was filtered using diatomaceous earth to remove a solid formed therefrom and the solvent in the resulting filtrate was removed under reduced pressure to thereby obtain a solid (Compound 821-3). The solid was used in the following reaction without any further purification.

Synthesis of Compound 821-4

3 g (10.98 mmol) of 2-bromo-1-phenyl-1H-benzo[d]imidazole, 2.33 g (10.98 mmol) of 4-naphtho[2,1-b]furan-1-ylboronic acid, 0.25 g (0.22 mmol) of $Pd(PPh_3)_4$, and 7.59 g (54.90 mmol) of $K_2CO_3$ were mixed with 80 mL of 1,4-dioxane and 40 mL of distilled water. Then, the mixture was stirred for 18 hours under reflux. Once the temperature was dropped to room temperature, an organic layer was extracted using MC, and anhydrous magnesium sulfate ($MgSO_4$) was added thereto to dry the organic layer. The resultant was filtered, and the solvent in the resulting filtrate was removed under reduced pressure. The residual was purified through column chromatography using EA and hexane at a ratio of 1:3 to thereby obtain 2.57 g of Compound 821-4 (65%).

Synthesis of Compound 821

3 g (2.56 mmol) of Compound 821-3 and 1.02 g (2.82 mmol) of Compound 821-4 were mixed with 50 mL of 2-ethoxyethanol and 50 mL of N,N-dimethylformamide. Then, the mixture was stirred under reflux for 18 hours at 120

°C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 0.74 g of Compound 821 (31 %). The resulting compound was identified by using mass spectroscopy and HPLC analysis. HRMS (MALDI) calcd. for $C_{51}H_{27}D_{12}IrN_4O$: m/z 928.3506, Found: 928.3504.

Synthesis Example 7 (Synthesis of Compound 822)

The synthesis of Compound 822 is shown in Scheme 7.

Scheme 7

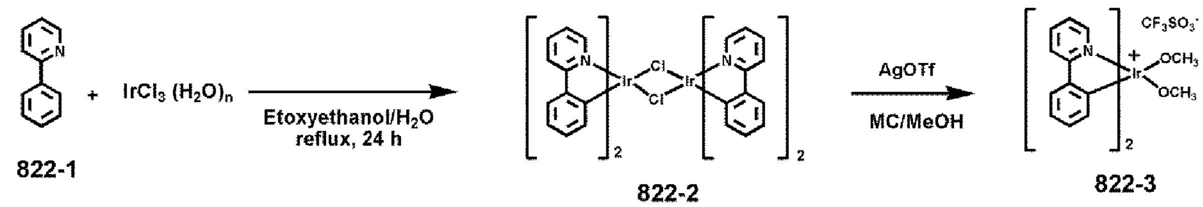


822-1 822-2 822-3

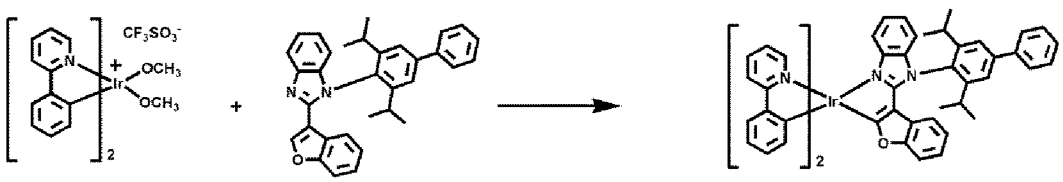

822-3 2-4 822

Synthesis of Compound 822-2

5 g (32.22 mmol) of Compound 822-1 (2-phenylpyridine) and 5.17 g (14.65 mmol) of iridium chloride were mixed with 90 mL of ethoxyethanol and 30 mL of distilled water. Then, the mixture was stirred while refluxing for about 24 hours to carry out a reaction, and then the temperature was dropped to room temperature. A solid was formed therefrom and separated by filtration. The solid was sufficiently washed with water, methanol, and hexane in this stated order and dried in a vacuum oven to thereby obtain 5.50 g of Compound 822-2 (70%).

Synthesis of Compound 822-3

45 mL of MC was mixed with 3.00 g (2.80 mmol) of Compound 822-2, and a solution, in which 1.29 g (5.02 mmol) of AgOTf is dissolved in 15 mL of methanol, was added thereto. Then, the mixture was stirred for about 18 hours to carry out a reaction at room temperature while blocking light by using an aluminum foil. The resultant was filtered using diatomaceous earth to remove a solid formed therefrom and the solvent in the resulting filtrate was removed under reduced pressure to thereby obtain a solid (Compound 822-3). The solid was used in the following reaction without any further purification.

Synthesis of Compound 822

2 g (2.80 mmol) of Compound 822-3 and 1.45 g (3.08 mmol) of Compound 2-4 were mixed with 50 mL of 2-ethoxyethanol and 50 mL of N,N-dimethylformamide. Then, the mixture was stirred under reflux for 18 hours at 120 °C to carry out the reaction. Then, the temperature was dropped. The resulting mixture was filtered to obtain a solid. Then, the solid was sufficiently washed with ethanol and hexane. Then, the solid was purified by column chromatography using EA and hexane at a ratio of 1:50 to thereby obtain 0.54 g of Compound 822 (20 %). The resulting compound was identified by using mass spectroscopy and HPLC analysis. HRMS (MALDI) calcd. for $C_{55}H_{45}IrN_4O$: m/z 970.3223, Found: 970.3227.

Synthesis Example 8 (Synthesis of Compound 767)

The synthesis of Compound 767 is shown in Scheme 8.

Scheme 8

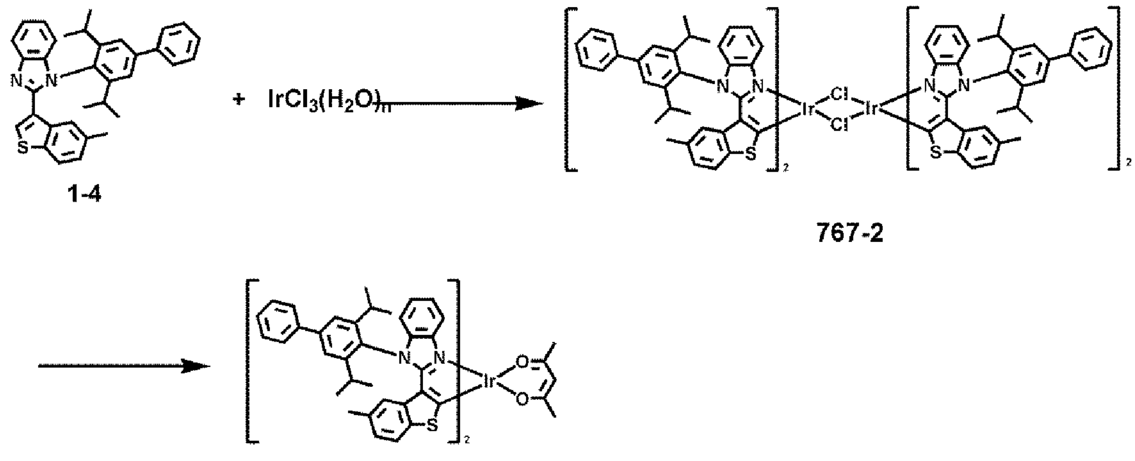


1-4

767-2

767

Synthesis of Compound 767-2

5 g (9.99 mmol) of Compound 1-4 and 1.76 g (5.00 mmol) of iridium chloride were mixed with 90 mL of ethoxyethanol and 30 mL of distilled water. Then, the mixture was stirred under reflux for 24 hours to carry out the reaction, and then the temperature was dropped to room temperature. A solid was formed therefrom and separated by filtration. The solid was sufficiently washed with water, methanol, and hexane in this stated order and dried in a vacuum oven to thereby obtain 4.91 g of Compound 767-2 (80%).

Synthesis of Compound 767

4 g (1.63 mmol) of Compound 767-2 and 1.80 g (18 mmol) of acetylacetone, and 2.49 g (18 mmol) of $K_2CO_3$ were added to 60 mL of 2-ethoxyethanol, followed by stirring at room temperature for 24 hours. The resulting solid product was removed therefrom by filtration, followed by performing column chromatography using ethyl acetate and hexane to thereby obtain 0.63 g of Compound 767 (30%). The resulting compound was identified by using mass spectroscopy and HPLC analysis. HRMS (MALDI) calcd. for $C_{73}H_{71}IrN_4O_2S_2$: m/z 1292.4648, Found: 1292.4644.

Example 1

A glass substrate, on which ITO is patterned as an anode, was cut to a size of 50 millimeters (mm) × 50 mm × 0.5 mm, sonicated in isopropyl alcohol and water for 5 minutes each, and cleaned by exposure to ultraviolet rays and ozone for 30 minutes. Subsequently, the glass substrate was mounted on a vacuum-deposition device.

Compound HT3 and Compound F6-TCNNQ were co-vacuum-deposited on the anode at a weight ratio of 98:2 to form a hole injection layer having a thickness of 100 Å. Compound HT3 was then vacuum-deposited on the hole injection layer to form a hole transport layer having a thickness of 1,650 Å.

Subsequently, Compound CBP (as a host) and Compound 1 (as a dopant) were co-deposited on the hole transport layer at a weight ratio of 95:5 to form an emission layer having a thickness of 400 Å.

Compound ET3 and Compound ET-D1 were co-deposited at a volume ratio of 50:50 on the emission layer to form an electron transport layer having a thickness of 350 Å, Compound ET-D1 was deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

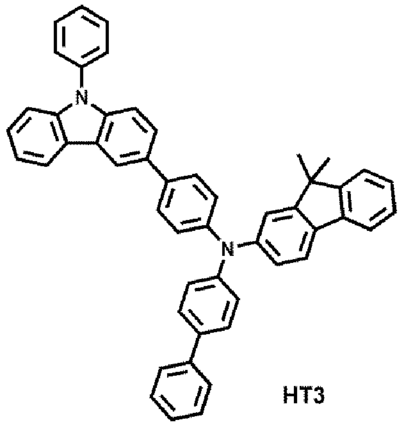

HT3

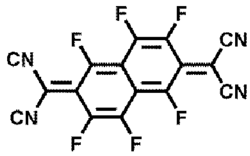

F6-TCNNQ

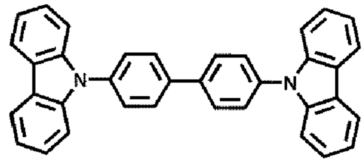

CBP

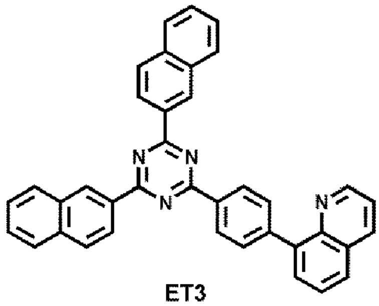

ET3

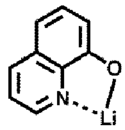

ET-D1

Examples 2 to 7 and Comparative Example A

Organic light-emitting devices were manufactured in substantially the same manner as in Example 1, except that the compounds shown in Table 2 were used instead of Compound 1 as a dopant in the formation of an emission layer.

Evaluation Example 1

The driving voltage (V), the maximum external quantum efficiency (Max EQE, %), and the roll-off ratio (%) of the organic light-emitting devices manufactured in Examples 1 to 7 and Comparative Example A were evaluated. The evaluation results are shown in Table 2. A Keithley 2400 current voltmeter and a luminance meter (Minolta Cs-1000A) were used in evaluation. The roll-off ratio was calculated by Equation 20. The max EQE in Table 2 are shown in relative values (%).

Equation 20

Roll-off ratio = {1-(efficiency (at 8,000 nit)/maximum luminescence efficiency)} × 100 %

Table 2

| | Dopant in emission layer | Driving voltage (V) | Max EQE (relative value, %) | Roll-off ratio (%) |
|---|---|---|---|---|
| Example 1 | 1 | 4.1 | 100 | 13 |
| Example 2 | 2 | 4.1 | 83 | 18 |
| Example 3 | 3 | 3.9 | 96 | 14 |
| Example 4 | 4 | 4.0 | 100 | 14 |
| Example 5 | 5 | 4.2 | 87 | 18 |

(continued)

| | Dopant in emission layer | Driving voltage (V) | Max EQE (relative value, %) | Roll-off ratio (%) |
|---|---|---|---|---|
| Example 6 | 821 | 4.3 | 74 | 20 |
| Example 7 | 822 | 4.3 | 78 | 15 |
| Comparative Example A | A | 4.6 | 65 | 25 |

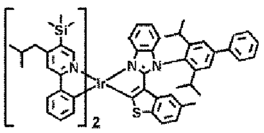
1

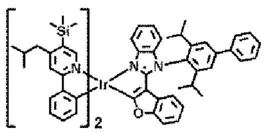
2

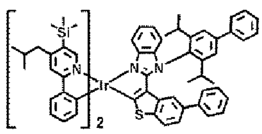
3

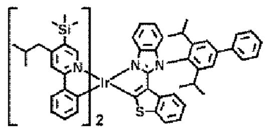
4

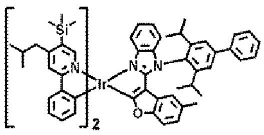
5

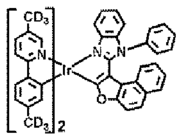
821

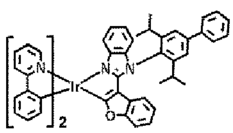
822

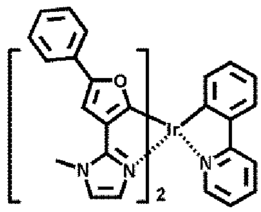
A

Referring to Table 2, the organic light-emitting devices of Examples 1 to 7 were found to have improved driving voltage, improved external quantum efficiency, and improved roll-off ratio, as compared with the organic light-emitting device of Comparative Example A.

Example 8 and Comparative Example B

Organic light-emitting devices were manufactured in substantially the same manner as in Example 1, except that the compounds shown in Table 3 were used instead of Compound 1 as a dopant in the formation of an emission layer.

Evaluation Example 2

The driving voltage (V), the Max EQE (%), and the roll-off ratio (%) of the organic light-emitting devices manufactured in Example 8 and Comparative Example B were evaluated in substantially the same manner as in Evaluation Example 1. The evaluation results are shown in Table 3. The Max EQE in Table 3 are shown in relative values (%).

Table 3

| | Dopant in emission layer | Driving voltage (V) | Max EQE (relative value, %) | Roll-off ratio (%) |
|---|---|---|---|---|
| Example 8 | 767 | 4.5 | 100 | 23 |
| Comparative Example B | B | 4.8 | 84 | 29 |

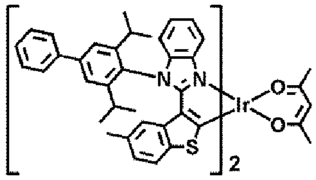 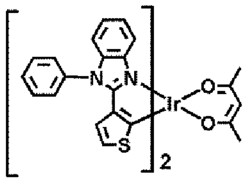

767 B

Referring to Table 3, the organic light-emitting device of Example 8 was found to have improved driving voltage, improved external quantum efficiency, and improved roll-off ratio, as compared with the organic light-emitting device of Comparative Example B.

As apparent from the foregoing description, the organometallic compound may have excellent electrical characteristics, and thus, an electronic device, e.g., an organic light-emitting device, including the organometallic compound may have improved driving voltage, improved external quantum efficiency, and/or improved roll-off ratio characteristics.

It should be understood that the exemplary embodiments described herein should be considered in a descriptive sense only and not for purposes of limitation. Descriptions of features or aspects within each exemplary embodiment should be considered as an available feature or aspect of other exemplary embodiments.

## Claims

1. An organometallic compound represented by Formula 1:

Formula 1 $M(L_1)_{n1}(L_2)_{n2}$

wherein, in Formula 1,

M is iridium (Ir), platinum (Pt), osmium (Os), titanium (Ti), zirconium (Zr), hafnium (Hf), europium (Eu), terbium (Tb), thulium (Tm), or rhodium (Rh),
$L_1$ is a ligand represented by Formula 2,
n1 is 1, 2, or 3, and when n1 is 2 or greater, at least two $L_1$ groups are identical to or different from each other,
$L_2$ is a monodentate ligand, a bidentate ligand, a tridentate ligand, or a tetradentate ligand,
n2 is 0, 1, 2, 3, or 4, and when n2 is 2 or greater, at least two $L_2$ groups are identical to or different from each other,
$L_1$ is different from $L_2$,

Formula 2

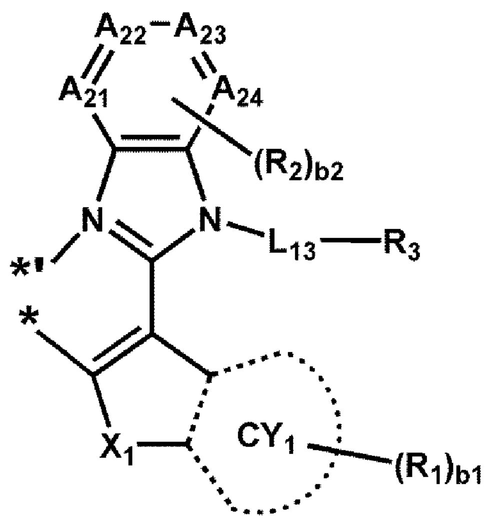

wherein, in Formula 2,
$A_{21}$ to $A_{24}$ are each independently N or C,

$X_1$ is O or S,

$L_{13}$ is a single bond, a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

ring $CY_1$ is a $C_5$-$C_{30}$ carbocyclic group or a $C_1$-$C_{30}$ heterocyclic group,

$R_1$ and $R_2$ are each independently hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -$N(Q_1)(Q_2)$, -$Si(Q_3)(Q_4)(Q_5)$, -$Ge(Q_3)(Q_4)(Q_5)$, -$B(Q_6)(Q_7)$, -$P(=O)(Q_8)(Q_9)$, or-$P(Q_8)(Q_9)$,

$R_3$ is a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, or a substituted or unsubstituted monovalent non-aromatic condensed heteropolycyclic group,

b1 is an integer from 0 to 20,

b2 is an integer from 0 to 4,

at least two groups from a plurality of $R_1$ groups are optionally bonded together to form a $C_5$-$C_{30}$ carbocyclic group unsubstituted or substituted with at least one $R_{10a}$, or at least two groups from a plurality of $R_1$ groups are optionally bonded together to form a $C_1$-$C_{30}$ heterocyclic group unsubstituted or substituted with at least one $R_{10a}$,

at least two groups from a plurality of $R_2$ groups are optionally bonded together to form a $C_5$-$C_{30}$ carbocyclic group unsubstituted or substituted with at least one $R_{10a}$, or at least two groups from a plurality of $R_2$ groups are optionally bonded together to form a $C_1$-$C_{30}$ heterocyclic group unsubstituted or substituted with at least one $R_{10a}$,

$R_3$ and one of $R_1$ and $R_2$ are optionally bonded to each other to form a $C_5$-$C_{30}$ carbocyclic group unsubstituted or substituted with at least one $R_{10a}$, or $R_3$ and one of $R_1$ and $R_2$ are optionally bonded to each other to form a $C_1$-$C_{30}$ heterocyclic group unsubstituted or substituted with at least one $R_{10a}$,

$R_{10a}$ is understood by referring to the description of $R_1$ provided herein,

* and *' each indicate a bonding site to M in Formula 1, and

a substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group are each independently:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or a $C_1$-$C_{60}$ alkoxy group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each substituted with deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl

group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, - $Ge(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, - $B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or a combination thereof,

wherein $Q_1$ to $Q_9$, $Q_{11}$ to $Q_{19}$, $Q_{21}$ to $Q_{29}$, and $Q_{31}$ to $Q_{39}$ are each independently hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group unsubstituted or substituted with deuterium, a $C_1$-$C_{60}$ alkyl group, a $C_6$-$C_{60}$ aryl group, or a combination thereof; a $C_2$-$C_{60}$ alkenyl group; a $C_2$-$C_{60}$ alkynyl group; a $C_1$-$C_{60}$ alkoxy group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group unsubstituted or substituted with deuterium, a $C_1$-$C_{60}$ alkyl group, a $C_6$-$C_{60}$ aryl group, or a combination thereof; a $C_6$-$C_{60}$ aryloxy group; a $C_6$-$C_{60}$ arylthio group; a $C_{7-}C_{60}$ arylalkyl group; a $C_1$-$C_{60}$ heteroaryl group; a $C_1$-$C_{60}$ heteroaryloxy group; a $C_1$-$C_{60}$ heteroarylthio group; a $C_2$-$C_{60}$ heteroarylalkyl group; a monovalent non-aromatic condensed polycyclic group; or a monovalent non-aromatic condensed heteropolycyclic group.

**2.** The organometallic compound of claim 1, wherein $L_{13}$ is:

a single bond; or

a divalent group that is a benzene group, a naphthalene group, a pyridine group, a dibenzofuran group, a dibenzothiophene group, or a carbazole group, each unsubstituted or substituted with at least one $R_{10a}$.

**3.** The organometallic compound of claims 1 or 2, wherein ring $CY_1$ is a cyclopentane group, a cyclohexane group, a cycloheptane group, a cyclopentene group, a cyclohexene group, a cycloheptene group, an adamantane group, a norbornane group, a norbornene group, a bicyclo[1.1.1]pentane group, a bicyclo[2.1.1]hexane group, a bicyclo[2.2.2]octane group, a benzene group, a naphthalene group, an anthracene group, a phenanthrene group, a triphenylene group, a pyrene group, a chrysene group, a 1,2,3,4-tetrahydronaphthalene group, a pyrrole group, borole group, a phosphole group, a cyclopentadiene group, a silole group, a germole group, a thiophene group, a selenophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophenegroup, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a quinoxaline group, a quinazoline group, a phenanthroline group, a pyrazole group, an imidazole group, a triazole group, an azaborole group, an azaphosphole group, an azacyclopentadiene group, an azasilole group, an azagermole group, an azaselenophene group, an oxazole group, an isooxazole group, a thiazole group, an isothiazole group, an oxadiazole group, a thiadiazole group, a benzopyrazole group, a benzimidazole group, a benzoxazole

group, a benzothiazole group, a benzoxadiazole group, a benzothiadiazole group, a 5,6,7,8-tetrahydroisoquinoline group, or a 5,6,7,8-tetrahydroquinoline group; and/or
wherein $R_1$ and $R_2$ are each independently:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, a $C_1$-$C_{20}$ alkenyl group, a $C_1$-$C_{20}$ alkoxy group, or a $C_1$-$C_{20}$ alkylthio group;

a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_2$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

-$N(Q_1)(Q_2)$, -$Si(Q_3)(Q_4)(Q_5)$, -$Ge(Q_3)(Q_4)(Q_5)$, -$B(Q_6)(Q_7)$, -$P(=O)(Q_8)(Q_9)$, or -$P(Q_8)(Q_9)$, wherein $Q_1$ to $Q_9$ are each independently:

deuterium, -F, -$CH_3$, -$CD_3$, -$CD_2H$, -$CDH_2$, -$CH_2CH_3$, -$CH_2CD_3$, -$CH_2CD_2H$, -$CH_2CDH_2$, -$CHDCH_3$, -$CHDCD_2H$, -$CHDCDH_2$, -$CHDCD_3$, -$CD_2CD_3$, -$CD_2CD_2H$, -$CD_2CDH_2$, -$CF_3$, -$CF_2H$, -$CFH_2$, -$CH_2CF_3$, -$CH_2CF_2H$, -$CH_2CFH_2$, -$CHFCH_3$, -$CHFCF_2H$, -$CHFCFH_2$, -$CHFCF_3$, -$CF_2CF_3$, -$CF_2CF_2H$, or -$CF_2CFH_2$; or an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a $C_1$-$C_{10}$ alkyl group, a phenyl group, or a combination thereof.

**4.** The organometallic compound of any of claims 1-3, wherein $R_2$ is hydrogen, deuterium, -F, a cyano group, a substituted or unsubstituted $C_1$-$C_{60}$ alkyl group, a substituted or unsubstituted $C_3$-$C_{10}$ cycloalkyl group, -$Si(Q_3)(Q_4)(Q_5)$, or -$Ge(Q_3)(Q_4)(Q_5)$.

**5.** The organometallic compound of any of claims 1-4, wherein a group represented by

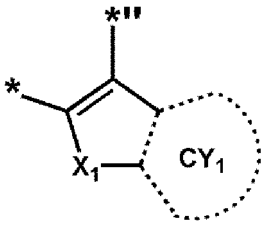

in Formula 2 is represented by one of Formulae 2(1) to 2(31):

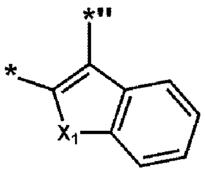

2(1)

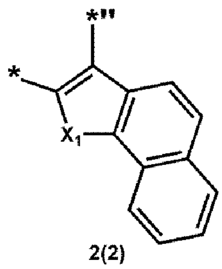

2(2)

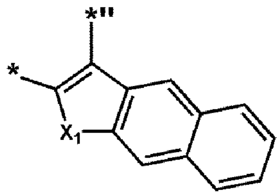

2(3)

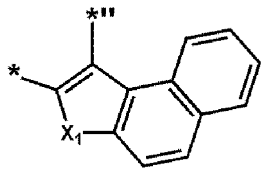

2(4)

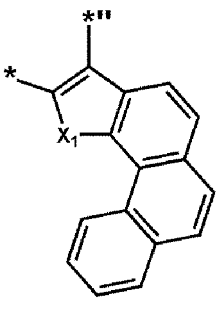

2(5)

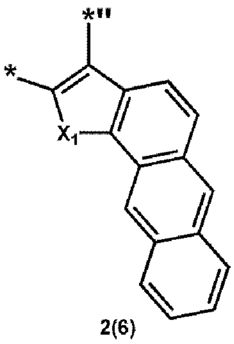

2(6)

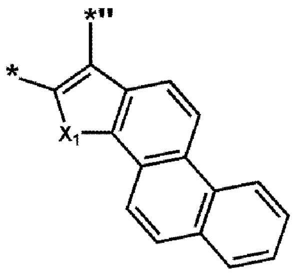

2(7)

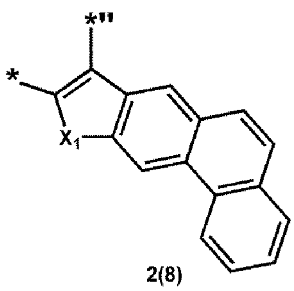

2(8)

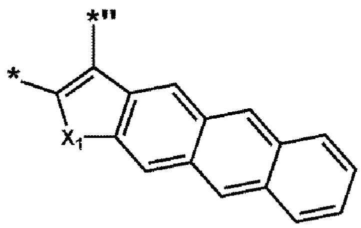

2(9)

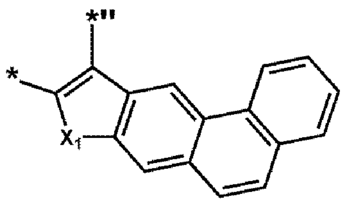

2(10)

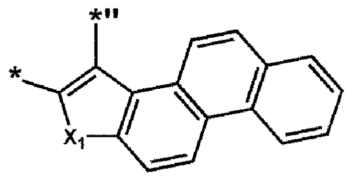

2(11)

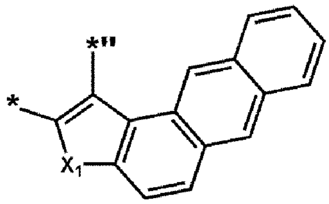

2(12)

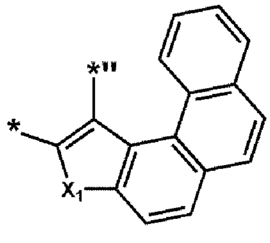

2(13)

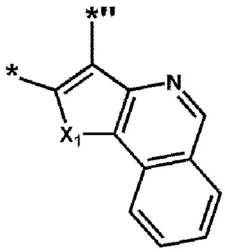

2(14)

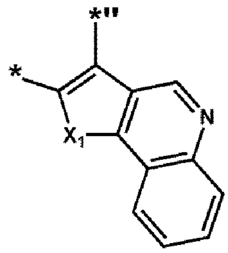

2(15)

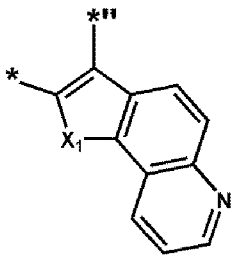

2(16)

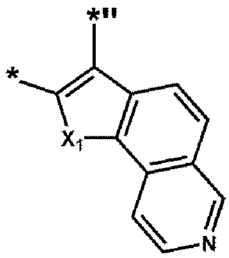

2(17)

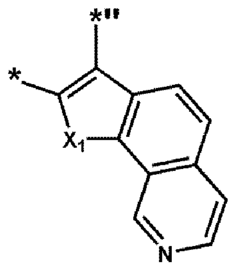

2(18)

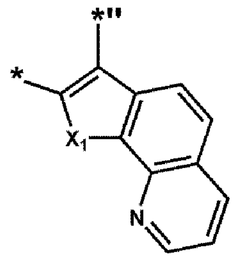

2(19)

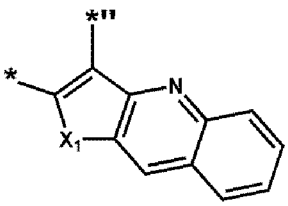

2(20)

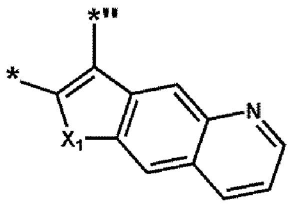

2(21)

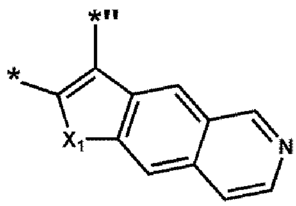

2(22)

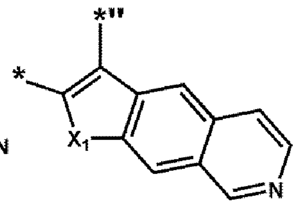

2(23)

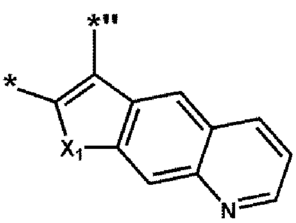

2(24)

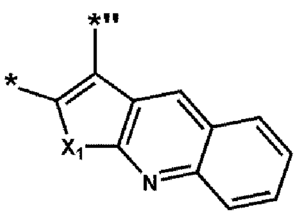

2(25)

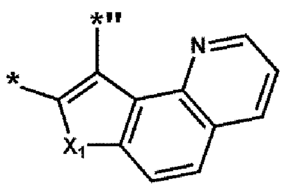

2(26)

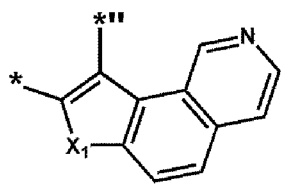

2(27)

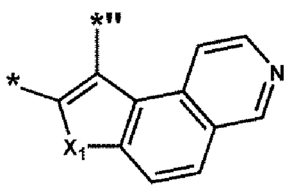

2(28)

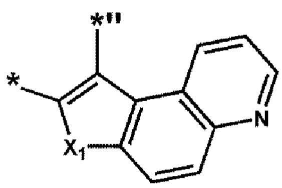

2(29)

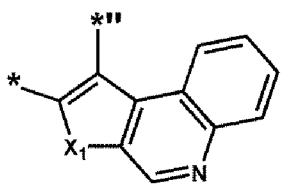

2(30)

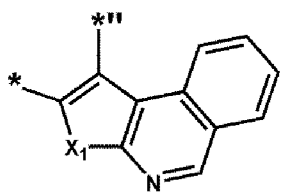

2(31)

wherein, in Formulae 2(1) to 2(31),

$X_1$ is understood by referring to the description of $X_1$ in claim 1,
* indicates a bonding site to M in Formula 1, and
*" indicates a bonding site to an adjacent carbon atom; or
wherein a group represented by

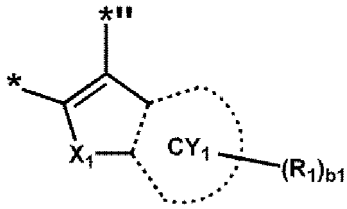

in Formula 2 is represented by one of Formulae 2-1 to 2-57:

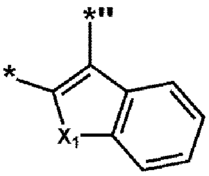

2-1

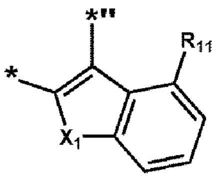

2-2

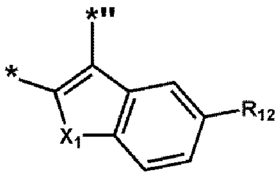

2-3

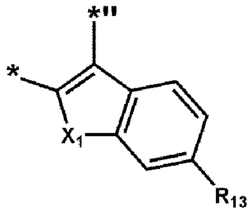

2-4

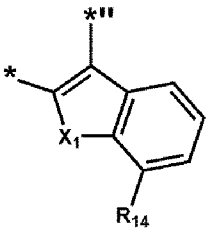

2-5

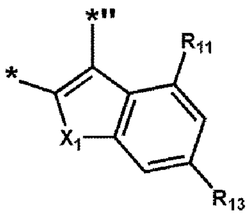

2-6

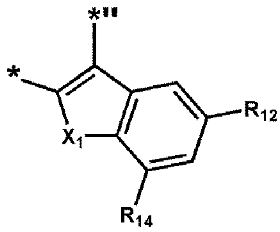

2-7

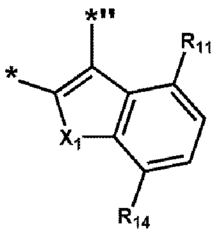

2-8

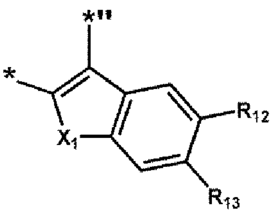

2-9

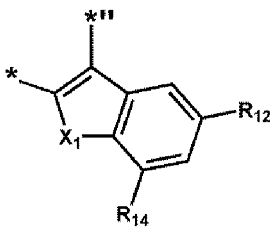

2-10

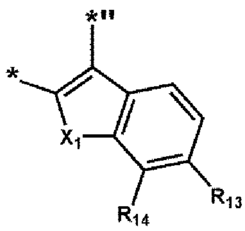

2-11

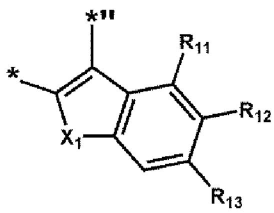

2-12

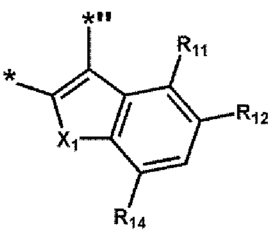

2-13

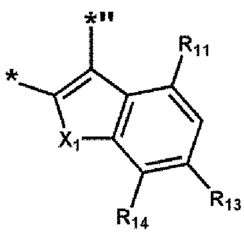

2-14

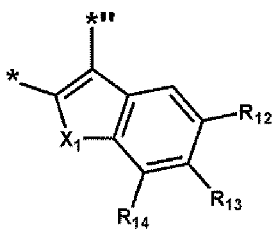

2-15

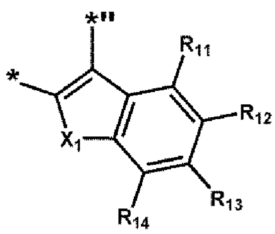

2-16

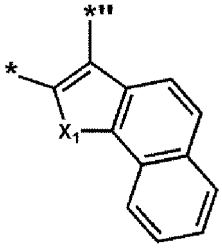

2-17

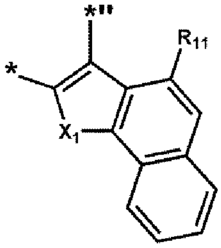

2-18

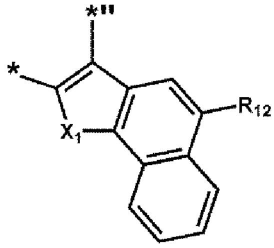

2-19

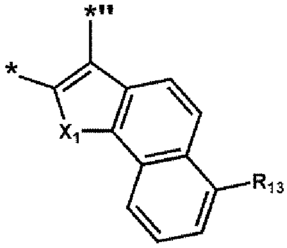

2-20

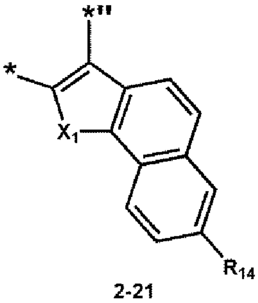

2-21

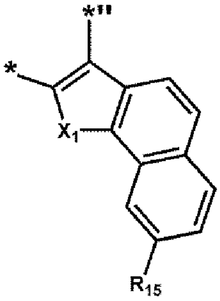

2-22

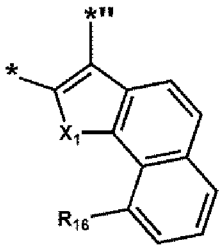

2-23

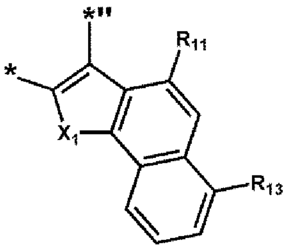

2-24

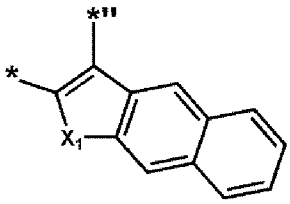

2-25

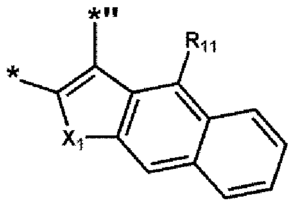

2-26

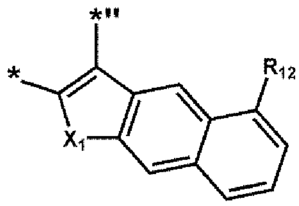

2-27

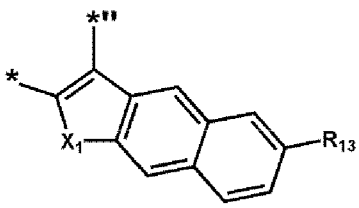

2-28

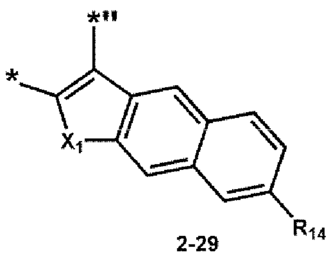

2-29

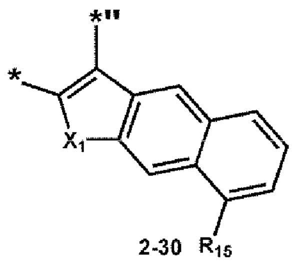

2-30

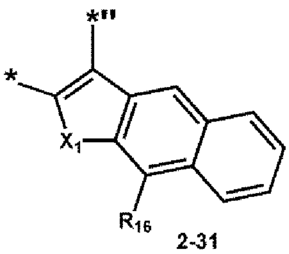

2-31

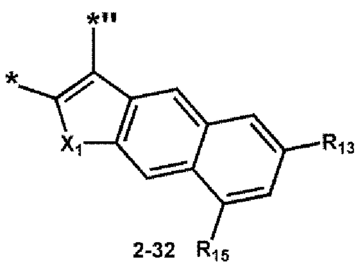

2-32

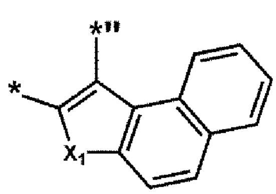

2-33

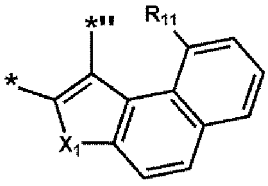
2-34

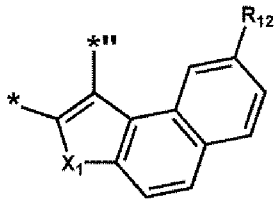
2-35

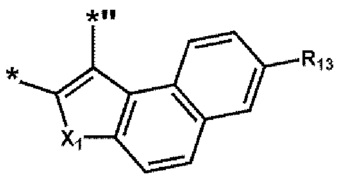
2-36

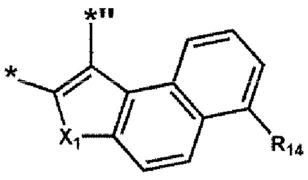
2-37

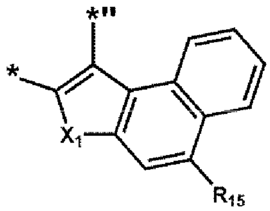
2-38

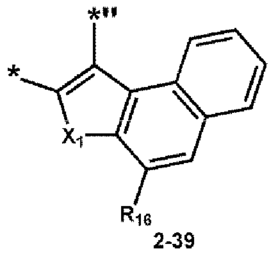
2-39

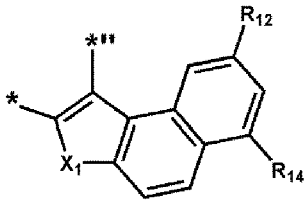
2-40

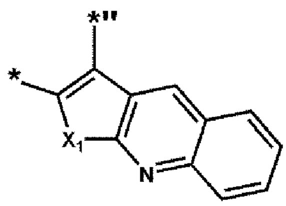
2-41

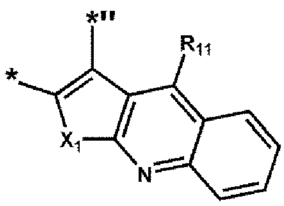
2-42

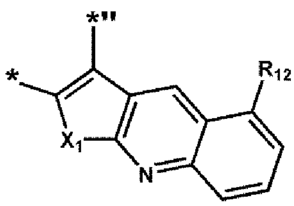
2-43

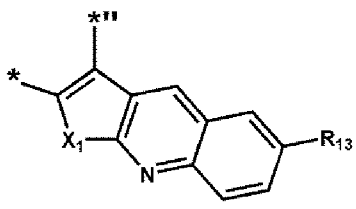
2-44

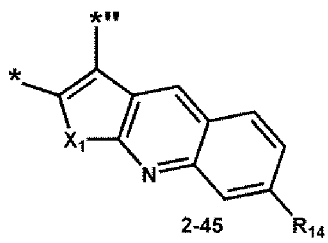
2-45

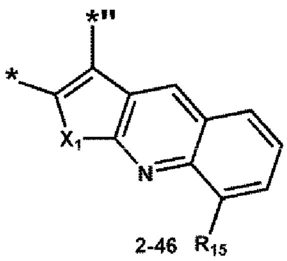
2-46

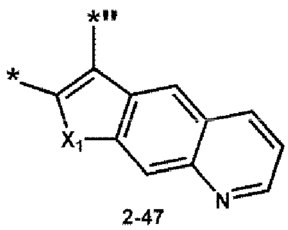
2-47

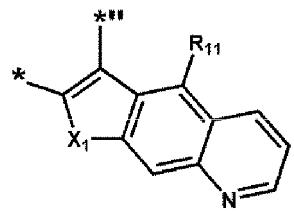
2-48

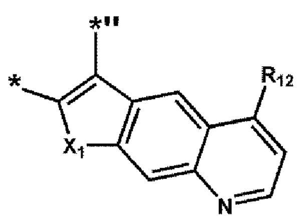
2-49

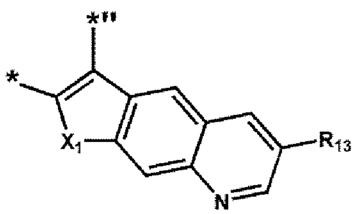
2-50

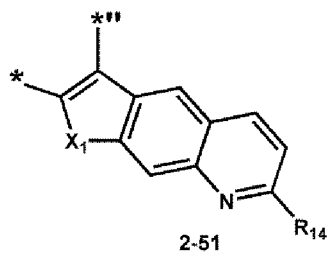
2-51

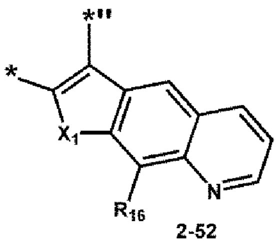

2-52

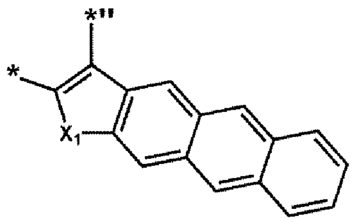

2-53

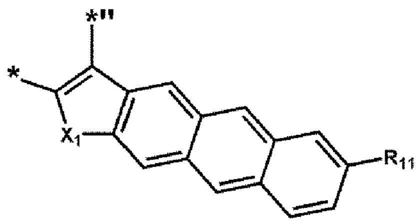

2-54

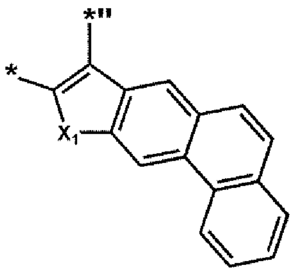

2-55

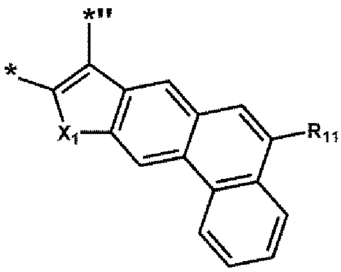

2-56

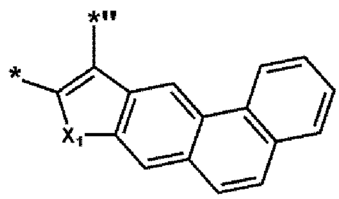

2-57

wherein, in Formulae 2-1 to 2-57,
$X_1$ is understood by referring to the description of $X_1$ in claim 1,
$R_{11}$ to $R_{16}$ are each understood by referring to the description of $R_1$ in claim 1, wherein $R_{11}$ to $R_{16}$ are each not hydrogen,
* indicates a bonding site to M in Formula 1, and
*" indicates a bonding site to an adjacent carbon atom.

6. The organometallic compound of any of claims 1-5, wherein $L_2$ in Formula 1 is a bidentate ligand bonded to M in Formula 1 via O, S, Se, N, C, P, Si, As, or a combination thereof; or
wherein $L_2$ in Formula 1 is a bidentate ligand bonded to M in Formula 1 via N and C or a bidentate ligand bonded to M in Formula 1 via two 0 atoms.

7. The organometallic compound of any of claims 1-6, wherein $L_2$ in Formula 1 is a group represented by one of Formulae 3A to 3F:

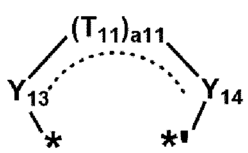

3A

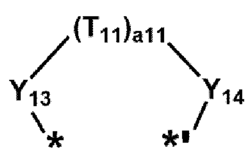

3B

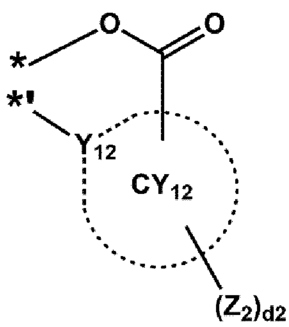

3C

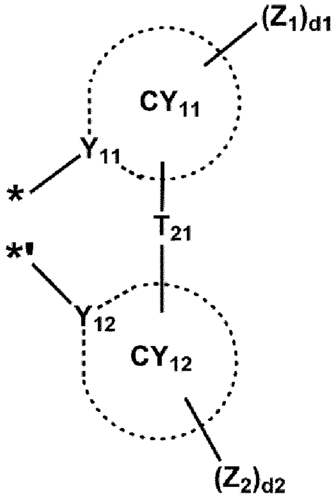

3D

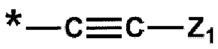

3E

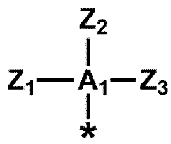

3F

wherein in Formulae 3A to 3F,

$Y_{13}$ is O, N, $N(Z_1)$, $P(Z_1)(Z_2)$, or $As(Z_1)(Z_2)$,
$Y_{14}$ is O, N, $N(Z_3)$, $P(Z_3)(Z_4)$, or $As(Z_3)(Z_4)$,
$T_{11}$ is a single bond, a double bond, $*-C(Z_{11})(Z_{12})-*'$, $*-C(Z_{11})=C(Z_{12})-*'$, $*=C(Z_{11})-*'$, $*-C(Z_{11})=*'$, $*=C(Z_{11})-C(Z_{12})=C(Z_{13})-*'$, $*-C(Z_{11})=C(Z_{12})-C(Z_{13})=*'$, $*-N(Z_{11})-*'$, or a $C_5$-$C_{30}$ carbocyclic group unsubstituted or substituted with at least one $Z_{11}$,
a11 is an integer from 1 to 10, and when a11 is 2 or greater, at least two $T_{11}$ groups are identical to or different from each other,
$Y_{11}$ and $Y_{12}$ are each independently C or N,
$T_{21}$ is a single bond, a double bond, O, S, $C(Z_{11})(Z_{12})$, $Si(Z_{11})(Z_{12})$, or $N(Z_{11})$,
ring $CY_{11}$ and ring $CY_{12}$ are each independently a $C_5$-$C_{30}$ carbocyclic group or a $C_1$-$C_{30}$ heterocyclic group,
$A_1$ is P or As,
$Z_1$ to $Z_4$ and $Z_{11}$ to $Z_{13}$ are each understood by referring to $R_1$ in claim 1,
d1 and d2 are each independently an integer from 0 to 20, and
* and *' each indicate a bonding site to M in Formula 1;
preferably wherein $L_2$ is a ligand represented by Formula 3D, and at least one of $Z_1$ and $Z_2$ in Formula 3D are each independently deuterium; $-Si(Q_3)(Q_4)(Q_5)$; $-Ge(Q_3)(Q_4)(Q_5)$; or a $C_1$-$C_{60}$ alkyl group substituted with at least one deuterium.

**8.** The organometallic compound of claim 7, wherein $L_2$ is a ligand represented by one of Formulae 3-1 and 3-101 to 3-112:

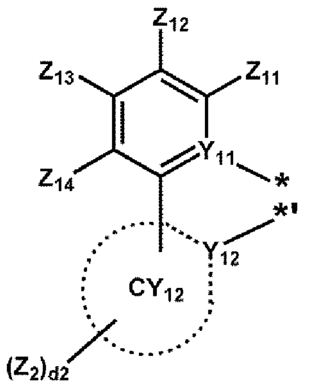

3-1

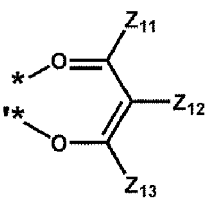

3-101

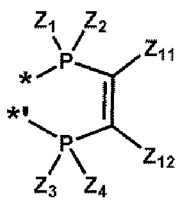

3-102

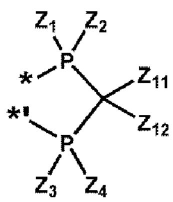

3-103

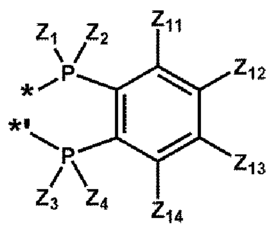

3-104

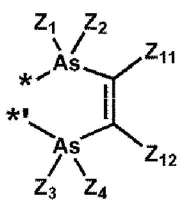

3-105

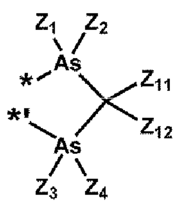

3-106

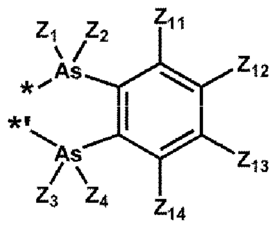

3-107

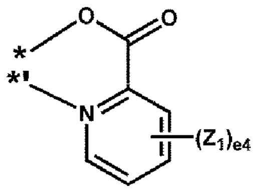

3-108

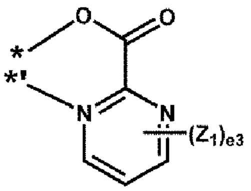

3-109

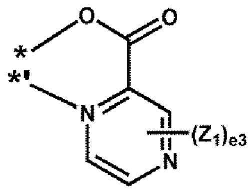

3-110

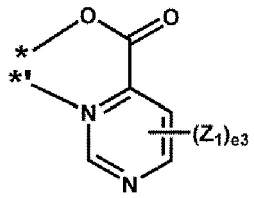

3-111

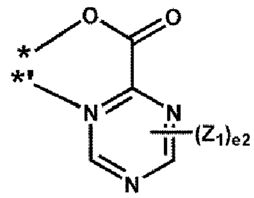

3-112

wherein, in Formulae 3-1 and 3-101 to 3-112,

$Y_{11}$, $Y_{12}$, ring $CY_{12}$, $Z_1$ to $Z_4$, $Z_{11}$ to $Z_{13}$, and d2 are each respectively understood by referring to $Y_{11}$, $Y_{12}$, ring $CY_{12}$, $Z_1$ to $Z_4$, $Z_{11}$ to $Z_{13}$, and d2 in claim 7,
$Z_{14}$ is understood by referring to $Z_1$ in claim 7,
e2 is an integer from 0 to 2,
e3 is an integer from 0 to 3,
e4 is an integer from 0 to 4, and
* and *' each indicate a bonding site to M in Formula 1.

**9.** The organometallic compound of claim 8, wherein $Z_{12}$ in Formula 3-1 is $-Si(Q_3)(Q_4)(Q_5)$; $-Ge(Q_3)(Q_4)(Q_5)$; or a $C_1$-$C_{60}$ alkyl group substituted with at least one deuterium.

**10.** The organometallic compound of claims 8 or 9, wherein $Z_{12}$ in Formula 3-1 is $-Si(Q_3)(Q_4)(Q_5)$ or $-Ge(Q_3)(Q_4)(Q_5)$, and $Z_{13}$ is not hydrogen or a methyl group.

**11.** The organometallic compound of any of claims 8-10, wherein a group represented by

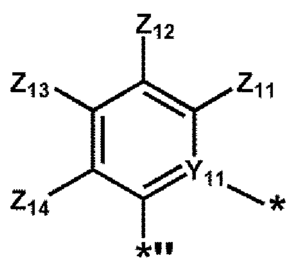

in Formula 3-1 is represented by one of Formulae 3-1-1 to 3-1-16, and a group represented by

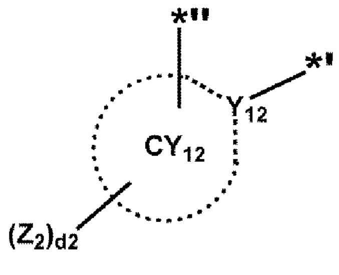

in Formula 3-1 is represented by one of Formulae 3-1(1) to 3-1(16):

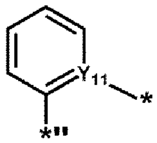
3-1-1

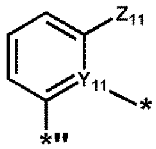
3-1-2

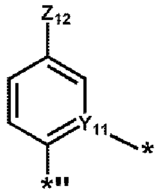
3-1-3

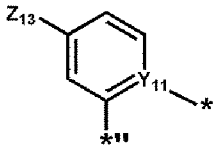
3-1-4

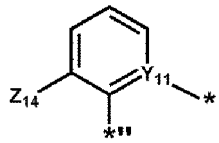
3-1-5

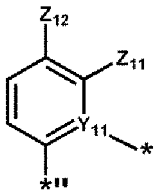
3-1-6

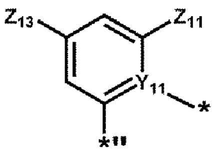
3-1-7

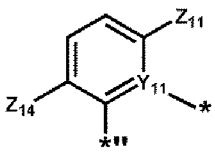
3-1-8

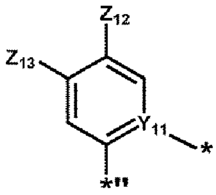
3-1-9

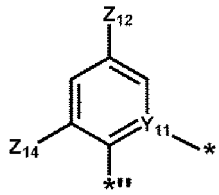
3-1-10

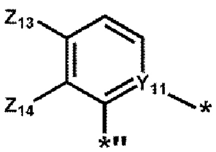
3-1-11

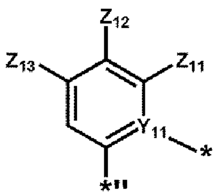
3-1-12

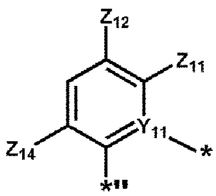
3-1-13

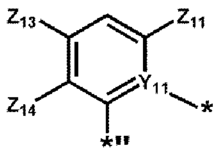
3-1-14

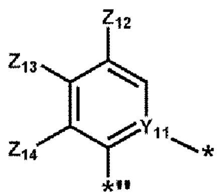
3-1-15

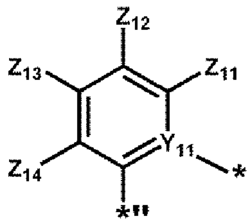
3-1-16

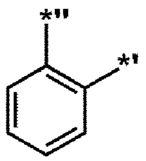
3-1(1)

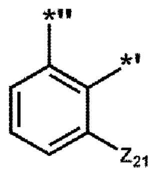
3-1(2)

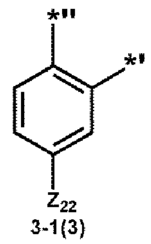
3-1(3)

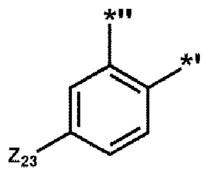
3-1(4)

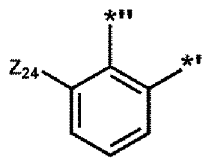
3-1(5)

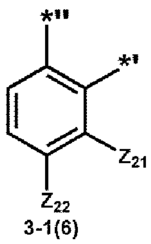
3-1(6)

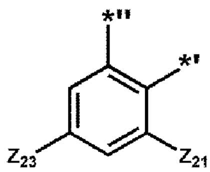
3-1(7)

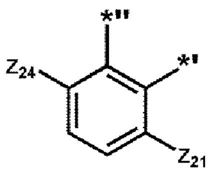
3-1(8)

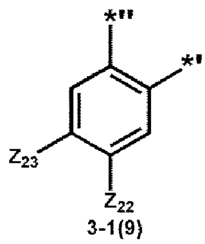
3-1(9)

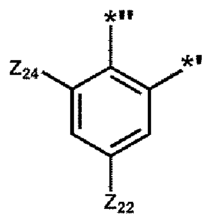
3-1(10)

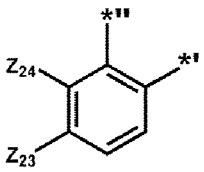
3-1(11)

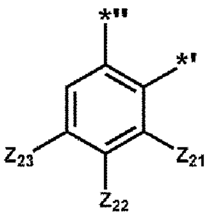
3-1(12)

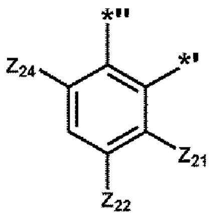
3-1(13)

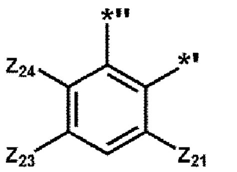
3-1(14)

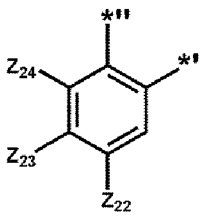
3-1(15)

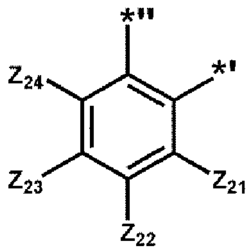
3-1(16)

wherein, in Formulae 3-1-1 to 3-1-16 and 3-1 (1) to 3-1 (16),

$Z_{11}$ to $Z_{14}$ are respectively understood by referring to $Z_{11}$ to $Z_{14}$ in claim 8, $Z_{21}$ to $Z_{24}$ are each understood by referring to $Z_2$ in claim 8, wherein $Z_{11}$ to $Z_{14}$ and $Z_{21}$ to $Z_{24}$ are not hydrogen,
* and *' each indicate a bonding site to M in Formula 1, and
*" indicates a bonding site to an adjacent atom.

**12.** The organometallic compound of any of claims 1-11, comprising: at least one deuterium atom.

**13.** An organic light-emitting device, comprising:

a first electrode;
a second electrode; and
an organic layer disposed between the first electrode and the second electrode and comprising an emission layer;
wherein the organic layer comprises at least one organometallic compound of any of claims 1-12;
preferably wherein
the first electrode is an anode,
the second electrode is a cathode, and
the organic layer further comprises a hole transport region disposed between the first electrode and the emission layer and an electron transport region disposed between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

**14.** The organic light-emitting device of claim 13, wherein the emission layer comprises the organometallic compound.

**15.** An electronic apparatus, comprising the organic light-emitting device of claim 14.

## Patentansprüche

**1.** Metallorganische Verbindung, dargestellt durch Formel 1:

Formel 1 $M(L_1)_{n1}(L_2)_{n2}$

wobei in Formel 1

M Iridium (Ir), Platin (Pt), Osmium (Os), Titan (Ti), Zirkonium (Zr), Hafnium (Hf), Europium (Eu), Terbium (Tb),

Thulium (Tm) oder Rhodium (Rh) ist,
$L_1$ ein Ligand ist, dargestellt durch Formel 2,
n1 1, 2 oder 3 ist, und wenn n1 2 oder größer ist, sind mindestens zwei $L_1$-Gruppen identisch oder voneinander verschieden,
$L_2$ ein einzähniger Ligand, ein zweizähniger Ligand, ein dreizähniger Ligand oder ein vierzähniger Ligand ist,
n2 0, 1, 2, 3 oder 4 ist, und wenn n2 2 oder größer ist, sind mindestens zwei $L_2$-Gruppen identisch oder voneinander verschieden,
$L_1$ von $L_2$ verschieden ist,

Formel 2

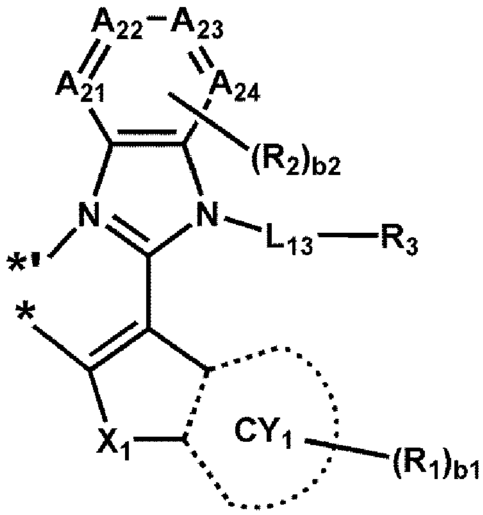

wobei in Formel 2
$A_{21}$ bis $A_{24}$ jeweils unabhängig N oder C sind,
$X_1$ O oder S ist,
$L_{13}$ eine Einfachbindung, eine carbocyclische $C_5$-$C_{30}$-Gruppe, unsubstituiert oder substituiert mit mindestens einem $R_{10a}$, oder eine heterocyclische $C_1$-$C_{30}$-Gruppe, unsubstituiert oder substituiert mit mindestens einem $R_{10a}$,
Ring $CY_1$ eine carbocyclische $C_5$-$C_{30}$-Gruppe oder eine heterocyclische $C_1$-$C_{30}$-Gruppe ist,
$R_1$ und $R_2$ jeweils unabhängig Wasserstoff, Deuterium, -F, -Cl, -Br, -I, -$SF_5$, eine Hydroxylgruppe, eine Cyanogruppe, eine Nitrogruppe, eine Aminogruppe, eine Amidinogruppe, eine Hydrazingruppe, eine Hydrazingruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte $C_1$-$C_{60}$-Alkylgruppe, eine substituierte oder unsubstituierte $C_2$-$C_{60}$-Alkenylgruppe, eine substituierte oder unsubstituierte $C_2$-$C_{60}$-Alkinylgruppe, eine substituierte oder unsubstituierte $C_1$-$C_{60}$-Alkoxygruppe, eine substituierte oder unsubstituierte $C_1$-$C_{60}$-Alkylthiogruppe, eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_7$-$C_{60}$-Arylalkylgruppe, eine substituierte oder unsubstituierte $C_1$-$C_{60}$-Heteroarylgruppe, eine substituierte oder unsubstituierte $C_1$-$C_{60}$-Heteroaryloxygruppe, eine substituierte oder unsubstituierte $C_1$-$C_{60}$-Heteroarylthiogruppe, eine substituierte oder unsubstituierte $C_2$-$C_{60}$-Heteroarylalkylgruppe, eine substituierte oder unsubstituierte einwertige nicht-aromatische kondensierte polyzyklische Gruppe, eine substituierte oder unsubstituierte einwertige nicht-aromatische -$N(Q_1)(Q_2)$, -$Si(Q_3)(Q_4)(Q_5)$, - $Ge(Q_3)(Q_4)(Q_5)$, -$B(Q_6)(Q_7)$, -$P(=O)(Q_8)(Q_9)$ oder -$P(Q_8)(Q_9)$ sind,
$R_3$ eine substituierte oder unsubstituierte $C_3$-$C_{10}$-Cycloalkylgruppe, eine substituierte oder unsubstituierte $C_1$-$C_{10}$-Heterocycloalkylgruppe, eine substituierte oder unsubstituierte $C_3$-$C_{10}$-Cycloalkenylgruppe, eine substituierte oder unsubstituierte $C_1$-$C_{10}$-Heterocycloalkenylgruppe, eine substituierte oder unsubstituierte $C_6$-$C_{60}$-Arylgruppe, eine substituierte oder unsubstituierte $C_6$-$C_{60}$-Aryloxygruppe, eine substituierte oder unsubstituierte $C_6$-$C_{60}$-Arylthiogruppe, eine substituierte oder unsubstituierte $C_1$-$C_{60}$-Heteroarylgruppe, eine substituierte oder unsubstituierte einwertige nicht-aromatische kondensierte polyzyklische Gruppe, eine substituierte oder unsubstituierte einwertige nicht-aromatische kondensierte heteropolyzyklische Gruppe ist,
b1 eine ganze Zahl von 0 bis 20 ist,
b2 eine ganze Zahl von 0 bis 4 ist,
mindestens zwei Gruppen aus einer Vielzahl von $R_1$-Gruppen optional aneinander gebunden sind, um eine $C_5$-$C_{30}$-carbocyclische Gruppe zu bilden, die unsubstituiert oder mit mindestens einem $R_{10a}$ substituiert ist, oder mindestens zwei Gruppen aus einer Vielzahl von $R_1$-Gruppen optional aneinander gebunden sind, um eine heterocyclische $C_1$-$C_{30}$-Gruppe zu bilden, die unsubstituiert oder mit mindestens einem $R_{10a}$ substituiert ist,
mindestens zwei Gruppen aus einer Vielzahl von $R_2$-Gruppen optional aneinander gebunden sind, um eine $C_5$-$C_{30}$-carbocyclische Gruppe zu bilden, die unsubstituiert oder mit mindestens einem $R_{10a}$ substituiert ist, oder mindestens zwei Gruppen aus einer Vielzahl von $R_2$-Gruppen optional aneinander gebunden sind, um eine heterocyclische $C_1$-$C_{30}$-Gruppe zu bilden, die unsubstituiert oder mit mindestens einem $R_{10a}$ substituiert ist,
$R_3$ und eines von $R_1$ und $R_2$ optional aneinander gebunden sind, um eine carbocyclische $C_5$-$C_{30}$-Gruppe zu bilden, die unsubstituiert oder mit mindestens einem $R_{10a}$ substituiert ist, oder $R_3$ und eines von $R_1$ und $R_2$ optional aneinander gebunden sind, um eine heterocyclische $C_1$-$C_{30}$-Gruppe zu bilden, die unsubstituiert oder mit mindestens einem $R_{10a}$ substituiert ist,
$R_{10a}$ unter Bezugnahme auf die hierin bereitgestellte Beschreibung von $R_1$ zu verstehen ist,
* und *' jeweils eine Bindungsstelle an M in Formel 1 angeben, und
ein Substituent der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_1$-$C_{60}$-Alkylthiogruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten monovalenten nicht-aromatischen kondensierten polyzyklischen Gruppe und der substituierten monovalenten nicht-aromatischen kondensierten heteropolyzyklischen Gruppe jeweils unabhängig wie folgt ist:

Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkynylgruppe oder eine $C_1$-$C_{60}$-Alkoxygruppe,
eine $C_1$-$C_{60}$-Alkylgruppe, eine $C_2$-$C_{60}$-Alkenylgruppe, eine $C_2$-$C_{60}$-Alkinylgruppe, oder eine $C_1$-$C_{60}$-Alkoxygruppe, jeweils substituiert mit Deuterium, -F, -Cl, -Br, -I, $-CD_3$, $-CD_2H$, - $CDH_2$, $-CF_3$, - $CF_2H$, $-CFH_2$, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_7$-$C_{60}$-Arylalkylgruppe, eine $C_1$-$C_{60}$-Heteroarylgruppe, eine $C_1$-$C_{60}$-Heteroaryloxygruppe, eine $C_1$-$C_{60}$-Heteroarylthiogruppe, eine $C_2$-$C_{60}$-Heteroarylalkylgruppe, eine monovalente nichtaromatische kondensierte polycyclische Gruppe, eine monovalente nichtaromatische kondensierte polycyclische Heteropolycyclische Gruppe, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, - $P(Q_{18})(Q_{19})$ oder eine Kombination davon;
eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalenten nicht-aromatischen kondensierten polycyclischen Gruppe oder eine monovalenten nicht-aromatischen kondensierten heteropolycyclischen Gruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{60}$-Alkylgruppe, eine $C_2$-$C_{60}$-Alkenylgruppe, eine $C_2$-$C_{60}$-Alkynylgruppe, eine $C_1$-$C_{60}$-Alkoxygruppe, eine $C_3$-$C_{10}$-Cycloalkylgruppe, eine $C_1$-$C_{10}$-Heterocycloalkylgruppe, eine $C_3$-$C_{10}$-Cycloalkenylgruppe, eine $C_1$-$C_{10}$-Heterocycloalkenylgruppe, eine $C_6$-$C_{60}$-Arylgruppe, eine $C_6$-$C_{60}$-Aryloxygruppe, eine $C_6$-$C_{60}$-Arylthiogruppe, eine $C_1$-$C_{60}$-Heteroarylgruppe, eine monovalente nicht-aromatische kondensierte polycyclische Gruppe, eine monovalente nicht-aromatische kondensierte heteropolycyclische Gruppe,

$-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$ oder eine Kombination davon;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$ oder $-P(Q_{38})(Q_{39})$; oder eine Kombination davon,

wobei $Q_1$ bis $Q_9$, $Q_{11}$ bis $Q_{19}$, $Q_{21}$ bis $Q_{29}$ und $Q_{31}$ bis $Q_{39}$ jeweils unabhängig Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine $C_1$-$C_{60}$-Alkylgruppe unsubstituiert oder substituiert mit Deuterium, eine $C_1$-$C_{60}$-Alkylgruppe, eine $C_6$-$C_{60}$-Arylgruppe oder einer Kombination davon; eine $C_2$-$C_{60}$-Alkenylgruppe; eine $C_2$-$C_{60}$-Alkinylgruppe, eine $C_1$-$C_{60}$-Alkoxygruppe; eine $C_3$-$C_{10}$-Cycloalkylgruppe; eine $C_1$-$C_{10}$-Heterocycloalkylgruppe; eine $C_3$-$C_{10}$-Cycloalkenylgruppe; eine $C_1$-$C_{10}$-Heterocycloalkenylgruppe; eine $C_6$-$C_{60}$-Arylgruppe unsubstituiert oder substituiert mit Deuterium, eine $C_1$-$C_{60}$-Alkylgruppe, eine $C_6$-$C_{60}$-Arylgruppe oder eine beliebige Kombination davon; eine $C_6$-$C_{60}$-Aryloxygruppe; eine $C_6$-$C_{60}$-Arylthiogruppe; eine $C_7$-$C_{60}$-Arylalkylgruppe; eine $C_1$-$C_{60}$-Heteroarylgruppe; eine $C_1$-$C_{60}$-Heteroaryloxygruppe; eine $C_1$-$C_{60}$-Heteroarylthiogruppe; eine $C_2$-$C_{60}$-Heteroarylalkylgruppe; eine monovalente nicht-aromatische kondensierte polycyclische Gruppe; oder eine monovalente nicht-aromatische kondensierte heteropolycyclische Gruppe sind.

**2.** Metallorganische Verbindung nach Anspruch 1, wobei $L_{13}$ wie folgt ist: eine Einfachbindung; oder eine zweiwertige Gruppe, die eine Benzolgruppe, eine Naphthalingruppe, eine Pyridingruppe, eine Dibenzofurangruppe, eine Dibenzothiophengruppe oder eine Carbazolgruppe, jeweils unsubstituiert oder substituiert mit mindestens einem $R_{10a}$, ist.

**3.** Metallorganische Verbindung nach Anspruch 1 oder 2, wobei Ring $CY_1$ eine Cyclopentangruppe, eine Cyclohexangruppe, eine Cycloheptangruppe, eine Cyclopentengruppe, eine Cyclohexengruppe, eine Cycloheptengruppe, eine Adamantangruppe, eine Norbornangruppe, eine Norbornengruppe, eine Bicyclo[1.1.1]pentangruppe, eine Bicyclo[2.1.1]hexangruppe, eine Bicyclo[2.2.2]octangruppe, eine Benzolgruppe, eine Naphthalingruppe, eine Anthracengruppe, eine Phenanthrengruppe, eine Triphenylengruppe, eine Pyrengruppe, eine Chrysengruppe, eine 1,2,3,4-Tetrahydronaphthalingruppe, eine Pyrrolgruppe, eine Borolgruppe, eine Phospholgruppe, eine Cyclopentadiengruppe, eine Silolgruppe, eine Germolgruppe, eine Thiophengruppe, eine Selenophengruppe, eine Furangruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-oxid-Gruppe, eine 9H-Fluoren-9-on-Gruppe, eine Dibenzothiophen-5,5-dioxid-Gruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-oxid-Gruppe, eine Aza-9H-Fluoren-9-ongruppe, eine Azadibenzothiophen-5,5-dioxid-Gruppe, eine Pyridingruppe, eine Pyrimidingruppe, eine Pyrazingruppe, eine Pyridazingruppe, eine Triazingruppe, eine Chinolingruppe, eine Isochinolingruppe, eine Benzochinolingruppe, eine Benzoisochinolingruppe, eine Chinoxalingruppe, eine Chinazolingruppe, eine Phenanthrolingruppe, eine Pyrazolgruppe, eine Imidazolgruppe, eine Triazolgruppe, eine Azaborolgruppe, eine Azaphospholgruppe, eine Azacyclopentadiengruppe, eine Azasilolgruppe, eine Azagermolgruppe, eine Azaselenophengruppe, eine Oxazolgruppe, eine Isooxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzoxazolgruppe, eine Benzothiazolgruppe, eine Benzoxadiazolgruppe, eine Benzothiadiazolgruppe, eine 5,6,7,8-Tetrahydroisochinolingruppe, oder eine 5,6,7,8-Tetrahydrochinolingruppe; und/oder
wobei $R_1$ und $R_2$ jeweils unabhängig wie folgt sind:

Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, $-SF_5$, eine $C_1$-$C_{20}$-Alkylgruppe, eine $C_1$-$C_{20}$-Alkenylgruppe, eine $C_1$-$C_{20}$-Alkoxygruppe oder eine $C_1$-$C_{20}$-Alkylthiogruppe;

eine $C_1$-$C_{20}$-Alkylgruppe, eine $C_2$-$C_{20}$-Alkenylgruppe, eine $C_1$-$C_{20}$-Alkoxygruppe oder eine $C_1$-$C_{20}$-Alkylthio-

gruppe, jeweils substituiert mit Deuterium, -F, -Cl, -Br, -I, $-CD_3$, $-CD_2H$, - $CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{10}$-Alkylgruppe, eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.2]octylgruppe, eine ($C_1$-$C_{20}$-Alkyl)-Cyclopentylgruppe, eine ($C_1$-$C_{20}$-Alkyl)-Cyclohexylgruppe, eine ($C_1$-$C_{20}$-Alkyl)-Cycloheptylgruppe, eine ($C_1$-$C_{20}$-Alkyl)-Cyclooctylgruppe, eine ($C_1$-$C_{20}$-Alkyl)-Adamantanylgruppe, eine ($C_1$-$C_{20}$-Alkyl)-Norbornanylgruppe, eine ($C_1$-$C_{20}$-Alkyl)-Norbornanylgruppe, eine ($C_1$-$C_{20}$-Alkyl)-Cyclopentenylgruppe, eine ($C_1$-$C_{20}$-Alkyl)-Cyclohexenylgruppe, eine ($C_1$-$C_{20}$-Alkyl)-Cycloheptenylgruppe, eine ($C_1$-$C_{20}$-Alkyl)-Bicyclo[1.1.1]pentylgruppe, eine ($C_1$-$C_{20}$-Alkyl)-Bicyclo[2.1.1]hexylgruppe, eine ($C_1$-$C_{20}$-Alkyl)-Bicyclo[2.2.2]octylgruppe, eine Phenylgruppe, eine ($C_1$-$C_{20}$-Alkyl)-Phenylgruppe, eine Biphenylgruppe, eine Terphenylgruppe, eine Naphthylgruppe, eine Pyridinylgruppe, eine Pyrimidinylgruppe oder eine Kombination davon;

eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.2]octylgruppe, eine Phenylgruppe, eine ($C_1$-$C_{20}$-Alkyl)-Phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe,

eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe oder eine Azadibenzothiophenylgruppe, jeweils unsubstituiert oder substituiert mit Deuterium, -F, -Cl, -Br, -I, $-CD_3$, $-CD_2H$, $-CDH_2$, $-CF_3$, $-CF_2H$, $-CFH_2$, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine $C_1$-$C_{20}$-Alkylgruppe, eine deuterierte $C_2$-$C_{20}$-Alkylgruppe, eine $C_1$-$C_{20}$-Alkoxygruppe, eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Bicyclo[1.1.1]pentylgruppe, eine Bicyclo[2.1.1]hexylgruppe, eine Bicyclo[2.2.2]octylgruppe, eine ($C_1$-$C_{20}$-Alkyl)-Cyclopentylgruppe, eine ($C_1$-$C_{20}$-Alkyl)-Cyclohexylgruppe, eine ($C_1$-$C_{20}$-Alkyl)-Cycloheptylgruppe, eine ($C_1$-$C_{20}$-Alkyl)-Cyclooctylgruppe, eine ($C_1$-$C_{20}$-Alkyl)-Adamantanylgruppe, eine ($C_1$-$C_{20}$-Alkyl)-Norbornanylgruppe, eine ($C_1$-$C_{20}$-Alkyl)-Norbornanylgruppe, eine ($C_1$-$C_{20}$-Alkyl)-Cyclopentenylgruppe, eine ($C_1$-$C_{20}$-Alkyl)-Cyclohexenylgruppe, eine ($C_1$-$C_{20}$-Alkyl)-Cycloheptenylgruppe, eine ($C_1$-$C_{20}$-Alkyl)-bicyclo[1.1.1]pentylgruppe, eine ($C_1$-$C_{20}$-Alkyl)-bicyclo[2.1.1]hexylgruppe, eine ($C_1$-$C_{20}$-Alkyl)-bicyclo[2.2.2]octylgruppe, eine Phenylgruppe, eine ($C_1$-$C_{20}$-Alkyl)-Phenylgruppe, eine Biphenylgruppe, eine Terphenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe, eine Imidazopyrimidinylgruppe, eine Azacarbazolylgruppe, eine Azadibenzofuranylgruppe, eine Azadibenzothiophenylgruppe oder eine Kombination davon; oder

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$ oder - $P(Q_8)(Q_9)$,

wobei $Q_1$ bis $Q_9$ jeweils unabhängig wie folgt sind:

Deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, - $CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, - $CF_2CF_3$, $-CF_2CF_2H$ oder $-CF_2CFH_2$; oder
eine n-Propylgruppe, eine iso-Propylgruppe, eine n-Butylgruppe, eine sec-Butylgruppe, eine Isobutylgruppe, eine tert-Butylgruppe, eine n-Pentylgruppe, eine tert-Pentylgruppe, eine Neopentylgruppe, eine Isopentylgruppe, eine sec-Pentylgruppe, eine 3-Pentylgruppe, eine sec-Isopentylgruppe, eine Phenylgruppe, eine Biphenylgruppe oder eine Naphthylgruppe, jeweils unsubstituiert oder substituiert mit Deuterium, -F, einer $C_1$-$C_{10}$-Alkylgruppe, einer Phenylgruppe oder einer Kombination davon.

**4.** Metallorganische Verbindung nach einem der Ansprüche 1-3, wobei
$R_2$ Wasserstoff, Deuterium, -F, eine Cyanogruppe, eine substituierte oder unsubstituierte $C_1$-$C_{60}$-Alkylgruppe, eine substituierte oder unsubstituierte $C_3$-$C_{10}$-Cycloalkylgruppe, - $Si(Q_3)(Q_4)(Q_5)$ oder $-Ge(Q_3)(Q_4)(Q_5)$ ist.

**5.** Metallorganische Verbindung nach einem der Ansprüche 1-4, wobei eine Gruppe dargestellt durch

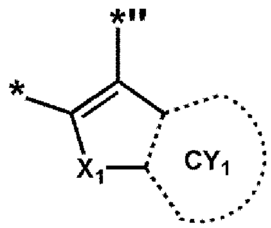

in Formel 2 durch eine der Formeln 2(1) bis 2(31) dargestellt ist:

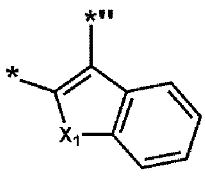

2(1)

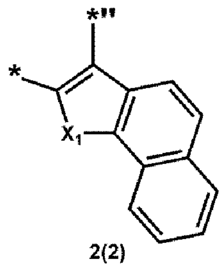

2(2)

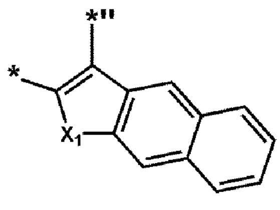

2(3)

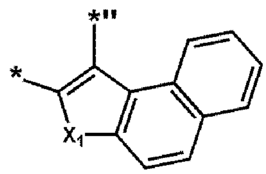

2(4)

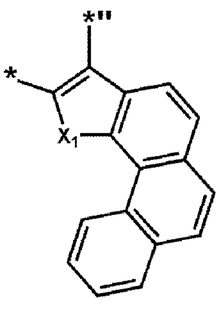

2(5)

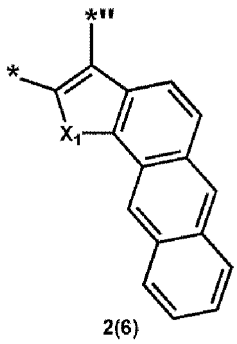

2(6)

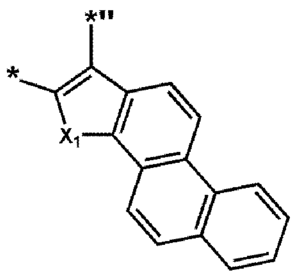

2(7)

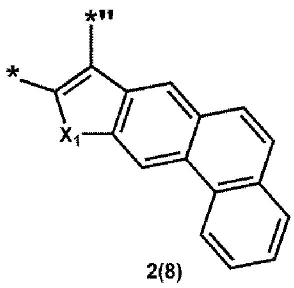

2(8)

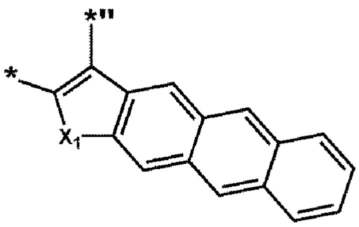
2(9)

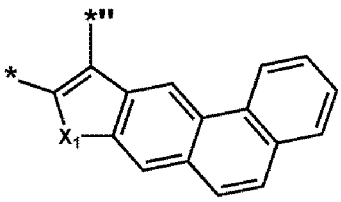
2(10)

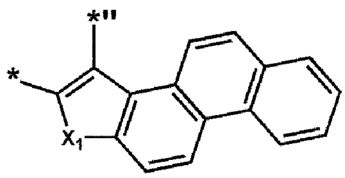
2(11)

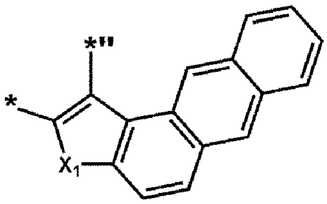
2(12)

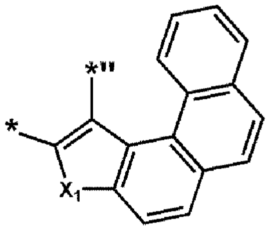
2(13)

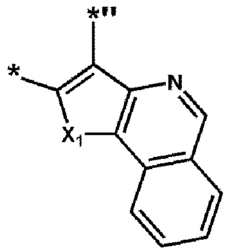
2(14)

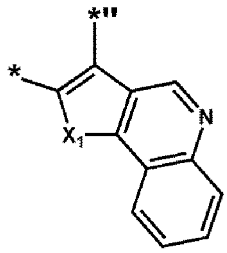
2(15)

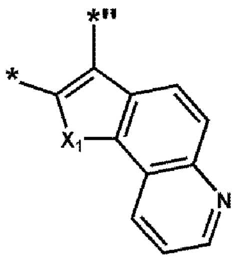
2(16)

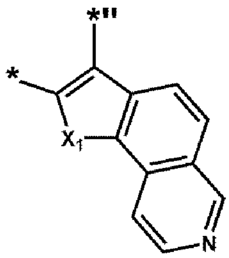
2(17)

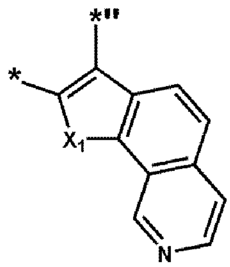
2(18)

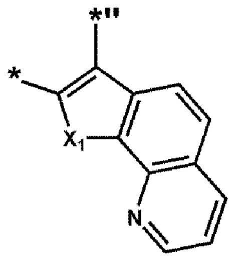
2(19)

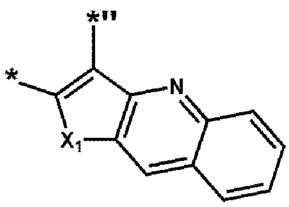
2(20)

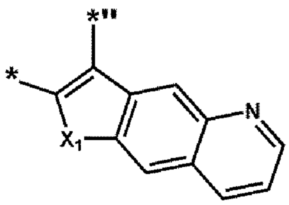
2(21)

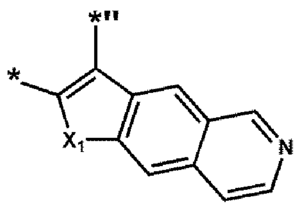
2(22)

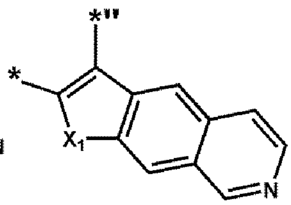
2(23)

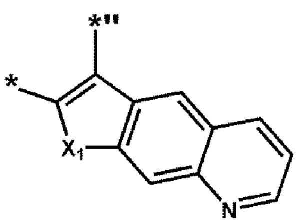
2(24)

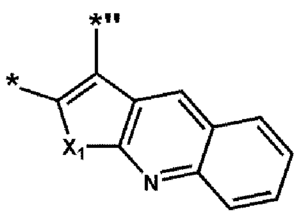
2(25)

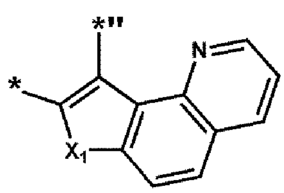
2(26)

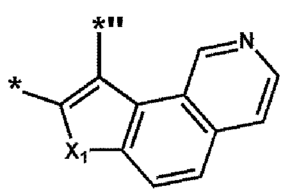
2(27)

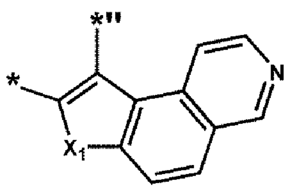
2(28)

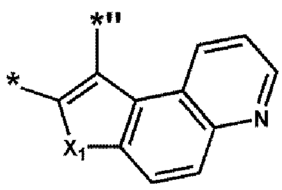
2(29)

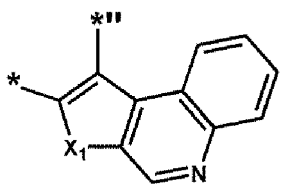
2(30)

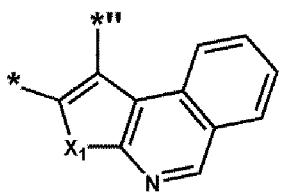
2(31)

wobei in Formel 2(1) bis 2(31)

$X_1$ unter Bezugnahme auf die Beschreibung von $X_1$ in Anspruch 1 zu verstehen ist,
* eine Bindungsstelle an M in Formel 1 angibt, und
*" eine Bindungsstelle an ein benachbartes Kohlenstoffatom angibt; oder
Wobei eine durch Formel 2

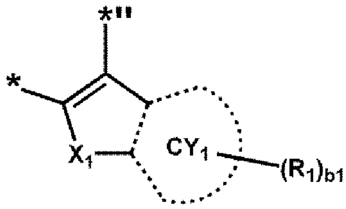

dargestellte Gruppe, dargestellt ist durch eine von Formel 2-1 bis 2-57:

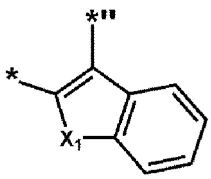
2-1

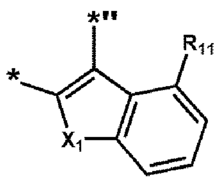
2-2

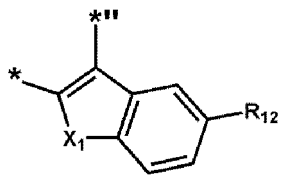
2-3

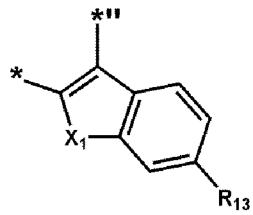
2-4

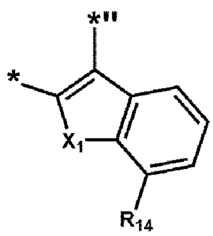
2-5

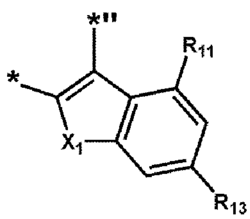
2-6

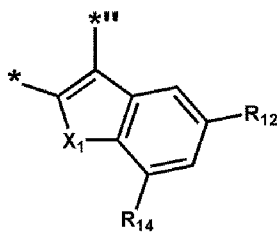
2-7

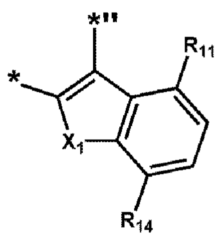
2-8

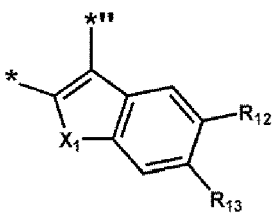
2-9

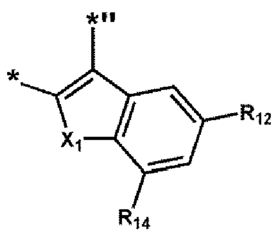
2-10

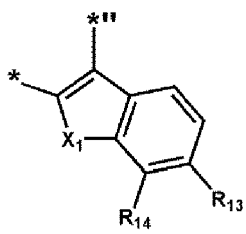
2-11

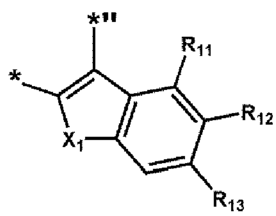
2-12

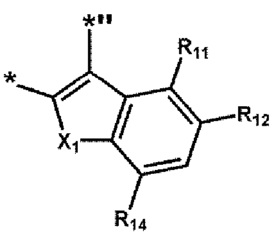
2-13

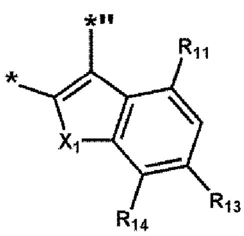
2-14

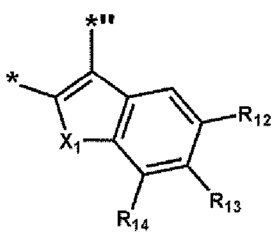
2-15

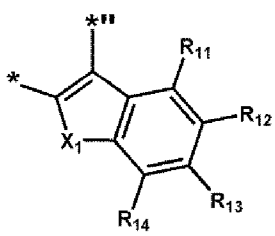
2-16

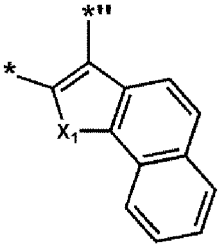

2-17

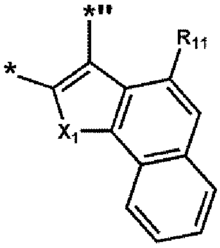

2-18

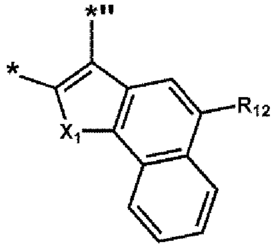

2-19

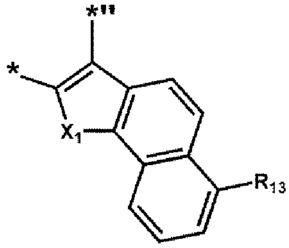

2-20

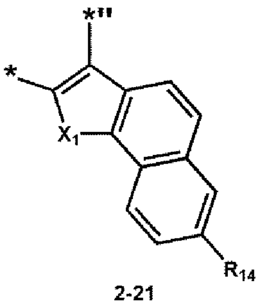

2-21

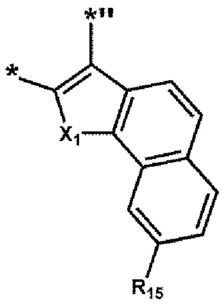

2-22

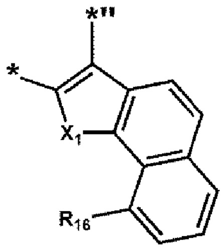

2-23

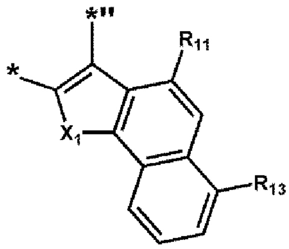

2-24

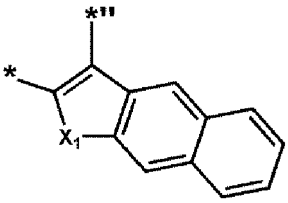

2-25

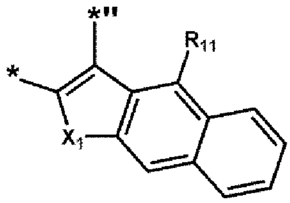

2-26

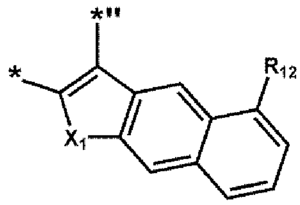

2-27

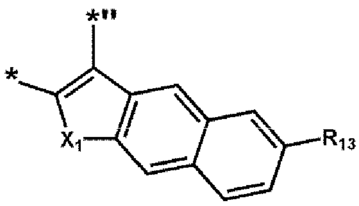

2-28

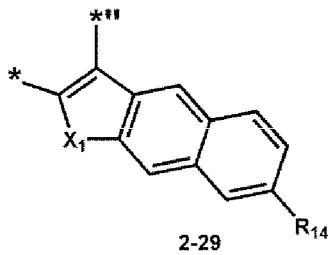

2-29

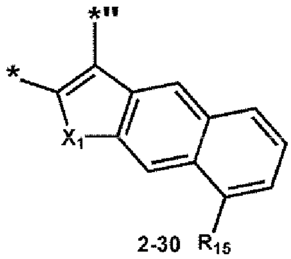

2-30

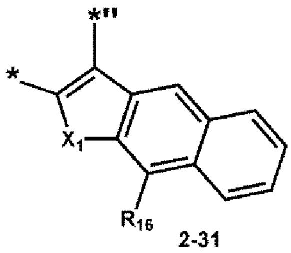

2-31

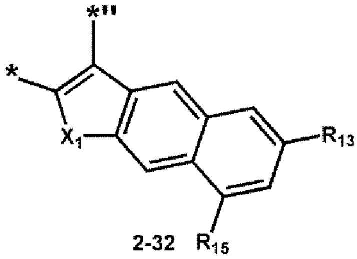

2-32

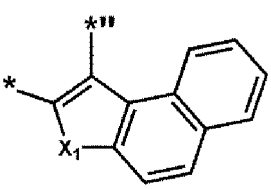

2-33

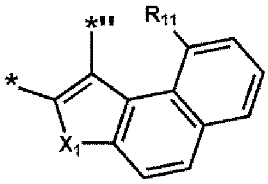
2-34

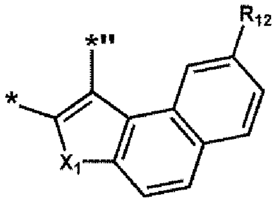
2-35

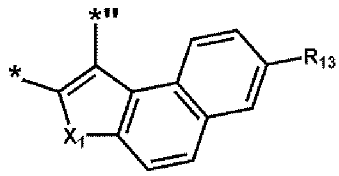
2-36

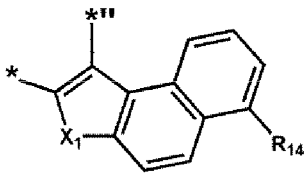
2-37

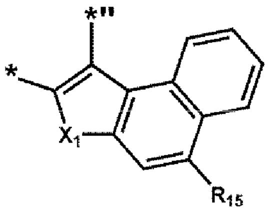
2-38

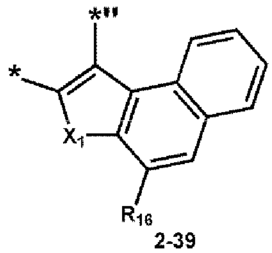
2-39

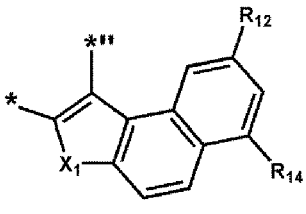
2-40

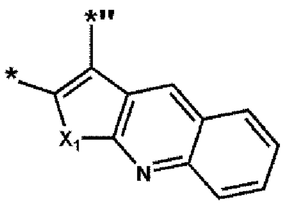
2-41

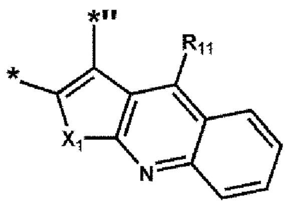
2-42

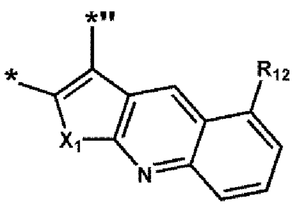
2-43

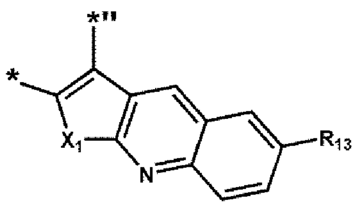
2-44

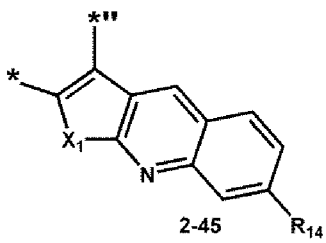
2-45

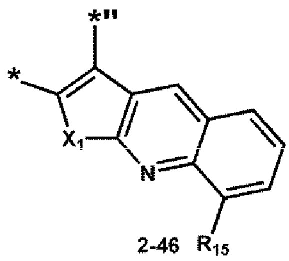
2-46

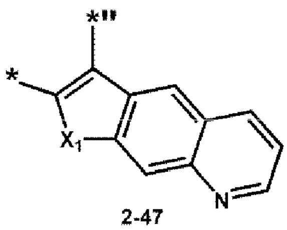
2-47

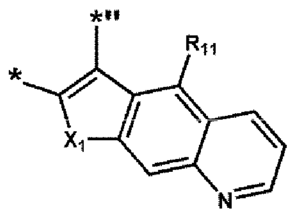
2-48

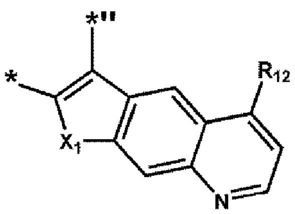
2-49

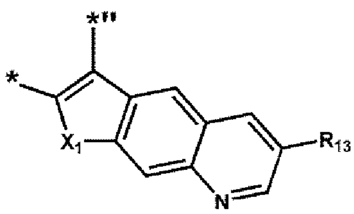
2-50

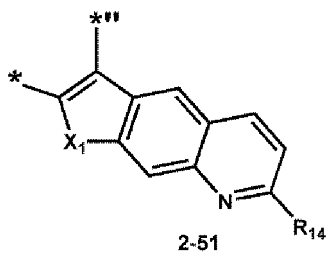
2-51

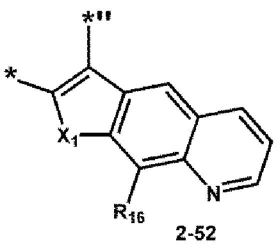

2-52

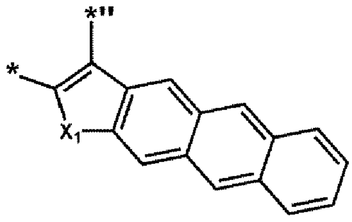

2-53

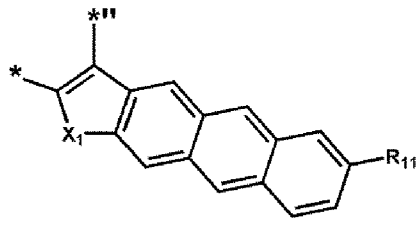

2-54

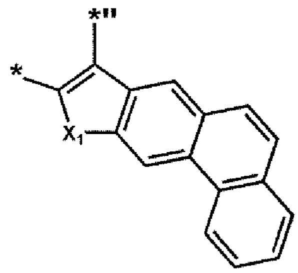

2-55

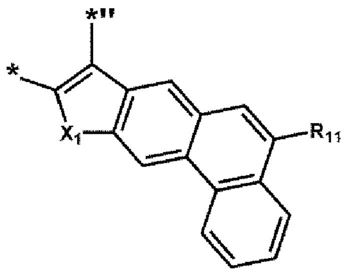

2-56

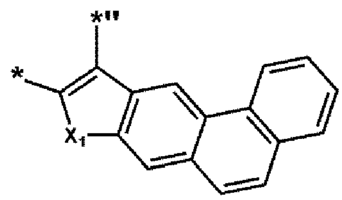

2-57

wobei in Formel 2-1 bis 2-57,

$X_1$ unter Bezugnahme auf die Beschreibung von $X_1$ in Anspruch 1 zu verstehen ist,
$R_{11}$ bis $R_{16}$ jeweils unter Bezugnahme auf die Beschreibung von $R_1$ in Anspruch 1 zu verstehen sind, wobei $R_{11}$ bis $R_{16}$ jeweils nicht Wasserstoff sind,
* eine Bindungsstelle an M in Formel 1 angibt, und
*" eine Bindungsstelle an ein benachbartes Kohlenstoffatom angibt.

**6.** Metallorganische Verbindung nach einem der Ansprüche 1-5, wobei $L_2$ in Formel 1 ein zweizähniger Ligand ist, der über O, S, Se, N, C, P, Si, As oder eine Kombination davon an M in Formel 1 gebunden ist; oder wobei $L_2$ in Formel 1 ein zweizähniger Ligand ist, der über N und C an M in Formel 1 gebunden ist, oder ein zweizähniger Ligand, der über zwei O-Atome an M in Formel 1 gebunden ist.

**7.** Metallorganische Verbindung nach einem der Ansprüche 1-6, wobei $L_2$ in Formel 1 eine Gruppe ist, die durch eine von Formel 3A bis 3F dargestellt ist:

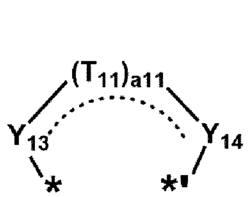

3A

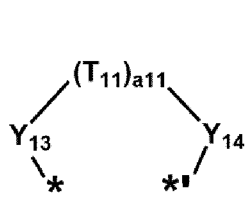

3B

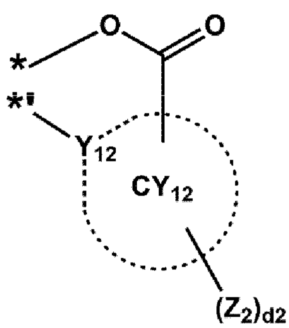

3C

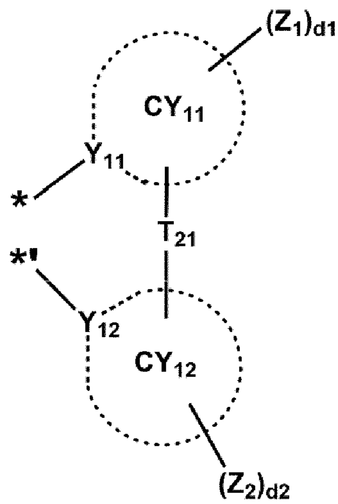

3D

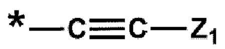
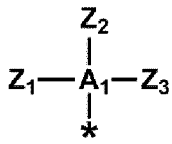

3E 3F

wobei in Formel 3A bis 3F

$Y_{13}$ O, N, $N(Z_1)$, $P(Z_1)(Z_2)$ oder $As(Z_1)(Z_2)$ ist,
$Y_{14}$ O, N, $N(Z_3)$, $P(Z_3)(Z_4)$ oder $As(Z_3)(Z_4)$ ist,
$T_{11}$ eine Einfachbindung, eine Doppelbindung, *-$C(Z_{11})(Z_{12})$-*', *-$C(Z_{11})$=$C(Z_{12})$-*', *=$C(Z_{11})$-*', *-$C(Z_{11})$=*', *=$C(Z_{11})$-$C(Z_{12})$=$C(Z_{13})$-*', *-$C(Z_{11})$=$C(Z_{12})$-$C(Z_{13})$=*', *-$N(Z_{11})$- *' oder eine carbocyclische $C_5$-$C_{30}$-Gruppe, unsubstituiert oder substituiert mit mindestens einem $Z_{11}$, ist,
a11 eine ganze Zahl von 1 bis 10 ist, und wenn a11 2 oder größer ist, mindestens zwei $T_{11}$-Gruppen identisch oder voneinander verschieden sind,
$Y_{11}$ und $Y_{12}$ jeweils unabhängig C oder N sind,
$T_{21}$ eine Einfachbindung, eine Doppelbindung, O, S, $C(Z_{11})(Z_{12})$, $Si(Z_{11})(Z_{12})$ oder $N(Z_{11})$ ist, Ring $CY_{11}$ und Ring $CY_{12}$ jeweils unabhängig eine carbocyclische $C_5$-$C_{30}$-Gruppe oder eine heterocyclische $C_1$-$C_{30}$-Gruppe sind,
$A_1$ P oder As ist,
$Z_1$ bis $Z_4$ und $Z_{11}$ bis $Z_{13}$ jeweils unter Bezugnahme auf $R_1$ in Anspruch 1 zu verstehen sind,
d1 und d2 jeweils unabhängig eine ganze Zahl von 0 bis 20 sind, und
* und *' jeweils eine Bindungsstelle an M in Formel 1 angeben;
vorzugsweise wobei $L_2$ ein Ligand ist, der von Formel 3D dargestellt ist, und mindestens eines von $Z_1$ und $Z_2$ in Formel 3D jeweils unabhängig Deuterium; -$Si(Q_3)(Q_4)(Q_5)$; - $Ge(Q_3)(Q_4)(Q_5)$; oder eine $C_1$-$C_{60}$-Alkylgruppe ist, die mit mindestens einem Deuterium substituiert ist.

8. Metallorganische Verbindung nach Anspruch 7, wobei $L_2$ ein Ligand ist, der durch eine von Formel 3-1 und 3-101 bis 3-112 dargestellt ist:

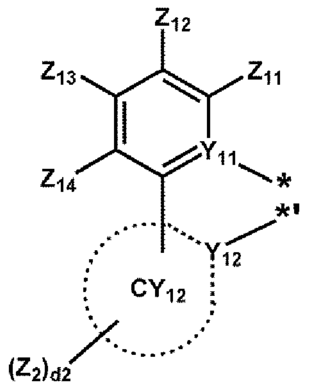

3-1

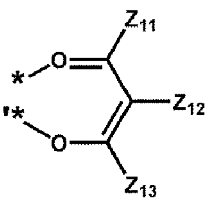
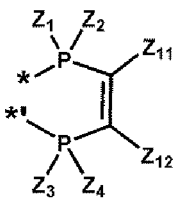
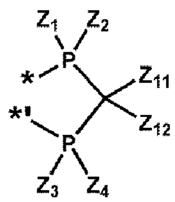
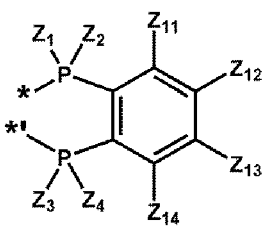

3-101 3-102 3-103 3-104

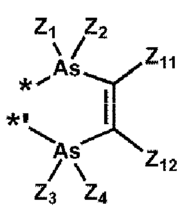

3-105

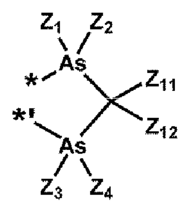

3-106

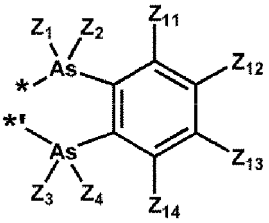

3-107

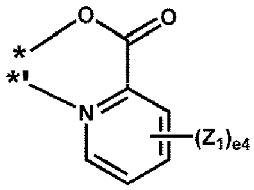

3-108

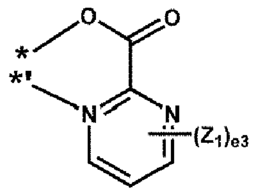

3-109

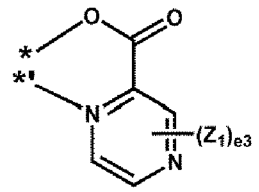

3-110

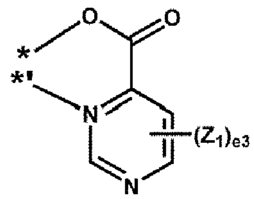

3-111

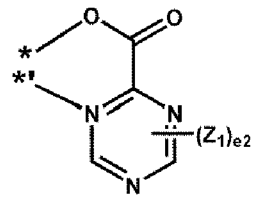

3-112

wobei in Formel 3-1 und 3-101 bis 3-112

$Y_{11}$, $Y_{12}$, Ring $CY_{12}$, $Z_1$ bis $Z_4$, $Z_{11}$ bis $Z_{13}$ und d2 jeweils unter Bezugnahme auf $Y_{11}$, $Y_{12}$, Ring $CY_{12}$, $Z_1$ bis $Z_4$, $Z_{11}$ bis $Z_{13}$ und d2 in Anspruch 7 zu verstehen sind,
$Z_{14}$ unter Bezugnahme auf $Z_1$ in Anspruch 7 zu verstehen ist,
e2 eine ganze Zahl von 0 bis 2 ist,
e3 eine ganze Zahl von 0 bis 3 ist,
e4 eine ganze Zahl von 0 bis 4 ist, und
* und *' jeweils eine Bindungsstelle an M in Formel 1 angeben.

**9.** Metallorganische Verbindung nach Anspruch 8, wobei $Z_{12}$ in Formel 3-1 $-Si(Q_3)(Q_4)(Q_5)$; $-Ge(Q_3)(Q_4)(Q_5)$; oder eine $C_1$-$C_{60}$-Alkylgruppe, substituiert mit mindestens einem Deuterium, ist.

**10.** Metallorganische Verbindung nach Anspruch 8 oder 9, wobei $Z_{12}$ in Formel 3-1 $-Si(Q_3)(Q_4)(Q_5)$ oder $-Ge(Q_3)(Q_4)(Q_5)$ ist, und $Z_{13}$ nicht Wasserstoff oder eine Methylgruppe ist.

**11.** Metallorganische Verbindung nach einem der Ansprüche 8-10, wobei eine durch

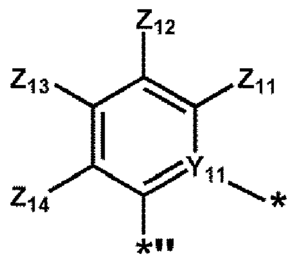

in Formel 3-1 dargestellte Gruppe durch eine von Formel 3-1-1 bis 3-1-16 dargestellt ist, und eine durch

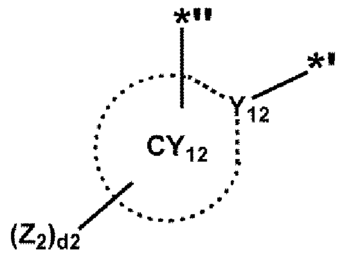

dargestellte Gruppe in Formel 3-1 durch eine von Formel 3-1(1) bis 3-1(16) dargestellt ist:

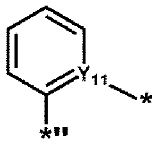
3-1-1

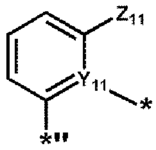
3-1-2

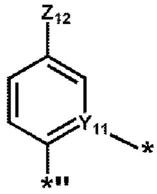
3-1-3

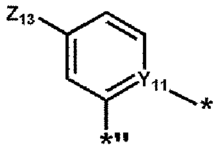
3-1-4

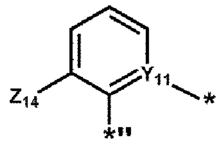
3-1-5

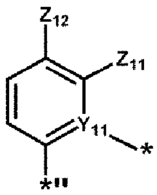
3-1-6

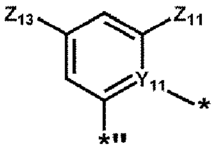
3-1-7

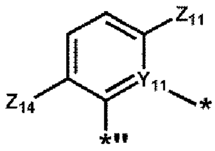
3-1-8

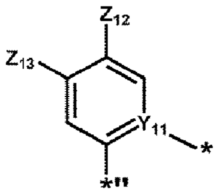
3-1-9

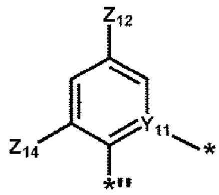
3-1-10

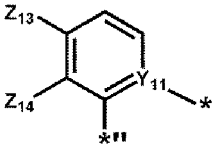
3-1-11

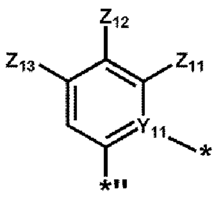
3-1-12

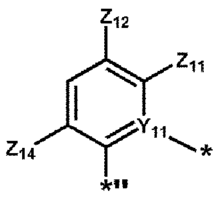
3-1-13

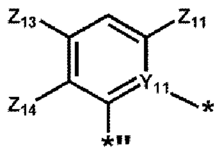
3-1-14

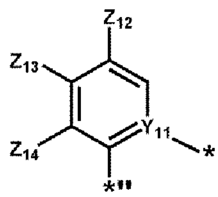
3-1-15

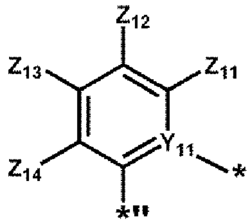
3-1-16

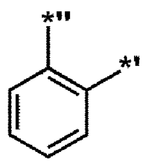
3-1(1)

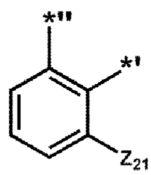
3-1(2)

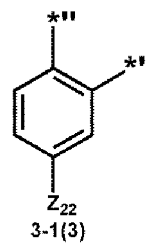
3-1(3)

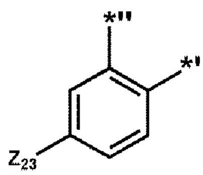
3-1(4)

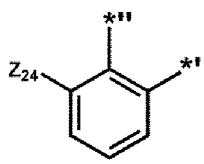
3-1(5)

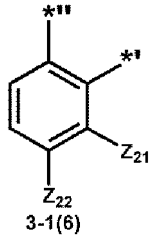
3-1(6)

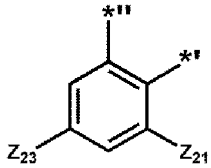
3-1(7)

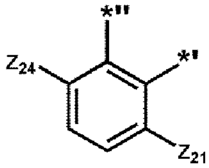
3-1(8)

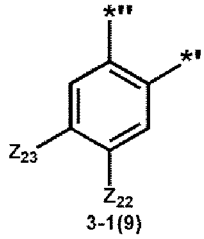
3-1(9)

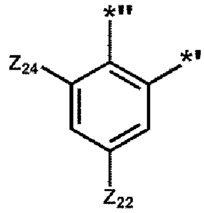
3-1(10)

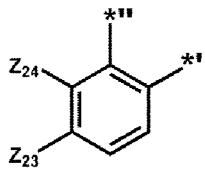

3-1(11)

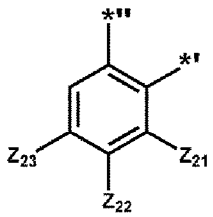

3-1(12)

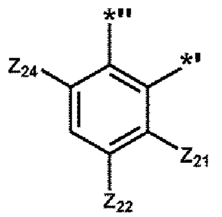

3-1(13)

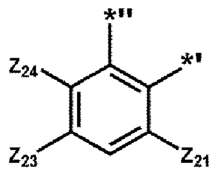

3-1(14)

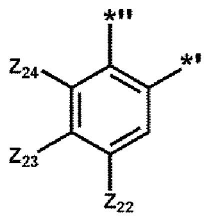

3-1(15)

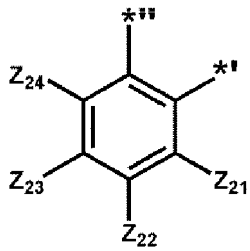

3-1(16)

wobei in Formel 3-1-1 bis 3-1-16 und 3-1(1) bis 3-1(16),

$Z_{11}$ bis $Z_{14}$ jeweils unter Bezugnahme auf $Z_{11}$ bis $Z_{14}$ in Anspruch 8 zu verstehen sind, $Z_{21}$ bis $Z_{24}$ jeweils unter Bezugnahme auf $Z_2$ in Anspruch 8 zu verstehen sind, wobei $Z_{11}$ bis $Z_{14}$ und $Z_{21}$ bis $Z_{24}$ nicht Wasserstoff sind,
* und *' jeweils eine Bindungsstelle an M in Formel 1 angeben, und
*" eine Bindungsstelle an ein benachbartes Atom angibt.

**12.** Metallorganische Verbindung nach einem der Ansprüche 1-11, umfassend: mindestens ein Deuteriumatom.

**13.** Organische lichtemittierende Vorrichtung, umfassend:

eine erste Elektrode;
eine zweite Elektrode; und
eine organische Schicht, die zwischen der ersten Elektrode und der zweiten Elektrode angeordnet ist und umfassend eine Emissionsschicht;
wobei die organische Schicht mindestens eine metallorganische Verbindung nach einem der Ansprüche 1-12 umfasst;
vorzugsweise wobei
die erste Elektrode eine Anode ist,
die zweite Elektrode eine Kathode ist, und
die organische Schicht ferner einen Lochtransportbereich, angeordnet zwischen der ersten Elektrode und der Emissionsschicht, und einen Elektronentransportbereich, angeordnet zwischen der Emissionsschicht und der zweiten Elektrode, umfasst,
der Lochtransportbereich eine Lochinjektionsschicht, eine Lochtransportschicht, eine Elektronensperrschicht, eine Pufferschicht oder eine Kombination davon umfasst, und
der Elektronentransportbereich eine Lochsperrschicht, eine Elektronentransportschicht, eine Elektroneninjektionsschicht oder eine Kombination davon umfasst.

**14.** Organische lichtemittierende Vorrichtung nach Anspruch 13, wobei die Emissionsschicht die metallorganische Verbindung umfasst.

**15.** Elektronische Vorrichtung, umfassend die organische lichtemittierende Vorrichtung nach Anspruch 14.

## Revendications

**1.** Composé organométallique représenté par la Formule 1 :

Formule 1 $M(L_1)_{n1}(L_2)_{n2}$

dans lequel, dans la Formule 1,

M est l'iridium (Ir), le platine (Pt), l'osmium (Os), le titane (Ti), le zirconium (Zr), l'hafnium (Hf), l'europium (Eu), le terbium (Tb), le thulium (Tm) ou le rhodium (Rh),
$L_1$ est un ligand représenté par la Formule 2,
n1 est 1, 2 à 3, et lorsque n1 est égal ou supérieur à 2, au moins deux groupes $L_1$ sont identiques ou différents l'un de l'autre,
$L_2$ est un ligand monodenté, un ligand bidenté, un ligand tridenté ou un ligand tétradenté,
n2 est 0, 1, 2, 3 ou 4, et lorsque n2 est égal ou supérieur à 2, au moins deux groupes $L_2$ sont identiques ou différents l'un de l'autre,
$L_1$ est différent de $L_2$,

Formule 2

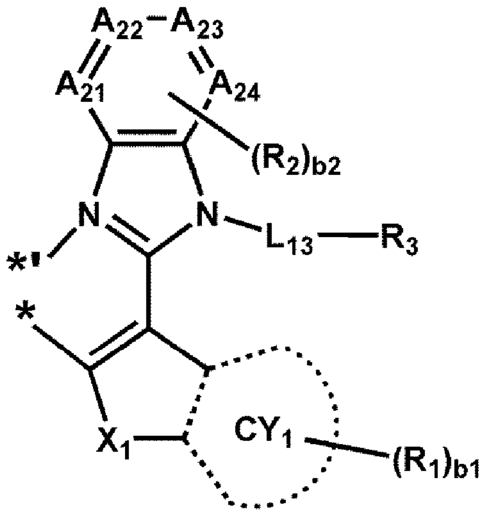

dans lequel, dans la Formule 2,
$A_{21}$ à $A_{24}$ sont chacun indépendamment N ou C,
$X_1$ est O ou S,
$L_{13}$ est une liaison simple, un groupe carbocyclique en $C_5$ à $C_{30}$ non substitué ou substitué par au moins un $R_{10a}$ ou un groupe hétérocyclique en $C_1$ à $C_{30}$ non substitué ou substitué par au moins un $R_{10a}$,
le cycle $CY_1$ est un groupe carbocyclique en $C_5$ à $C_{30}$ ou un groupe hétérocyclique en $C_1$ à $C_{30}$,
$R_1$ et $R_2$,sont chacun indépendamment l'hydrogène, le deutérium, -F, -Cl, -Br, -I, $-SF_5$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$ substitué ou non substitué, un groupe alcényle en $C_2$ à $C_{60}$ substitué ou non substitué, un groupe alkynyle en $C_2$ à $C_{60}$ substitué ou non substitué, un groupe alcoxy en $C_1$ à $C_{60}$ substitué ou non substitué, un groupe alkylthio en $C_1$ à $C_{60}$ substitué ou non substitué, un groupe cycloalkyle en $C_3$ à $C_{10}$ substitué ou non substitué, un groupe hétérocycloalkyle en $C_1$ à $C_{10}$ substitué ou non substitué, un groupe cycloalcényle $C_3$ à $C_{10}$ substitué ou non substitué, un groupe hétérocycloalcényle en $C_1$ à $C_{10}$ substitué ou non substitué, un groupe aryle en $C_6$ à $C_{60}$ substitué ou non substitué, un groupe aryloxy en $C_6$ à $C_{60}$ substitué ou non substitué, un groupe arylthio en $C_6$ à $C_{60}$ substitué ou non substitué, un groupe arylalkyle en $C_7$ à $C_{60}$ substitué ou non substitué, un groupe hétéroaryle en $C_1$ à $C_{60}$ substitué ou non substitué, un groupe hétéroaryloxy en $C_1$ à $C_{60}$ substitué ou non substitué, un groupe hétéroarylthio en $C_1$ à $C_{60}$ substitué ou non substitué, un groupe hétéroarylalkyle en $C_2$ à $C_{60}$ substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, ou- $P(Q_8)(Q_9)$,
$R_3$ est un groupe cycloalkyle en $C_3$ à $C_{10}$ substitué ou non substitué, un groupe hétérocycloalkyle en $C_1$ à $C_{10}$ substitué ou non substitué, un groupe cycloalcényle en $C_3$ à $C_{10}$ substitué ou non substitué, un groupe hétérocycloalcényle en $C_1$ à $C_{10}$ substitué ou non substitué, un groupe aryle en $C_6$ à $C_{60}$ substitué ou non substitué,

un groupe aryloxy en $C_6$ à $C_{60}$ substitué ou non substitué, un groupe arylthio en $C_6$ à $C_{60}$ substitué ou non substitué, un groupe hétéroaryle en $C_1$ à $C_{60}$ substitué ou non substitué, un groupe polycyclique condensé non aromatique monovalent substitué ou non substitué, ou un groupe hétéropolycyclique condensé non aromatique monovalent substitué ou non substitué,

b1 est un entier de 0 à 20,

b2 est un entier de 0 à 4,

au moins deux groupes parmi une pluralité de groupes $R_1$ sont éventuellement liés ensemble pour former un groupe carbocyclique en $C_5$ à $C_{30}$ non substitué ou substitué par au moins un $R_{10a}$, ou au moins deux groupes parmi une pluralité de groupes $R_1$ sont éventuellement liés ensemble pour former un groupe hétérocyclique en $C_1$ à $C_{30}$ non substitué ou substitué par au moins un $R_{10a}$,

au moins deux groupes parmi une pluralité de groupes $R_2$ sont éventuellement liés ensemble pour former un groupe carbocyclique en $C_5$ à $C_{30}$ non substitué ou substitué par au moins un $R_{10a}$, ou au moins deux groupes parmi une pluralité de groupes $R_2$ sont éventuellement liés ensemble pour former un groupe hétérocyclique en $C_1$ à $C_{30}$ non substitué ou substitué par au moins un $R_{10a}$,

$R_3$ et l'un de $R_1$ et $R_2$ sont éventuellement liés l'un à l'autre pour former un groupe carbocyclique en $C_5$ à $C_{30}$ non substitué ou substitué par au moins un $R_{10a}$, ou $R_3$ et l'un de $R_1$ et $R_2$ sont éventuellement liés l'un à l'autre pour former un groupe hétérocyclique en $C_1$ à $C_{30}$ non substitué ou substitué par au moins un $R_{10a}$,

$R_{10a}$ s'entend en se référant à la description de $R_1$ fournie ici,

* et *' indiquent chacun un site de liaison à M dans la Formule 1, et

un substituant du groupe alkyle en $C_1$ à $C_{60}$ substitué, du groupe alcényle en $C_2$ à $C_{60}$ substitué, du groupe alcynyle en $C_2$ à $C_{60}$ substitué, du groupe alcoxy en $C_1$ à $C_{60}$ substitué, du groupe alkylthio en $C_1$ à $C_{60}$ substitué, du groupe cycloalkyle en $C_3$ à $C_{10}$ substitué, du groupe hétérocycloalkyle en $C_1$ à $C_{10}$ substitué, due groupe cycloalcényle en $C_3$ à $C_{10}$ substitué, du groupe hétérocycloalcényle en $C_1$ à $C_{10}$ substitué, du groupe aryle en $C_6$ à $C_{60}$ substitué, du groupe aryloxy en $C_6$ à $C_{60}$ substitué, du groupe arylthio en $C_6$ à $C_{60}$ substitué, du groupe arylalkyle en $C_7$ à $C_{60}$ substitué, du groupe hétéroaryle en $C_1$ à $C_{60}$ substitué, du groupe hétéroaryloxy en $C_1$ à $C_{60}$ substitué, du groupe hétéroarylthio en $C_1$ à $C_{60}$ substitué, du groupe hétéroarylalkyle en $C_2$ à $C_{60}$ substitué, du groupe polycyclique condensé non aromatique monovalent substitué et du groupe hétéropolycyclique condensé non aromatique monovalent substitué sont chacun indépendamment :

le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$, un groupe alcényle en $C_2$ à $C_{60}$, un groupe alcynyle en $C_2$ à $C_{60}$, ou un groupe alcoxy en $C_1$ à $C_{60}$ ;

un groupe alkyle en $C_1$ à $C_{60}$, un groupe alcényle en $C_2$ à $C_{60}$, un groupe alkynyle en $C_2$ à $C_{60}$, un groupe alcoxy en $C_1$ à $C_{60}$, chacun substitué par le deutérium, -F, -Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en $C_6$ à $C_{60}$, un groupe arylthio en $C_6$ à $C_{60}$, un groupe arylalkyle en $C_7$ à $C_{60}$, un groupe hétéroaryle en $C_1$ à $C_{60}$, un groupe hétéroaryloxy en $C_1$ à $C_{60}$, un groupe hétéroarylthio en $C_1$ à $C_{60}$, un groupe hétéroarylalkyle en $C_2$ à $C_{60}$, un groupe polycyclique condensé non aromatique monovalent, un groupe hétéropolycyclique condensé non aromatique monovalent, - $N(Q_{11})(Q_{12})$, $-Si(Q_{13})(Q_{14})(Q_{15})$, $Ge(Q_{13})(Q_{14})(Q_{15})$, $-B(Q_{16})(Q_{17})$, $-P(=O)(Q_{18})(Q_{19})$, - $P(Q_{18})(Q_{19})$, ou une combinaison de ceux-ci ;

un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en $C_6$ à $C_{60}$, un groupe arylthio en $C_6$ à $C_{60}$, un groupe hétéroaryle en $C_1$ à $C_{60}$, un groupe polycyclique condensé non aromatique monovalent ou un groupe hétéropolycyclique condensé non aromatique monovalent, chacun non substitué ou substitué par le deutérium, -F, - Cl, -Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphoriqueou un sel de celui-ci, un groupe alkyle en $C_1$ à $C_{60}$, un groupe alcényle en $C_2$ à $C_{60}$, un groupe alcynyle en $C_2$ à $C_{60}$, un groupe alcoxy en $C_1$ à $C_{60}$, un groupe cycloalkyle en $C_3$ à $C_{10}$, un groupe hétérocycloalkyle en $C_1$ à $C_{10}$, un groupe cycloalcényle en $C_3$ à $C_{10}$, un groupe hétérocycloalcényle en $C_1$ à $C_{10}$, un groupe aryle en $C_6$ à $C_{60}$, un groupe aryloxy en $C_6$ à $C_{60}$, un groupe arylthio en $C_6$ à $C_{60}$, un groupe hétéroaryle en $C_1$ à $C_{60}$, un groupe polycyclique

condensé non aromatique monovalent, un groupe hétéropolycyclique condensé non aromatique monovalent, -N($Q_{21}$)($Q_{22}$), -Si($Q_{23}$)($Q_{24}$)($Q_{25}$), -Ge($Q_{23}$)($Q_{24}$)($Q_{25}$), -B($Q_{26}$)($Q_{27}$), -P(=O)($Q_{28}$)($Q_{29}$), - P($Q_{28}$)($Q_{29}$), ou une combinaison de ceux-ci ;

-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), -P(=O)($Q_{38}$)($Q_{39}$), ou -P($Q_{38}$)($Q_{39}$) ; ou

une combinaison de ceux-ci,

dans lequel $Q_1$ à $Q_9$, $Q_{11}$ à $Q_{19}$, $Q_{21}$ à $Q_{29}$ et $Q_{31}$ à $Q_{39}$ sont chacun indépendamment l'hydrogène, le deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{60}$ non substitué ou substitué par le deutérium, un groupe alkyle en $C_1$ à $C_{60}$, un groupe aryle en $C_6$ à $C_{60}$, ou une combinaison de ceux-ci ; un groupe alcényle en $C_2$ à $C_{60}$ ; un groupe alkynyle en $C_2$ à $C_{60}$ ; un groupe alcoxy en $C_1$ à $C_{60}$, un groupe cycloalkyle en $C_3$ à $C_{10}$ ; un groupe hétérocycloalkyle en $C_1$ à $C_{10}$ ; un groupe cycloalcényle en $C_3$ à $C_{10}$ ; un groupe hétérocycloalcényle en $C_1$ à $C_{10}$ ; un groupe aryle en $C_6$ à $C_{60}$ non substitué ou substitué par le deutérium, un groupe alkyle en $C_1$ à $C_{60}$, un groupe aryle en $C_6$ à $C_{60}$ ou une combinaison de ceux-ci ; un groupe aryloxy en $C_6$ à $C_{60}$ ; un groupe arylthio en $C_6$ à $C_{60}$ ; un groupe arylalkyle en $C_7$ à $C_{60}$ ; un groupe hétéroaryle en $C_1$ à $C_{60}$ ; un groupe hétéroaryloxy en $C_1$ à $C_{60}$ ; un groupe hétéroarylthio en $C_1$ à $C_{60}$ ; un groupe hétéroarylalkyle en $C_2$ à $C_{60}$ ; un groupe polycyclique condensé non aromatique monovalent ; ou un groupe hétéropolycyclique condensé non aromatique monovalent.

**2.** Composé organométallique selon la revendication 1, dans lequel $L_{13}$ est :

une liaison simple ; ou

un groupe divalent qui est un groupe benzène, un groupe naphtalène, un groupe pyridine, un groupe dibenzofuranne, un groupe dibenzothiophène ou un groupe carbazole, chacun non substitué ou substitué par au moins un $R_{10a}$.

**3.** Composé organométallique selon la revendication 1 ou 2, dans lequel le cycle $CY_1$ est un groupe cyclopentane, un groupe cyclohexane, un groupe cycloheptane, un groupe cyclopentène, un groupe cyclohexène, un groupe cycloheptène, un groupe adamantane, un groupe norbornane, un groupe norbornène, un groupe bicyclo[1.1.1]pentane, un groupe bicyclo[2.1.1]hexane, un groupe bicyclo[2.2.2]octane, un groupe benzène, un groupe naphtalène, un groupe anthracène, un groupe phénanthrène, un groupe triphénylène, un groupe pyrène, un groupe chrysène, un groupe 1,2,3,4-tétrahydronaphtalène, un groupe pyrrole, un groupe borole, un groupe phosphole, un groupe cyclopentadiène, un groupe silole, un groupe germole, un groupe thiophène, un groupe sélénophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un dibenzophosphole un groupe fluorène, un groupe dibenzosilole, un groupe dibenzogermole, un groupe dibenzothiophène, un groupe dibenzosélénophène, un groupe dibenzofuranne, un groupe dibenzothiophène 5-oxyde, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorène-9-one, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe benzoquinoléine, un groupe benzoisoquinoléine, un groupe quinoxaline, un groupe quinazoline, un groupe phénanthroline, un groupe pyrazole, un groupe imidazole, un groupe triazole, un groupe azaborole, un groupe azaphosphole, un groupe azacyclopentadiène, un groupe azasilole, un groupe azagermole, un groupe azasélénophène, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoline, ou un groupe 5,6,7,8-tétrahydroquinoline ; et/ou
dans lequel $R_1$ et $R_2$ sont chacun indépendamment :

hydrogène, deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de

celui-ci, un groupe acide sulfonique ou un sel de celui-ci, un groupe acide phosphorique ou un sel de celui-ci, $-SF_5$, un groupe alkyle en $C_1$ à $C_{20}$, un groupe alcényle en $C_1$ à $C_{20}$, un groupe alcoxy en $C_1$ à $C_{20}$, ou un groupe alkylthio en $C_1$ à $C_{20}$ ;

un groupe alkyle en $C_1$ à $C_{20}$, un groupe alcényle en $C_2$ à $C_{20}$, un groupe alcoxy en $C_1$ à $C_{20}$ ou un groupe alkylthio en $C_1$ à $C_{20}$, chacun substitué par du deutérium, -F, -Cl, -Br, -I, $-CD_3$, - $CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{10}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.2]octyle, un groupe (alkyle en $C_1$ à $C_{20}$)cyclopentyle, un groupe (alkyle en $C_1$ à $C_{20}$)cyclohexyle, un groupe (alkyle en $C_1$ à $C_{20}$)cycloheptyle, un groupe (alkyle en $C_1$ à $C_{20}$)cyclooctyle, un groupe (alkyle en $C_1$ à $C_{20}$)adamantanyle, un groupe (alkyle en $C_1$ à $C_{20}$)norbornanyle, un groupe (alkyle en $C_1$ à $C_{20}$)norbornényle, un groupe (alkyle en $C_1$ à $C_{20}$)cyclopentényle, un groupe (alkyle en $C_1$ à $C_{20}$)cyclohexényle, un groupe (alkyle en $C_1$ à $C_{20}$)cycloheptényle, un groupe (alkyle en $C_1$ à $C_{20}$)bicyclo[1.1.1]pentyle, un groupe (alkyle en $C_1$ à $C_{20}$)bicyclo[2.1.1]hexyle, un groupe (alkyle en $C_1$ à $C_{20}$)bicyclo[2.2.2]octyle, un groupe phényle, un groupe (alkyle en $C_1$ à $C_{20}$)phényle, un groupe biphényle, un groupe terphényle, un groupe naphtyle, un groupe pyridinyle, un groupe pyrimidinyle, ou une combinaison de ceux-ci ;

un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.2]octyle, un groupe phényle, un groupe (alkyle en $C_1$ à $C_{20}$)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, un groupe azacarbazolyle, un groupe azadibenzofuranyle, ou un groupe azadibenzothiophényle, chacun non substitué ou substitué par le deutérium, -F, -Cl, Br, -I, $-CD_3$, $-CD_2H$, $-CDH_2$, $-CF_3$, $-CF_2H$, $-CFH_2$, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en $C_1$ à $C_{20}$, un groupe alkyle en $C_2$ à $C_{20}$ deutérié, un groupe alcoxy en $C_1$ à $C_{20}$, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe bicyclo[1.1.1]pentyle, un groupe bicyclo[2.1.1]hexyle, un groupe bicyclo[2.2.2]octyle, un groupe (alkyle en $C_1$ à $C_{20}$)cyclopentyle, un groupe (alkyle en $C_1$ à $C_{20}$)cyclohexyle, un groupe (alkyle en $C_1$ à $C_{20}$)cycloheptyle, un groupe (alkyle en $C_1$ à $C_{20}$)cyclooctyle, un groupe (alkyle en $C_1$ à $C_{20}$)adamantanyle, un groupe (alkyle en $C_1$ à $C_{20}$)norbornanyle, un groupe (alkyle en $C_1$ à $C_{20}$) norbornenyle, un groupe (alkyle en $C_1$ à $C_{20}$)cyclopentenyle, un groupe (alkyle en $C_1$ à $C_{20}$)cyclohexényle, un groupe (alkyle en $C_1$ à $C_{20}$)cycloheptenyle, un groupe (alkyle en $C_1$ à $C_{20}$)bicyclo[1.1.1]pentyle, un groupe (alkyle en $C_1$ à $C_{20}$)bicyclo[2.1.1]hexyle, un groupe (alkyle en en $C_1$ à $C_{20}$)bicyclo[2.2.2]octyle, un groupe phényle, un groupe (alkyle en en $C_1$ à $C_{20}$)phényle, un groupe biphényle, un groupe terphényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un

groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle ; un groupe azacarbazolyle, un groupe azadibenzofuranyle, un groupe azadibenzothiophényle, ou une combinaison de ceux-ci ; ou
$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, ou $-P(Q_8)(Q_9)$,
dans lequel $Q_1$ à $Q_9$ sont chacun indépendamment :

deutérium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, - $CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, - $CF_2CF_3$, $-CF_2CF_2H$, ou $-CF_2CFH_2$ ; ou
un groupe n-propyle, un groupe iso-propyle, un groupe n-butyle, un groupe sec-butyle, un groupe isobutyle, un groupe tert-butyle, un groupe n-pentyle, un groupe tert-pentyle, un groupe néopentyle, un groupe isopentyle, un groupe sec-pentyle, un groupe 3-pentyle, un groupe sec-isopentyle, un groupe phényle, un groupe biphényle ou un groupe naphtyle, chacun non substitué ou substitué par du deutérium, -F, un groupe alkyle $C_1$ à $C_{10}$, un groupe phényle ou une combinaison de ceux-ci.

4. Composé organométallique selon l'une quelconque des revendications 1 à 3, dans lequel
$R_2$ est hydrogène, deutérium, -F, un groupe cyano, un groupe alkyle en $C_1$ à $C_{60}$ substitué ou non substitué, un groupe cycloalkyle en $C_3$ à $C_{10}$ substitué ou non substitué, $-Si(Q_3)(Q_4)(Q_5)$, ou $-Ge(Q_3)(Q_4)(Q_5)$.

5. Composé organométallique selon l'une quelconque des revendications 1 à 4, dans lequel un groupe représenté par

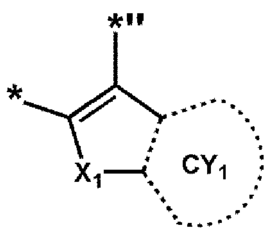

dans la Formule 2 est représenté par l'une des Formules 2(1) à 2(31) :

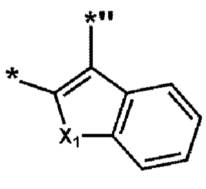
2(1)

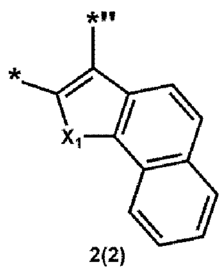
2(2)

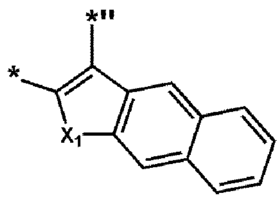
2(3)

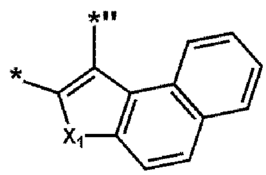
2(4)

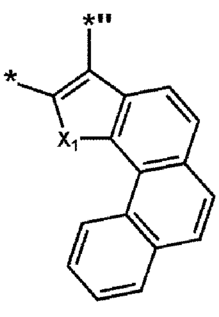
2(5)

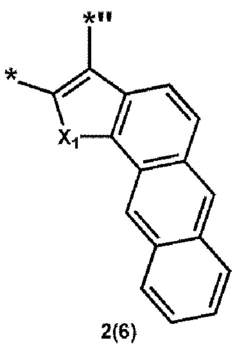
2(6)

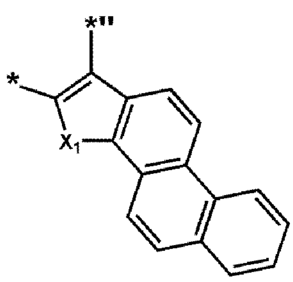
2(7)

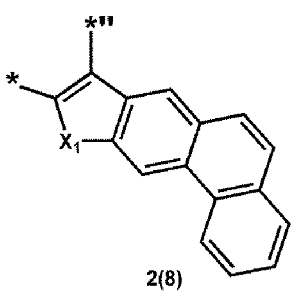
2(8)

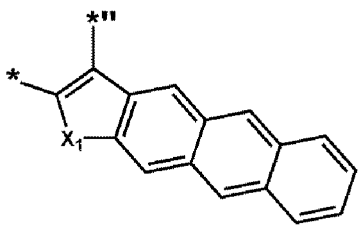
2(9)

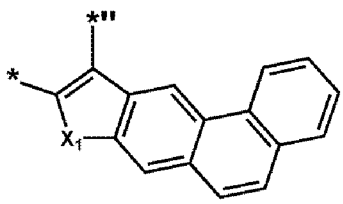
2(10)

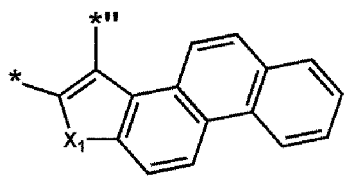
2(11)

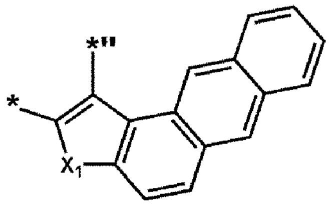
2(12)

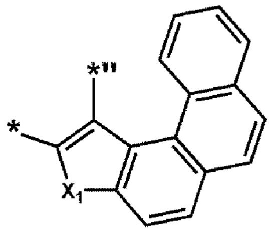
2(13)

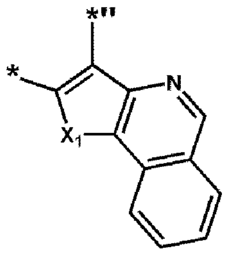
2(14)

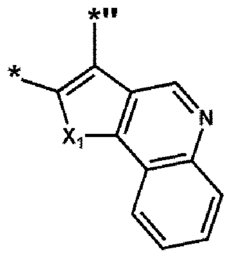
2(15)

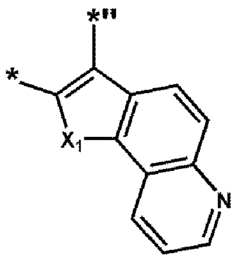
2(16)

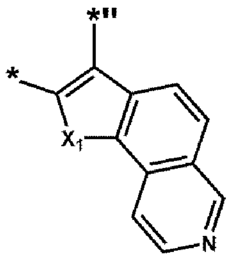
2(17)

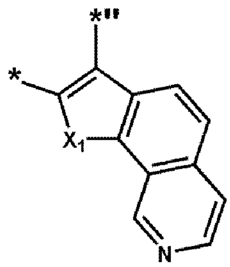
2(18)

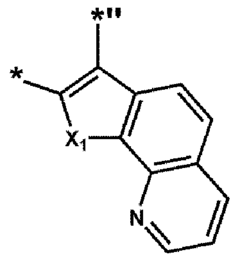
2(19)

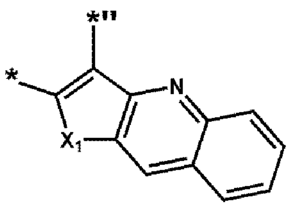
2(20)

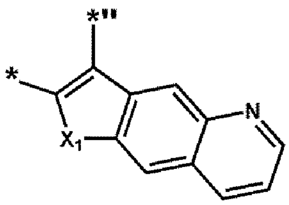
2(21)

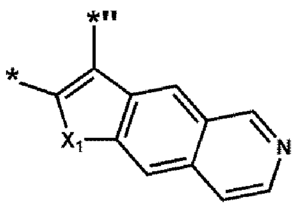
2(22)

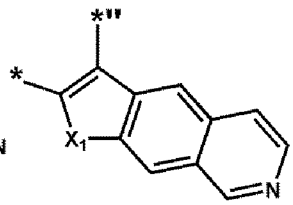
2(23)

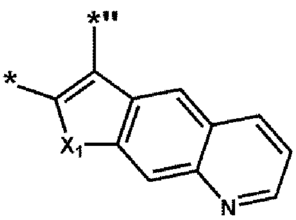
2(24)

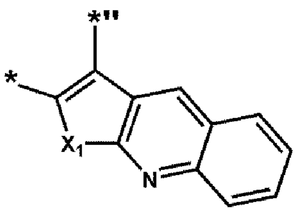
2(25)

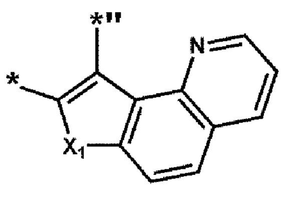
2(26)

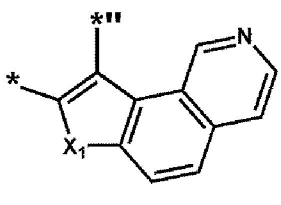
2(27)

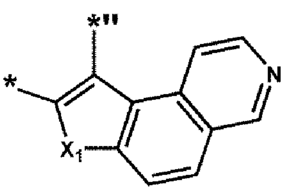
2(28)

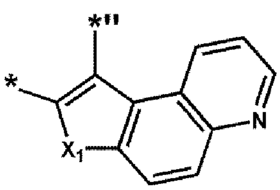
2(29)

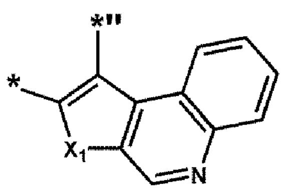
2(30)

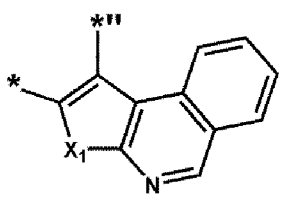
2(31)

dans lequel, dans les formules 2(1) à 2(31),

$X_1$ s'entend en se référant à la description de $X_1$ dans la revendication 1,
* indique un site de liaison à M dans la Formule 1, et
*" indique un site de liaison à un atome de carbone adjacent ; ou
dans lequel un groupe représenté par

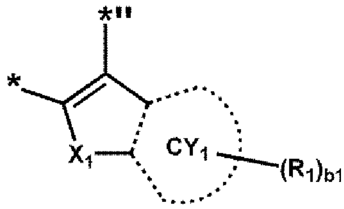

dans la Formule 2 est représenté par l'une des Formules 2-1 à 2-57 :

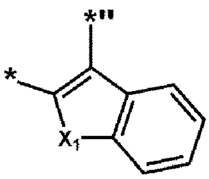

2-1

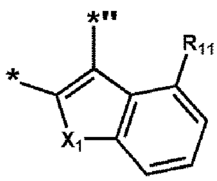

2-2

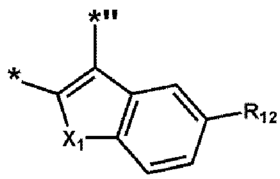

2-3

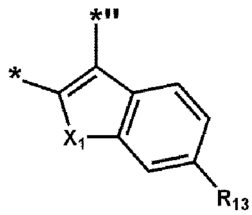

2-4

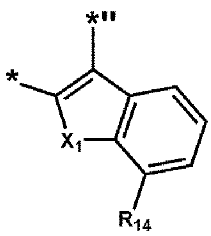

2-5

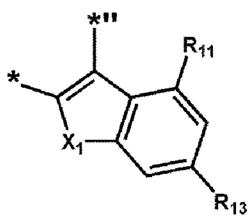

2-6

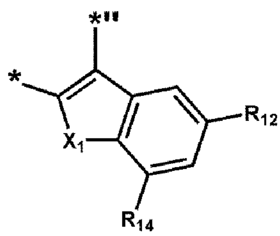

2-7

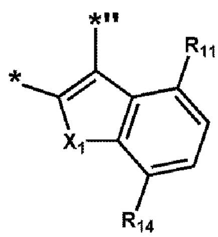

2-8

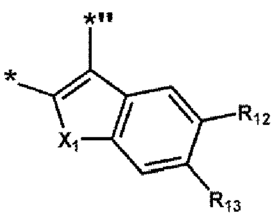

2-9

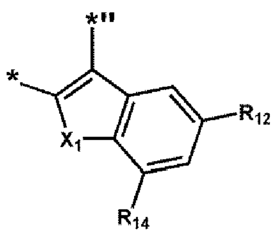

2-10

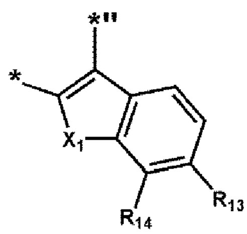

2-11

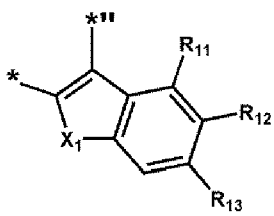

2-12

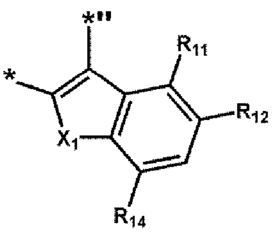

2-13

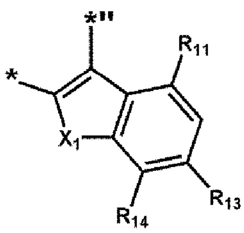

2-14

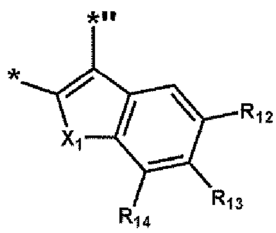

2-15

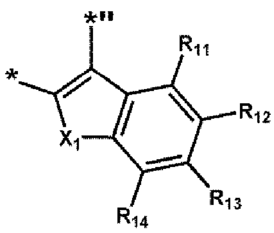

2-16

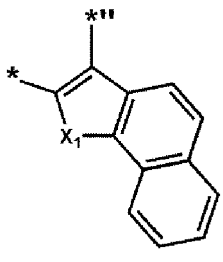
2-17

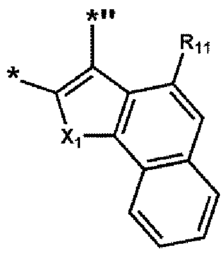
2-18

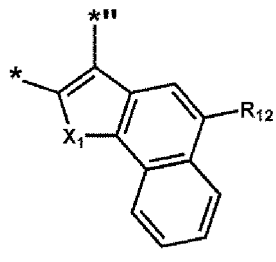
2-19

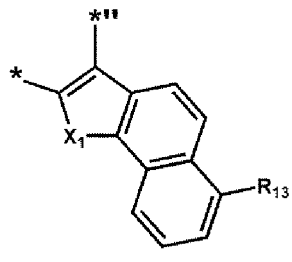
2-20

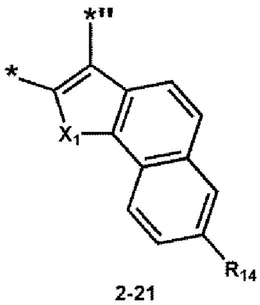
2-21

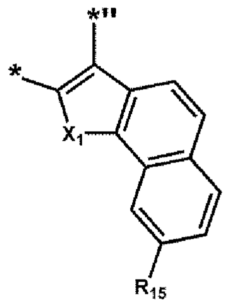
2-22

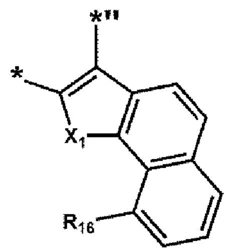
2-23

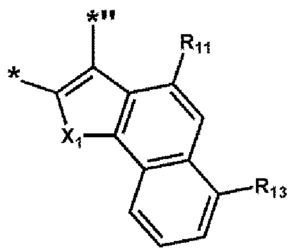
2-24

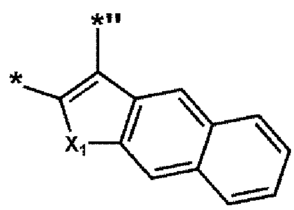
2-25

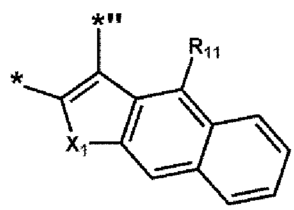
2-26

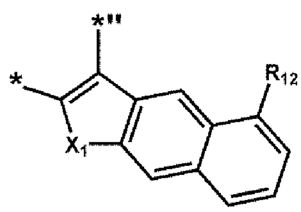
2-27

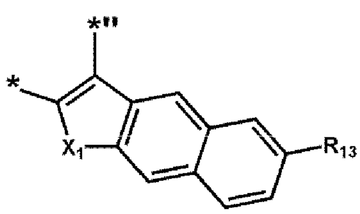
2-28

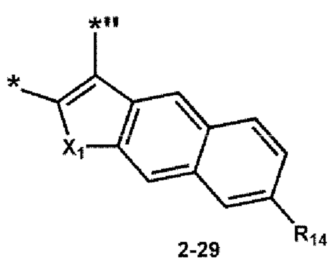
2-29

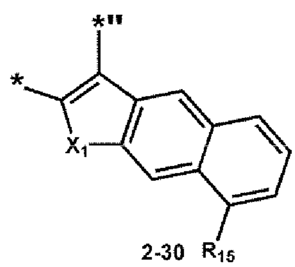
2-30

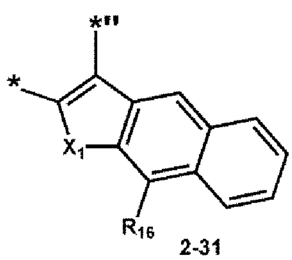
2-31

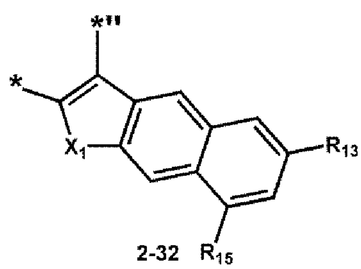
2-32

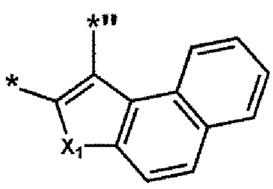
2-33

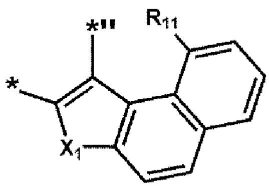
2-34

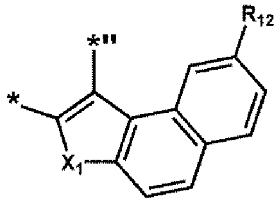
2-35

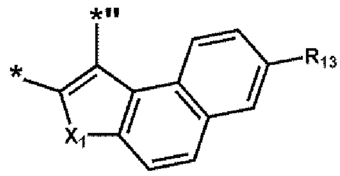
2-36

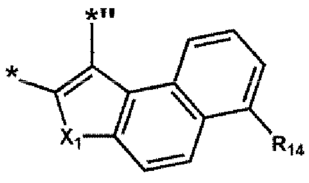
2-37

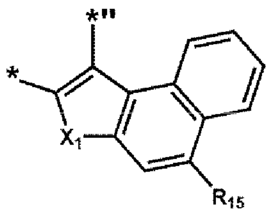
2-38

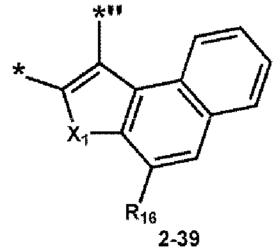
2-39

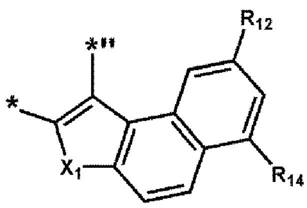
2-40

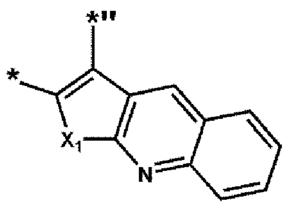
2-41

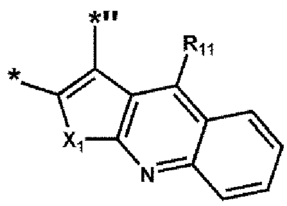
2-42

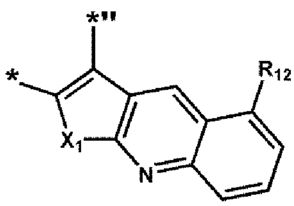
2-43

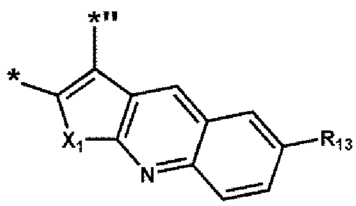
2-44

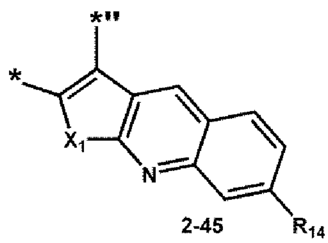
2-45

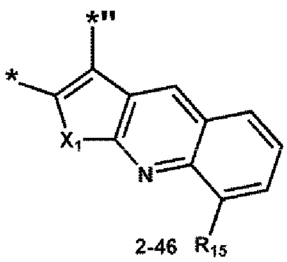
2-46

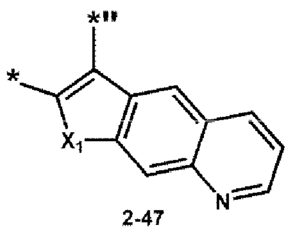
2-47

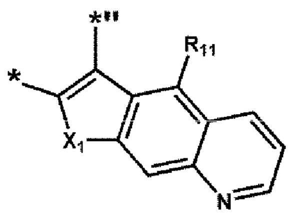
2-48

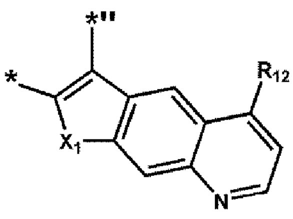
2-49

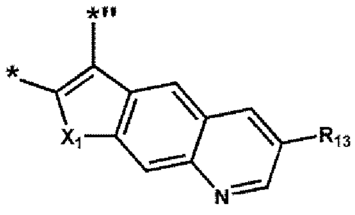
2-50

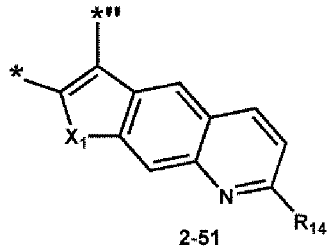
2-51

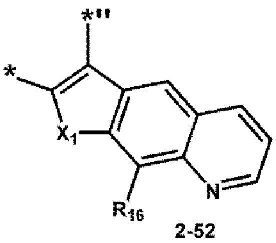
2-52

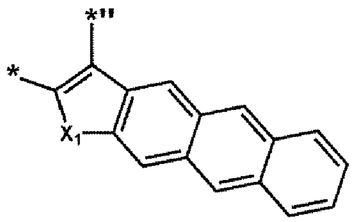
2-53

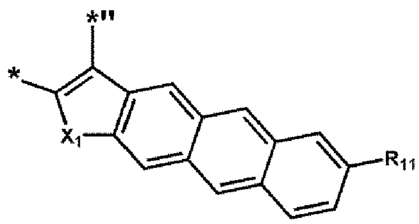
2-54

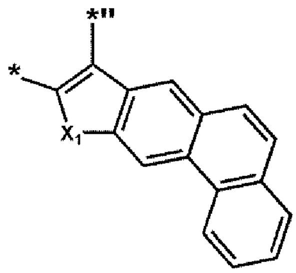
2-55

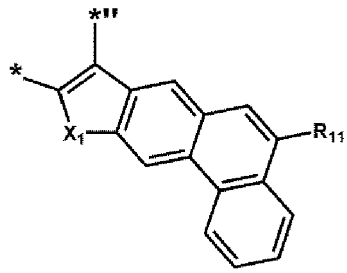
2-56

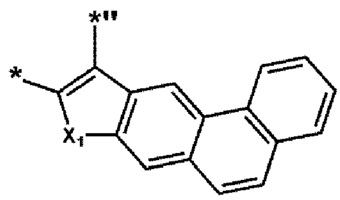
2-57

dans lequel, dans les formules 2-1 à 2-57,
$X_1$ s'entend en se référant à la description de $X_1$ dans la revendication 1,
$R_{11}$ à $R_{16}$ s'entendent chacun en se référant à la description de $R_1$ dans la revendication 1, dans lequel $R_{11}$ à $R_{16}$ sont chacun non hydrogène,
* indique un site de liaison à M dans la formule 1, et
*" indique un site de liaison à un atome de carbone adjacent.

6. Composé organométallique selon l'une quelconque des revendications 1 à 5, dans lequel $L_2$ dans la Formule 1 est un ligand bidenté lié à M dans la Formule 1 via O, S, Se, N, C, P, Si, As, ou une combinaison de ceux-ci ; ou dans lequel $L_2$ dans la Formule 1 est un ligand bidenté lié à M dans la Formule 1 via N et C ou un ligand bidenté lié à M dans la Formule 1 via deux atomes O.

7. Composé organométallique selon l'une quelconque des revendications 1 à 6, dans lequel $L_2$ dans la Formule 1 est un groupe représenté par l'une des Formules 3A à 3F :

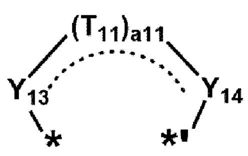
3A

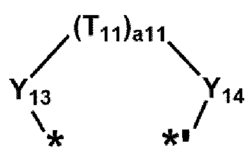
3B

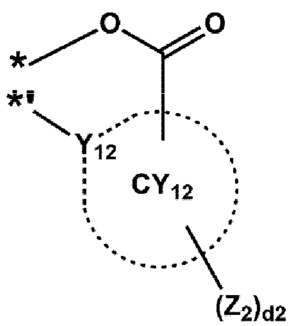
3C

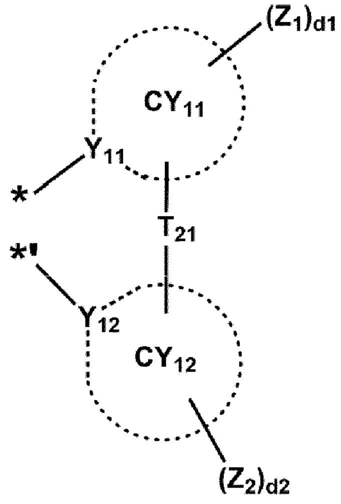
3D

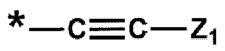 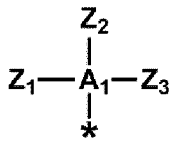

3E 3F

dans lequel, dans les Formules 3A à 3F,

$Y_{13}$ est O, N, $N(Z_1)$, $P(Z_1)(Z_2)$, ou $As(Z_1)(Z_2)$,
$Y_{14}$ est O, N, $N(Z_3)$, $P(Z_3)(Z_4)$, ou $As(Z_3)(Z_4)$,
$T_{11}$ est une simple liaison, une double liaison, *-$C(Z_{11})(Z_{12})$-*', *-$C(Z_{11})=C(Z_{12})$-*', *=$C(Z_{11})$-*', *-$C(Z_{11})$=*', *-$C(Z_{11})$-$C(Z_{12})=C(Z_{13})$-*', *-$C(Z_{11})=C(Z_{12})$-$C(Z_{13})$=*', *-$N(Z_{11})$- *', ou un groupe carbocyclique en $C_5$-$C_{30}$ non substitué ou substitué par au moins un $Z_{11}$,
a11 est un nombre entier de 1 à 10, et lorsque a11 est égal ou supérieur à 2, au moins deux groupes $T_{11}$ sont identiques ou différents l'un de l'autre,
$Y_{11}$ et $Y_{12}$ sont chacun indépendamment C ou N,
$T_{21}$ est une simple liaison, une double liaison, O, S, $C(Z_{11})(Z_{12})$, $Si(Z_{11})(Z_{12})$ ou $N(Z_{11})$,
le cycle $CY_{11}$ et le cycle $CY_{12}$ sont chacun indépendamment un groupe carbocyclique en $C_5$ à $C_{30}$ ou un groupe hétérocyclique en $C_1$ à $C_{30}$,
$A_1$ est P ou As,
$Z_1$ à $Z_4$ et $Z_{11}$ à $Z_{13}$ s'entendent chacun en se référant à $R_1$ dans la revendication 1,
d1 et d2 sont chacun indépendamment un nombre entier de 0 à 20, et
* et *' indiquent chacun un site de liaison à M dans la Formule 1 ;
de préférence dans lequel $L_2$ est un ligand représenté par la Formule 3D, et au moins l'un parmi $Z_1$ et $Z_2$ dans la Formule 3D sont chacun indépendamment du deutérium ; -$Si(Q_3)(Q_4)(Q_5)$ ; - $Ge(Q_3)(Q_4)(Q_5)$ ; ou un groupe alkyle en $C_1$ à $C_{60}$ substitué par au moins un deutérium.

**8.** Composé organométallique selon la revendication 7, dans lequel $L_2$ est un ligand représenté par l'une des Formules 3-1 et 3-101 à 3-112 :

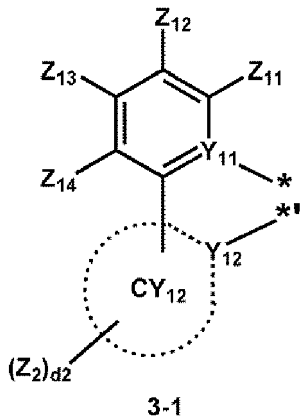

3-1

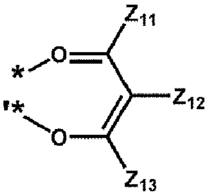 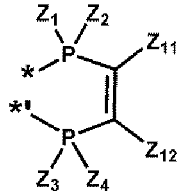 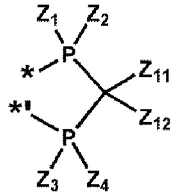 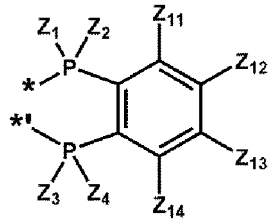

3-101 3-102 3-103 3-104

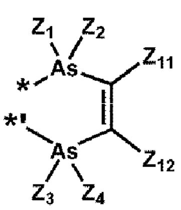

3-105

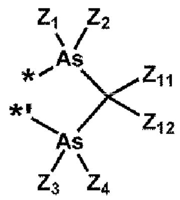

3-106

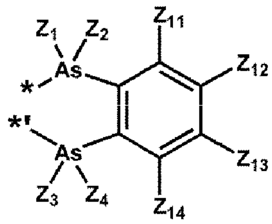

3-107

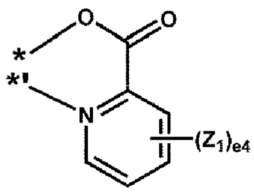

3-108

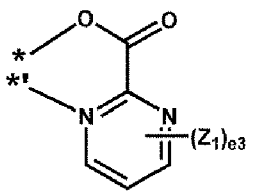

3-109

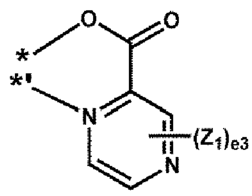

3-110

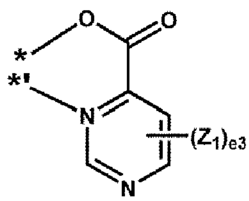

3-111

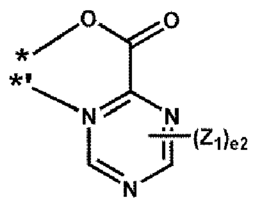

3-112

dans lequel, dans les Formules 3-1 et 3-101 à 3-112,

$Y_{11}$, $Y_{12}$, le cycle $CY_{12}$, $Z_1$ à $Z_4$, $Z_{11}$ à $Z_{13}$ et d2 s'entendent respectivement en se référant à $Y_{11}$, $Y_{12}$, au cycle $CY_{12}$, $Z_1$ à $Z_4$, $Z_{11}$ à $Z_{13}$, et d2 dans la revendication 7,
$Z_{14}$ s'entend en se référant à $Z_1$ dans la revendication 7,
e2 est un nombre entier de 0 à 2,
e3 est un nombre entier de 0 à 3,
e4 est un nombre entier de 0 à 4 ; et
* et *' indiquent chacun un site de liaison à M dans la Formule 1.

**9.** Composé organométallique selon la revendication 8, dans lequel $Z_{12}$ dans la Formule 3-1 est $-Si(Q_3)(Q_4)(Q_5)$ ; $-Ge(Q_3)(Q_4)(Q_5)$ ; ou un groupe alkyle en $C_1$ à $C_{60}$ substitué par au moins un deutérium.

**10.** Composé organométallique selon les revendications 8 ou 9, dans lequel $Z_{12}$ dans la Formule 3-1 est $-Si(Q_3)(Q_4)(Q_5)$ ou $-Ge(Q_3)(Q_4)(Q_5)$ et $Z_{13}$ n'est pas un hydrogène ni un groupe méthyle.

**11.** Composé organométallique selon l'une quelconque des revendications 8 à 10, dans lequel un groupe représenté par

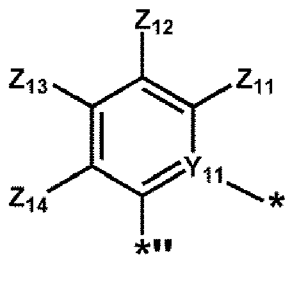

dans la Formule 3-1 est représenté par l'une des Formules 3-1-1 à 3-1-16, et un groupe représenté par

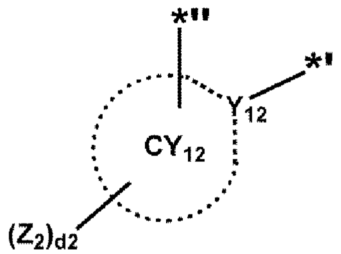

dans la Formule 3-1 est représenté par l'une des formules 3-1(1) à 3-1(16) :

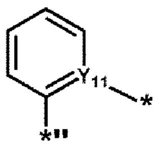
3-1-1

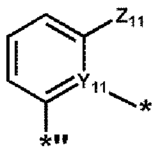
3-1-2

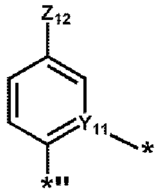
3-1-3

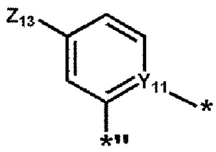
3-1-4

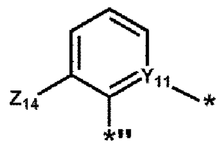
3-1-5

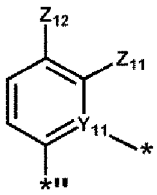
3-1-6

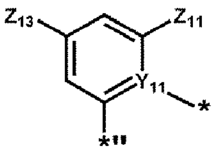
3-1-7

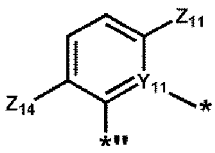
3-1-8

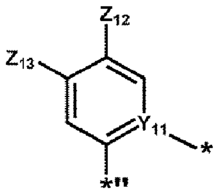
3-1-9

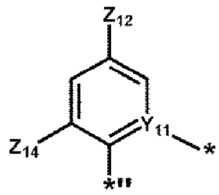
3-1-10

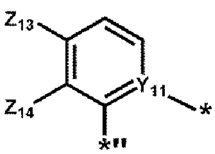
3-1-11

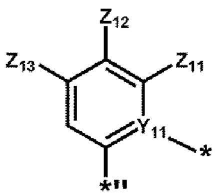
3-1-12

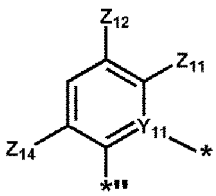
3-1-13

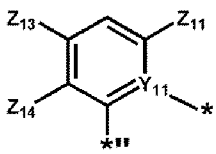
3-1-14

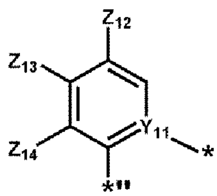
3-1-15

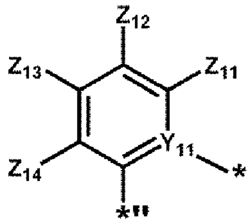
3-1-16

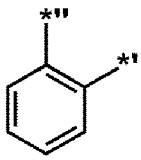
3-1(1)

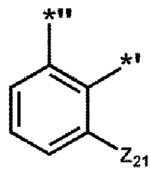
3-1(2)

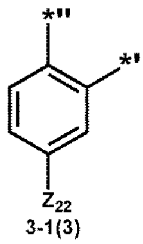
3-1(3)

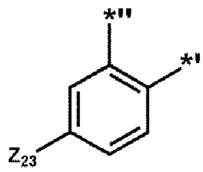
3-1(4)

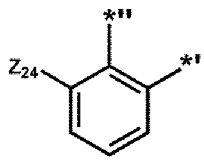
3-1(5)

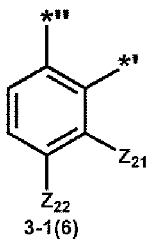
3-1(6)

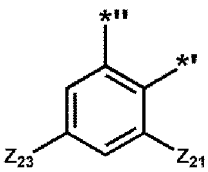
3-1(7)

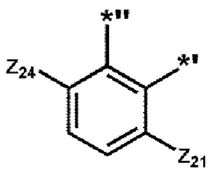
3-1(8)

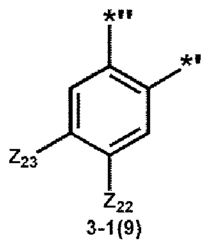
3-1(9)

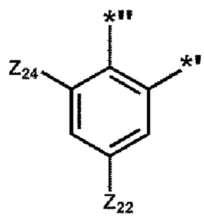
3-1(10)

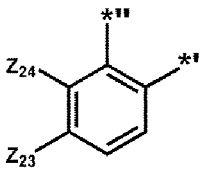
3-1(11)

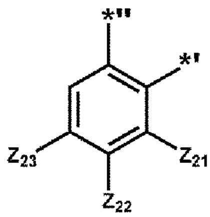
3-1(12)

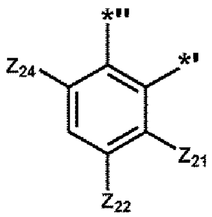
3-1(13)

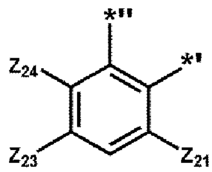
3-1(14)

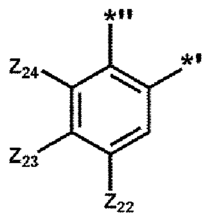
3-1(15)

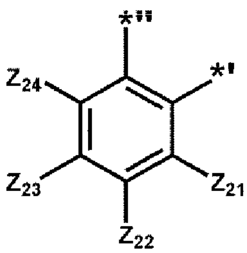
3-1(16)

dans lequel, dans les Formules 3-1-1 à 3-1-16 et 3-1(1) à 3-1(16),

$Z_{11}$ à $Z_{14}$s'entendent respectivement en se référant à $Z_{11}$ à $Z_{14}$ dans la revendication 8, $Z_{21}$ à $Z_{24}$ s'entendent chacun en se référant à $Z_2$ dans la revendication 8, dans lequel $Z_{11}$ à $Z_{14}$ et $Z_{21}$ à $Z_{24}$ sont non hydrogène,
* et *' indiquent chacun un site de liaison à M dans la Formule 1, et
*" indique un site de liaison à un atome adjacent.

**12.** Composé organométallique selon l'une quelconque des revendications 1 à 11, comprenant : au moins un atome de deutérium.

**13.** Dispositif électroluminescent organique comprenant :

une première électrode ;
une seconde électrode ; et
une couche organique disposée entre la première électrode et la seconde électrode et comprenant une couche d'émission ;
dans lequel la couche organique comprend au moins un composé organométallique selon l'une quelconque des revendications 1 à 12 ;
de préférence dans lequel
la première électrode est une anode,
la seconde électrode est une cathode, et
la couche organique comprend une région de transport de trous disposée entre la première électrode et la couche d'émission et une région de transport d'électrons disposée entre la couche d'émission et la seconde électrode,
la région de transport de trous comprend une couche d'injection de trous, une couche de transport de trous, une couche de blocage d'électrons, une couche tampon, ou toute combinaison de celles-ci, et
la région de transport d'électrons comprend une couche de blocage de trous, une couche de transport d'électrons, une couche d'injection d'électrons ou toute combinaison de celles-ci.

**14.** Dispositif électroluminescent organique selon la revendication 13, dans lequel la couche d'émission comprend le composé organométallique.

**15.** Appareil électronique, comprenant le dispositif électroluminescent organique selon la revendication 14.

# FIGURE

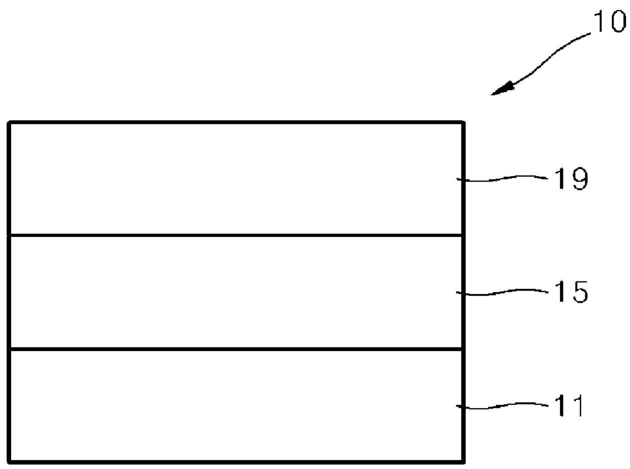

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003252888 A